# EUROPEAN PATENT APPLICATION

(11) **EP 4 478 862 A1**
(43) Date of publication of application: **18.12.2024**
(21) Application number: 23179376.1
(22) Date of filing: 15.06.2023
(51) Int. Cl.: H10K 50/19, H10K 50/17, H10K 85/30, H10K 71/30, H10K 101/30

(54) **ORGANIC ELECTROLUMINESCENT DEVICE COMPRISING A FIRST METAL COMPOUND AND A SECOND METAL COMPOUND, AND A DISPLAY DEVICE COMPRISING THE ORGANIC ELECTROLUMINESCENT DEVICE**

(71) Applicant: Novaled GmbH, 01099 Dresden (DE)
(72) Inventor: UVAROV, Vladimir c/o Novaled GmbH, 01099 Dresden (DE); PINTER, Piermaria c/o Novaled GmbH, 01099 Dresden (DE); LUSCHTINETZ, Regina c/o Novaled GmbH, 01099 Dresden (DE)
(74) Representative: Michalski Hüttermann & Partner Patentanwälte mbB

(57) **Abstract**

The present invention relates to an organic electroluminescent device comprising a first metal compound and a second metal compound, and a display device comprising the organic electroluminescent device.

## Description

### Technical Field

The present invention relates to an organic electroluminescent device comprising a first metal compound and a second metal compound, and a display device comprising the organic electroluminescent device.

### Background Art

Organic electronic devices, such as organic light-emitting diodes OLEDs, which are self-emitting devices, have a wide viewing angle, excellent contrast, quick response, high brightness, excellent operating voltage characteristics, and color reproduction. A typical OLED comprises an anode, a hole transport layer HTL, an emission layer EML, an electron transport layer ETL, and a cathode, which are sequentially stacked on a substrate. In this regard, the HTL, the EML, and the ETL are thin films formed from organic compounds.

When a voltage is applied to the anode and the cathode, holes injected from the anode move to the EML, via the HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency and/or a long lifetime.

Performance of an organic light emitting diode may be affected by characteristics of the semiconductor layers, and among them, may be affected by characteristics of the compounds contained in the semiconductor layers.

There remains a need to improve performance of organic electroluminescent devices, in particular to achieve improved operating voltage, improved operating voltage stability over time and improved current efficiency.

### DISCLOSURE

An object of the present invention is the provision of an organic electroluminescent device, that can be a stacked OLED, also named multi-stack OLED, with improved performance in particular improved current efficiency, improved external quantum efficiency, improved operational voltage, and/or improved operational voltage stability over time especially an improved current efficiency and at the same time an improved operational voltage stability over time with a good operational voltage.

The organic electroluminescent device, may comprises a first metal compound such as a metal salt or metal complex in the hole injection layer having a monoanion or a monoanionic ligand comprising 5 covalently bound atoms, wherein the first metal compound has a LUMO energy level of ≤ -4.65 eV, preferably < -4.65 eV, and a second metal compound such as a metal salt or metal complex having a monoanion or a monoanionic ligand comprising 5 covalently bound atoms in the p-type charge generation layer, wherein the second metal compound has a LUMO energy level of ≤ -4.65 eV.

An aspect of the present invention provides organic electroluminescent device comprising an anode layer, a cathode layer, a first emission layer, a second emission layer, a hole injection layer, and a first charge generation layer,
wherein the hole injection layer is in direct contact to the anode layer,
wherein the first charge generation layer is arranged between the first emission layer and the second emission layer;
   wherein the first charge generation layer comprises a first n-type charge generation layer and a first p-type charge generation layer;
   wherein the first n-type charge generation layer comprises an organic electron transport matrix compound and a metal-dopant, and the first n-type charge generation layer is arranged closer to the anode layer than the first p-type charge generation layer;
   wherein the hole injection layer comprises a first metal compound,
   wherein the first metal compound is selected from the group comprising a metal salt, or a metal complex, wherein the metal complex comprises a metal cation and at least one monoanion comprising at least 5 covalently bound atoms and/or at least one monoanionic ligand L comprising at least 5 covalently bound atoms, wherein the first metal compound has a LUMO energy level of ≤ -4.65 eV, preferably < -4.65 eV;
   wherein the first p-type charge generation layer comprises a second metal compound,
   wherein the second metal compound is selected from the group comprising a metal salt, or a metal complex, wherein the metal complex comprises a metal cation and at least one monoanion comprising at least 5 covalently bound atoms and/or at least one monoanionic ligand L comprising at least 5 covalently bound atoms, the second metal compound has a LUMO energy level of ≤ -4.65 eV;
   and wherein the first metal compound of the hole injection layer is selected different from the second metal compound of the first p-type charge generation layer.

It should be noted that throughout the application and the claims any A¹, A², A³ and A⁴, R, R¹, R², R³ , R⁴, R⁵, R⁶ and R⁷, R^{a}, R^{b}, R^{c} and R^{d}, R^{a'} and R^{b'}, R^{1'} to R^{4'}, X¹, X², X³ and X⁴, Z, etc. always refer to the same moieties as individually defined from each other, unless otherwise noted.

In the present specification, when a definition is not otherwise provided, "substituted" refers to one substituted with a deuterium, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, =N, =N-.

However, in the present specification "aryl substituted" refers to a substitution with one or more aryl groups, which themselves may be substituted with one or more aryl and/or heteroaryl groups.

Correspondingly, in the present specification "heteroaryl substituted" refers to a substitution with one or more heteroaryl groups, which themselves may be substituted with one or more aryl and/or heteroaryl groups.

In the present specification, when a definition is not otherwise provided, an "alkyl group" refers to a saturated aliphatic hydrocarbyl group. The alkyl group may be a C₁ to C₁₂ alkyl group. More specifically, the alkyl group may be a C₁ to C₁₀ alkyl group or a C₁ to C₆ alkyl group. For example, a C₁ to C₄ alkyl group includes 1 to 4 carbons in alkyl chain, and may be selected from methyl, ethyl, propyl, iso-propyl, n-butyl, iso-butyl, sec-butyl, and tert-butyl.

Specific examples of the alkyl group may be a methyl group, an ethyl group, a propyl group, an isopropyl group, a butyl group, an iso-butyl group, a sec-butyl group, a tert-butyl group, a pentyl group, a hexyl group.

The term "cycloalkyl" refers to saturated hydrocarbyl groups derived from a cycloalkane by formal abstraction of one hydrogen atom from a ring atom comprised in the corresponding cycloalkane. Examples of the cycloalkyl group may be a cyclopropyl group, a cyclobutyl group, a cyclopentyl group, a cyclohexyl group, a methylcyclohexyl group, an adamantly group and the like.

The term "hetero" is understood the way that at least one carbon atom, in a structure which may be formed by covalently bound carbon atoms, is replaced by another polyvalent atom. Preferably, the heteroatoms are selected from B, Si, N, P, O, S; more preferably from N, P, O, S.

In the present specification, "aryl group" refers to a hydrocarbyl group which can be created by formal abstraction of one hydrogen atom from an aromatic ring in the corresponding aromatic hydrocarbon. Aromatic hydrocarbon refers to a hydrocarbon which contains at least one aromatic ring or aromatic ring system. Aromatic ring or aromatic ring system refers to a planar ring or ring system of covalently bound carbon atoms, wherein the planar ring or ring system comprises a conjugated system of delocalized electrons fulfilling Hiickel's rule. Examples of aryl groups include monocyclic groups like phenyl or tolyl, polycyclic groups which comprise more aromatic rings linked by single bonds, like biphenyl, and polycyclic groups comprising fused rings, like naphthyl or fluoren-2-yl.

Analogously, under heteroaryl, it is especially where suitable understood a group derived by formal abstraction of one ring hydrogen from a heterocyclic aromatic ring in a compound comprising at least one such ring.

Under heterocycloalkyl, it is especially where suitable understood a group derived by formal abstraction of one ring hydrogen from a saturated cycloalkyl ring in a compound comprising at least one such ring.

The term "fused aryl rings" or "condensed aryl rings" is understood the way that two aryl rings are considered fused or condensed when they share at least two common sp²-hybridized carbon atoms.

The term "cyano moiety" refers to a CN substituent.

The term "electron-withdrawing group" refers to a chemical group in a molecule, which can draw electrons away from an adjacent part of the molecule. The distance over which the electron-withdrawing group can exert its effect, namely the number of bonds over which the electron-withdrawing effect spans, is extended by conjugated pi-electron systems such as aromatic systems. Examples of electron-withdrawing groups include NO₂, CN, halogen, Cl, F, partially fluorinated or perfluorinated alkyl and partially fluorinated or perfluorinated C₁ to C₁₂ alkyl, partially fluorinated or perfluorinated alkoxy, partially fluorinated or perfluorinated C₁ to C₆ alkoxy.

In the present specification, the single bond refers to a direct bond.

The term "n-type charge generation layer" is sometimes in the art also named n-CGL or electron generation layer and is intended to include the both.

The term "p-type charge generation layer" is sometimes in the art also named p-CGL or hole generation layer and is intended to include the both.

The term "free of', "does not contain", "does not comprise" does not exclude impurities which may be present in the compounds prior to deposition. Impurities have no technical effect with respect to the object achieved by the present invention.

The term "contacting sandwiched" refers to an arrangement of three layers whereby the layer in the middle is in direct contact with the two adjacent layers.

The terms "light-absorbing layer" and "light absorption layer" are used synonymously.

The terms "light-emitting layer", "light emission layer" and "emission layer" are used synonymously.

The terms "OLED", "organic light-emitting diode" and "organic light-emitting device" are used synonymously.

The terms "anode", "anode layer" and "anode electrode" are used synonymously.

The terms "cathode", "cathode layer" and "cathode electrode" are used synonymously.

The term "top emission device" is understood to mean an organic electronic device wherein the light is emitted through the cathode layer.

The term "bottom emission device" is understood to mean an organic electronic device wherein the light is emitted through the substrate.

In the specification, hole characteristics refer to an ability to donate an electron to form a hole when an electric field is applied and that a hole formed in the anode may be easily injected into the emission layer and transported in the emission layer due to conductive characteristics according to a highest occupied molecular orbital (HOMO) level.

In addition, electron characteristics refer to an ability to accept an electron when an electric field is applied and that electrons formed in the cathode may be easily injected into the emission layer and transported in the emission layer due to conductive characteristics according to a lowest unoccupied molecular orbital (LUMO) level.

### Advantageous Effects

Surprisingly, it was found that the organic electroluminescent device according to the invention solves the problem underlying the present invention by enabling devices in various aspects superior over the organic electroluminescent devices known in the art, in particular with respect to OLED performance such as improved operating voltage, improved current efficiency, and improved external quantum efficiency, and OLED stability such as improved operating voltage stability over time, and lifetime.

### Multi-stacked OLED

The organic electroluminescent device, can be a stacked OLED, also named multi-stack OLED.

According to one embodiment the organic electroluminescent device can be a multi-stacked OLED comprising an anode layer, a cathode layer, a first emission layer, a second emission layer, a hole injection layer, and a first charge generation layer,
wherein the hole injection layer is in direct contact to the anode layer,
wherein the first charge generation layer is arranged between the first emission layer and the second emission layer;
   wherein the first charge generation layer comprises a first n-type charge generation layer and a first p-type charge generation layer;
   wherein the first n-type charge generation layer comprises an organic electron transport matrix compound and a metal-dopant, and the first n-type charge generation layer is arranged closer to the anode layer than the first p-type charge generation layer;
   wherein the hole injection layer comprises a first metal compound,
   wherein the first metal compound is selected from the group comprising a metal salt, or a metal complex, wherein the metal complex comprises a metal cation and at least one monoanion comprising at least 5 covalently bound atoms and/or at least one monoanionic ligand L comprising at least 5 covalently bound atoms, wherein the first metal compound has a LUMO energy level of ≤ -4.65 eV, preferably < -4.65 eV;
   wherein the first p-type charge generation layer comprises a second metal compound,
   wherein the second metal compound is selected from the group comprising a metal salt, or a metal complex, wherein the metal complex comprises a metal cation and at least one monoanion comprising at least 5 covalently bound atoms and/or at least one monoanionic ligand L comprising at least 5 covalently bound atoms, the second metal compound has a LUMO energy level of ≤ -4.65 eV;
   and wherein the first metal compound of the hole injection layer is selected different from the second metal compound of the first p-type charge generation layer.

### Embodiments

According to one embodiment, wherein the organic electroluminescent device comprises an anode layer, a cathode layer, a first emission layer, a second emission layer, a hole injection layer, and a first charge generation layer,
wherein the hole injection layer is in direct contact to the anode layer,
wherein the first charge generation layer is arranged between the first emission layer and the second emission layer;
   wherein the first charge generation layer comprises a first n-type charge generation layer and a first p-type charge generation layer;
   wherein the first n-type charge generation layer comprises an organic electron transport matrix compound and a metal-dopant, and the first n-type charge generation layer is arranged closer to the anode layer than the first p-type charge generation layer;
   wherein the hole injection layer comprises a first metal compound,
   wherein the first metal compound is selected from the group comprising a metal salt, or a metal complex, wherein the metal complex comprises a metal cation and at least one monoanion comprising at least 5 covalently bound atoms and/or at least one monoanionic ligand L comprising at least 5 covalently bound atoms, wherein the first metal compound has a LUMO energy level of ≤ -4.65 eV, preferably < -4.65 eV;
   wherein the first p-type charge generation layer comprises a second metal compound,
   wherein the second metal compound is selected from the group comprising a metal salt, or a metal complex, wherein the metal complex comprises a metal cation and at least one monoanion comprising at least 5 covalently bound atoms and/or at least one monoanionic ligand L comprising at least 5 covalently bound atoms, the second metal compound has a LUMO energy level of ≤ -4.65 eV;
   and wherein the first metal compound of the hole injection layer is selected different from the second metal compound of the first p-type charge generation layer;
   and wherein the monoanion and/or monoanionic ligand L comprises at least one aromatic 6-member-ring heterocycle or aromatic 6-member ring carbocycle or at least two rings selected from aromatic 6-member-ring heterocycle, or aromatic 6-member ring carbocycle.

According to one embodiment, wherein the organic electroluminescent device comprises an anode layer, a cathode layer, a first emission layer, a second emission layer, a hole injection layer, and a first charge generation layer,
wherein the hole injection layer is in direct contact to the anode layer,
wherein the first charge generation layer is arranged between the first emission layer and the second emission layer;
   wherein the first charge generation layer comprises a first n-type charge generation layer and a first p-type charge generation layer;
   wherein the first n-type charge generation layer comprises an organic electron transport matrix compound and a metal-dopant, and the first n-type charge generation layer is arranged closer to the anode layer than the first p-type charge generation layer;
   wherein the hole injection layer comprises a first metal compound,
   wherein the first metal compound is selected from the group comprising a metal salt, or a metal complex, wherein the metal complex comprises a metal cation and at least one monoanion comprising at least 5 covalently bound atoms and/or at least one monoanionic ligand L comprising at least 5 covalently bound atoms, wherein the first metal compound has a LUMO energy level of ≤ -4.65 eV, preferably < -4.65 eV;
   wherein the first p-type charge generation layer comprises a second metal compound,
   wherein the second metal compound is selected from the group comprising a metal salt, or a metal complex, wherein the metal complex comprises a metal cation and at least one monoanion comprising at least 5 covalently bound atoms and/or at least one monoanionic ligand L comprising at least 5 covalently bound atoms, the second metal compound has a LUMO energy level of ≤ -4.65 eV;
   and wherein the first metal compound of the hole injection layer is selected different from the second metal compound of the first p-type charge generation layer;
   and wherein the monoanion and/or monoanionic ligand L comprises at least one aromatic 6-member-ring heterocycle or at least one aromatic 6-member ring carbocycle; or at least two rings selected from aromatic 6-member-ring heterocycle or aromatic 6-member ring carbocycle, wherein the at least one aromatic 6-member ring heterocycle comprises at least one N-atom in the aromatic 6-member ring or when two aromatic 6-member-ring heterocycle are selected the two two aromatic 6-member ring heterocycle comprises at least one N-atom in each of the at least two aromatic 6-member rings.

According to one embodiment, wherein the organic electroluminescent device comprises an anode layer, a cathode layer, a first emission layer, a second emission layer, a hole injection layer, and a first charge generation layer,
wherein the hole injection layer is in direct contact to the anode layer,
wherein the first charge generation layer is arranged between the first emission layer and the second emission layer;
   wherein the first charge generation layer comprises a first n-type charge generation layer and a first p-type charge generation layer;
   wherein the first n-type charge generation layer comprises an organic electron transport matrix compound and a metal-dopant, and the first n-type charge generation layer is arranged closer to the anode layer than the first p-type charge generation layer;
   wherein the hole injection layer comprises a first metal compound,
   wherein the first metal compound is selected from the group comprising a metal salt, or a metal complex, wherein the metal complex comprises a metal cation and at least one monoanion comprising at least 5 covalently bound atoms and/or at least one monoanionic ligand L comprising at least 5 covalently bound atoms, wherein the first metal compound has a LUMO energy level of ≤ -4.65 eV, preferably < -4.65 eV;
   wherein the first p-type charge generation layer comprises a second metal compound,
   wherein the second metal compound is selected from the group comprising a metal salt, or a metal complex, wherein the metal complex comprises a metal cation and at least one monoanion comprising at least 5 covalently bound atoms and/or at least one monoanionic ligand L comprising at least 5 covalently bound atoms, the second metal compound has a LUMO energy level of ≤ -4.65 eV;
   and wherein the first metal compound of the hole injection layer is selected different from the second metal compound of the first p-type charge generation layer;
   and wherein the monoanion and/or monoanionic ligand L comprises at least one aromatic 6-member-ring heterocycle or at least one aromatic 6-member ring carbocycl; or at least two rings selected from aromatic 6-member-ring heterocycle or aromatic 6-member ring carbocycle, wherein the at least one aromatic 6-member ring heterocycle comprises at least one N-atom in the aromatic 6-member ring or when two aromatic 6-member-ring heterocycle are selected, the two aromatic 6-member ring heterocycle comprises at least one N-atom in each of the at least two aromatic 6-member rings.

According to one embodiment, wherein the organic electroluminescent device comprises an anode layer, a cathode layer, a first emission layer, a second emission layer, a hole injection layer, and a first charge generation layer,
wherein the hole injection layer is in direct contact to the anode layer,
wherein the first charge generation layer is arranged between the first emission layer and the second emission layer;
   wherein the first charge generation layer comprises a first n-type charge generation layer and a first p-type charge generation layer;
   wherein the first n-type charge generation layer comprises an organic electron transport matrix compound and a metal-dopant, and the first n-type charge generation layer is arranged closer to the anode layer than the first p-type charge generation layer;
   wherein the hole injection layer comprises a first metal compound,
   wherein the first metal compound is selected from the group comprising a metal salt, or a metal complex, wherein the metal complex comprises a metal cation and at least one monoanion comprising at least 5 covalently bound atoms and/or at least one monoanionic ligand L comprising at least 5 covalently bound atoms, wherein the first metal compound has a LUMO energy level of ≤ -4.65 eV, preferably < -4.65 eV;
   wherein the first p-type charge generation layer comprises a second metal compound,
   wherein the second metal compound is selected from the group comprising a metal salt, or a metal complex, wherein the metal complex comprises a metal cation and at least one monoanion comprising at least 5 covalently bound atoms and/or at least one monoanionic ligand L comprising at least 5 covalently bound atoms, the second metal compound has a LUMO energy level of ≤ -4.65 eV;
   and wherein the first metal compound of the hole injection layer is selected different from the second metal compound of the first p-type charge generation layer;
   and wherein the monoanion and/or monoanionic ligand L comprises at least one substituted aromatic 6-member-ring heterocycle or at least one substituted aromatic 6-member ring carbocycle; or at least two rings selected from substituted aromatic 6-member-ring heterocycle or substituted aromatic 6-member ring carbocycle; wherein the at least one substituted aromatic 6-member ring heterocycle comprises at least one N-atom in the substituted aromatic 6-member ring or when two substituted aromatic 6-member-ring heterocycle are selected from two substituted aromatic 6-member-ring heterocycle the two substituted aromatic 6-member-ring heterocycle comprises at least one N-atom in each of the at least two substituted aromatic 6-member rings; and wherein the at least one of the substituents of the substituted aromatic 6-member-ring heterocycle or the at least one of the substituents of the substituted aromatic 6-member ring carbocycle is a CN, F₃C and/or F₅C₂ group, or wherein the at least two of the substituents of the at least one substituted aromatic 6-member-ring heterocycle or substituted 6-member ring carbocycle or when two aromatic two aromatic 6-member ring heterocycle are selected the at least two of the substituents of the two substituted aromatic 6-member-ring heterocycle is a CN, F₃C and/or F₅C₂ group, preferably CN or F₃C.

According to one embodiment, wherein the organic electroluminescent device comprises an anode layer, a cathode layer, a first emission layer, a second emission layer, a hole injection layer, and a first charge generation layer,
wherein the hole injection layer is in direct contact to the anode layer,
wherein the first charge generation layer is arranged between the first emission layer and the second emission layer;
   wherein the first charge generation layer comprises a first n-type charge generation layer and a first p-type charge generation layer;
   wherein the first n-type charge generation layer comprises an organic electron transport matrix compound and a metal-dopant, and the first n-type charge generation layer is arranged closer to the anode layer than the first p-type charge generation layer;
   wherein the hole injection layer comprises a first metal compound,
   wherein the first metal compound is selected from the group comprising a metal salt, or a metal complex, wherein the metal complex comprises a metal cation and at least one monoanion comprising at least 5 covalently bound atoms and/or at least one monoanionic ligand L comprising at least 5 covalently bound atoms, wherein the first metal compound has a LUMO energy level of ≤ -4.65 eV, preferably < -4.65 eV;
   wherein the first p-type charge generation layer comprises a second metal compound,
   wherein the second metal compound is selected from the group comprising a metal salt, or a metal complex, wherein the metal complex comprises a metal cation and at least one monoanion comprising at least 5 covalently bound atoms and/or at least one monoanionic ligand L comprising at least 5 covalently bound atoms, the second metal compound has a LUMO energy level of ≤ -4.65 eV;
   and wherein the first metal compound of the hole injection layer is selected different from the second metal compound of the first p-type charge generation layer;
   and wherein the monoanion and/or monoanionic ligand L comprises at least one aromatic 6-member-ring heterocycle or at least one aromatic 6-member ring carbocycle or at least two aromatic rings selected from aromatic 6-member-ring heterocycle or aromatic 6-member ring carbocycle, wherein the at least one aromatic 6-member ring heterocycle comprises at least one N-atom in the aromatic 6-member ring or when two aromatic 6-member-ring heterocycle are selected, the two aromatic 6-member ring heterocycle comprises at least one N-atom in each of the at least two aromatic 6-member rings;
and wherein the first metal compound and/or the second metal compound is represented by formula (II): 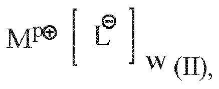 wherein
   L is represented by formula (I);
   M is a metal ion;
   p is the valency of M;
   w is p, and preferably w is independently selected from 1 to 4, more preferably 1 to 3; and
   wherein L is selected the same or different;
   and wherein the first metal compound of the hole injection layer and/or the second metal compound of the p-type charge generation layer is selected from the group comprising Cr, Mn, Fe, Cu, Ce, Ru, Pt or Ag, and preferably the first metal compound of the hole injection layer and/or the second metal compound of the p-type charge generation layer is selected from the group comprising Cr(VI), Mn(III), Fe(III), Cu(II), Ce(IV), Ru(III), Pt(IV), or Ag(I).

According to one embodiment, wherein the organic electroluminescent device comprises an anode layer, a cathode layer, a first emission layer, a second emission layer, a hole injection layer, and a first charge generation layer,
wherein the hole injection layer is in direct contact to the anode layer,
wherein the first charge generation layer is arranged between the first emission layer and the second emission layer;
   wherein the first charge generation layer comprises a first n-type charge generation layer and a first p-type charge generation layer;
   wherein the first n-type charge generation layer comprises an organic electron transport matrix compound and a metal-dopant, and the first n-type charge generation layer is arranged closer to the anode layer than the first p-type charge generation layer;
   wherein the hole injection layer comprises a first metal compound,
   wherein the first metal compound is selected from the group comprising a metal salt, or a metal complex, wherein the metal complex comprises a metal cation and at least one monoanion comprising at least 5 covalently bound atoms and/or at least one monoanionic ligand L comprising at least 5 covalently bound atoms, wherein the first metal compound has a LUMO energy level of ≤ -4.65 eV, preferably < -4.65 eV;
   wherein the first p-type charge generation layer comprises a second metal compound,
   wherein the second metal compound is selected from the group comprising a metal salt, or a metal complex, wherein the metal complex comprises a metal cation and at least one monoanion comprising at least 5 covalently bound atoms and/or at least one monoanionic ligand L comprising at least 5 covalently bound atoms, the second metal compound has a LUMO energy level of ≤ -4.65 eV;
   and wherein the first metal compound of the hole injection layer is selected different from the second metal compound of the first p-type charge generation layer;
   and wherein the monoanion and/or monoanionic ligand L comprises at least one substituted aromatic 6-member-ring heterocycle or at least one substituted aromatic 6-member ring carbocycle; or at least two rings selected from substituted aromatic 6-member-ring heterocycle or substituted aromatic 6-member ring carbocycle, wherein the at least one substituted aromatic 6-member ring heterocycle comprises at least one N-atom in the substituted aromatic 6-member ring or or when two substituted aromatic 6-member-ring heterocycle are selected from two substituted aromatic 6-member-ring heterocycles the two substituted aromatic 6-member-ring heterocycle comprises at least one N-atom in each of the at least two substituted aromatic 6-member rings; and wherein the at least one of the substituents of the substituted aromatic 6-member-ring heterocycle or the at least one of the substituents of the substituted aromatic 6-member ring carbocycle is a CN, F₃C and/or F₅C₂ group,
or wherein the at least two of the substituents of the at least one ubstituted aromatic 6-member-ring heterocycle or substituted 6-member ring carbocycle or when two aromatic two aromatic 6-member ring heterocycle are selected the at least two of the substituents of the two substituted aromatic 6-member-ring heterocycle is a CN, F₃C and/or F₅C₂ group, preferably CN or F₃C;
and wherein the first metal compound and/or the second metal compound is represented by formula (II): 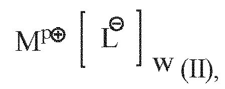 wherein
   L is represented by formula (I);
   M is a metal ion;
   p is the valency of M;
   w is p, and preferably w is independently selected from 1 to 4, more preferably 1 to 3; and
   wherein L is selected the same or different;
   and wherein the first metal compound of the hole injection layer and/or the second metal compound of the p-type charge generation layer is selected from the group comprising Cr, Mn, Fe, Cu, Ce, Ru, Pt or Ag, and preferably the first metal compound of the hole injection layer and/or the second metal compound of the p-type charge generation layer is selected from the group comprising Cr(VI), Mn(III), Fe(III), Cu(II), Ce(IV), Ru(III), Pt(IV), or Ag(I).

### First and Second Metal compound

According to one embodiment, wherein the first metal compound of the hole injection layer has a LUMO energy level of ≤ -4.65 eV; wherein the LUMO energy level is calculated by applying the hybrid functional B3LYP with a ZORA-Def2-TZVP basis set and the SARC-ZORA-TZVP segmented all-electron relativistically contracted basis sets for elements beyond Krypton from the optimized geometries obtained by applying the functional BP86 with a ZORA-Def2-SVP basis set and the SARC-ZORA-TZVP segmented all-electron relativistically contracted basis sets for elements beyond Krypton in the gas phase as implemented in the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany).

According to a preferred embodiment, wherein the first metal compound of the hole injection layer has a LUMO energy level of ≤ -4.90 eV, preferably ≤ -5.00, more preferably ≤ -5.20 eV, and most preferably ≤ -5.40 eV.

According to one embodiment, wherein the second metal compound of the first p-type charge generation layer has a LUMO energy level of ≤ -4.65 eV; wherein the LUMO energy level is calculated by applying the hybrid functional B3LYP with a ZORA-Def2-TZVP basis set and the SARC-ZORA-TZVP segmented all-electron relativistically contracted basis sets for elements beyond Krypton from the optimized geometries obtained by applying the functional BP86 with a ZORA-Def2-SVP basis set and the SARC-ZORA-TZVP segmented all-electron relativistically contracted basis sets for elements beyond Krypton in the gas phase as implemented in the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany).

According to a preferred embodiment, wherein the second metal compound of the p-type charge generation layer has a LUMO energy level of ≤ -4.90 eV,-preferably ≤ -5.00, more preferably ≤ -5.20 eV, and most preferably ≤ -5.40 eV.

According to an embodiment, wherein the first metal compound of the hole injection layer, preferably the metal complex, comprises a metal cation, wherein the metal cation is selected from the group comprising metal cations of Ce, Cu, Fe, Ru, Mn, Ag and/or Pt.

According to an embodiment, wherein the first metal compound of the hole injection layer, preferably the metal complex, comprises a metal cation, wherein the metal cation is selected from the group comprising metal cations of Ce(IV), Cu(II), Fe(III), Ru(III), Mn(III), Ag(I) and/or Pt(IV).

According to one embodiment, wherein the first metal compound of the hole injection layer, preferably the metal complex, comprises a metal cation, wherein the metal cation is selected from the group comprising metal cations of Cr, Mn, Fe, Cu, Ce, Ru, Pt or Ag.

According to one embodiment, wherein the first metal compound of the hole injection layer, preferably the metal complex, comprises a metal cation, wherein the metal cation is selected from the group comprising metal cations of Fe, Cu or Ce.

According to one embodiment, wherein the first metal compound of the hole injection layer, preferably the metal complex, comprises a metal cation, wherein the metal cation is selected from Ce(IV), Cu(II), Fe(III), Ru(III), Mn(III), Ag(I) and/or Pt(IV).

According to one embodiment, wherein the first metal compound of the hole injection layer, preferably the metal complex, comprises a metal cation, wherein the metal cation is selected from Fe(III), Cu(II) or Ce(IV).

According to one embodiment, wherein the first metal compound of the hole injection layer, preferably the metal complex, is present in the hole injection layer in an amount of ≥ 1 wt% and ≤ 20 wt% based on the total weight of the hole injection layer, preferably the metal compound or the metal complex is present in the hole injection layer in an amount of ≥ 5 wt% and ≤ 10 wt%.

According to one embodiment, wherein the first metal compound of the hole injection layer and/or the second metal compound of the p-type charge generation layer is selected from the group comprising Cr, Mn, Fe, Cu, Ce, Ru, Pt or Ag, and preferably the first metal compound of the hole injection layer and/or the second metal compound of the p-type charge generation layer is selected from the group comprising Cr(VI), Mn(III), Fe(III), Cu(II), Ce(IV), Ru(III), Pt(IV), or Ag(I).

According to one embodiment, wherein the second metal compound of the p-type charge generation layer is selected from the group comprising Cr, Mn, Fe, Cu, Ce, Ru, Pt or Ag, and preferably the second metal compound of the p-type charge generation layer is selected from the group comprising Cr(VI), Mn(III), Fe(III), Cu(II), Ce(IV), Ru(III), Pt(IV), or Ag(I).

According to one embodiment, wherein the second metal compound of the p-type charge generation layer is selected from the group comprising Fe(III), Cu(II) or Ce(IV).

### Monoanion of the first and second metal / first and second monoanionic ligand L

According to to one embodiment, wherein the monoanion of the first metal compound and/or second metal compound comprises at least 10 covalently bound atoms. According to to one embodiment, wherein the monoanion of the first metal compound and/or second metal compound comprises at least 15 covalently bound atoms. According to to one embodiment, wherein the monoanion of the first metal compound and/or second metal compound comprises at least 20 covalently bound atoms.

According to to one embodiment, wherein the at least one monoanionic ligand L of the first metal compound and/or second metal compound comprises 10 covalently bound atoms. According to to one embodiment, wherein the at least one monoanionic ligand L of the first metal compound and/or second metal compound comprises 15 covalently bound atoms. According to to one embodiment, wherein the at least one monoanionic ligand L of the first metal compound and/or second metal compound comprises 20 covalently bound atoms.

According to to one embodiment, wherein the monoanion of the first metal compound and/or second metal compound comprises at least 10 covalently bound atoms and the at least one monoanionic ligand L of the first metal compound and/or second metal compound comprises 10 covalently bound atoms, preferably the monoanion comprises at least 15 covalently bound atoms and the at least one monoanionic ligand L comprises 15 covalently bound atoms, and more preferably the monoanion comprises at least 20 covalently bound atoms and the at least one monoanionic ligand L comprises 20 covalently bound atoms.

### Formula (Ia), (Ib) or (Ic)

According to to one embodiment, wherein the monoanion and/or monoanionic ligand L is represented by formula (Ia), (Ib) or (Ic): 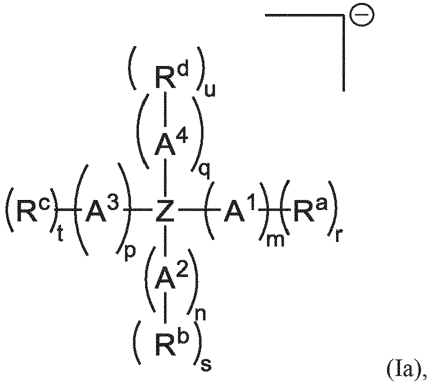 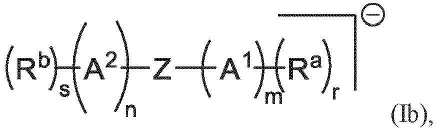 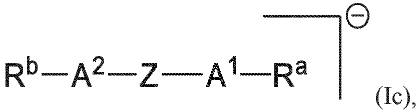 wherein
m, n, p, and q are independently selected from 0 or 1;
r, s, t, and u are independently selected from 0 or 1;
at least one of r, s, t, and u is 1;
Z is selected from CR¹, C, O, N, B, preferably Z is selected from N, O or CR¹, or further preferred
   Z is selected from C and A¹, A², A³ and A⁴ is selected from C-O or C-NR³,
if Z is selected O then n, p, q and are selected from 0 and s, t and u are selected from 0;
if Z is selected from N or CR¹ then p and q are selected from 0, and t and u are selected from 0;
if Z is selected from C then q is selected from 0, and u is selected from 0;
if Z is selected from B then n, m, p, and q are selected from 1, and r, s, t, and u are selected from 1;
A¹, A², A³ and A⁴ are independently selected from C=O, C-O, C=NR², C-NR³, SO, SO₂, or P(=O)R⁴, and preferably A¹, A², A³ and A⁴ are independently selected from C=O, C-O, or SO₂;
if A¹, A², A³ and A⁴ is selected from C-O or C-NR³ then Z forms a double bond to A¹, A², A³ and A4;
R¹ is selected from H, D, electron-withdrawing group, halogen, Cl, F, CN, NO₂, SF₅, isonitrile, ester group, carboxylic group, carbonyl group, acyl group, thio group sulfinyl group, sulfonyl group, phosphine group, substituted or unsubstituted C₁ to C₁₂ alkyl, partially perfluorinated C₁ to C₁₂ alkyl, perfluorinated C₁ to C₁₂ alkyl, CF₃, substituted or unsubstituted C₁ to C₁₂ alkoxy, partially perfluorinated C₁ to C₆ alkoxy, perfluorinated C₁ to C₆ alkoxy, CF₃, substituted or unsubstituted C₆ to C₄₀ aryl, substituted or unsubstituted C₂ to C₄₀ heteroaryl, substituted or unsubstituted C₃ to C₃₀, carbocyclyl, substituted or unsubstituted C₃ to C₃₀ heterocyclyl;
   wherein the one or more substituents on R¹ are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, =N, =N-;
R², R³ and R⁴ are independently selected from H, D, electron-withdrawing group, halogen, Cl, F, CN, ester group, carboxylic group, carbonyl group, acyl group, thio group sulfinyl group, sulfonyl group, phosphine group, substituted or unsubstituted alkyl, partially perfluorinated C₁ to C₁₂ alkyl, perfluorinated C₁ to C₁₂ alkyl, CF₃, substituted or unsubstituted C₁ to C₆ alkoxy, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₃₀ heteroaryl, substituted or unsubstituted C₃ to C₃₀ carbocyclyl, substituted or unsubstituted C₂ to C₃₀ heterocyclyl,
   wherein the substituents on R², R³ and R⁴ are independently selected from D, electron-withdrawing group, halogen, Cl, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃;
R^{a}, R^{b}, R^{c} and R^{d} are independently selected from H, D, electron-withdrawing group, halogen, F, Cl, CN, substituted or unsubstituted C₁ to C₁₂ alkyl, partially perfluorinated C₁ to C₁₂ alkyl, perfluorinated C₁ to C₁₂ alkyl, CF₃, substituted or unsubstituted C₆ to C₄₀ aryl, substituted or unsubstituted C₂ to C₃₀ heteroaryl, substituted or unsubstituted carbocyclyl, substituted or unsubstituted C₂ to C₃₀ heterocyclyl, O, S, N, NR⁵, substituted or unsubstituted amine group having ≥ 0 to ≤ 20 carbon atoms,
   wherein the one more substituents on R^{a}, R^{b}, R^{c} and R^{d} are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, partially perfluorinated C₁ to C₆ alkoxy, perfluorinated C₁ to C₆ alkoxy, OCF₃;
wherein
R⁵ is selected from substituted or unsubstituted C₆ to C₄₀ aryl, substituted or unsubstituted C₂ to C₄₀ heteroaryl, substituted or unsubstituted C₁ to C₁₂ alkyl, partially perfluorinated C₁ to C₁₂ alkyl, perfluorinated C₁ to C₁₂ alkyl,
wherein the one or more substituents on R⁵ is selected from electron-withdrawing group, halogen, F, CN, NO₂, SF₅, isonitrile, ester group, carboxylic group, carbonyl group, acyl group, thio group sulfinyl group, sulfonyl group, phosphine group, partially fluorinated C₁ to C₁₂ alkyl, perfluorinated C₁ to C₁₂ alkyl, CF₃, CF₂CF₃, partially fluorinated C₁ to C₆ alkoxy, perfluorinated C₁ to C₆ alkoxy, OCF₃, OCF₂CCF₃.

According to to one embodiment, wherein two of A¹, A², A³ and A⁴ together form a substituted or unsubstituted heterocycle or substituted or unsubstituted carbocycle with Z, wherein the one or more substituent on the heterocycle or carbocycle is independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, substituted or unsubstituted alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₄₀ heteroaryl, substituted or unsubstituted C₃ to C₃₀ carbocyclyl, or substituted or unsubstituted C₂ to C₃₀ heterocyclyl.

According to to one embodiment, wherein for formula (Ib) Z is selected from O, N, or CR¹, and if Z is selected from O then n is selected from 0, and s is selected from 0.

According to to one embodiment, wherein for formula (Ic) Z is selected from N or CR¹.

According to to one embodiment, wherein:
- for formula (Ib) Z is selected from O, N, or CR¹, and if Z is selected from O then n is selected from 0, and s is selected from 0; and
- for formula (Ic) Z is selected from N or CR¹.

According to one embodiment, wherein at least one of R^{a}, R^{b}, R^{c} and R^{d} is independently selected from each other from substituted or unsubstituted C₆ to C₄₀ aryl, substituted or unsubstituted C₂ to C₄₀ heteroaryl, substituted or unsubstituted C₁ to C₁₂ alkyl, substituted or unsubstituted C₃ to C₃₀ carbocyclyl, substituted or unsubstituted C₂ to C₃₀ heterocyclyl, wherein the substituents on R^{a}, R^{b}, R^{c} and R^{d} are independently selected from electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃.

According to one embodiment, wherein the monoanion ligand L is represented by at least one of the formula (Ia), (Ib) or (Ic): 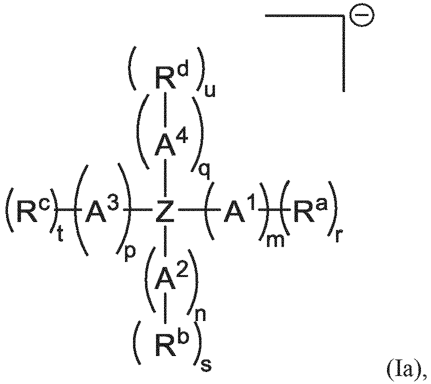 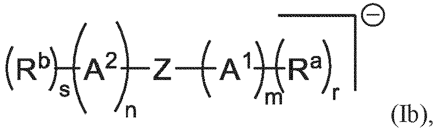 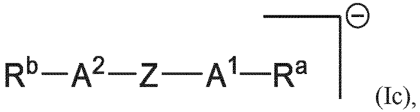 wherein
m, n, p, and q are independently selected from 0 or 1;
r, s, t, and u are independently selected from 0 or 1;
at least one of r, s, t, and u is 1;
Z is selected from CR¹, C, O, N, B, preferably Z is selected from N, O or CR¹, or further preferred Z is selected from C and A¹, A², A³ and A⁴ is selected from C-O or C-NR³;
if Z is selected O then n, p, q and are selected from 0 and s, t and u are selected from 0;
if Z is selected from N or CR¹ then p and q are selected from 0, and t and u are selected from 0;
if Z is selected from C then q is selected from 0, and u is selected from 0;
if Z is selected from B then n, m, p, and q are selected from 1, and r, s, t, and u are selected from 1;
A¹, A², A³ and A⁴ are independently selected from C=O, C-O, C=NR², C-NR³, SO, SO₂, or P(=O)R⁴, and preferably A¹, A², A³ and A⁴ are independently selected from C=O, C-O, or SO₂;
if A¹, A², A³ and A⁴ is selected from C-O or C-NR³ then Z forms a double bond to A¹, A², A³ and A4;
R¹ is selected from H, D, electron-withdrawing group, halogen, Cl, F, CN, NO₂, SF₅, isonitrile, ester group, carboxylic group, carbonyl group, acyl group, thio group sulfinyl group, sulfonyl group, phosphine group, substituted or unsubstituted C₁ to C₁₂ alkyl, partially perfluorinated C₁ to C₁₂ alkyl, perfluorinated C₁ to C₁₂ alkyl, CF₃, substituted or unsubstituted C₁ to C₁₂ alkoxy, partially perfluorinated C₁ to C₆ alkoxy, perfluorinated C₁ to C₆ alkoxy, CF₃, substituted or unsubstituted C₆ to C₄₀ aryl, substituted or unsubstituted C₂ to C₄₀ heteroaryl, substituted or unsubstituted C₃ to C₃₀, carbocyclyl, substituted or unsubstituted C₃ to C₃₀ heterocyclyl;
   wherein the one or more substituents on R¹ are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, =N, =N-;
R², R³ and R⁴ are independently selected from H, D, electron-withdrawing group, halogen, Cl, F, CN, ester group, carboxylic group, carbonyl group, acyl group, thio group sulfinyl group, sulfonyl group, phosphine group, substituted or unsubstituted alkyl, partially perfluorinated C₁ to C₁₂ alkyl, perfluorinated C₁ to C₁₂ alkyl, CF₃, substituted or unsubstituted C₁ to C₆ alkoxy, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₃₀ heteroaryl, substituted or unsubstituted C₃ to C₃₀ carbocyclyl, substituted or unsubstituted C₂ to C₃₀ heterocyclyl,
   wherein the substituents on R², R³ and R⁴ are independently selected from D, electron-withdrawing group, halogen, Cl, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃;
R^{a}, R^{b}, R^{c} and R^{d} are independently selected from H, D, electron-withdrawing group, halogen, F, Cl, CN, substituted or unsubstituted C₁ to C₁₂ alkyl, partially perfluorinated C₁ to C₁₂ alkyl, perfluorinated C₁ to C₁₂ alkyl, CF₃, substituted or unsubstituted C₆ to C₄₀ aryl, substituted or unsubstituted C₂ to C₃₀ heteroaryl, substituted or unsubstituted carbocyclyl, substituted or unsubstituted C₂ to C₃₀ heterocyclyl, O, S, N, NR⁵, substituted or unsubstituted amine group having ≥ 0 to ≤ 20 carbon atoms;
   wherein the one more substituents on R^{a}, R^{b}, R^{c} and R^{d} are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, partially perfluorinated C₁ to C₆ alkoxy, perfluorinated C₁ to C₆ alkoxy, OCF₃;
wherein
R⁵ is selected from substituted or unsubstituted C₆ to C₄₀ aryl, substituted or unsubstituted C₂ to C₄₀ heteroaryl, substituted or unsubstituted C₁ to C₁₂ alkyl, partially perfluorinated C₁ to C₁₂ alkyl, perfluorinated C₁ to C₁₂ alkyl,
   wherein the one or more substituents on R⁵ is selected from electron-withdrawing group, halogen, F, CN, NO₂, SF₅, isonitrile, ester group, carboxylic group, carbonyl group, acyl group, thio group sulfinyl group, sulfonyl group, phosphine group, partially fluorinated C₁ to C₁₂ alkyl, perfluorinated C₁ to C₁₂ alkyl, CF₃, CF₂CF₃, partially fluorinated C₁ to C₆ alkoxy, perfluorinated C₁ to C₆ alkoxy, OCF₃, OCF₂CCF₃;
and at least one of R^{a}, R^{b}, R^{c}, R^{d} is independently selected from each other from a substituted or unsubstituted heterocycle or substituted or unsubstituted C₃ to C₄₀ carbocycle with R¹,
   wherein the one or more substituent on the heterocycle or carbocycle is independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, substituted or unsubstituted alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₄₀ heteroaryl, substituted or unsubstituted C₃ to C₃₀ carbocyclyl, or substituted or unsubstituted C₂ to C₃₀ heterocyclyl, and
preferably wherein the one or more substituent on the substituent on the heterocycle or carbocyle is independently selected form D, electron-withdrawing group, halogen, F, substituted or unsubstituted C₁ to C₁₂ alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃; and
further preferred none of R^{a}, R^{b}, R^{c} and R^{d} is substituted or unsubstituted C₃ to C₄₀ carbocyclyl.

According to one embodiment, wherein the monoanion ligand L is represented by at least one of the formula (Ia), (Ib) or (Ic): 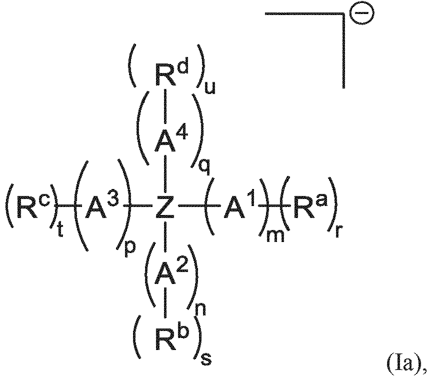 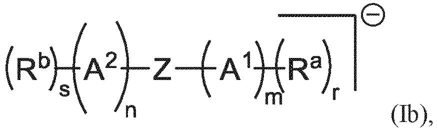 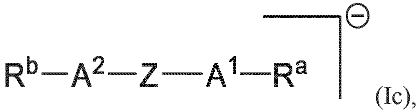 wherein
m, n, p, and q are independently selected from 0 or 1;
r, s, t, and u are independently selected from 0 or 1;
at least one of r, s, t, and u is 1;
Z is selected from CR¹, C, O, N, B, preferably Z is selected from N, O or CR¹, or further preferred
   Z is selected from C and A¹, A², A³ and A⁴ is selected from C-O or C-NR³,
if Z is selected O then n, p, q and are selected from 0 and s, t and u are selected from 0;
if Z is selected from N or CR¹ then p and q are selected from 0, and t and u are selected from 0;
if Z is selected from C then q is selected from 0, and u is selected from 0;
if Z is selected from B then n, m, p, and q are selected from 1, and r, s, t, and u are selected from 1;
A¹, A², A³ and A⁴ are independently selected from C=O, C-O, C=NR², C-NR³, SO, SO₂, or P(=O)R⁴, and preferably A¹, A², A³ and A⁴ are independently selected from C=O, C-O, or SO₂;
if A¹, A², A³ and A⁴ is selected from C-O or C-NR³ then Z forms a double bond to A¹, A², A³ and A4;
R¹ is selected from H, D, electron-withdrawing group, halogen, Cl, F, CN, NO₂, SF₅, isonitrile, ester group, carboxylic group, carbonyl group, acyl group, thio group sulfinyl group, sulfonyl group, phosphine group, substituted or unsubstituted C₁ to C₁₂ alkyl, partially perfluorinated C₁ to C₁₂ alkyl, perfluorinated C₁ to C₁₂ alkyl, CF₃, substituted or unsubstituted C₁ to C₁₂ alkoxy, partially perfluorinated C₁ to C₆ alkoxy, perfluorinated C₁ to C₆ alkoxy, CF₃, substituted or unsubstituted C₆ to C₄₀ aryl, substituted or unsubstituted C₂ to C₄₀ heteroaryl, substituted or unsubstituted C₃ to C₃₀, carbocyclyl, substituted or unsubstituted C₃ to C₃₀ heterocyclyl;
   wherein the one or more substituents on R¹ are independently selected from D, electron-withdrawing group, halogen, F, CN, NO₂, SFs, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, =N, =N-;
R², R³ and R⁴ are independently selected from H, D, electron-withdrawing group, halogen, Cl, F, CN, ester group, carboxylic group, carbonyl group, acyl group, thio group sulfinyl group, sulfonyl group, phosphine group, substituted or unsubstituted alkyl, partially perfluorinated C₁ to C₁₂ alkyl, perfluorinated C₁ to C₁₂ alkyl, CF₃, substituted or unsubstituted C₁ to C₆ alkoxy, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₃₀ heteroaryl, substituted or unsubstituted C₃ to C₃₀ carbocyclyl, substituted or unsubstituted C₂ to C₃₀ heterocyclyl,
   wherein the substituents on R², R³ and R⁴ are independently selected from D, electron-withdrawing group, halogen, Cl, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃;
R^{a}, R^{b}, R^{c} and R^{d} are independently selected from H, D, electron-withdrawing group, halogen, F, Cl, CN, substituted or unsubstituted C₁ to C₁₂ alkyl, partially perfluorinated C₁ to C₁₂ alkyl, perfluorinated C₁ to C₁₂ alkyl, CF₃, substituted or unsubstituted C₆ to C₄₀ aryl, substituted or unsubstituted C₂ to C₃₀ heteroaryl, substituted or unsubstituted carbocyclyl, substituted or unsubstituted C₂ to C₃₀ heterocyclyl, O, S, N, NR⁵, substituted or unsubstituted amine group having ≥ 0 to ≤ 20 carbon atoms;
   wherein the one more substituents on R^{a}, R^{b}, R^{c} and R^{d} are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, partially perfluorinated C₁ to C₆ alkoxy, perfluorinated C₁ to C₆ alkoxy, OCF₃;
wherein
R⁵ is selected from substituted or unsubstituted C₆ to C₄₀ aryl, substituted or unsubstituted C₂ to C₄₀ heteroaryl, substituted or unsubstituted C₁ to C₁₂ alkyl, partially perfluorinated C₁ to C₁₂ alkyl, perfluorinated C₁ to C₁₂ alkyl,
   wherein the one or more substituents on R⁵ is selected from electron-withdrawing group, halogen, F, CN, NO₂, SF₅, isonitrile, ester group, carboxylic group, carbonyl group, acyl group, thio group sulfinyl group, sulfonyl group, phosphine group, partially fluorinated C₁ to C₁₂ alkyl, perfluorinated C₁ to C₁₂ alkyl, CF₃, CF₂CF₃, partially fluorinated C₁ to C₆ alkoxy, perfluorinated C₁ to C₆ alkoxy, OCF₃, OCF₂CCF₃;
   and
   - two of A¹, A², A³ and A⁴ together form a substituted or unsubstituted heterocycle or substituted or unsubstituted carbocycle with Z; or
   - one of A¹, A², A³ and A⁴ form a substituted or unsubstituted heterocycle or substituted or unsubstituted carbocycle with Z;
   wherein the one or more substituent on the heterocycle or carbocycle is independently selected from D, electron-withdrawing group, halogen, F, CN, NO₂, SF₅, isonitrile, ester group, carboxylic group, carbonyl group, acyl group, thiogroup sulfinyl group, sulfonyl group, phosphine group, substituted or unsubstituted alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₄₀ heteroaryl, substituted or unsubstituted C₃ to C₃₀ carbocyclyl, or substituted or unsubstituted C₂ to C₃₀ heterocyclyl;
and further preferred none of R^{a}, R^{b}, R^{c} and R^{d} is substituted or unsubstituted C₃ to C₄₀ carbocyclyl.

According to one embodiment, wherein the monoanion ligand L is represented by at least one of the formula (Ib) or (Ic): 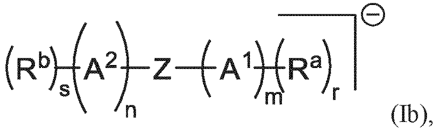 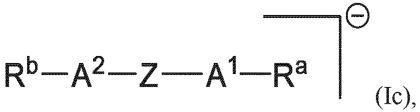 wherein
m and n are independently selected from 0 or 1;
r and s are independently selected from 0 or 1;
at least one of r and s is 1;
Z is selected from CR¹, C, O, N, B, preferably Z is selected from N, O or CR¹, or further preferred Z is selected from C and A¹ and A² is selected from C-O or C-NR³,
if Z is selected from B then n and m are selected from 1, and r and s are selected from 1;
A¹ and A² are independently selected from C=O, C-O, C=NR², C-NR³, SO, SO₂, or P(=O)R⁴, and preferably A¹ and A² are independently selected from C=O, CO, or SO₂;
if A¹ and A² is selected from C-O or C-NR³ then Z forms a double bond to A¹ and A²;
R¹ is selected from H, D, electron-withdrawing group, halogen, Cl, F, CN, NO₂, SF₅, isonitrile, ester group, carboxylic group, carbonyl group, acyl group, thio group sulfinyl group, sulfonyl group, phosphine group, substituted or unsubstituted C₁ to C₁₂ alkyl, partially perfluorinated C₁ to C₁₂ alkyl, perfluorinated C₁ to C₁₂ alkyl, CF₃, substituted or unsubstituted C₁ to C₁₂ alkoxy, partially perfluorinated C₁ to C₆ alkoxy, perfluorinated C₁ to C₆ alkoxy, CF₃, substituted or unsubstituted C₆ to C₄₀ aryl, substituted or unsubstituted C₂ to C₄₀ heteroaryl, substituted or unsubstituted C₃ to C₃₀, carbocyclyl, substituted or unsubstituted C₃ to C₃₀ heterocyclyl;
   wherein the one or more substituents on R¹ are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, =N, =N-;
R², R³ and R⁴ are independently selected from H, D, electron-withdrawing group, halogen, Cl, F, CN, ester group, carboxylic group, carbonyl group, acyl group, thio group sulfinyl group, sulfonyl group, phosphine group, substituted or unsubstituted alkyl, partially perfluorinated C₁ to C₁₂ alkyl, perfluorinated C₁ to C₁₂ alkyl, CF₃, substituted or unsubstituted C₁ to C₆ alkoxy, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₃₀ heteroaryl, substituted or unsubstituted C₃ to C₃₀ carbocyclyl, substituted or unsubstituted C₂ to C₃₀ heterocyclyl,
   wherein the substituents on R², R³ and R⁴ are independently selected from D, electron-withdrawing group, halogen, Cl, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃;
R^{a} and R^{b} are independently selected from H, D, electron-withdrawing group, halogen, F, Cl, CN, substituted or unsubstituted C₁ to C₁₂ alkyl, partially perfluorinated C₁ to C₁₂ alkyl, perfluorinated C₁ to C₁₂ alkyl, CF₃, substituted or unsubstituted C₆ to C₄₀ aryl, substituted or unsubstituted C₂ to C₃₀ heteroaryl, substituted or unsubstituted carbocyclyl, substituted or unsubstituted C₂ to C₃₀ heterocyclyl, O, S, N, NR⁵, substituted or unsubstituted amine group having ≥ 0 to ≤ 20 carbon atoms;
   wherein the one more substituents on R^{a} and R^{b} are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, partially perfluorinated C₁ to C₆ alkoxy, perfluorinated C₁ to C₆ alkoxy, OCF₃;
wherein
R⁵ is selected from substituted or unsubstituted C₆ to C₄₀ aryl, substituted or unsubstituted C₂ to C₄₀ heteroaryl, substituted or unsubstituted C₁ to C₁₂ alkyl, partially perfluorinated C₁ to C₁₂ alkyl, perfluorinated C₁ to C₁₂ alkyl,
wherein the one or more substituents on R⁵ is selected from electron-withdrawing group, halogen, F, CN, NO₂, SF₅, isonitrile, ester group, carboxylic group, carbonyl group, acyl group, thio group sulfinyl group, sulfonyl group, phosphine group, partially fluorinated C₁ to C₁₂ alkyl, perfluorinated C₁ to C₁₂ alkyl, CF₃, CF₂CF₃, partially fluorinated C₁ to C₆ alkoxy, perfluorinated C₁ to C₆ alkoxy, OCF₃, OCF₂CCF₃.

According to one embodiment, wherein the monoanion ligand L is represented by at least one of the formula (Ib) or (Ic): 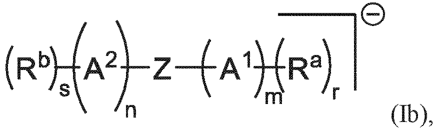 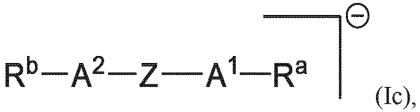 wherein
m and n are independently selected from 0 or 1;
r and s are independently selected from 0 or 1;
at least one of r and s is 1;
Z is selected from CR¹, C, O, N, B, preferably Z is selected from N, O or CR¹, or further preferred Z is selected from C and A¹ and A² is selected from C-O or C-NR³,
if Z is selected from B then n and m are selected from 1, and r and s are selected from 1;
A¹ and A² are independently selected from C=O, C-O, C=NR², C-NR³, SO, SO₂, or P(=O)R⁴, and preferably A¹ and A² are independently selected from C=O, CO, or SO₂;
if A¹ and A² is selected from C-O or C-NR³ then Z forms a double bond to A¹ and A²;
R¹ is selected from H, D, electron-withdrawing group, halogen, Cl, F, CN, NO₂, SF₅, isonitrile, ester group, carboxylic group, carbonyl group, acyl group, thio group sulfinyl group, sulfonyl group, phosphine group, substituted or unsubstituted C₁ to C₁₂ alkyl, partially perfluorinated C₁ to C₁₂ alkyl, perfluorinated C₁ to C₁₂ alkyl, CF₃, substituted or unsubstituted C₁ to C₁₂ alkoxy, partially perfluorinated C₁ to C₆ alkoxy, perfluorinated C₁ to C₆ alkoxy, CF₃, substituted or unsubstituted C₆ to C₄₀ aryl, substituted or unsubstituted C₂ to C₄₀ heteroaryl, substituted or unsubstituted C₃ to C₃₀, carbocyclyl, substituted or unsubstituted C₃ to C₃₀ heterocyclyl;
   wherein the one or more substituents on R¹ are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, =N, =N-;
R², R³ and R⁴ are independently selected from H, D, electron-withdrawing group, halogen, Cl, F, CN, ester group, carboxylic group, carbonyl group, acyl group, thio group sulfinyl group, sulfonyl group, phosphine group, substituted or unsubstituted alkyl, partially perfluorinated C₁ to C₁₂ alkyl, perfluorinated C₁ to C₁₂ alkyl, CF₃, substituted or unsubstituted C₁ to C₆ alkoxy, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₃₀ heteroaryl, substituted or unsubstituted C₃ to C₃₀ carbocyclyl, substituted or unsubstituted C₂ to C₃₀ heterocyclyl, wherein the substituents on R², R³ and R⁴ are independently selected from D, electron-withdrawing group, halogen, Cl, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃;
R^{a} and R^{b} are independently selected from H, D, electron-withdrawing group, halogen, F, Cl, CN, substituted or unsubstituted C₁ to C₁₂ alkyl, partially perfluorinated C₁ to C₁₂ alkyl, perfluorinated C₁ to C₁₂ alkyl, CF₃, substituted or unsubstituted C₆ to C₄₀ aryl, substituted or unsubstituted C₂ to C₃₀ heteroaryl, substituted or unsubstituted carbocyclyl, substituted or unsubstituted C₂ to C₃₀ heterocyclyl, O, S, N, NR⁵, substituted or unsubstituted amine group having ≥ 0 to ≤ 20 carbon atoms;
   wherein the one more substituents on R^{a} and R^{b} are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, partially perfluorinated C₁ to C₆ alkoxy, perfluorinated C₁ to C₆ alkoxy, OCF₃;
wherein
R⁵ is selected from substituted or unsubstituted C₆ to C₄₀ aryl, substituted or unsubstituted C₂ to C₄₀ heteroaryl, substituted or unsubstituted C₁ to C₁₂ alkyl, partially perfluorinated C₁ to C₁₂ alkyl, perfluorinated C₁ to C₁₂ alkyl,
   wherein the one or more substituents on R⁵ is selected from electron-withdrawing group, halogen, F, CN, NO₂, SF₅, isonitrile, ester group, carboxylic group, carbonyl group, acyl group, thio group sulfinyl group, sulfonyl group, phosphine group, partially fluorinated C₁ to C₁₂ alkyl, perfluorinated C₁ to C₁₂ alkyl, CF₃, CF₂CF₃, partially fluorinated C₁ to C₆ alkoxy, perfluorinated C₁ to C₆ alkoxy, OCF₃, OCF₂CCF₃;
and at least one of R^{a} and R^{b} is independently selected from each other from a substituted or unsubstituted heterocycle or substituted or unsubstituted C₃ to C₄₀ carbocycle with R¹,
   wherein the one or more substituent on the heterocycle or carbocycle is independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, substituted or unsubstituted alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₄₀ heteroaryl, substituted or unsubstituted C₃ to C₃₀ carbocyclyl, or substituted or unsubstituted C₂ to C₃₀ heterocyclyl, and
preferably wherein the one or more substituent on the substituent on the heterocycle or carbocyle is independently selected form D, electron-withdrawing group, halogen, F, substituted or unsubstituted C₁ to C₁₂ alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃; and
further preferred none of R^{a} and R^{b} is substituted or unsubstituted C₃ to C₄₀ carbocyclyl.

According to one embodiment, wherein the monoanion ligand L is represented by at least one of the formula (Ib) or (Ic): 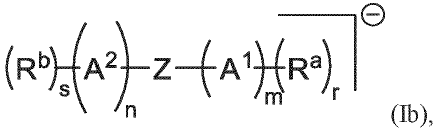 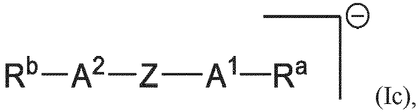 wherein
m and n are independently selected from 0 or 1;
r and s are independently selected from 0 or 1;
at least one of r and s is 1;
Z is selected from CR¹, C, O, N, B, preferably Z is selected from N, O or CR¹, or further preferred Z is selected from C and A¹ and A² is selected from C-O or C-NR³,
if Z is selected from B then n and m are selected from 1, and r and s are selected from 1;
A¹ and A² are independently selected from C=O, C-O, C=NR², C-NR³, SO, SO₂, or P(=O)R⁴, and preferably A¹ and A² are independently selected from C=O, CO, or SO₂;
if A¹ and A² is selected from C-O or C-NR³ then Z forms a double bond to A¹ and A²;
R¹ is selected from H, D, electron-withdrawing group, halogen, Cl, F, CN, NO₂, SF₅, isonitrile, ester group, carboxylic group, carbonyl group, acyl group, thio group sulfinyl group, sulfonyl group, phosphine group, substituted or unsubstituted C₁ to C₁₂ alkyl, partially perfluorinated C₁ to C₁₂ alkyl, perfluorinated C₁ to C₁₂ alkyl, CF₃, substituted or unsubstituted C₁ to C₁₂ alkoxy, partially perfluorinated C₁ to C₆ alkoxy, perfluorinated C₁ to C₆ alkoxy, CF₃, substituted or unsubstituted C₆ to C₄₀ aryl, substituted or unsubstituted C₂ to C₄₀ heteroaryl, substituted or unsubstituted C₃ to C₃₀, carbocyclyl, substituted or unsubstituted C₃ to C₃₀ heterocyclyl;
   wherein the one or more substituents on R¹ are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, =N, =N-;
R², R³ and R⁴ are independently selected from H, D, electron-withdrawing group, halogen, Cl, F, CN, ester group, carboxylic group, carbonyl group, acyl group, thio group sulfinyl group, sulfonyl group, phosphine group, substituted or unsubstituted alkyl, partially perfluorinated C₁ to C₁₂ alkyl, perfluorinated C₁ to C₁₂ alkyl, CF₃, substituted or unsubstituted C₁ to C₆ alkoxy, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₃₀ heteroaryl, substituted or unsubstituted C₃ to C₃₀ carbocyclyl, substituted or unsubstituted C₂ to C₃₀ heterocyclyl,
   wherein the substituents on R², R³ and R⁴ are independently selected from D, electron-withdrawing group, halogen, Cl, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃;
R^{a} and R^{b} are independently selected from H, D, electron-withdrawing group, halogen, F, Cl, CN, substituted or unsubstituted C₁ to C₁₂ alkyl, partially perfluorinated C₁ to C₁₂ alkyl, perfluorinated C₁ to C₁₂ alkyl, CF₃, substituted or unsubstituted C₆ to C₄₀ aryl, substituted or unsubstituted C₂ to C₃₀ heteroaryl, substituted or unsubstituted carbocyclyl, substituted or unsubstituted C₂ to C₃₀ heterocyclyl, O, S, N, NR⁵, substituted or unsubstituted amine group having ≥ 0 to ≤ 20 carbon atoms;
   wherein the one more substituents on R^{a} and R^{b} are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, partially perfluorinated C₁ to C₆ alkoxy, perfluorinated C₁ to C₆ alkoxy, OCF₃;
wherein
R⁵ is selected from substituted or unsubstituted C₆ to C₄₀ aryl, substituted or unsubstituted C₂ to C₄₀ heteroaryl, substituted or unsubstituted C₁ to C₁₂ alkyl, partially perfluorinated C₁ to C₁₂ alkyl, perfluorinated C₁ to C₁₂ alkyl,
   wherein the one or more substituents on R⁵ is selected from electron-withdrawing group, halogen, F, CN, NO₂, SF₅, isonitrile, ester group, carboxylic group, carbonyl group, acyl group, thio group sulfinyl group, sulfonyl group, phosphine group, partially fluorinated C₁ to C₁₂ alkyl, perfluorinated C₁ to C₁₂ alkyl, CF₃, CF₂CF₃, partially fluorinated C₁ to C₆ alkoxy, perfluorinated C₁ to C₆ alkoxy, OCF₃, OCF₂CCF₃;
   and
   - A¹ and A² together form a substituted or unsubstituted heterocycle or substituted or unsubstituted carbocycle with Z; or
   - one of A¹ and A² form a substituted or unsubstituted heterocycle or substituted or unsubstituted carbocycle with Z;
      wherein the one or more substituent on the heterocycle or carbocycle is independently selected from D, electron-withdrawing group, halogen, F, CN, NO₂, SF₅, isonitrile, ester group, carboxylic group, carbonyl group, acyl group, thiogroup sulfinyl group, sulfonyl group, phosphine group, substituted or unsubstituted alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₄₀ heteroaryl, substituted or unsubstituted C₃ to C₃₀ carbocyclyl, or substituted or unsubstituted C₂ to C₃₀ heterocyclyl;
and further preferred none of R^{a} and R^{b} is substituted or unsubstituted C₃ to C₄₀ carbocyclyl.

According to one embodiment, the compound of formula (Ia), (Ib) or (Ic) comprises at least one CF₃ group.

According to one embodiment, in formula (Ia), (Ib) or (Ic), A² and A³ - if present - each R' is CN.

According to an embodiment, wherein the compound of at least one of the formula (Ib) or (Ic) comprises at least one CF₃ group which is not bound to an oxygen.

According to one embodiment, in formula (Ia), (Ib) or (Ic), at least two of A¹, A², and A³ -if present - are selected the same.

According to one embodiment, in formula (Ia), (Ib) or (Ic), A² and A³ - if present - are identical.

According to one embodiment, in formula (Ia), (Ib) or (Ic), A¹, A² and A³ - if present - are identical.

According to one embodiment, in formula (Ia), (Ib) or (Ic) A¹- if present - is different from A² and/or A³.

According to one embodiment, in formula (Ia), (Ib) or (Ic) Ar¹, Ar², and Ar³ - if present - are independently selected from substituted or unsubstituted C₆ to C₁₂ aryl and substituted or unsubstituted C₃ to C₁₂ heteroaryl.

According to one embodiment, in formula (Ia), (Ib) or (Ic) Arl, Ar², and Ar³ - if present - are independently selected from substituted or unsubstituted C₆ aryl and substituted or unsubstituted C₃ to C₅ heteroaryl.

According to one embodiment, in formula (Ia), (Ib) or (Ic) the substituents on Ar¹, Ar², and Ar³ - if present - are independently selected from the group consisting of an electron-withdrawing group, halogen, Cl, F, CN, partially fluorinated alkyl, and perfluorinated alkyl.

According to one embodiment, in formula (Ia), (Ib) or (Ic) the substituents on Ar¹, Ar², and Ar³ - if present - are independently selected from the group consisting of Cl, F, CN, and perfluorinated alkyl.

According to one embodiment, in formula (Ia), (Ib) or (Ic) the substituents on Ar¹, Ar², and Ar³ - if present - are independently selected from the group consisting of F, CN, and perfluorinated alkyl.

According to one embodiment, in formula (Ia), (Ib) or (Ic) the substituents on Ar¹, Ar², and Ar³ - if present - are independently selected from the group consisting of F, CN, and CF₃.

According to one embodiment, in formula (Ia), (Ib) or (Ic) the substituents on Ar¹, Ar², and Ar³ - if present - are independently selected from the group consisting of CN, and CF₃.

According to one embodiment, in formula (Ia), (Ib) or (Ic) the substituents on Ar¹, Ar², and Ar³ - if present - are independently selected from the group consisting of CN.

According to one embodiment, in formula (Ia), (Ib) or (Ic) the substituents on Ar¹, Ar², and Ar³ are independently selected from the group consisting of CF₃.

According to one embodiment, in formula (Ia), (Ib) or (Ic) Ar¹, Ar², and Ar³ - if present - independently each comprise more then one and less then five substituents, preferably more then two and less then four, for example 4.

According to one embodiment, in formula (Ia), (Ib) or (Ic) each R' - if present - is independently selected from electron-withdrawing group, partially fluorinated C₁ to C₈ alkyl, perfluorinated C₁ to C₈ alkyl, halogen, F and CN.

According to one embodiment, in formula (Ia), (Ib) or (Ic) each R' - if present - is independently selected from partially fluorinated C₁ to C₈ alkyl, perfluorinated C₁ to C₈ alkyl, halogen, F and CN.

According to one embodiment, in formula (Ia), (Ib) or (Ic) each R'- if present - is independently selected from CF₃, F and CN.

According to an embodiment, wherein the compound of at least one of the formula (Ia), (Ib) and/or (Ic), wherein
- two of A¹, A², A³ and A⁴ together form a substituted or unsubstituted heterocycle or substituted or unsubstituted carbocycle with Z; or
- one of A¹, A², A³ and A⁴ form a substituted or unsubstituted heterocycle or substituted or unsubstituted carbocycle with Z;
wherein the one or more substituent on the heterocycle or carbocycle is independently selected from D, electron-withdrawing group, halogen, F, CN, NO₂, SF₅, isonitrile, ester group, carboxylic group, carbonyl group, acyl group, thiogroup sulfinyl group, sulfonyl group, phosphine group, substituted or unsubstituted alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₄₀ heteroaryl, substituted or unsubstituted C₃ to C₃₀ carbocyclyl, or substituted or unsubstituted C₂ to C₃₀ heterocyclyl,
wherein the one or more substituent on the substituent on the heterocycle or carbocyle is independently selected form D, electron-withdrawing group, halogen, F, substituted or unsubstituted C₁ to C₁₂ alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃.

According to an embodiment, wherein the compound of formula (Ia) having
- two of A¹, A², A³ and A⁴ together form a substituted or unsubstituted heterocycle or substituted or unsubstituted carbocycle with Z; or
- one of A¹, A², A³ and A⁴ form a substituted or unsubstituted heterocycle or substituted or unsubstituted carbocycle with Z;
wherein the one or more substituent on the heterocycle or carbocycle is independently selected from D, electron-withdrawing group, halogen, F, CN, NO₂, SF₅, isonitrile, ester group, carboxylic group, carbonyl group, acyl group, thiogroup sulfinyl group, sulfonyl group, phosphine group, substituted or unsubstituted alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₄₀ heteroaryl, substituted or unsubstituted C₃ to C₃₀ carbocyclyl, or substituted or unsubstituted C₂ to C₃₀ heterocyclyl,
wherein the one or more substituent on the substituent on the heterocycle or carbocyle is independently selected form D, electron-withdrawing group, halogen, F, substituted or unsubstituted C₁ to C₁₂ alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃.

According to an embodiment, wherein the compound of formula (Ib) and/or (Ic) having
- A¹ and A² together form a substituted or unsubstituted heterocycle or substituted or unsubstituted carbocycle with Z; or
- one of A¹ and A² form a substituted or unsubstituted heterocycle or substituted or unsubstituted carbocycle with Z;
wherein the one or more substituent on the heterocycle or carbocycle is independently selected from D, electron-withdrawing group, halogen, F, CN, NO₂, SF₅, isonitrile, ester group, carboxylic group, carbonyl group, acyl group, thiogroup sulfinyl group, sulfonyl group, phosphine group, substituted or unsubstituted alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₄₀ heteroaryl, substituted or unsubstituted C₃ to C₃₀ carbocyclyl, or substituted or unsubstituted C₂ to C₃₀ heterocyclyl,
wherein the one or more substituent on the substituent on the heterocycle or carbocyle is independently selected form D, electron-withdrawing group, halogen, F, substituted or unsubstituted C₁ to C₁₂ alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃.

According to an embodiment, wherein the compound of formula (Ia), (Ib) and/or (Ic) having:
- one of R^{a}, R^{b}, R^{c}, R^{d} can independently from each other form a substituted or unsubstituted heterocycle or substituted or unsubstituted carbocycle with R¹,
   wherein the one or more substituent on the heterocycle or carbocycle is independently selected from D, electron-withdrawing group, halogen, F, CN, NO₂, SF₅, isonitrile, ester group, carboxylic group, carbonyl group, acyl group, thiogroup sulfinyl group, sulfonyl group, phosphine group, substituted or unsubstituted alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₄₀ heteroaryl, substituted or unsubstituted C₃ to C₃₀ carbocyclyl, or substituted or unsubstituted C₂ to C₃₀ heterocyclyl,
   wherein the one or more substituent on the substituent on the heterocycle or carbocyle is independently selected form D, electron-withdrawing group, halogen, F, substituted or unsubstituted C₁ to C₁₂ alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃;
   R¹ is selected from H, D, electron-withdrawing group, halogen, Cl, F, CN, NO₂, SF₅, isonitrile, ester group, carboxylic group, carbonyl group, acyl group, thio group sulfinyl group, sulfonyl group, phosphine group, substituted or unsubstituted C₁ to C₁₂ alkyl, partially perfluorinated C₁ to C₁₂ alkyl, perfluorinated C₁ to C₁₂ alkyl, CF₃, substituted or unsubstituted C₁ to C₁₂ alkoxy, partially perfluorinated C₁ to C₆ alkoxy, perfluorinated C₁ to C₆ alkoxy, CF₃, substituted or unsubstituted C₆ to C₄₀ aryl, substituted or unsubstituted C₂ to C₄₀ heteroaryl, substituted or unsubstituted C₃ to C₃₀, carbocyclyl, substituted or unsubstituted C₃ to C₃₀ heterocyclyl;
   wherein the one or more substituents on R¹ are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, =N, =N-.

According to an embodiment, wherein the compound of formula (Ia) having:
- one of R^{a}, R^{b}, R^{c}, R^{d} can independently from each other form a substituted or unsubstituted heterocycle or substituted or unsubstituted carbocycle with R¹,
   wherein the one or more substituent on the heterocycle or carbocycle is independently selected from D, electron-withdrawing group, halogen, F, CN, NO₂, SF₅, isonitrile, ester group, carboxylic group, carbonyl group, acyl group, thiogroup sulfinyl group, sulfonyl group, phosphine group, substituted or unsubstituted alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₄₀ heteroaryl, substituted or unsubstituted C₃ to C₃₀ carbocyclyl, or substituted or unsubstituted C₂ to C₃₀ heterocyclyl,
   wherein the one or more substituent on the substituent on the heterocycle or carbocyle is independently selected form D, electron-withdrawing group, halogen, F, substituted or unsubstituted C₁ to C₁₂ alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃;

According to an embodiment, wherein the compound of formula (Ib) having:
- one of R^{a} or R^{b} can independently from each other form a substituted or unsubstituted heterocycle or substituted or unsubstituted carbocycle with R¹,
   wherein the one or more substituent on the heterocycle or carbocycle is independently selected from D, electron-withdrawing group, halogen, F, CN, NO₂, SF₅, isonitrile, ester group, carboxylic group, carbonyl group, acyl group, thiogroup sulfinyl group, sulfonyl group, phosphine group, substituted or unsubstituted alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₄₀ heteroaryl, substituted or unsubstituted C₃ to C₃₀ carbocyclyl, or substituted or unsubstituted C₂ to C₃₀ heterocyclyl,
      wherein the one or more substituent on the substituent on the heterocycle or carbocyle is independently selected form D, electron-withdrawing group, halogen, F, substituted or unsubstituted C₁ to C₁₂ alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃;
   R¹ is selected from H, D, electron-withdrawing group, halogen, Cl, F, CN, NO₂, SF₅, isonitrile, ester group, carboxylic group, carbonyl group, acyl group, thio group sulfinyl group, sulfonyl group, phosphine group, substituted or unsubstituted C₁ to C₁₂ alkyl, partially perfluorinated C₁ to C₁₂ alkyl, perfluorinated C₁ to C₁₂ alkyl, CF₃, substituted or unsubstituted C₁ to C₁₂ alkoxy, partially perfluorinated C₁ to C₆ alkoxy, perfluorinated C₁ to C₆ alkoxy, CF₃, substituted or unsubstituted C₆ to C₄₀ aryl, substituted or unsubstituted C₂ to C₄₀ heteroaryl, substituted or unsubstituted C₃ to C₃₀, carbocyclyl, substituted or unsubstituted C₃ to C₃₀ heterocyclyl;
      wherein the one or more substituents on R¹ are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, =N, =N-.

According to an embodiment, wherein the compound of formula (Ic) having:
- one of R^{a} or R^{b} can independently from each other form a substituted or unsubstituted heterocycle or substituted or unsubstituted carbocycle with R¹,
   wherein the one or more substituent on the heterocycle or carbocycle is independently selected from D, electron-withdrawing group, halogen, F, CN, NO₂, SF₅, isonitrile, ester group, carboxylic group, carbonyl group, acyl group, thiogroup sulfinyl group, sulfonyl group, phosphine group, substituted or unsubstituted alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₄₀ heteroaryl, substituted or unsubstituted C₃ to C₃₀ carbocyclyl, or substituted or unsubstituted C₂ to C₃₀ heterocyclyl,
   wherein the one or more substituent on the substituent on the heterocycle or carbocyle is independently selected form D, electron-withdrawing group, halogen, F, substituted or unsubstituted C₁ to C₁₂ alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃;
   R¹ is selected from H, D, electron-withdrawing group, halogen, Cl, F, CN, NO₂, SF₅, isonitrile, ester group, carboxylic group, carbonyl group, acyl group, thio group sulfinyl group, sulfonyl group, phosphine group, substituted or unsubstituted C₁ to C₁₂ alkyl, partially perfluorinated C₁ to C₁₂ alkyl, perfluorinated C₁ to C₁₂ alkyl, CF₃, substituted or unsubstituted C₁ to C₁₂ alkoxy, partially perfluorinated C₁ to C₆ alkoxy, perfluorinated C₁ to C₆ alkoxy, CF₃, substituted or unsubstituted C₆ to C₄₀ aryl, substituted or unsubstituted C₂ to C₄₀ heteroaryl, substituted or unsubstituted C₃ to C₃₀, carbocyclyl, substituted or unsubstituted C₃ to C₃₀ heterocyclyl;
   wherein the one or more substituents on R¹ are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, =N, =N-.

According to an embodiment, in formula (Ia) Al, A², A³ and A⁴ are independently selected from C=O, C-O, or SO₂.

According to an embodiment, wherein in formula (Ia) or (Ib) or (Ic), preferably (Ia), Z can form a double bond to A¹, A², A³ and A⁴, if A¹, A², A³ and A⁴ is selected from C-O or C-NR³ and Z is selected from N, O or CR¹, or A¹, A², A³ and A⁴ is selected from C-O or C-NR³ and Z is selected from C;
- and wherein optionally two of A¹, A², A³ and A⁴ together can form a substituted or unsubstituted heterocycle or substituted or unsubstituted carbocycle with Z, or wherein optionally one of A¹, A², A³ and A⁴ can form a substituted or unsubstituted heterocycle or substituted or unsubstituted carbocycle with Z,
- wherein the one or more substituent on the heterocycle or carbocycle is independently selected from D, electron-withdrawing group, halogen, F, CN, NO₂, SF₅, partially perfluorinated C₁ to C₆ alkyl, perfluorinated C₁ to C₆ alkyl, CF₃, partially perfluorinated C₁ to C₆ alkoxy, perfluorinated C₁ to C₆ alkoxy, OCF₃, substituted or unsubstituted C₆ to C₁₂ aryl, substituted or unsubstituted C₃ to C₁₂ heteroaryl, substituted or unsubstituted C₃ to C₁₂ carbocyclyl, or substituted or unsubstituted C₃ to C₁₂ heterocyclyl.

According to an embodiment, in formula (Ia) or (Ib) or (Ic), preferably (Ia), R¹ is selected from CN, substituted or unsubstituted C₁ to C₁₂ alkyl, perfluorinated C₁ to C₁₂ alkyl, or CF₃.

According to an embodiment, in formula (Ia) or (Ib) or (Ic), preferably (Ia), R¹ is selected from CN, or substituted or unsubstituted C₁ to C₁₂ alkyl.

According to an embodiment, in formula (Ia) or (Ib) or (Ic), preferably (Ia), R^{a}, R^{b}, R^{c} and R^{d} are independently selected from H, D, electron-withdrawing group, halogen, F, Cl, CN, substituted or unsubstituted C₁ to C₆ alkyl, partially perfluorinated C₁ to C₆ alkyl, perfluorinated C₁ to C₆ alkyl, CF₃, substituted or unsubstituted C₆ to C₁₂ aryl, substituted or unsubstituted C₃ to C₁₂ heteroaryl, substituted or unsubstituted C3 to C₁₂ heterocyclyl, O, S, N, NR⁵, substituted or unsubstituted amine group having 0 to 20 carbon atoms;
wherein the one more substituents on R^{a}, R^{b}, R^{c} and R^{d} are independently selected from electron-withdrawing group, halogen, F, CN, NO₂, SF₅, partially perfluorinated C₁ to C₆ alkyl, perfluorinated C₁ to C₆ alkyl, perfluorinated C₁ to C₆ alkoxy, OCF₃;
wherein R⁵ is selected from substituted or unsubstituted C₆ to C₁₂ aryl, substituted or unsubstituted C₃ to C₁₂ heteroaryl, substituted or unsubstituted C₁ to C₆ alkyl, partially perfluorinated C₁ to C₆ alkyl, perfluorinated C₁ to C₆ alkyl,
   wherein the one or more substituents on R⁵ is selected from electron-withdrawing group, halogen, F, CN, NO₂, SF₅,CF₃, CF₂CF₃, partially fluorinated C₁ to C₆ alkoxy, perfluorinated C₁ to C₆ alkoxy, OCF₃, OCF₂CCF₃;
preferably at least one of R^{a}, R^{b}, R^{c} and R^{d} is independently selected from substituted or unsubstituted C₆ to C₁₂ aryl, substituted or unsubstituted C₃ to C₁₂ heteroaryl, substituted or unsubstituted C₁ to C₆ alkyl, substituted or unsubstituted C₃ to C₁₂ heterocyclyl,
   wherein the substituents on R^{a}, R^{b}, R^{c} and R^{d} are independently selected from electron-withdrawing group, halogen, F, CN, NO₂, SF₅, perfluorinated C₁ to C₆ alkyl, CF₃, perfluorinated C₁ to C₆ alkoxy, OCF₃,;
wherein optionally one of R^{a}, R^{b}, R^{c}, R^{d} can independently from each other form a substituted or unsubstituted heterocycle or substituted or unsubstituted carbocycle with R¹,
   wherein the one or more substituent on the heterocycle or carbocycle is independently selected from D, electron-withdrawing group, halogen, F, CN, NO₂, SF₅, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, substituted or unsubstituted C₆ to C₁₂ aryl, substituted or unsubstituted C₃ to C₁₂ heteroaryl, substituted or unsubstituted C₃ to C₁₂ carbocyclyl, or substituted or unsubstituted C3 to C₁₂ heterocyclyl,
   and preferably wherein the one or more substituent on the substituent on the heterocycle or carbocycle is independently selected form D, electron-withdrawing group, halogen, F, perfluorinated C₁ to C₆ alkyl, CF₃, perfluorinated C₁ to C₆ alkoxy, OCF₃.

According to an embodiment, in formula (Ia) or (Ib) or (Ic), preferably (Ia), R², R³ and R⁴ are independently selected from substituted or unsubstituted alkyl, partially perfluorinated C₁ to C₁₂ alkyl, perfluorinated C₁ to C₁₂ alkyl, CF₃, substituted or unsubstituted C₁ to C₆ alkoxy, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₃₀ heteroaryl, substituted or unsubstituted C₃ to C₃₀ carbocyclyl, substituted or unsubstituted C₂ to C₃₀ heterocyclyl,
wherein the substituents on R², R³ and R⁴ are independently selected from D, F, CN, NO₂, SF₅.

According to an embodiment, in formula (Ia) or (Ib) or (Ic), preferably (Ia), A¹, A², A³ and A⁴ are independently selected from C=O, C-O, or SO₂;
wherein Z can form a double bond to A¹, A², A³ and A⁴, if A¹, A², A³ and A⁴ is selected from C-O or C-NR³ and Z is selected from N, O or CR¹, or A¹, A², A³ and A⁴ is selected from C-O or C-NR³ and Z is selected from C;
and wherein optionally two of A¹, A², A³ and A⁴ together can form a substituted or unsubstituted heterocycle or substituted or unsubstituted carbocycle with Z, or wherein optionally one of A¹, A², A³ and A⁴ can form a substituted or unsubstituted heterocycle or substituted or unsubstituted carbocycle with Z,
   wherein the one or more substituent on the heterocycle or carbocycle is independently selected from D, electron-withdrawing group, halogen, F, CN, NO₂, SF₅, partially perfluorinated C₁ to C₆ alkyl, perfluorinated C₁ to C₆ alkyl, CF₃, partially perfluorinated C₁ to C₆ alkoxy, perfluorinated C₁ to C₆ alkoxy, OCF₃, substituted or unsubstituted C₆ to C₁₂ aryl, substituted or unsubstituted C₃ to C₁₂ heteroaryl, substituted or unsubstituted C₃ to C₁₂ carbocyclyl, or substituted or unsubstituted C₃ to C₁₂ heterocyclyl;
R¹ is selected from CN, substituted or unsubstituted C₁ to C₁₂ alkyl, perfluorinated C₁ to C₁₂ alkyl,or CF₃;
R², R³ and R⁴ are independently selected from substituted or unsubstituted alkyl, partially perfluorinated C₁ to C₁₂ alkyl, perfluorinated C₁ to C₁₂ alkyl, CF₃, substituted or unsubstituted C₁ to C₆ alkoxy, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₃₀ heteroaryl, substituted or unsubstituted C₃ to C₃₀ carbocyclyl, substituted or unsubstituted C₂ to C₃₀ heterocyclyl,
   wherein the substituents on R², R³ and R⁴ are independently selected from D, F, CN, NO₂, SF₅;
R^{a}, R^{b}, R^{c} and R^{d} are independently selected from H, D, electron-withdrawing group, halogen, F, Cl, CN, substituted or unsubstituted C₁ to C₆ alkyl, partially perfluorinated C₁ to C₆ alkyl, perfluorinated C₁ to C₆ alkyl, CF₃, substituted or unsubstituted C₆ to C₁₂ aryl, substituted or unsubstituted C₃ to C₁₂ heteroaryl, substituted or unsubstituted C3 to C₁₂ heterocyclyl, O, S, N, NR⁵, substituted or unsubstituted amine group having 0 to 20 carbon atoms;
   wherein the one more substituents on R^{a}, R^{b}, R^{c} and R^{d} are independently selected from electron-withdrawing group, halogen, F, CN, NO₂, SF₅, partially perfluorinated C₁ to C₆ alkyl, perfluorinated C₁ to C₆ alkyl, perfluorinated C₁ to C₆ alkoxy, OCF₃;
wherein R⁵ is selected from substituted or unsubstituted C₆ to C₁₂ aryl, substituted or unsubstituted C₃ to C₁₂ heteroaryl, substituted or unsubstituted C₁ to C₆ alkyl, partially perfluorinated C₁ to C₆ alkyl, perfluorinated C₁ to C₆ alkyl,
   wherein the one or more substituents on R⁵ is selected from electron-withdrawing group, halogen, F, CN, NO₂, SF₅,CF₃, CF₂CF₃, partially fluorinated C₁ to C₆ alkoxy, perfluorinated C₁ to C₆ alkoxy, OCF₃, OCF₂CCF₃;
preferably at least one of R^{a}, R^{b}, R^{c} and R^{d} is independently selected from substituted or unsubstituted C₆ to C₁₂ aryl, substituted or unsubstituted C₃ to C₁₂ heteroaryl, substituted or unsubstituted C₁ to C₆ alkyl, substituted or unsubstituted C₃ to C₁₂ heterocyclyl,
   wherein the substituents on R^{a}, R^{b}, R^{c} and R^{d} are independently selected from electron-withdrawing group, halogen, F, CN, NO₂, SF₅, perfluorinated C₁ to C₆ alkyl, CF₃, perfluorinated C₁ to C₆ alkoxy, OCF₃,
wherein optionally one of R^{a} R^{b}, R^{c}, R^{d} can independently from each other form a substituted or unsubstituted heterocycle or substituted or unsubstituted carbocycle with R¹,
   wherein the one or more substituent on the heterocycle or carbocycle is independently selected from D, electron-withdrawing group, halogen, F, CN, NO₂, SF₅, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, substituted or unsubstituted C₆ to C₁₂ aryl, substituted or unsubstituted C₃ to C₁₂ heteroaryl, substituted or unsubstituted C₃ to C₁₂ carbocyclyl, or substituted or unsubstituted C3 to C12 heterocyclyl;
   and preferably wherein the one or more substituent on the substituent on the heterocycle or carbocycle is independently selected form D, electron-withdrawing group, halogen, F, perfluorinated C₁ to C₆ alkyl, CF₃, perfluorinated C₁ to C₆ alkoxy, OCF₃.

According to an embodiment, in formula (Ia) or (Ib) or (Ic), preferably (Ia), if Z is selected from N and p and q are selected from 0, t and u are selected from 0, m and n are selected from 1, and r and s are selected from 1 then if one of A¹ and A² is selected from SO₂ then the other one of A¹ and A² cannot be C=O or C-O.

According to an embodiment, in formula (Ia) or (Ib) or (Ic), preferably (Ia), if Z is selected from N and p and q are selected from 0, and t and u are selected from 0 then if one of A¹ and A² is selected from SO₂ then the other one of A¹ and A² cannot be C=O or C-O.

According to an embodiment, in formula (Ia) if Z is selected from N or CR¹ then p and q are selected from 0, and t and u are selected from 0, and
if Z is selected from N then A¹ and A² are selected from SO₂, or
if Z is selected from CR¹ then A¹ and A² are selected from C=O or C-O.

According to an embodiment, in formula (Ib) if Z is selected from N, and
if Z is selected from N then A¹ and A² are selected from SO₂, or
if Z is selected from CR¹ then A¹ and A² are selected from C=O or C-O.

According to an embodiment, in formula (Ib) if Z is selected from N, m and n are selected from 1, and r and s are selected from 1, then if one of A¹ and A² is selected from SO₂ then the other one of A¹ and A² cannot be C=O or CO.

According to an embodiment, in formula (Ib) if Z is selected from N, then if one of A¹ and A² is selected from SO₂ then the other one of A¹ and A² cannot be C=O or CO.

According to an embodiment, in formula (Ib) if Z is selected from N, then if one of A¹ and A² is selected from SO₂ then the other one of A¹ and A² cannot be C=O or CO.

### A¹, A², A³ and A⁴

According to to one embodiment, wherein one of A¹, A², A³ and A⁴ form a substituted or unsubstituted heterocycle or substituted or unsubstituted carbocycle with Z, wherein the one or more substituent on the heterocycle or carbocycle is independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, substituted or unsubstituted alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₄₀ heteroaryl, substituted or unsubstituted C₃ to C₃₀ carbocyclyl, or substituted or unsubstituted C₂ to C₃₀ heterocyclyl.

According to to one embodiment, wherein
- two of A¹, A², A³ and A⁴ together form a substituted or unsubstituted heterocycle or substituted or unsubstituted carbocycle with Z; or
- one of A¹, A², A³ and A⁴ form a substituted or unsubstituted heterocycle or substituted or unsubstituted carbocycle with Z;
wherein the one or more substituent on the heterocycle or carbocycle is independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, substituted or unsubstituted alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₄₀ heteroaryl, substituted or unsubstituted C₃ to C₃₀ carbocyclyl, or substituted or unsubstituted C₂ to C₃₀ heterocyclyl.

### R^{a}, R^{b}, R^{c} and R^{d}

According to to one embodiment, wherein at least one of R^{a}, R^{b}, R^{c} and R^{d} are independently selected from each other from substituted or unsubstituted heterocycle or substituted or unsubstituted carbocycle with R¹,
wherein the one or more substituent on the heterocycle or carbocycle is independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, substituted or unsubstituted alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₄₀ heteroaryl, substituted or unsubstituted C₃ to C₃₀ carbocyclyl, or substituted or unsubstituted C₂ to C₃₀ heterocyclyl;
wherein the one or more substituent on the substituent on the heterocycle or carbocyle is independently selected form D, electron-withdrawing group, halogen, F, substituted or unsubstituted C₁ to C₁₂ alkyl, partially perfluorinated C₁ to C₁₂ alkyl, perfluorinated C₁ to C₁₂ alkyl, CF₃, partially perfluorinated C₁ to C₆ alkoxy, or perfluorinated C₁ to C₆ alkoxy, OCF₃.

### Metal compound of Formula (II)

According to an embodiment, wherein the first metal compound and/or the second metal compound is represented by formula (II): 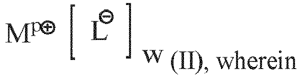
- L: is represented by formula (I);
- M: is a metal ion;
- p: is the valency of M;
- w: is p.

According to an embodiment, wherein the first metal compound and/or the second metal compound is represented by formula (II): 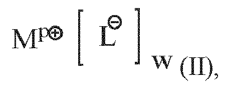 wherein
- L: is represented by formula (I);
- M: is a metal ion;
- p: is the valency of M;
- w: is p, wherein L is selected the same or different.

According to an embodiment, wherein the first metal compound and/or the second metal compound is represented by formula (II): 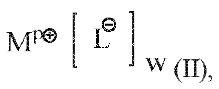 wherein
- L: is represented by formula (I);
- M: is a metal ion;
- p: is the valency of M;
- w: is independently selected from 1 to 4, more preferably 1 to 3, and wherein L is selected the same or different.

According to an embodiment, wherein the first metal compound and/or the second metal compound is represented by formula (II): 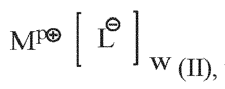 wherein
- L: is represented by formula (I);
- M: is a metal ion;
- p: is the valency of M;
- w: is p, and preferably w is independently selected from 1 to 4, more preferably 1 to 3; and wherein L is selected the same or different.

The term "valency" refers to the amount of charges of the metal.

### Compounds of Formulas (III), (IV), (V), (VI), (VII), (VIII) and (IX)

The monoanion or the monoanionic ligand L also named "ligand L" throughout the specification may have the formula (III), (IV), (V), (VI), (VII), (VIII) and (IX).

According to an embodiment, wherein the monoanion or the monoanionic ligand L is represented by one of the following formulas (III), (IV), (V), (VI), (VII), (VIII) and (IX): 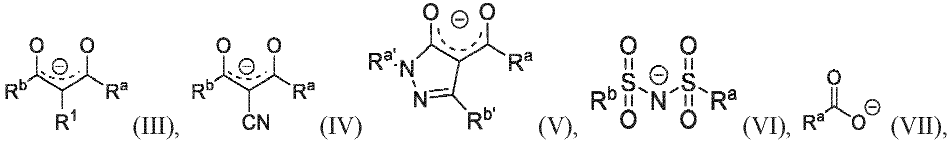 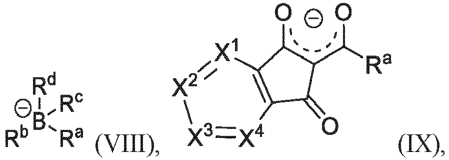 wherein
- R^{a}, R^{b}, R^{c} and R^{d}: are independently selected from perfluorinated C₁ to C₆ alkyl, CF₃, 3,5-CF₃-phenyl, N, NR⁵, 2,6-CF₃-pyridinyl, substituted or unsubstituted amine group having 0 to 20 carbon atoms;
wherein the one or more substituents on R^{a} and R^{b} are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, partially perfluorinated C₁ to C₆ alkoxy, perfluorinated C₁ to C₆ alkoxy, OCF₃;
- R¹: is selected from H, D, CN, substituted or unsubstituted C₁ to C₈ alkyl;
wherein the one or more substituents on R¹ are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, =N, =N-;
- R^{a'}: is independently selected from substituted or unsubstituted C₁ to C₁₂ alkyl, substituted or unsubstituted C₆ to C₁₉ aryl, substituted or unsubstituted C₂ to C₂₀ heteroaryl, or substituted or unsubstituted 6-membered heteroaryl;
wherein at least one of the substituents of the substituted C₁ to C₁₂ alkyl, substituted C₆ to C₁₉ aryl, substituted C₂ to C₂₀ heteroaryl, or substituted 6-membered heteroaryl are independently selected from halogen, Cl, F, CN, partially or perfluorinated C₁ to C₈ alkyl, partially or perfluorinated C₁ to C₈ alkoxy;
- R^{b'}: is selected from substituted or unsubstituted C₁ to C₁₂ alkyl, substituted or unsubstituted C₆ to C₁₉ aryl, substituted or unsubstituted C₂ to C₂₀ heteroaryl, substituted or unsubstituted 6-membered heteroaryl, or CN;
wherein at least one of the substituents of the substituted C₁ to C₁₂ alkyl, substituted C₆ to C₁₉ aryl, substituted C₂ to C₂₀ heteroaryl, or substituted 6-membered heteroaryl are independently selected from halogen, Cl, F, CN, partially or perfluorinated C₁ to C₈ alkyl, partially or perfluorinated C₁ to C₈ alkoxy;
- X¹: is selected from C-R^{1'} or N;
- X²: is selected from C-R^{2'} or N;
- X³: is selected from C-R^{3'} or N;
- X⁴: is selected from C-R^{4'} or N;
wherein
- 0, 1 or 2: of the group consisting of X¹, X², X³, and X⁴ are selected from N;
- R^{1'} to R^{4'}: are independently selected from H, D, substituted or unsubstituted C₁ to C₁₂ alkyl, substituted or unsubstituted C₆ to C₁₉ aryl, substituted or unsubstituted C₂ to C₂₀ heteroaryl, substituted or unsubstituted 6-membered heteroaryl, halogen, F, Cl or CN; and whereby optional any R^{k'} to R(^{k+1)'} with k is from 1 to 3 form a ring, preferably a 5- or 6- membered ring.

According to one embodiment, wherein in formula (V) at least one of R^{a'}, R^{b'} and R^{a} comprises at least three atoms selected from the group consisting of halogen, Cl, F or N.

According to an embodiment, wherein the monoanion and/or monoanionic ligand L is represented by formula (III) or (IV): 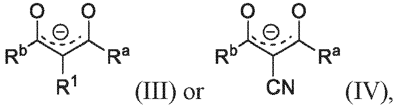 wherein
- R^{a} and R^{b}: are independently selected from perfluorinated C₁ to C₆ alkyl, CF₃, 3,5-CF₃-phenyl, N, NR⁵, 2,6-CF₃-pyridinyl, substituted or unsubstituted amine group having 0 to 20 carbon atoms;
wherein the one or more substituents on R^{a} and R^{b} are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, partially perfluorinated C₁ to C₆ alkoxy, perfluorinated C₁ to C₆ alkoxy, OCF₃;
- R¹: is selected from H, D, CN, substituted or unsubstituted C₁ to C₈ alkyl;
wherein the one or more substituents on R¹ are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, =N, =N-;
wherein optional two adjacent substituents selected from the group of R^{a}, R^{b}, and R¹ are connected to form a heterocycle or carbocycle.

According to an embodiment, the monoanion or the monoanionic ligand L is selected from formula (III): 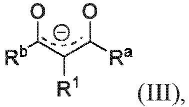 wherein two adjacent substituents R^{a}, R^{b}, and R¹ can optionally be connected to form heterocycle or carbocycle.

According to an embodiment, the monoanionic ligand L is selected from formula (III): 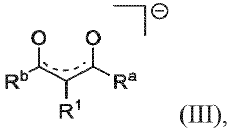
- R^{a} and R^{b}: are independently selected from perfluorinated C₁ to C₆ alkyl, CF₃, substituted or unsubstituted C₆ to C₄₀ aryl, 3,5-CF₃-phenyl, N, NR⁵, substituted or unsubstituted C₂ to C₄₀ heteroaryl, 2,6-CF₃-pyridinyl, substituted or unsubstituted amine group having 0 to 20 carbon atoms;
wherein the one or more substituents on R^{a}, R^{b}, R^{c} and R^{d} are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, partially perfluorinated C₁ to C₆ alkoxy, perfluorinated C₁ to C₆ alkoxy, OCF₃;
- R¹: is selected from H, D, CN, substituted or unsubstituted C₁ to C₈ alkyl, acyl, sulfonyl; wherein the one or more substituents on R¹ are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, =N, =N-;
wherein two adjacent substituents R^{a}, R^{b}, and R¹ can optionally be connected to form heterocycle or carbocycle.

According to a preferred embodiment, the monoanion or the monoanionic ligand is represented by formulae (III), (IV), (V) and (IX).

According to embodiment, wherein the monoanion or the monoanionic ligand is represented by one of the following formulas (III), (IV), (V) or (IX): 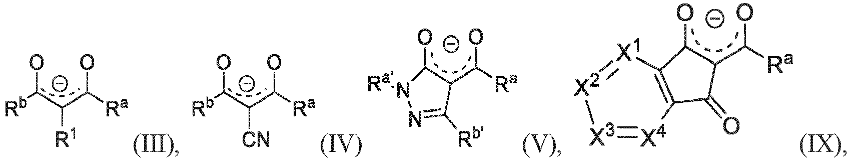 wherein
- R^{a'}: is independently selected from substituted or unsubstituted C₁ to C₁₂ alkyl, substituted or unsubstituted C₆ to C₁₉ aryl, substituted or unsubstituted C₂ to C₂₀ heteroaryl, or substituted or unsubstituted 6-membered heteroaryl;
- R^{b'}: is selected from substituted or unsubstituted C₁ to C₁₂ alkyl, substituted or unsubstituted C₆ to C₁₉ aryl, substituted or unsubstituted C₂ to C₂₀ heteroaryl, substituted or unsubstituted 6-membered heteroaryl, or CN;
wherein at least one of the substituents of the substituted C₁ to C₁₂ alkyl, substituted C₆ to C₁₉ aryl, substituted C₂ to C₂₀ heteroaryl, or substituted 6-membered heteroaryl are independently selected from halogen, Cl, F, CN, partially or perfluorinated C₁ to C₈ alkyl, partially or perfluorinated C₁ to C₈ alkoxy;

wherein preferably in formula (V) at least one of R^{a'}, R^{b'} and R^{a} comprises at least three atoms selected from the group consisting of halogen, Cl, F or N.
wherein
   - X¹: is selected from C-R^{1'} or N;
   - X²: is selected from C-R^{2'} or N;
   - X³: is selected from C-R^{3'} or N;
   - X⁴: is selected from C-R^{4'} or N;
wherein 0, 1 or 2 of the group consisting of X¹, X², X³, X⁴ are selected from N;
   - R^{1'} to R^{4'}: are independently selected from H, D, substituted or unsubstituted C₁ to C₁₂ alkyl, substituted or unsubstituted C₆ to C₁₉ aryl, substituted or unsubstituted C₂ to C₂₀ heteroaryl, substituted or unsubstituted 6-membered heteroaryl, halogen, F, Cl or CN; and whereby any R^{k} to R^{k+1} may form a ring, preferably a 5- or 6- membered ring;
wherein in formula (IX) preferably at least one of R^{1'} to R^{4'} and/or R^{a} comprises at least one CF₃ moiety and/or one of R¹, R², R³, R⁴ and R⁵ is CF₃, and wherein the other substituents are as defined above.

According to one embodiment, wherein in formula (IX) at least one of R^{1'} to R^{4'} and/or R^{a} comprises at least one CF₃ moiety and/or one of R¹, R², R³, R⁴ and R⁵ is CF₃.

According to an embodiment, wherein at least one of R^{a}, R^{b}, R^{c} or R^{d} is independently selected from the group of D1 to D108: 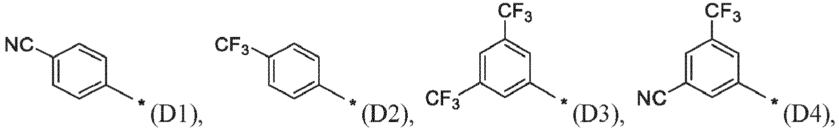 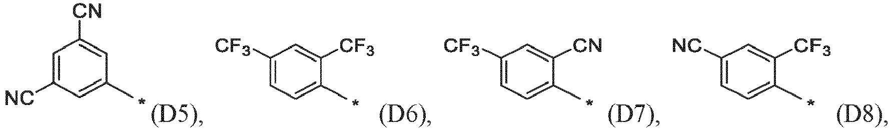 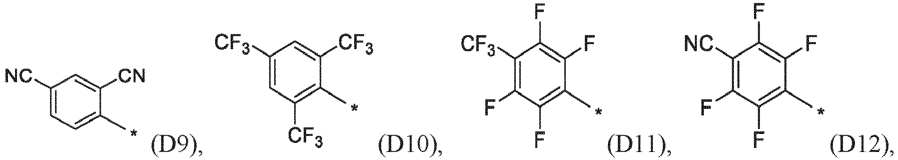 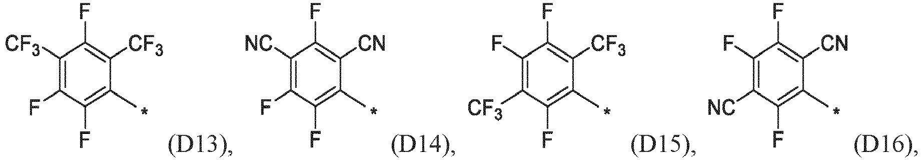 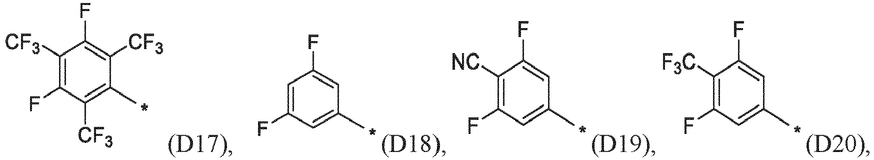 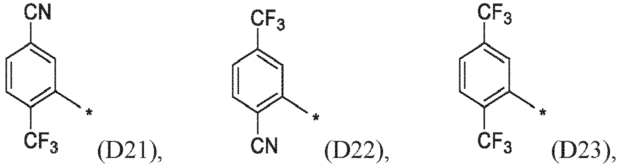 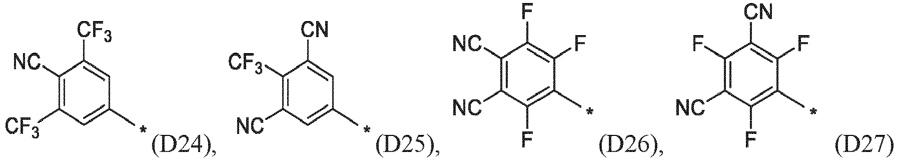 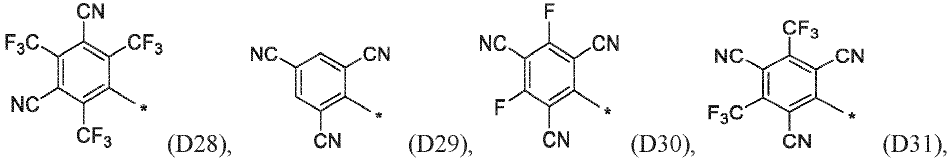 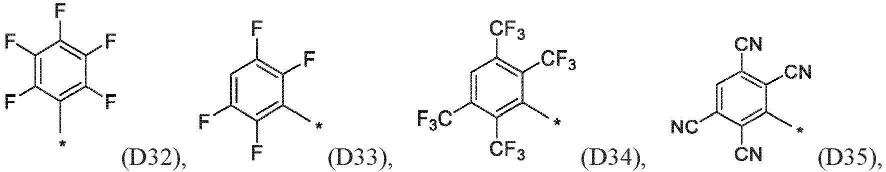 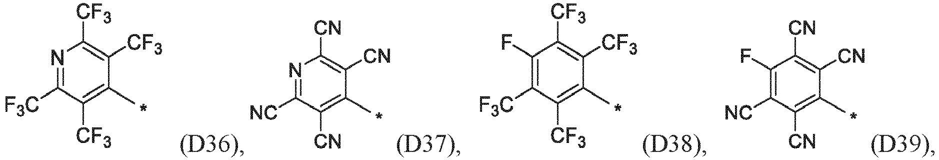 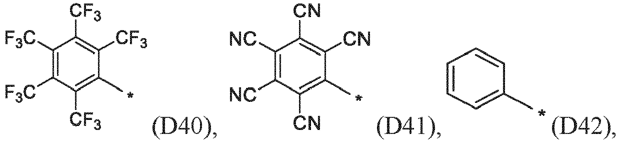 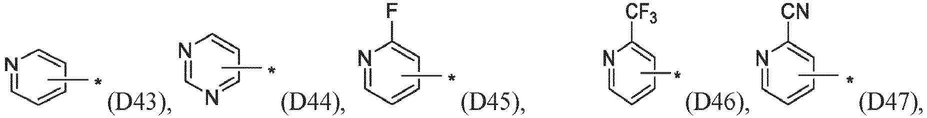 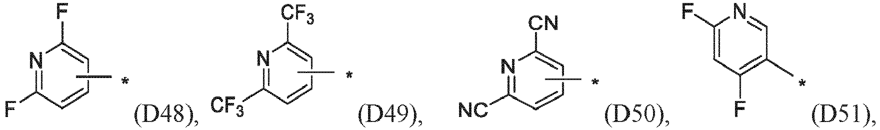 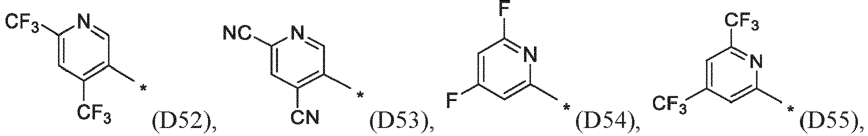 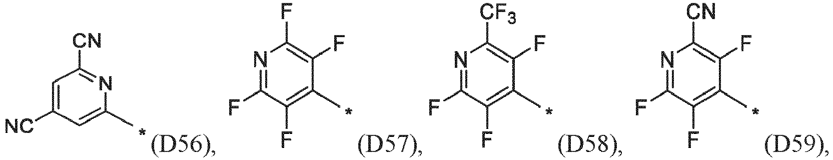 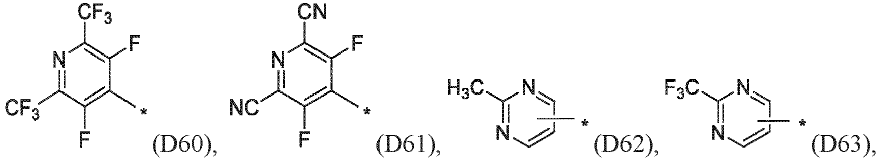 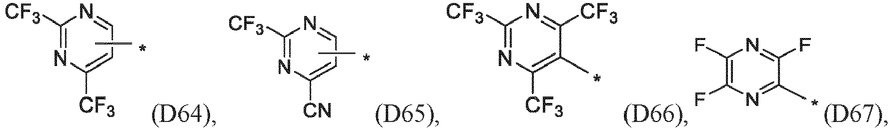 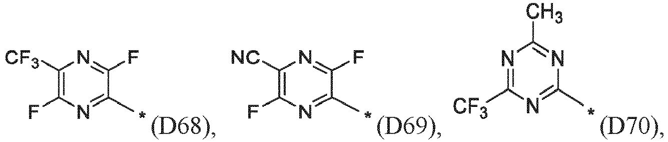 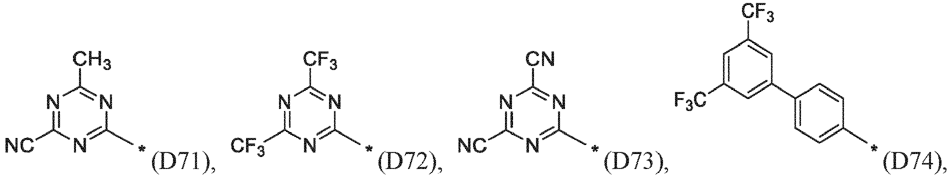 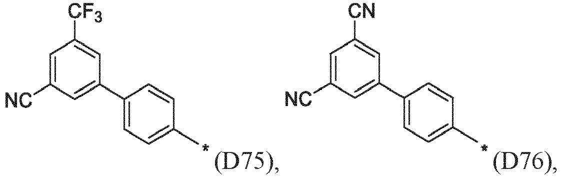
-CF₃(D77), -C₂F₅(D78), -C₃F₇(D79), -CF₂CF₂CF₃(D80), 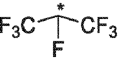 (D81),
-C₄F₉ (D82), -CF₂CF₂CF₂CF₃(D83), 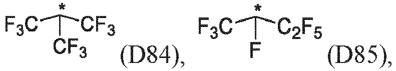
-C₅F₁₁(D86), -C₆F₁₃(D87), -CH₃(D88), -C₂H₅(D89) -CH(CH₃)₂(D90),
-C(CH₃)₃(91), 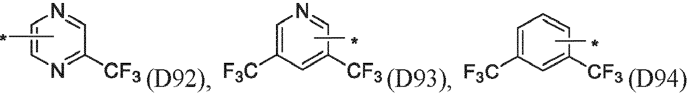 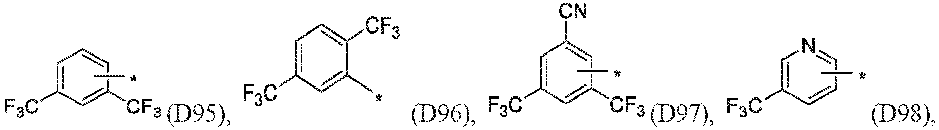 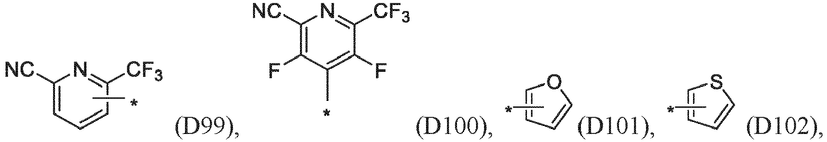 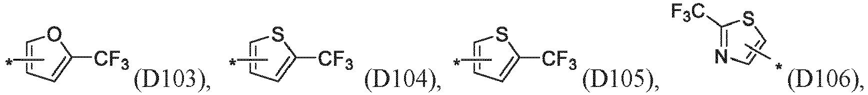 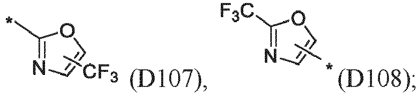 wherein the "*" or "-" denotes the binding position.

According to an embodiment, wherein the monoanion or the monoanionic ligand L of formula (Ia), (Ib) and/or (Ic) is selected from a group L1 to L518:

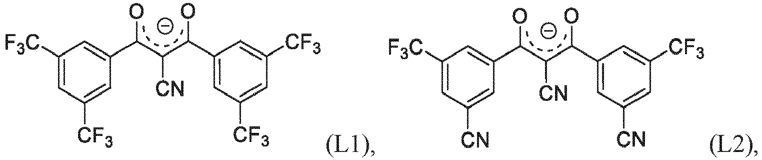

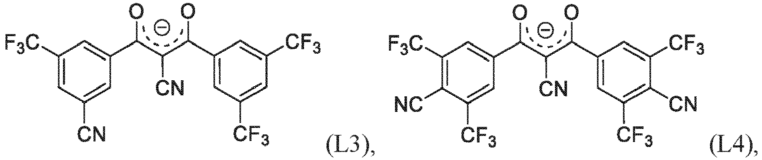

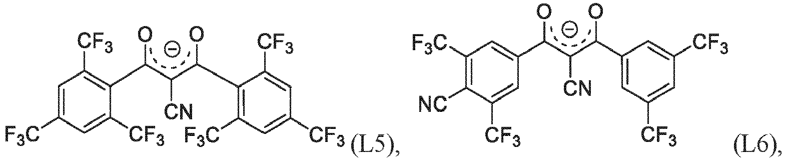

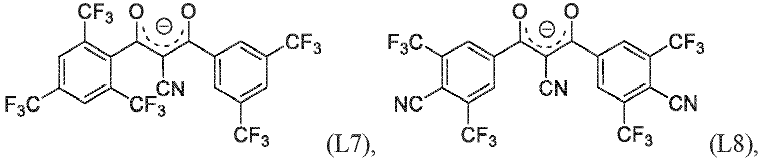

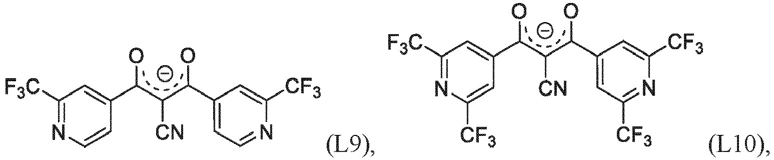

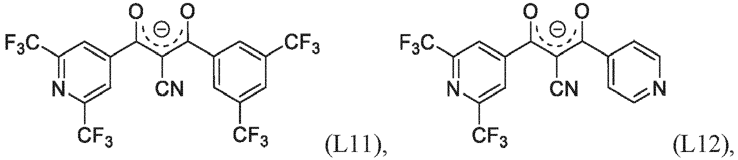

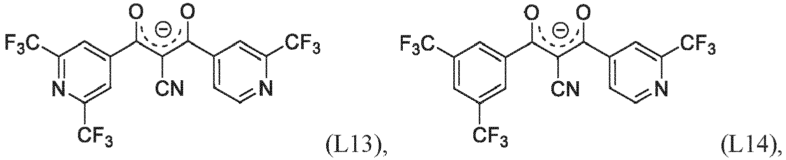

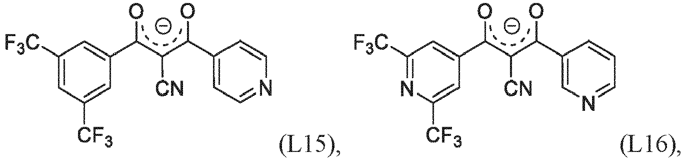

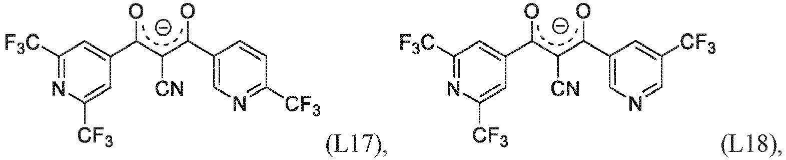

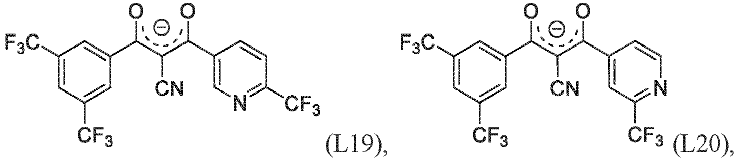

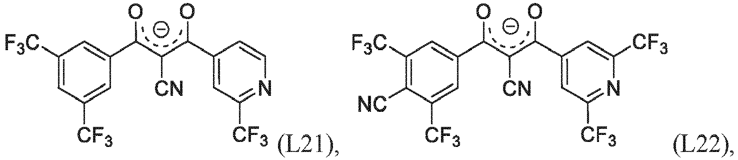

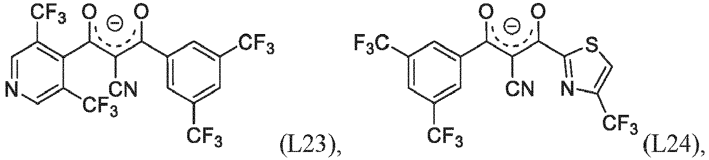

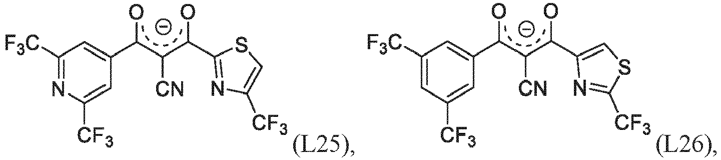

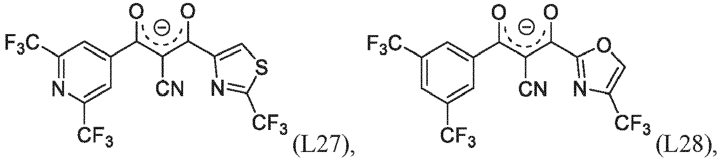

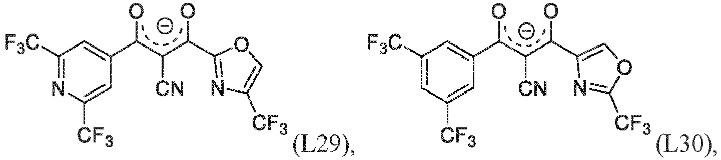

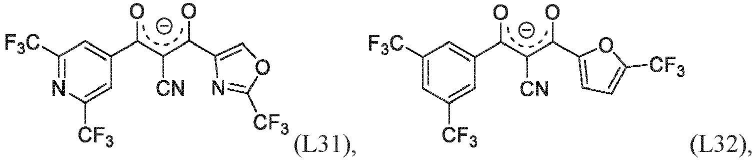

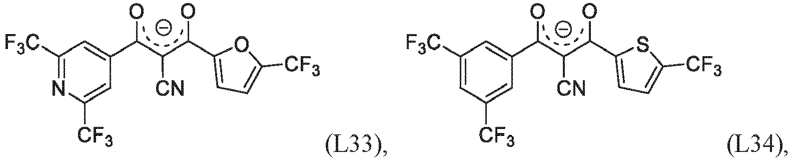

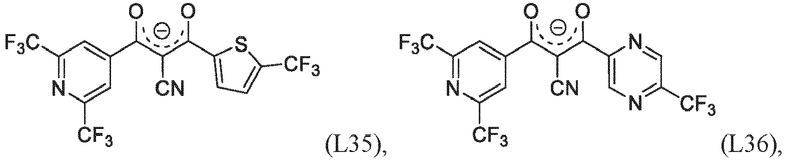

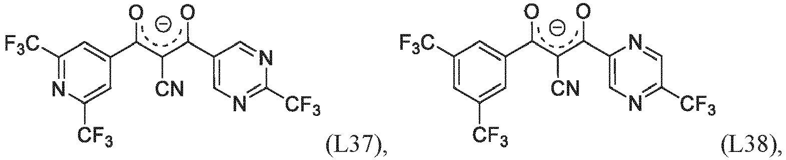

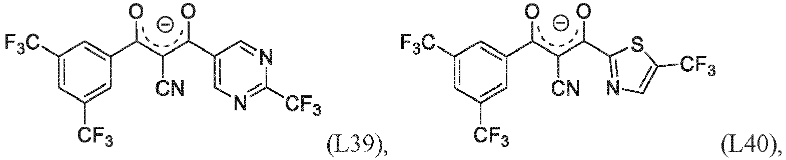

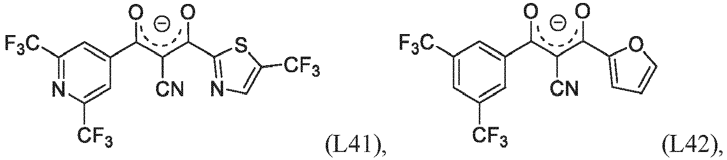

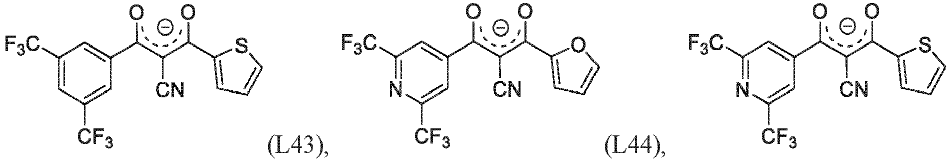

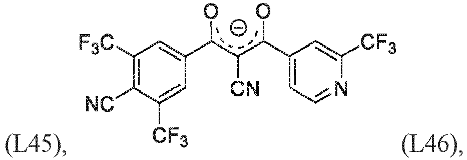

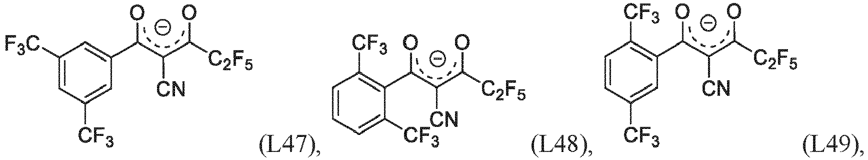

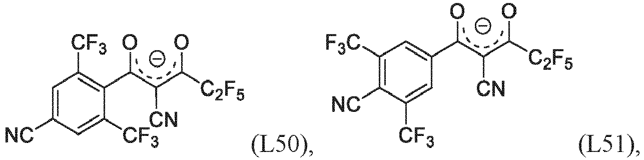

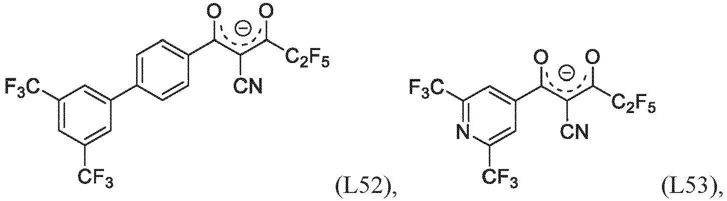

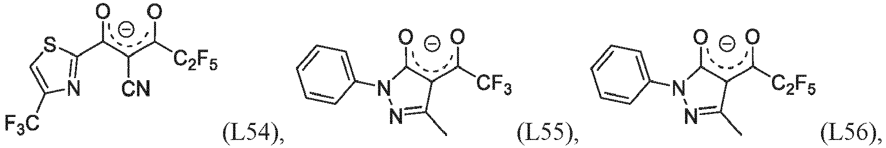

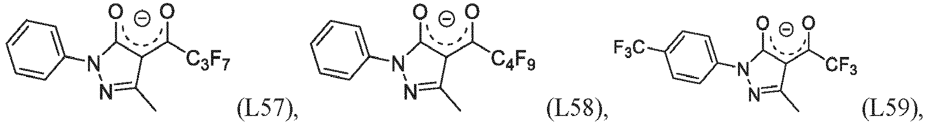

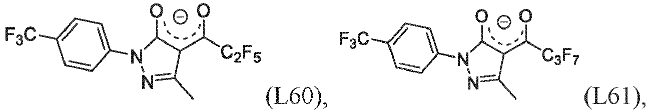

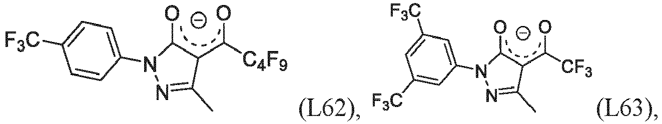

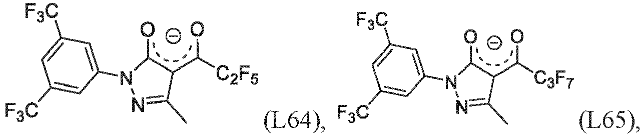

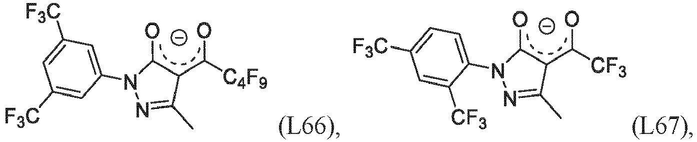

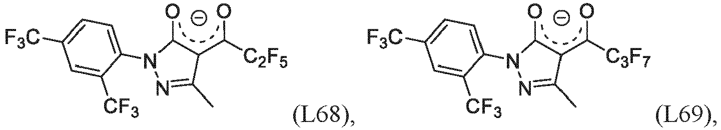

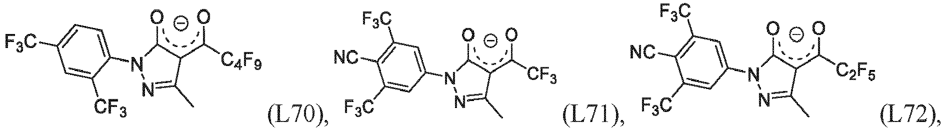

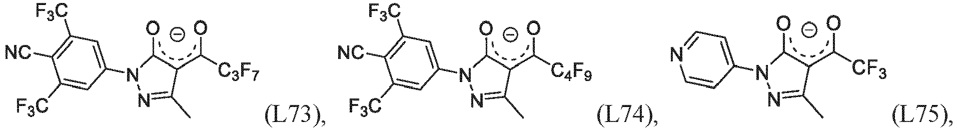

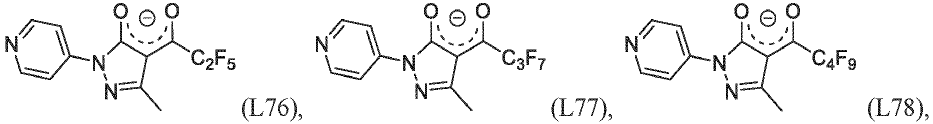

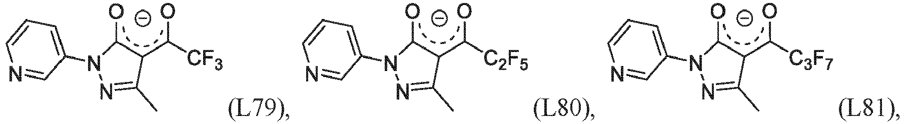

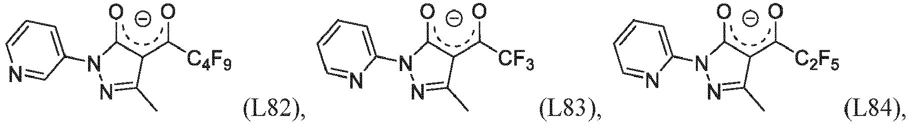

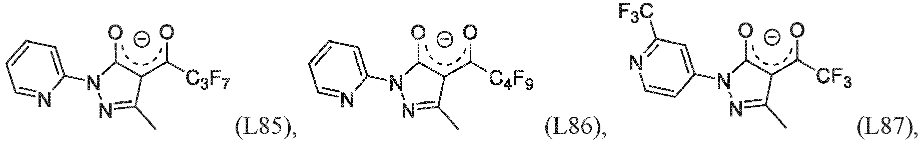

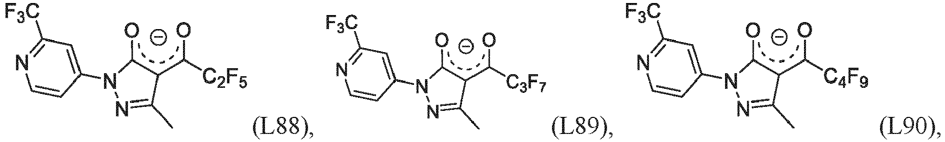

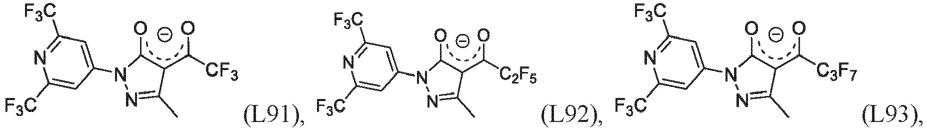

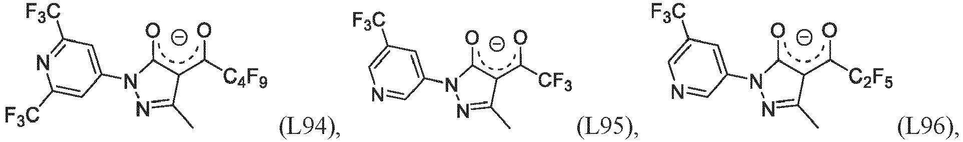

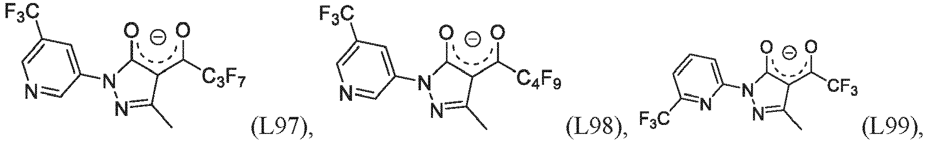

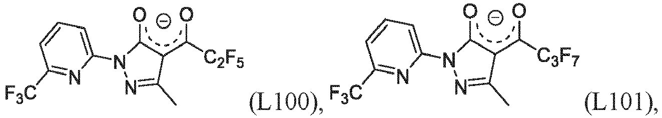

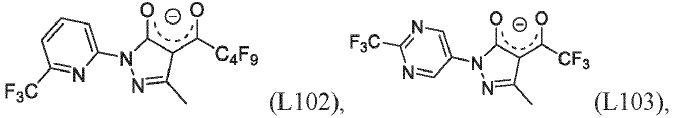

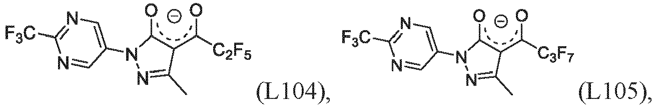

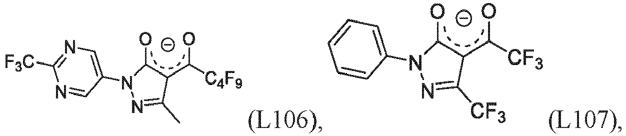

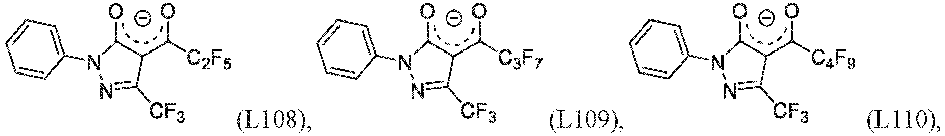

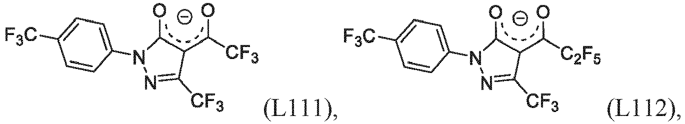

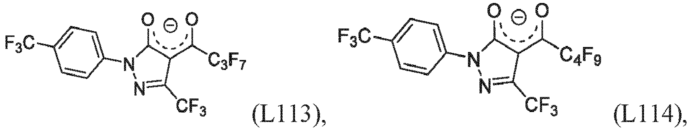

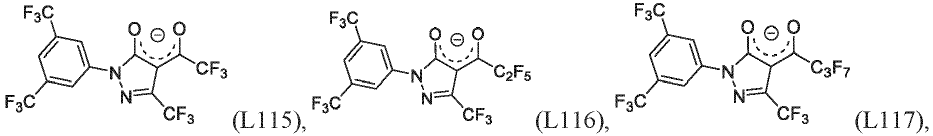

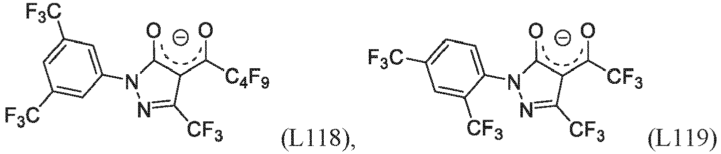

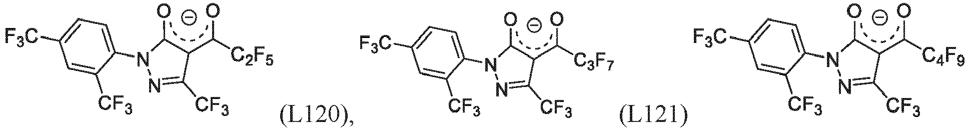

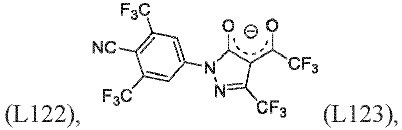

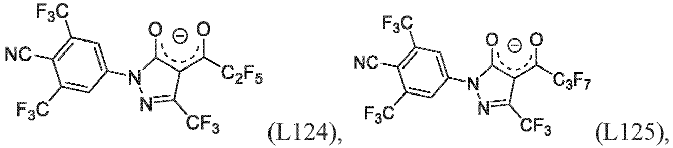

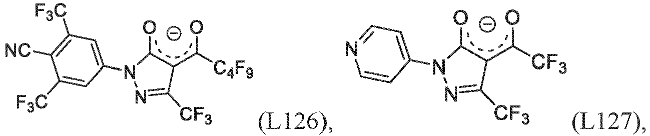

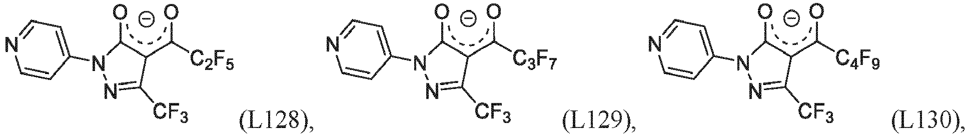

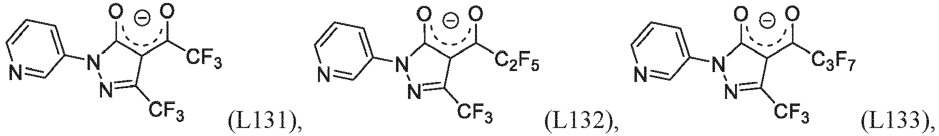

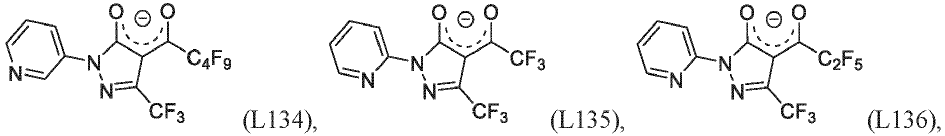

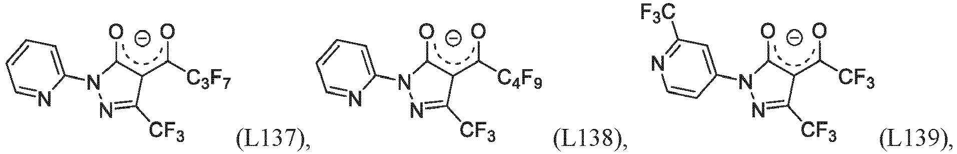

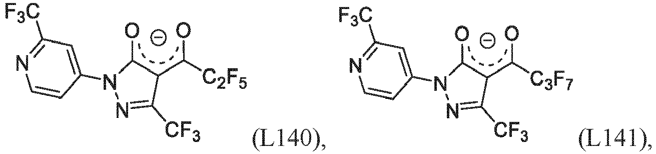

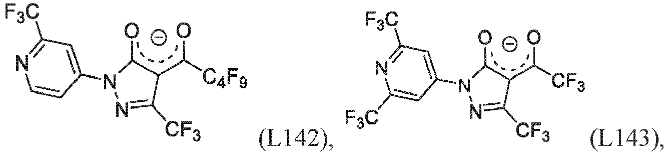

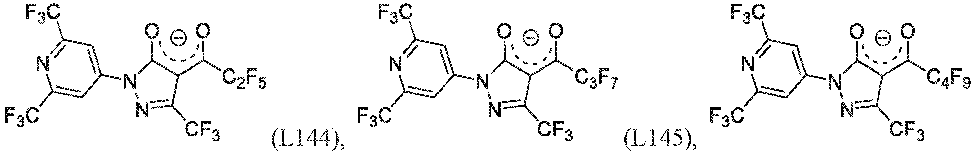

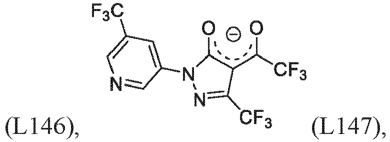

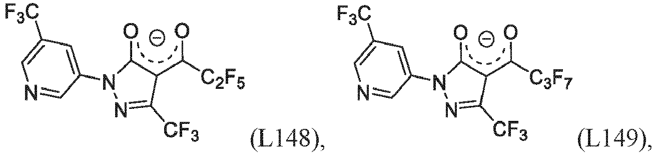

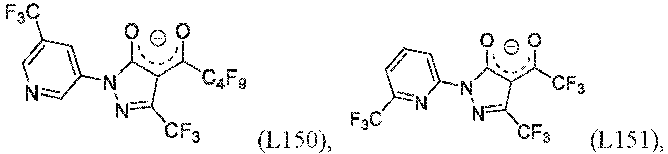

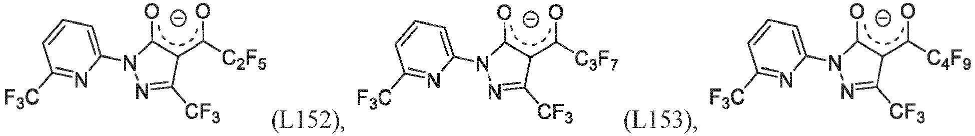

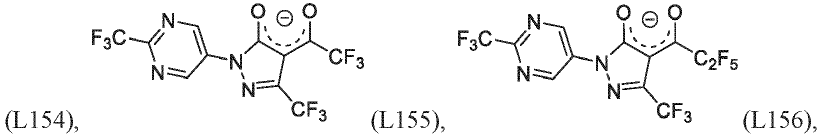

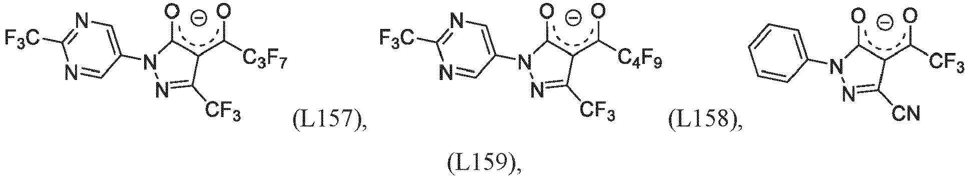

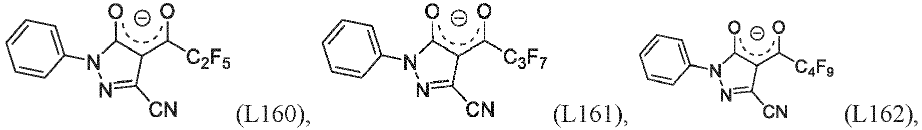

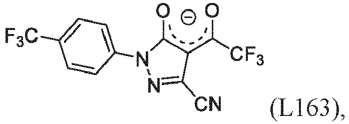

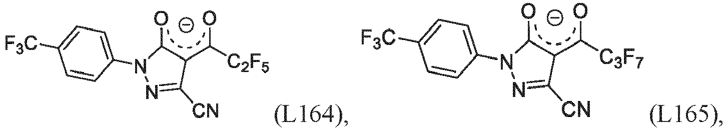

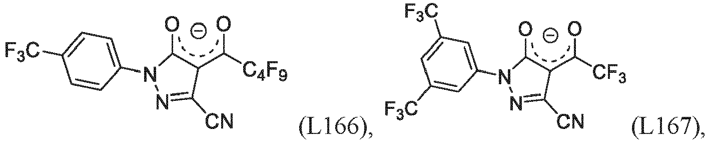

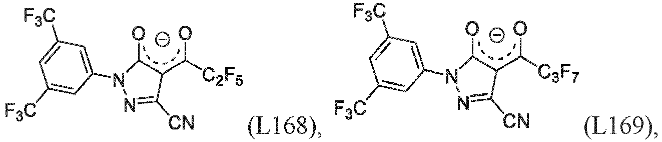

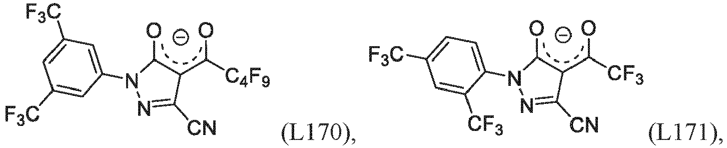

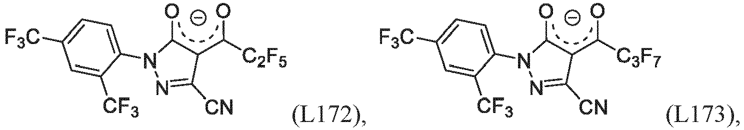

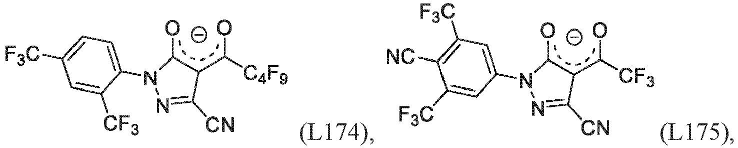

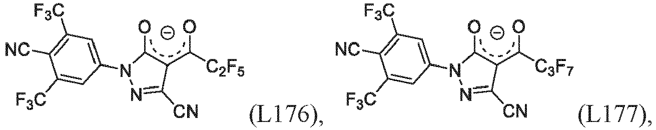

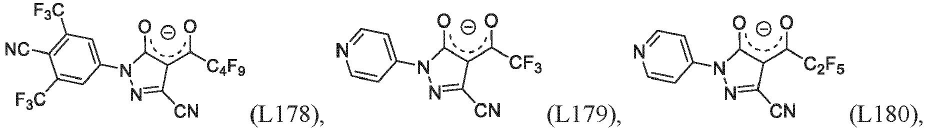

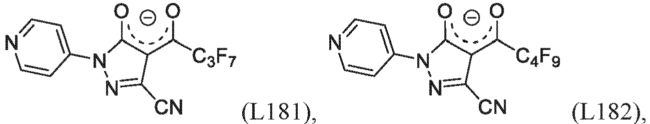

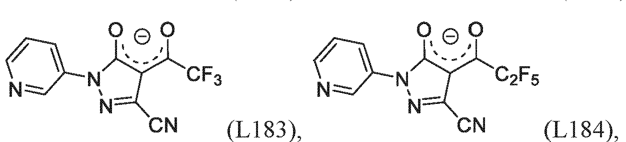

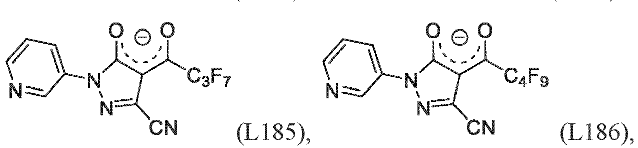

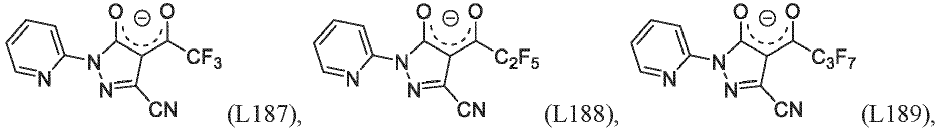

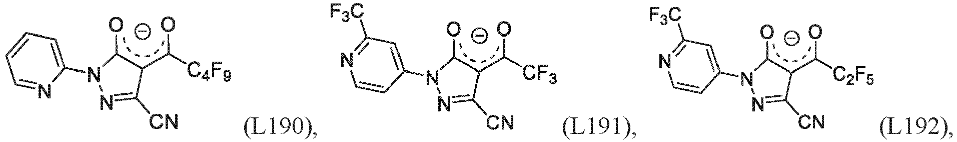

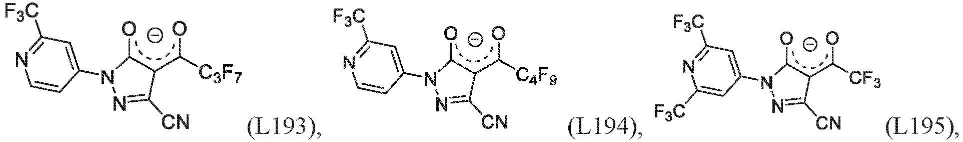

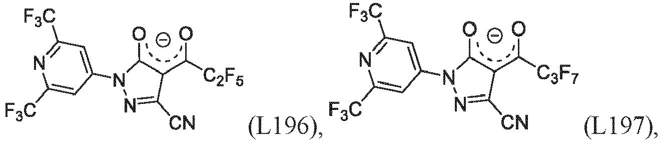

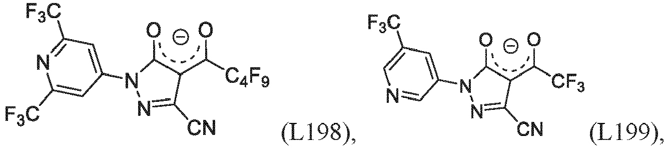

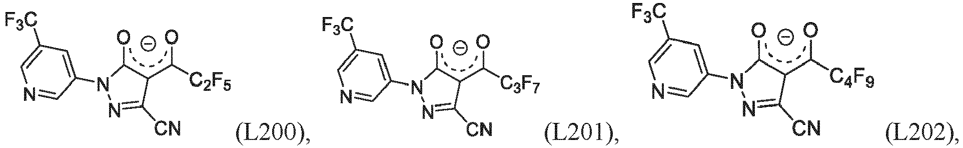

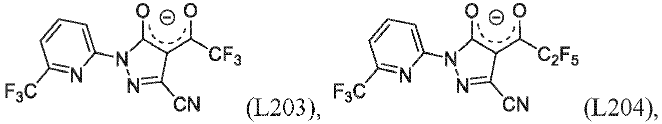

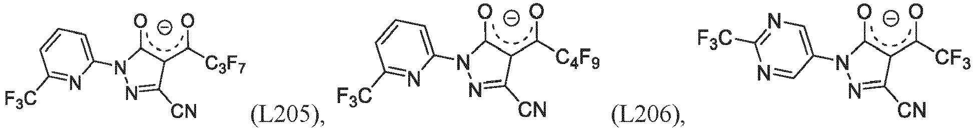

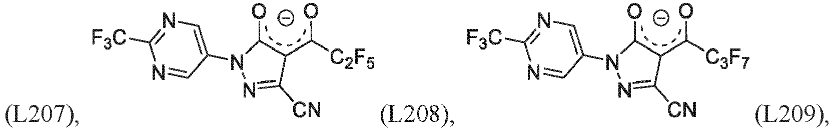

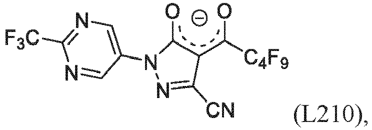

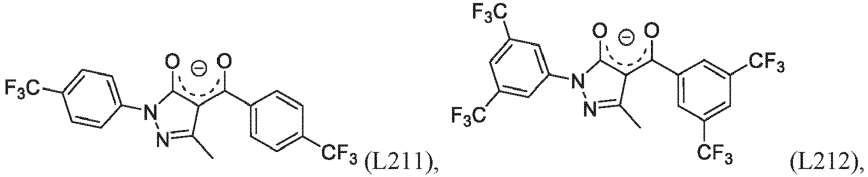

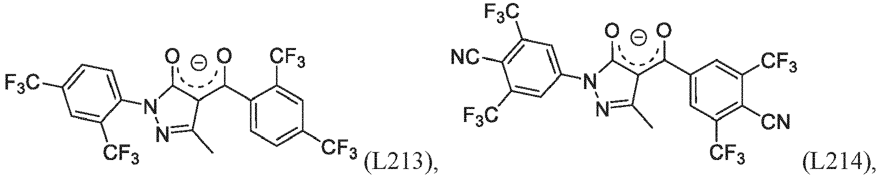

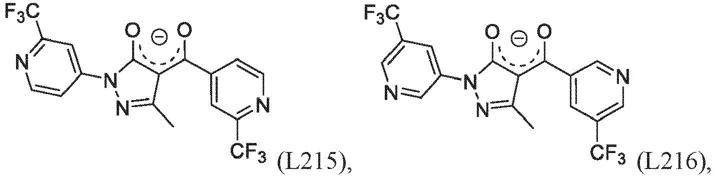

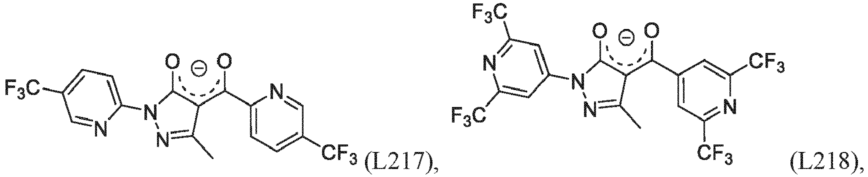

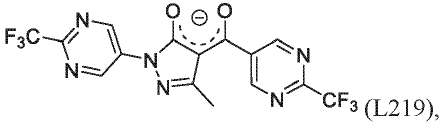

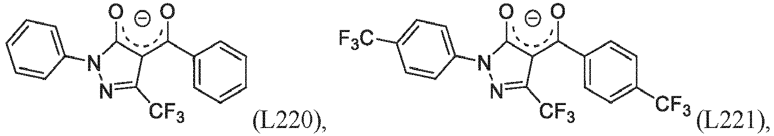

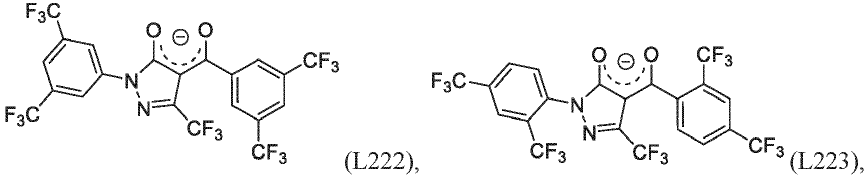

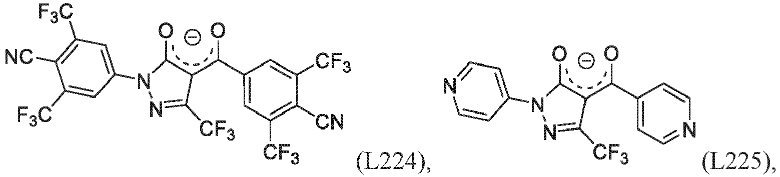

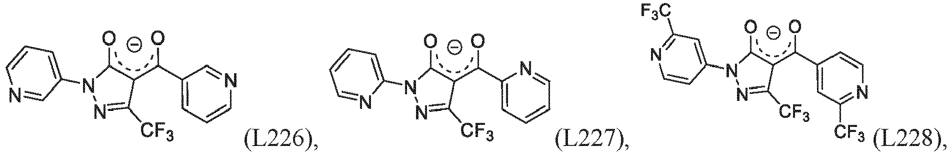

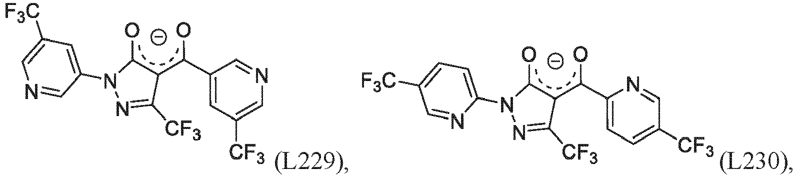

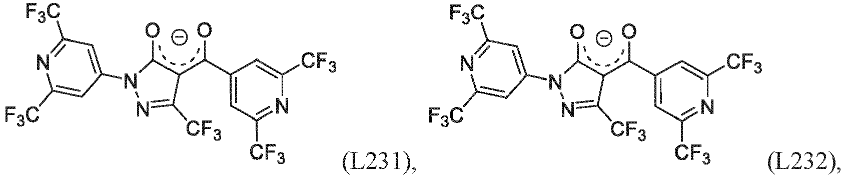

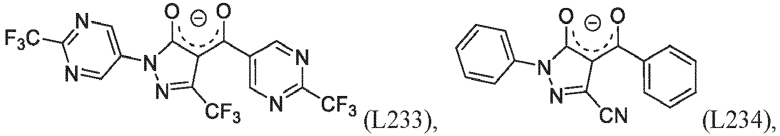

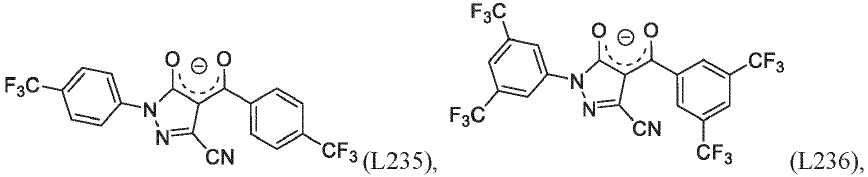

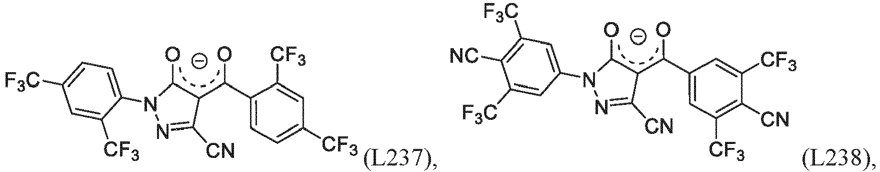

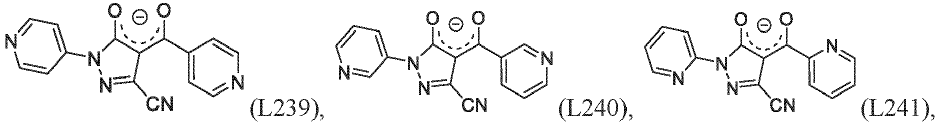

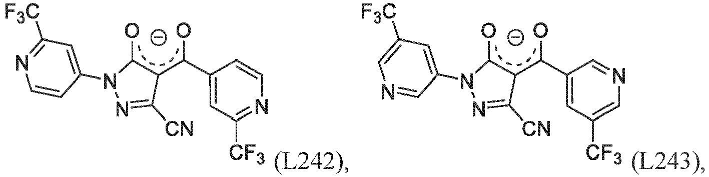

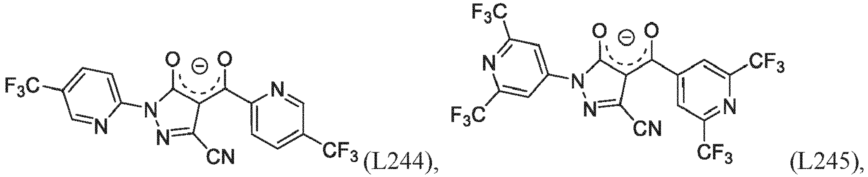

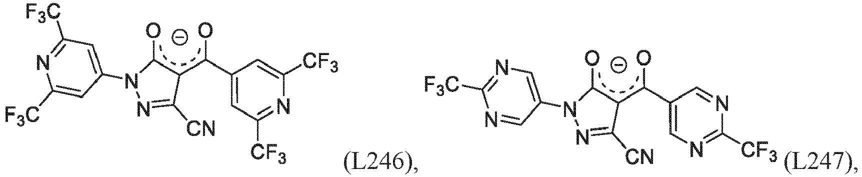

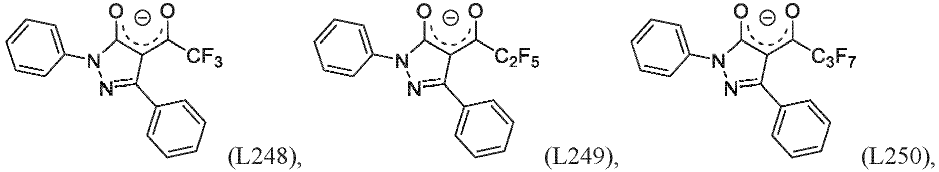

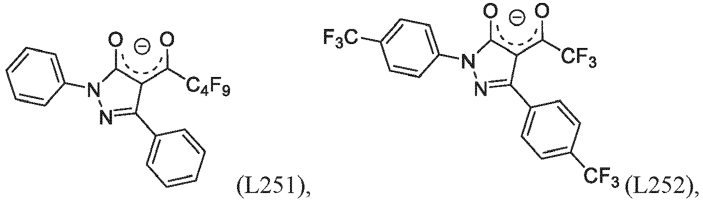

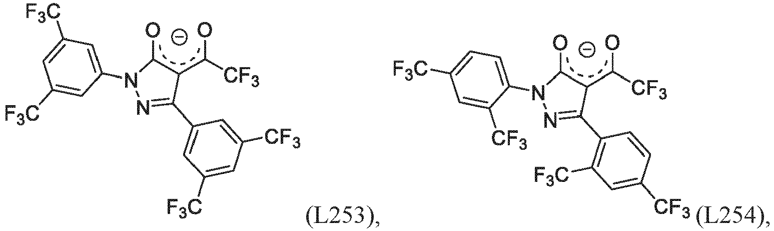

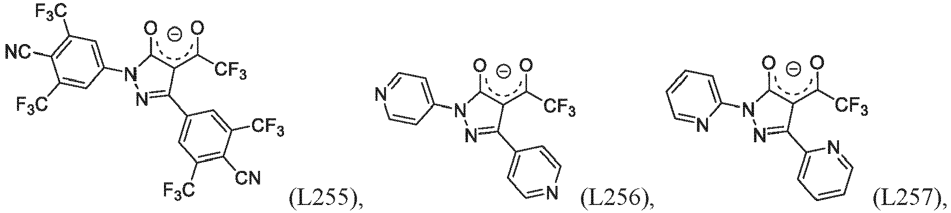

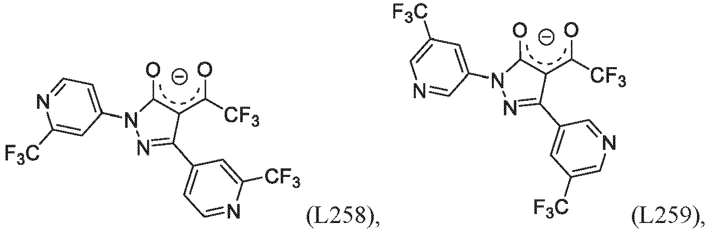

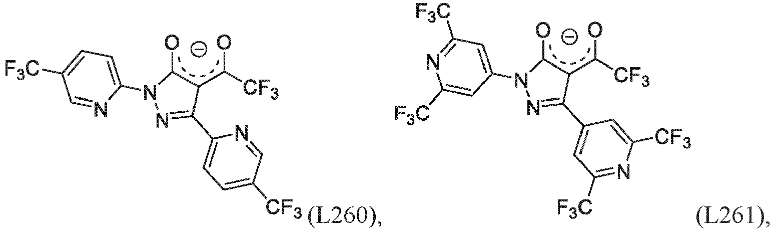

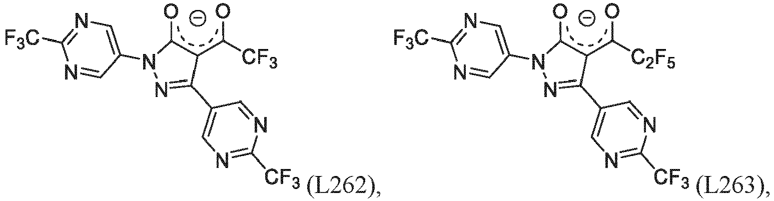

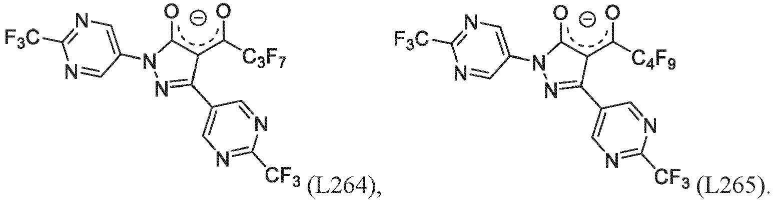

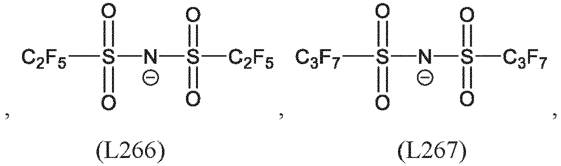

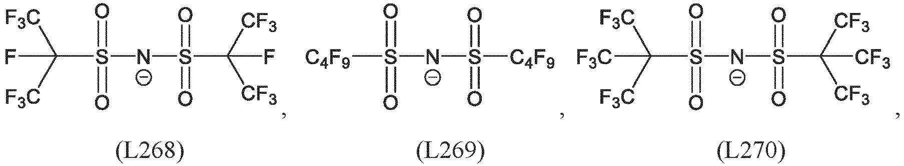

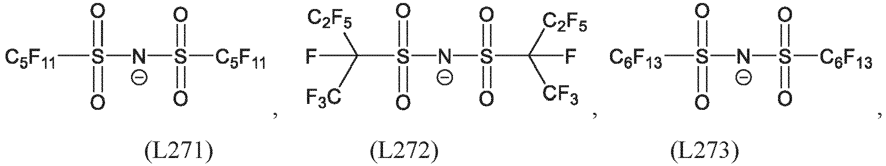

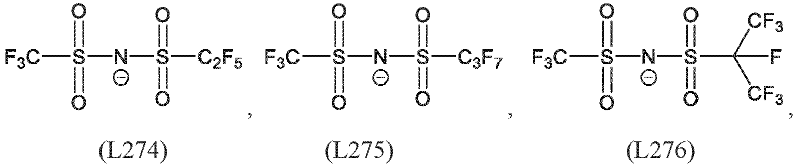

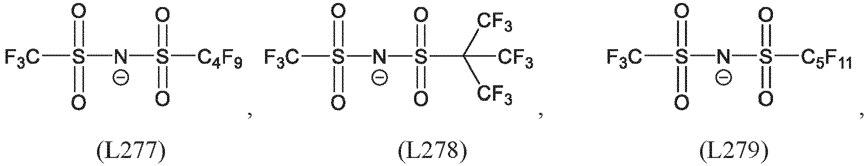

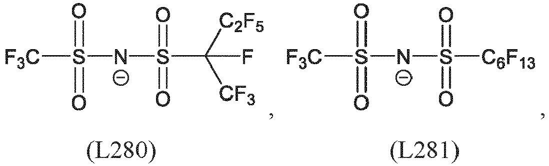

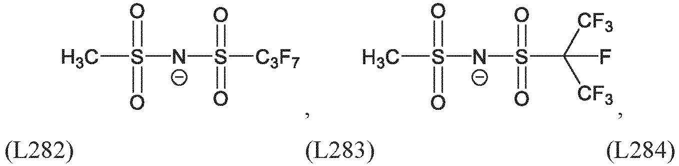

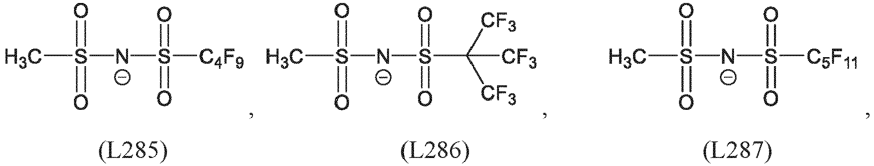

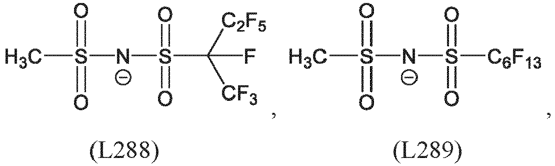

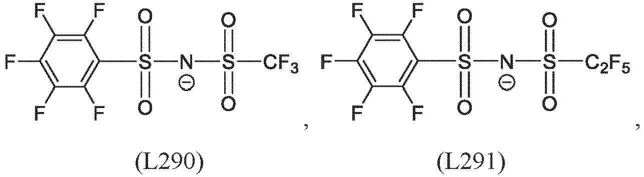

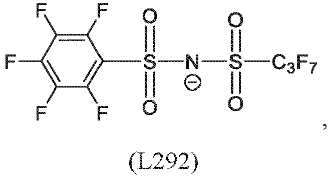

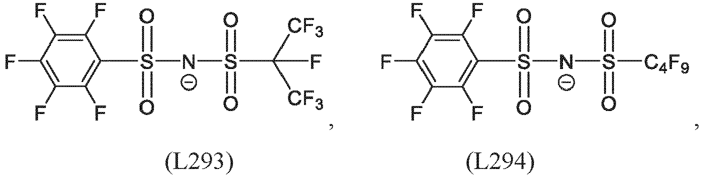

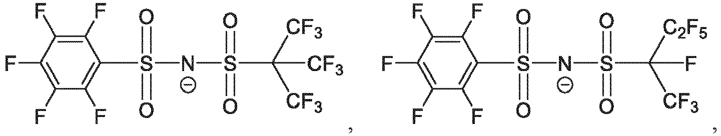

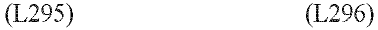

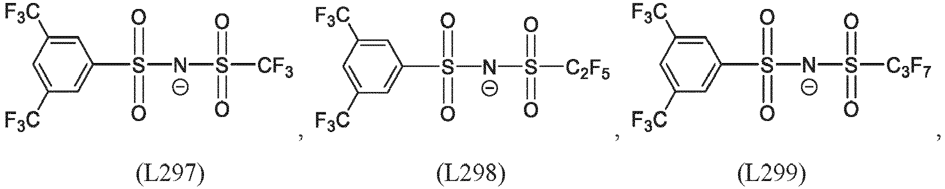

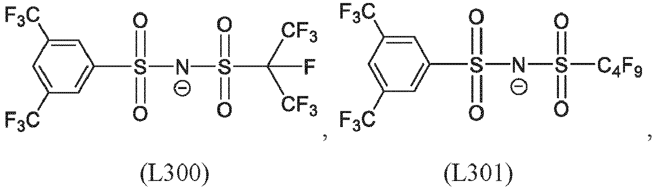

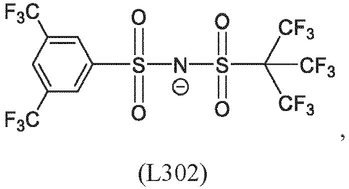

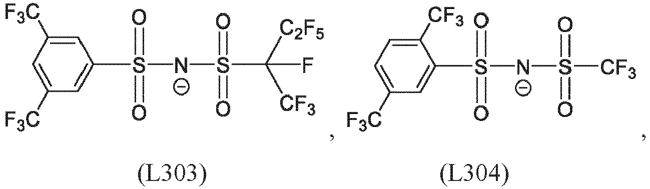

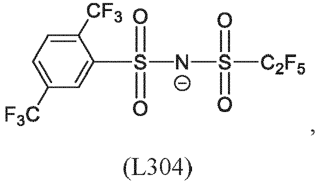

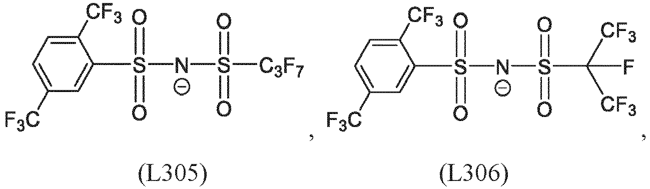

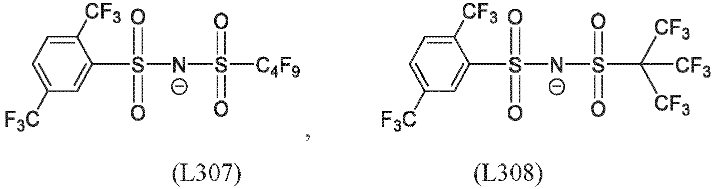

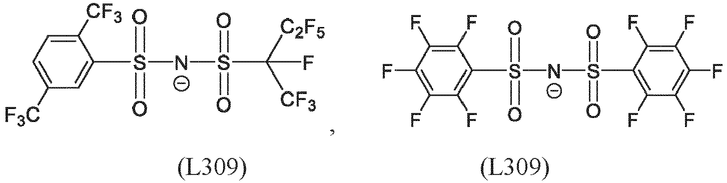

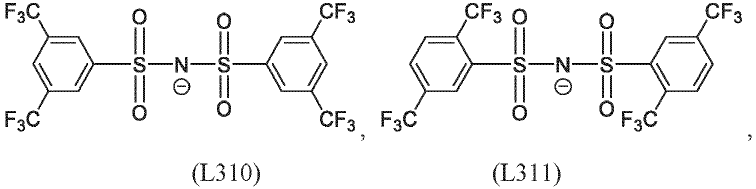

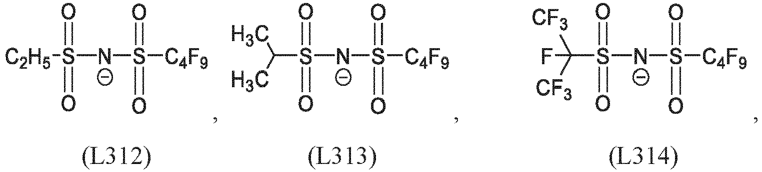

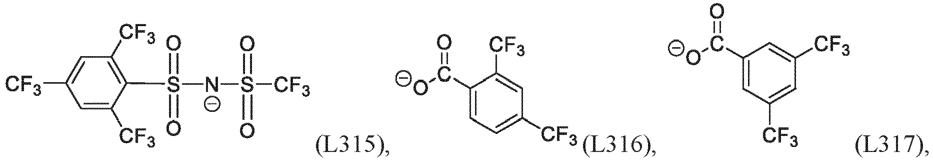

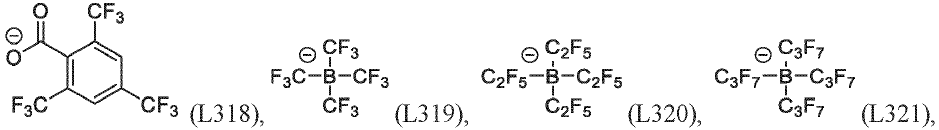

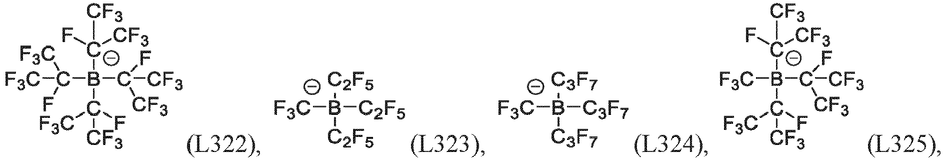

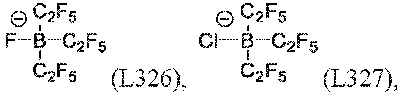

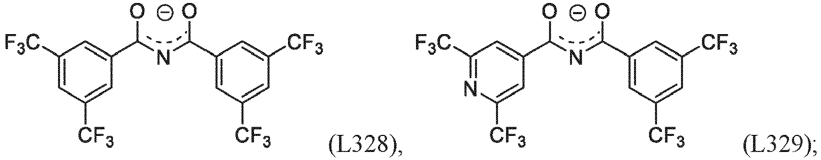

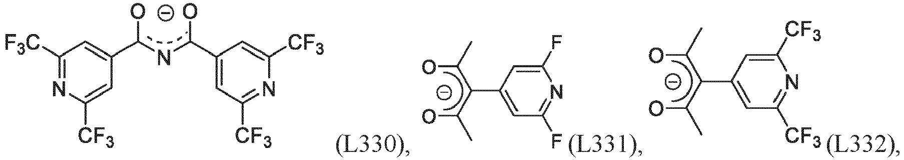

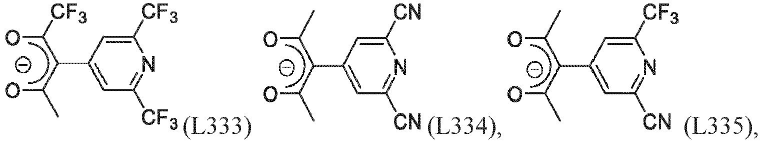

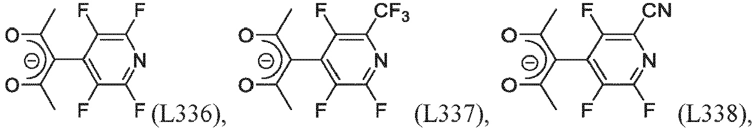

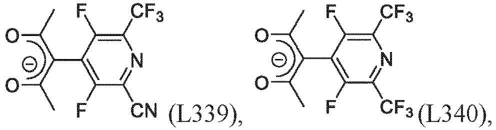

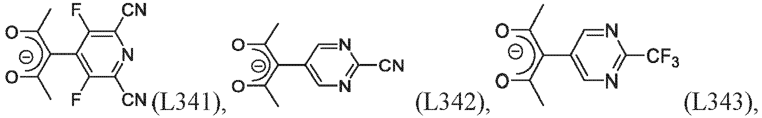

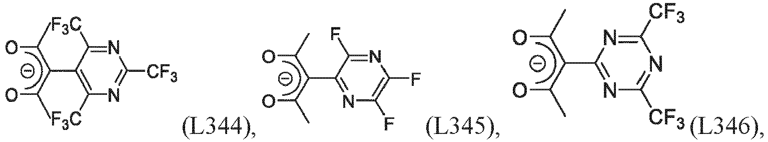

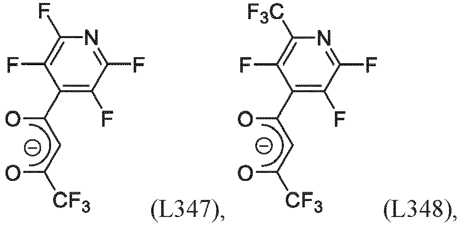

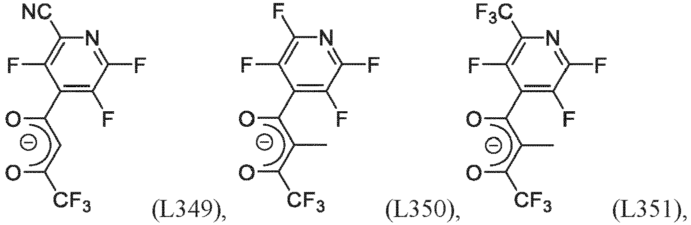

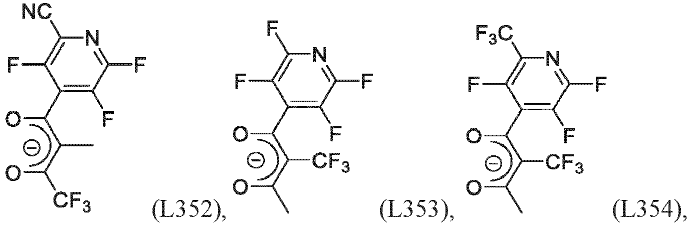

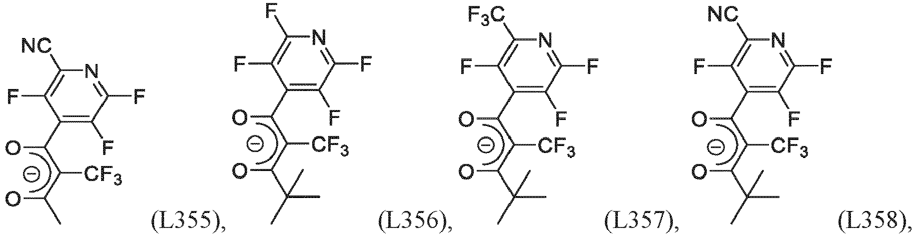

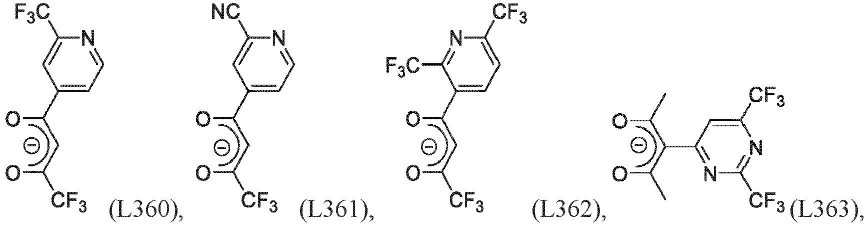

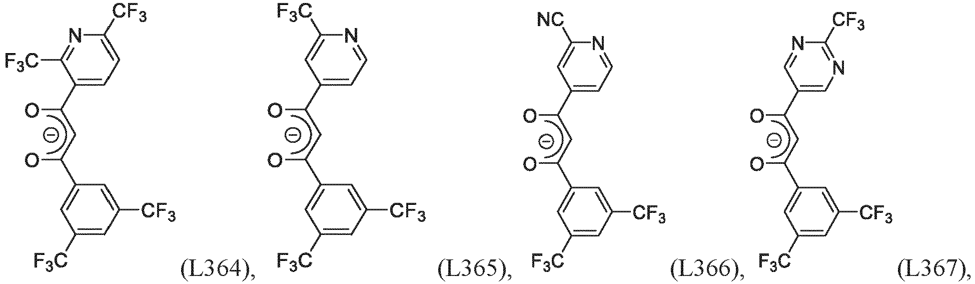

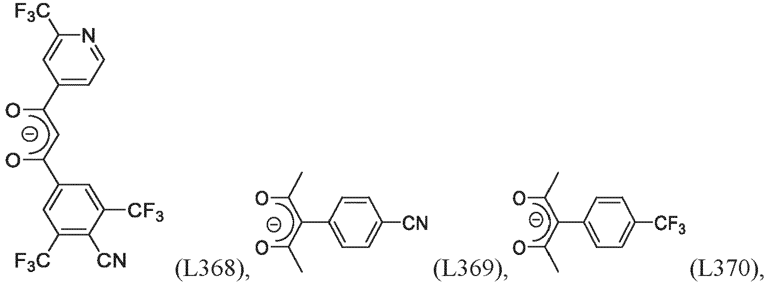

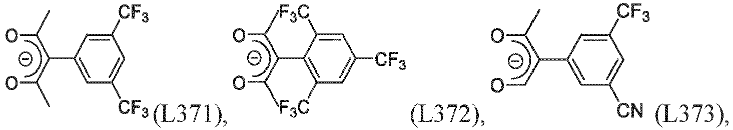

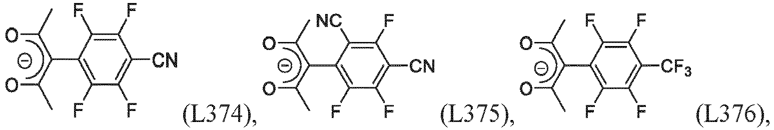

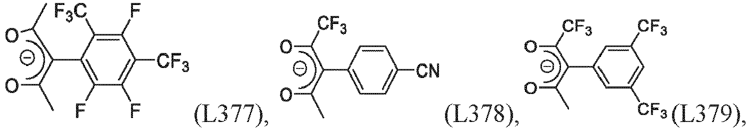

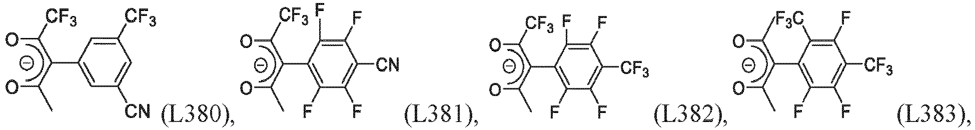

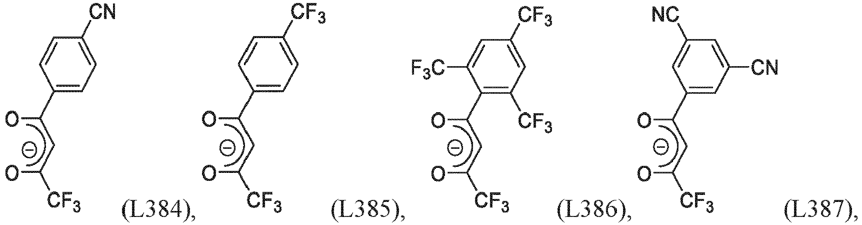

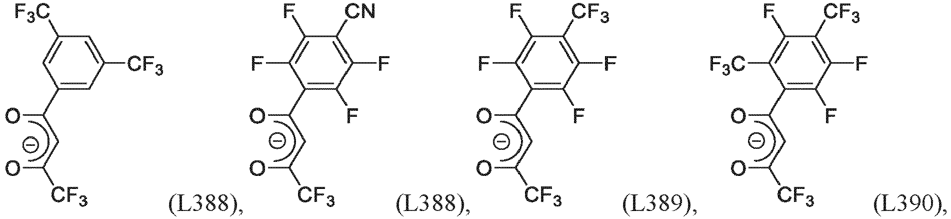

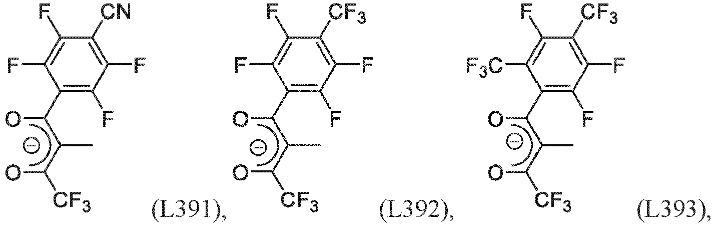

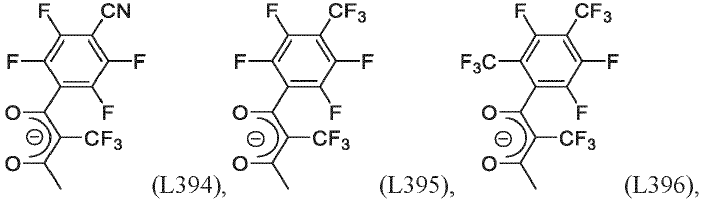

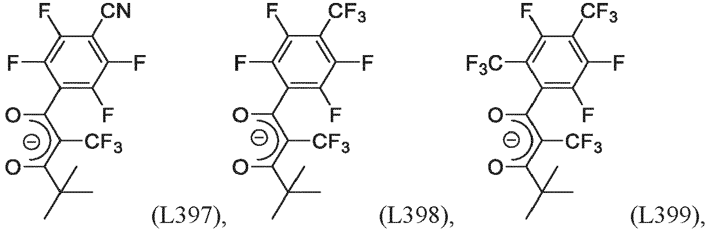

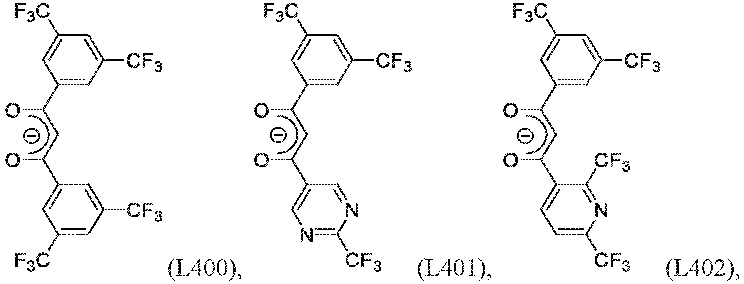

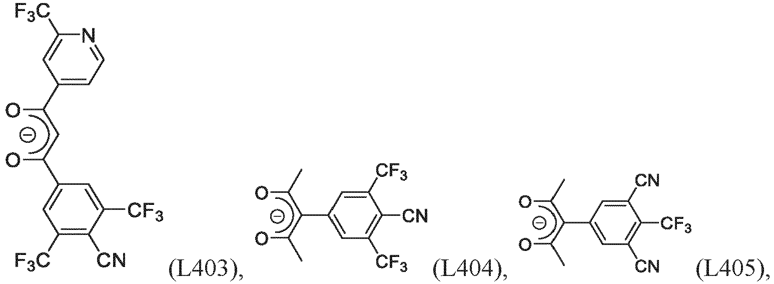

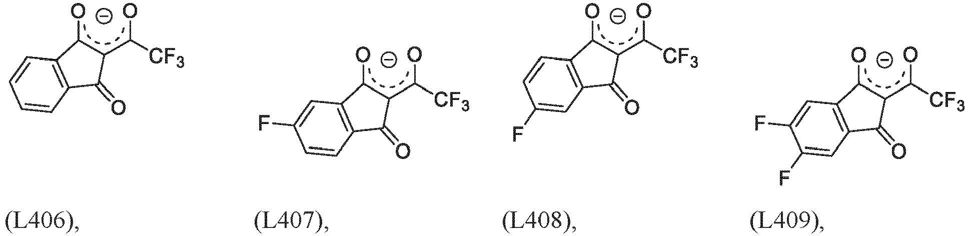

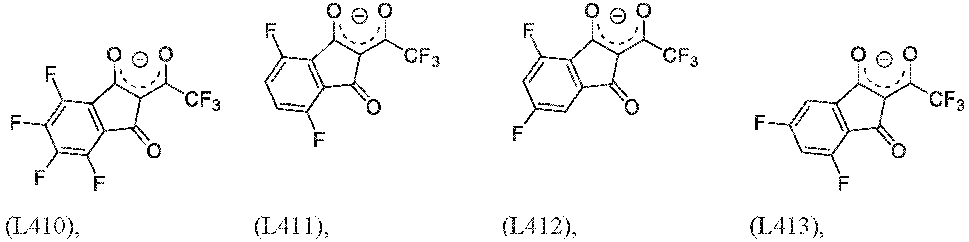

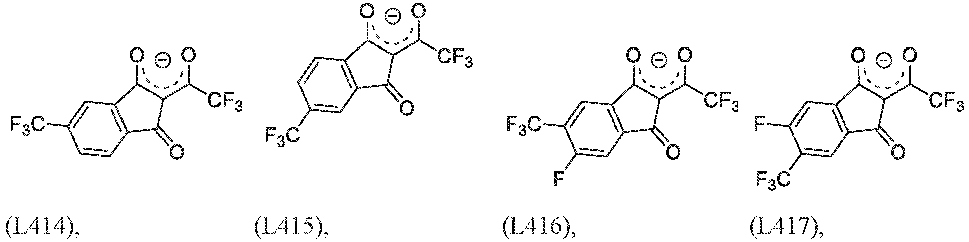

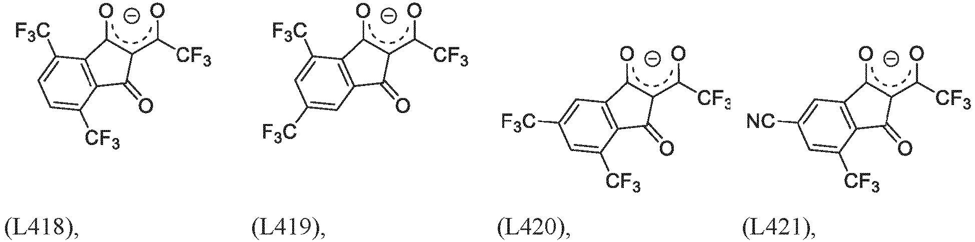

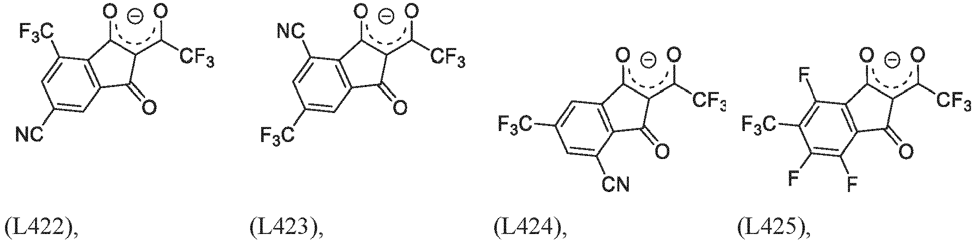

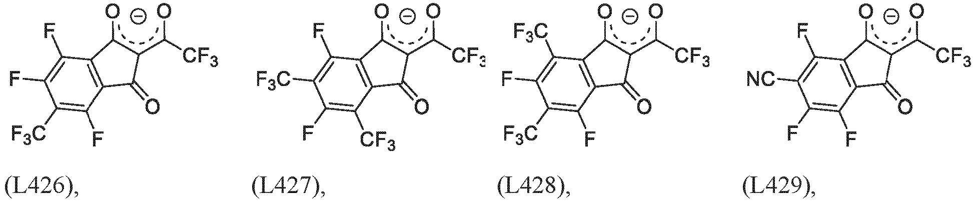

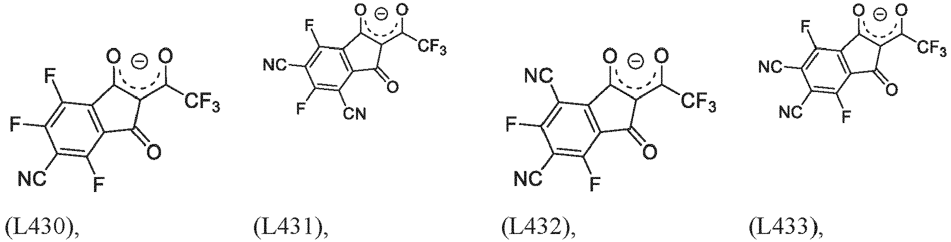

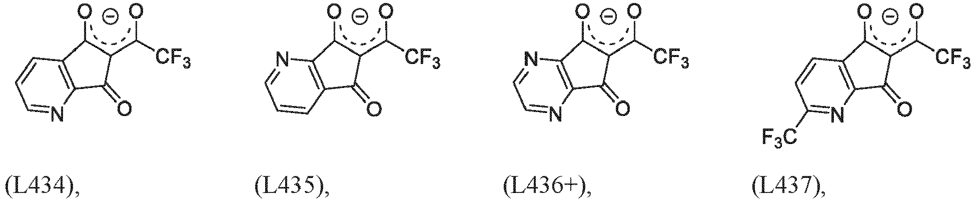

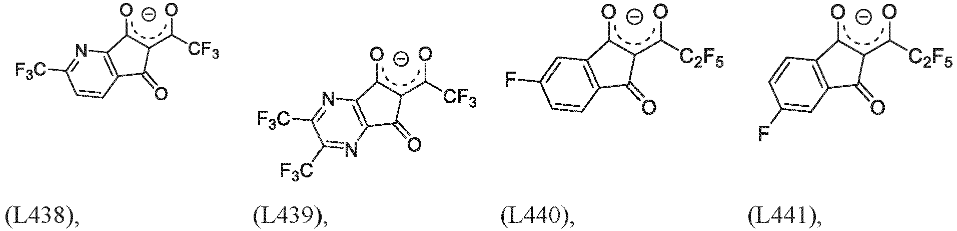

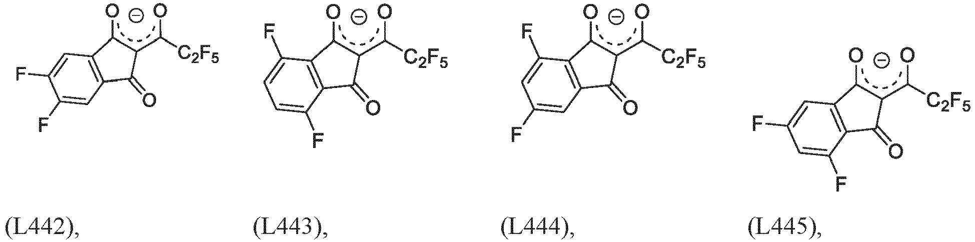

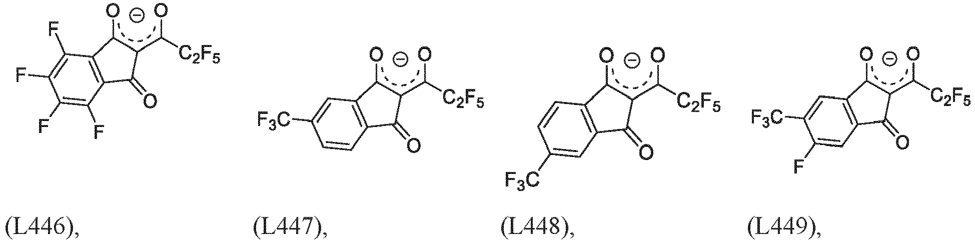

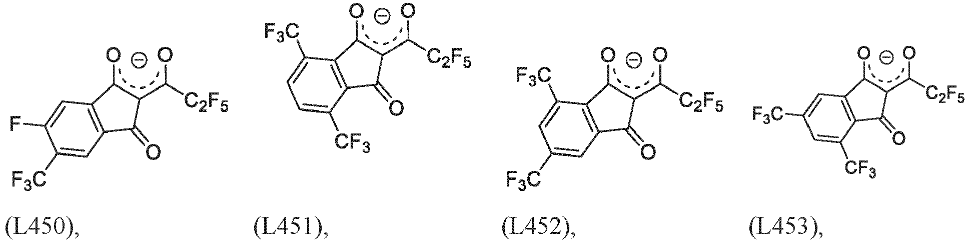

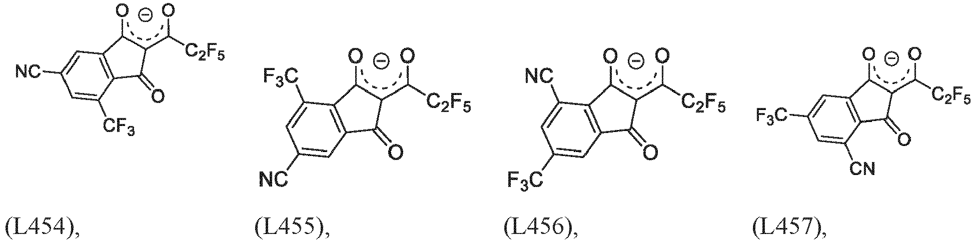

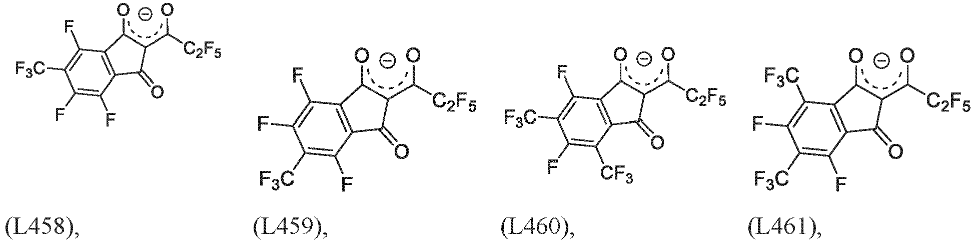

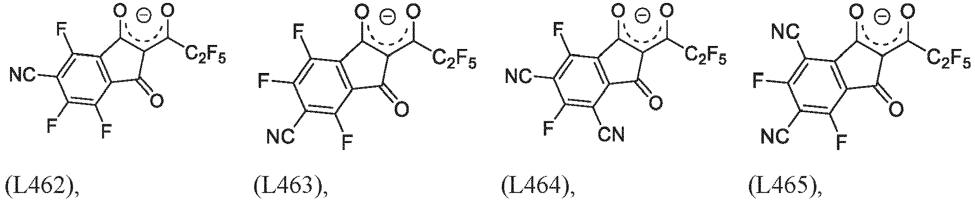

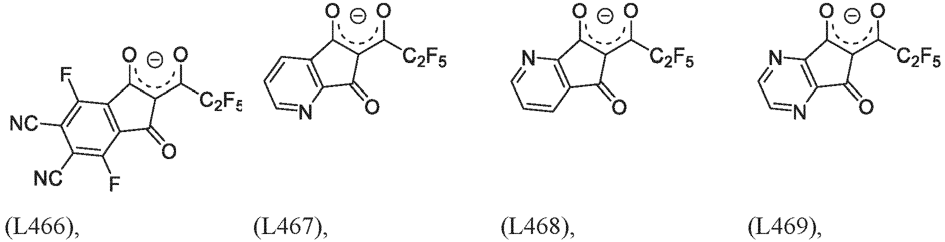

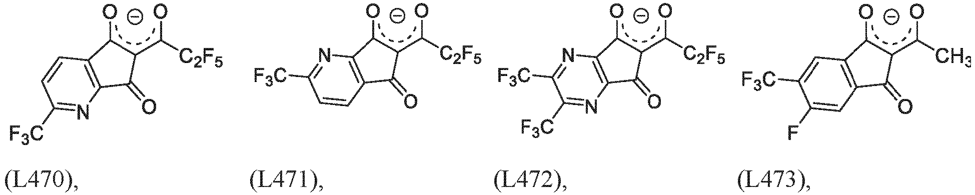

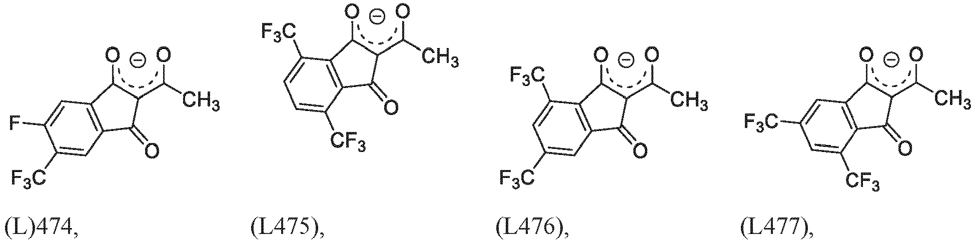

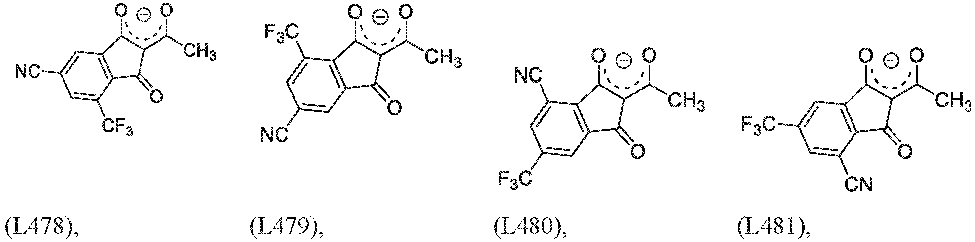

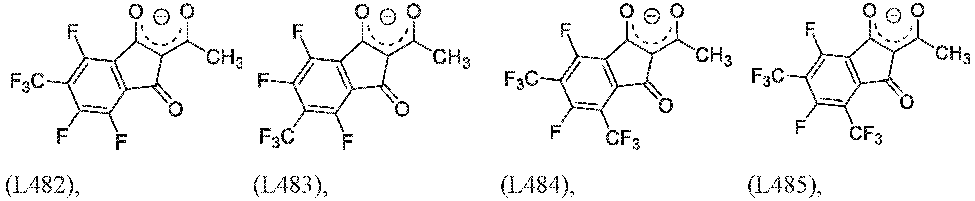

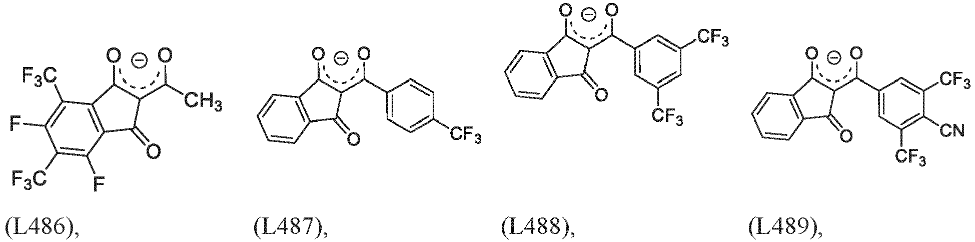

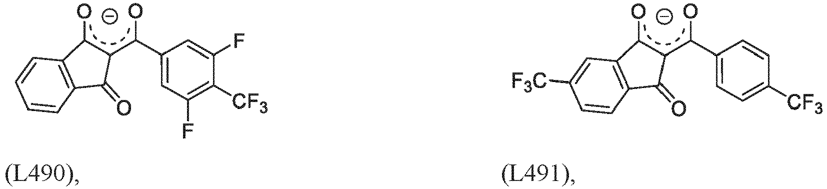

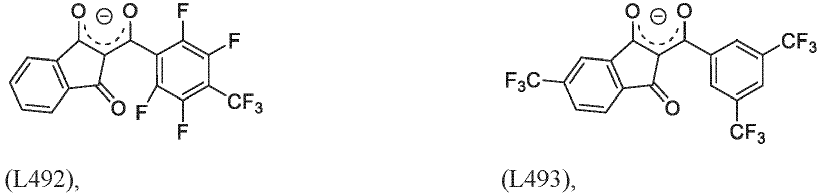

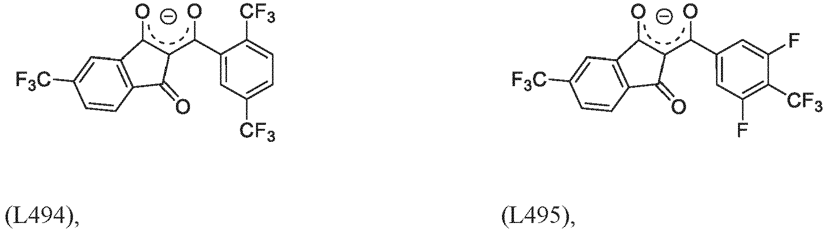

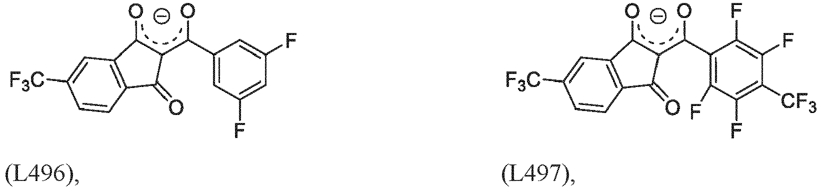

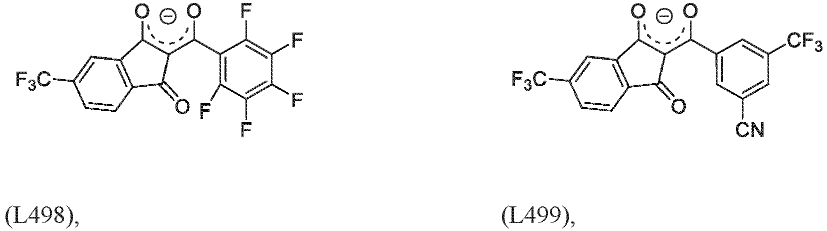

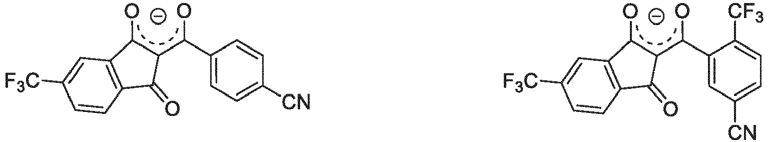

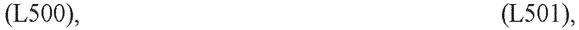

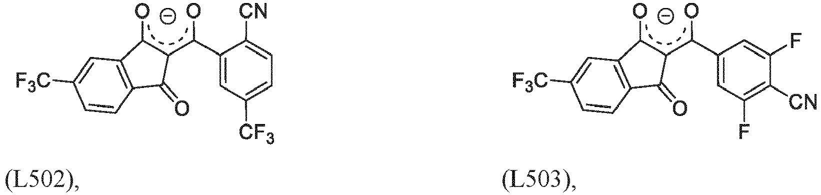

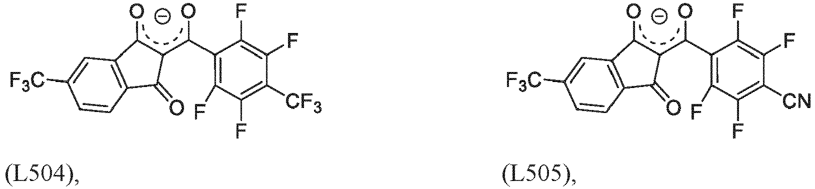

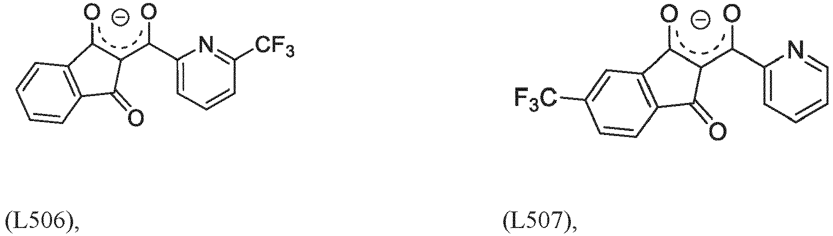

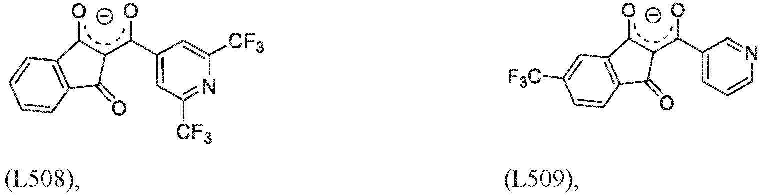

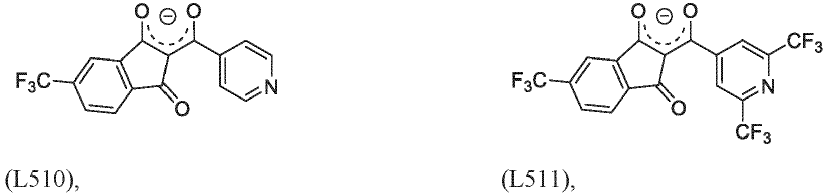

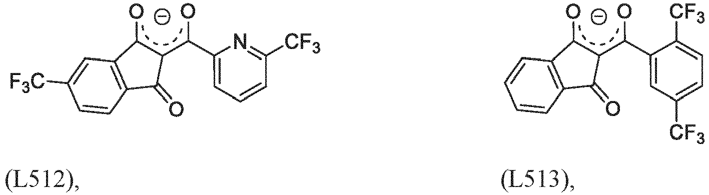

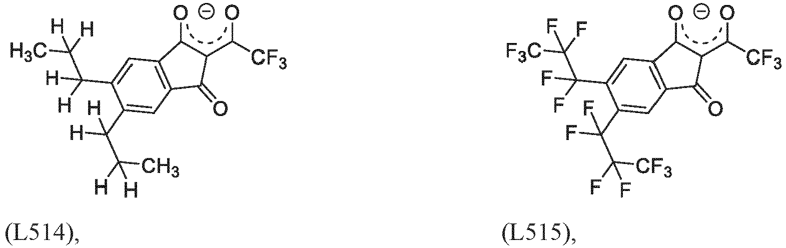

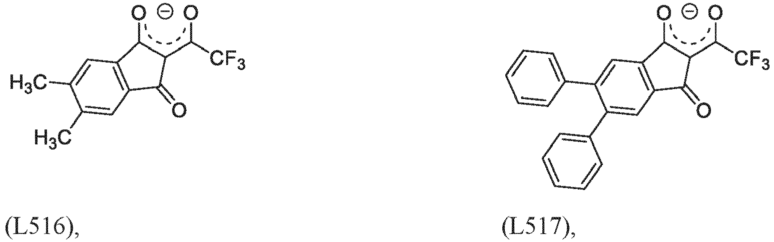

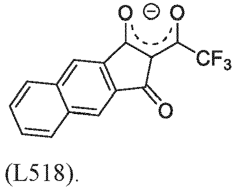

According to an embodiment, wherein the monoanion or the monoanionic ligand is selected from L1 to L315, L319 to L327, L331 to L518.

According to an embodiment, wherein the monoanion or the monoanionic ligand is selected from L1 to L315, L319 to L327, L331 to L518.

According to an embodiment, wherein the monoanion or the monoanionic ligand is selected from L1 to L315, and L331 to L518.

According to an embodiment, wherein the monoanion or the monoanionic ligand is selected from L1 to L265, and L331 to L518.

According to an embodiment, wherein the monoanion or the monoanionic ligand is selected from L1 to L265.

According to an embodiment, wherein the monoanion or the monoanionic ligand is selected from L1 to L54.

According to an embodiment, wherein the monoanion or the monoanionic ligand is selected from L55 to L265.

### First metal compound - HIL

According to an embodiment, wherein the first metal compound in the p-type charge generation layer has a LUMO energy level of ≤ -4.90 eV,-preferably ≤ -5.00, more preferably ≤ - 5.20 eV, and most preferably ≤ -5.40 eV.

According to an embodiment, the monoanion or monoanionic ligand is selected from L1 to L54, L55 to L265, L316 to L327, L328 to L330, L331 to L405, L406 to 518. According to a preferred embodiment, the monoanion or monoanionic ligand is selected from L1 to L54, L55 to L265, L331 to L405, and L406 to 518. According to a more preferred embodiment, the monoanion or monoanionic ligand is selected from L1 to L54.

### Second metal compound - p-CGL

According to an embodiment, wherein the second metal compound in the p-type charge generation layer has a LUMO energy level of ≤ -4.90 eV,-preferably ≤ -5.00, more preferably ≤ - 5.20 eV, and most preferably ≤ -5.40 eV.

According to an embodiment, Copper(II) bis(trifluoromethylsulfonyl)imide as second metal compound is excluded.

According to an embodiment, metal sulfonylimide as second metal compound is excluded.

According to an embodiment, Copper(II) bis(trifluoromethylsulfonyl)imide as second metal compound is excluded and metal sulfonylimide as second metal compound is excluded.

According to an embodiment, wherein the compound of formula (XI) is excluded as a second metal compound: 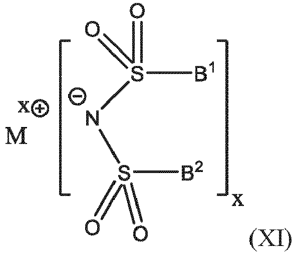
M is a metal;
X is the valency of M;
B¹ and B² is any substituent.

According to an embodiment, wherein the compound of formula (XI) is excluded as a second metal compound: 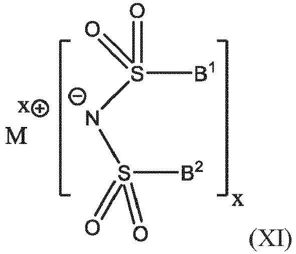
M is a metal;
X is the valency of M;
B¹ and B² is any substituent; and Copper(II) bis(trifluoromethylsulfonyl)imide as second metal compound is excluded and/or metal sulfonylimide as second metal compound is excluded.

According to an embodiment, the monoanion or monoanionic ligand is selected from L1 to L54, L55 to L265, L316 to L327, L328 to L330, L331 to L405, L406 to 518.

According to a preferred embodiment, the monoanion or monoanionic ligand is selected from L1 to L54, L55 to L265, L331 to L405, and L406 to 518.

According to a more preferred embodiment, the monoanion or monoanionic ligand is selected from L1 to L54.

### Ancillary ligand (AL)

Ancillary ligands are defined as those ligands that provide the appropriate steric and electronic environment around the central element but may remain innocent in any transformation that the compound undergoes. In contrast, reactive ligands are those groups that undergo changes.

According to an embodiment, wherein the first metal compound and/or the second metal compound may comprise an ancillary ligand (AL). According to an embodiment, wherein the first metal compound and/or the second metal compound may comprise an ancillary ligand (AL), which coordinates to the metal cation or the metal cation M^{p+}. According to an embodiment, wherein the first metal compound and/or the second metal compound represented by formula (II), comprises an ancillary ligand (AL). According to an embodiment, wherein the first metal compound and/or the second metal compound represented by formula (II), comprises an ancillary ligand (AL) ), which coordinates to the metal cation or the metal cation M^{p+}.

According to one embodiment, wherein the ancillary ligand (AL) is selected from the group comprising H₂O, C₂ to C₄₀ mono- or multi-dentate ethers and C₂ to C₄₀ thioethers, C₂ to C₄₀ amines, C₂ to C₄₀ phosphine, C₂ to C₂₀ alkyl nitrile, C₂ to C₄₀ aryl nitrile, or a compound according to Formula (X): 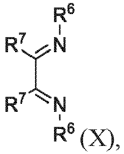 wherein
R⁶ and R⁷ are independently selected from C₁ to C₂₀ alkyl, C₁ to C₂₀ heteroalkyl, C₆ to C₂₀ aryl, heteroaryl with 5 to 20 ring-forming atoms, halogenated or perhalogenated C₁ to C₂₀ alkyl, halogenated or perhalogenated C₁ to C₂₀ heteroalkyl, halogenated or perhalogenated C₆ to C₂₀ aryl, halogenated or perhalogenated heteroaryl with 5 to 20 ring-forming atoms, or at least one R⁶ and R⁷ are bridged and form a 5 to 20 member ring, or the two R⁶ and/or the two R⁷ are bridged and form a 5 to 40 member ring or form a 5 to 40 member ring comprising an unsubstituted or C₁ to C₁₂ substituted phenanthroline.

According to an embodiment, second metal compound of formula (II) may be present in the hole injection layer in an amount of ≤ 99.9 wt.% based on the total weight of the hole injection layer, preferably ≤ 99.0 wt.%, more preferably ≤ 95.0 wt.%, more preferably ≤ 90.0 wt.%, more preferably ≤ 80.0 wt.%, more preferably ≤ 70.0 wt.%, more preferably ≤ 60.0 wt.%, more preferably ≤ 50.0 wt.%, more preferably ≤ 40.0 wt.%, more preferably ≤ 30.0 wt.%, more preferably ≤ 20.0 wt.%, more preferably ≤ 10.0 wt.-%, more preferably ≤ 5.0 wt.%, more preferably ≤ 3.0 wt.%.

According to one embodiment, the second metal compound of formula (II) may be present in the p-type charge generation layer in an amount of ≤99.9 wt.-% based on the total weight of the p-type charge generation layer, preferably ≤99 wt.-%, more preferably ≤95 wt.-%, more preferably ≤90 wt.-%, more preferably ≤80 wt.-%, more preferably ≤70 wt.-%, more preferably ≤60 wt.-%, more preferably ≤50 wt.-%, more preferably ≤40 wt.-%, more preferably ≤30 wt.-%, more preferably ≤20 wt.%, more preferably ≤ 10 wt.-%, more preferably ≤ 5 wt.-%

According to an embodiment, a hole transport matrix compound may be present in the first p-type charge generation layer in an amount of ≥ 0.1 wt.% based on the total weight of the hole injection layer, preferably ≥ 1.0 wt.%, more preferably ≥ 5.0 wt.%, more preferably ≥ 10.0 wt.%, more preferably ≥ 20.0 wt.%, more preferably ≥ 30.0 wt.%, more preferably ≥ 40.0 wt.%, more preferably ≥ 50 wt.%, more preferably ≥ 60 wt.%, more preferably ≥ 70 wt.%, more preferably ≥ 80 wt.%, more preferably ≥ 90 wt.%, more preferably ≥ 95 wt.%, more preferably ≥ 97.0 wt.%, more preferably ≥ 97.75 wt.%, more preferably ≥ 96 wt.%, and most preferably ≥ 97.0 wt.%.

According to one embodiment, the hole transport matrix compound may be present in the first p-type charge generation layer in an amount of ≥ 0.1 wt.-%, based on the total weight of the p-type charge generation layer, preferably ≥ 1 wt.-%, more preferably ≥ 5 wt.-%, more preferably ≥ 10 wt.-%, more preferably ≥ 20 wt.-%, more preferably ≥ 30 wt.%, more preferably ≥ 40 wt.-%, more preferably ≥ 50 wt.-%, more preferably ≥ 60 wt.-%, more preferably ≥70 wt.-%, more preferably ≥ 80 wt.-%, more preferably ≥ 90 wt.-%, more preferably ≥ 95 wt.-%, based on the total weight of the p-type charge generation layer.

### Metal compound of formula (II)

The first metal compound, the second metal compound and the compound of formula (II) can be selected from the following compounds M1 to M9:

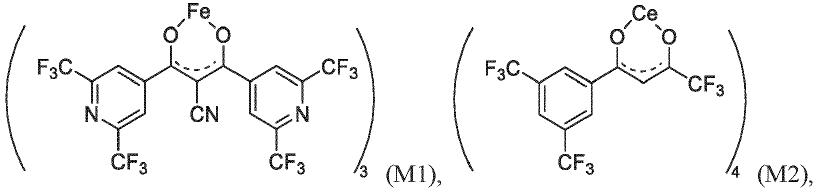

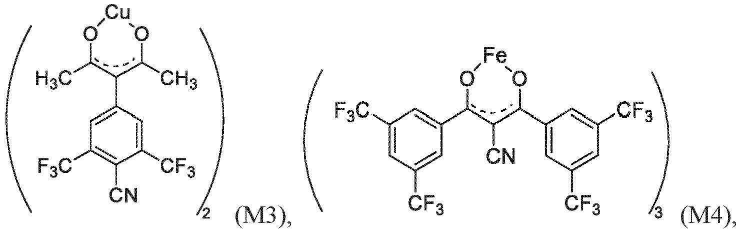

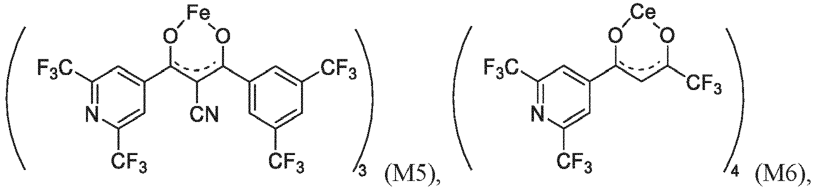

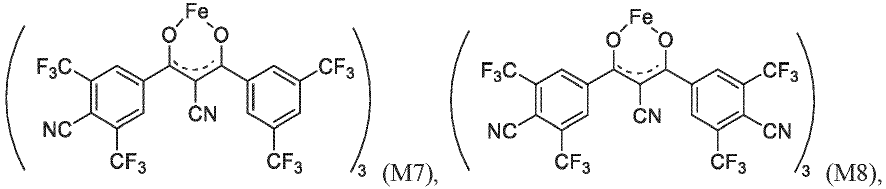

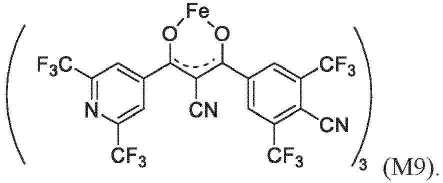

### Hole transport matrix compound

According to one embodiment, the hole transport matrix compound is a substantially covalent matrix compound. According to one embodiment, the hole transport matrix compound is an organic hole transport matrix compound. According to one embodiment, the hole transport matrix compound is a substantially covalent organic matrix compound. According to one embodiment, the hole transport matrix compound of the p-type charge generation layer is a substantially covalent matrix compound. According to one embodiment, the organic hole transport matrix compound of the charge generation layer may be the same as the organic hole transport matrix compound of the p-type charge generation layer.

According to one embodiment, wherein the hole injection layer and the first p-type charge generation layer each further comprises a hole transport matrix compound, wherein the hole transport matrix compound is selected same or different.

According to one embodiment the hole injection layer comprises a hole transport matrix compound, also named "first hole transport matrix compound".

According to one embodiment the first p-type charge generation layer comprises a hole transport matrix compound, also named "second hole transport matrix compound".

The hole transport matrix compound, also named "first hole transport matrix compound and second hole transport matrix compound" herein, may comprises at least one arylamine compound, diarylamine compound, triarylamine compound, a compound of formula (XV) or a compound of formula (XVI): 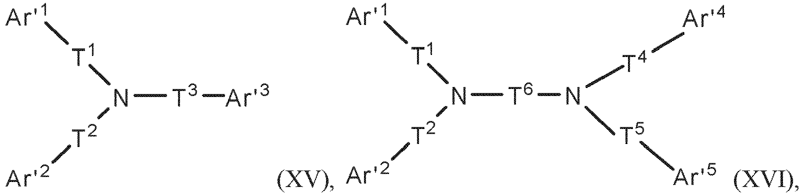 wherein:
T¹, T², T³, T⁴ and T⁵ are independently selected from a single bond, phenylene, biphenylene, terphenylene or naphthenylene, preferably a single bond or phenylene;
T⁶ is phenylene, biphenylene, terphenylene or naphthenylene;
Ar'¹, Ar'², Ar'³, Ar'⁴ and Ar'⁵are independently selected from substituted or unsubstituted C₆ to C₂₀ aryl, or substituted or unsubstituted C₃ to C₂₀ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi [fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein the substituents of Ar'¹, Ar'², Ar'³, Ar'⁴ and Ar'⁵ are selected the same or different from the group comprising H, D, F, C(=O)R'², CN, Si(R'²)₃, P(=O)(R'²)₂, OR'², S(=O)R'², S(=O)₂R'², substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted C₆ to C₁₈ aryl, unsubstituted C₃ to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein R'² may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl or C₃ to C₁₈ heteroaryl.

According to an embodiment wherein T1, T², T³, T⁴ and T⁵ may be independently selected from a single bond, phenylene, biphenylene or terphenylene. According to an embodiment wherein T¹, T², T³, T⁴ and T⁵ may be independently selected from phenylene, biphenylene or terphenylene and one of T¹, T², T³, T⁴ and T⁵ are a single bond. According to an embodiment wherein T¹, T², T³, T⁴ and T⁵ may be independently selected from phenylene or biphenylene and one of T¹, T², T³, T⁴ and T⁵ are a single bond. According to an embodiment wherein T¹, T², T³, T⁴ and T⁵ may be independently selected from phenylene or biphenylene and two of T¹, T², T³, T⁴ and T⁵ are a single bond.

According to an embodiment wherein T¹, T² and T³ may be independently selected from phenylene and one of T¹, T² and T³ are a single bond. According to an embodiment wherein T¹, T² and T³ may be independently selected from phenylene and two of T¹, T² and T³ are a single bond.

According to an embodiment wherein T⁶ may be phenylene, biphenylene, terphenylene. According to an embodiment wherein T⁶ may be phenylene. According to an embodiment wherein T⁶ may be biphenylene. According to an embodiment wherein T⁶ may be terphenylene.

According to an embodiment wherein Ar'¹, Ar'², Ar'³, Ar'⁴ and Ar'⁵ may be independently selected from E1 to E16: 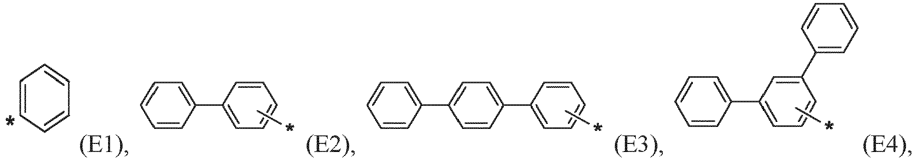 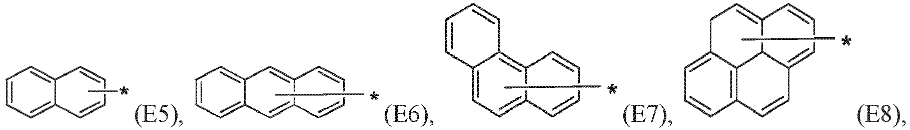 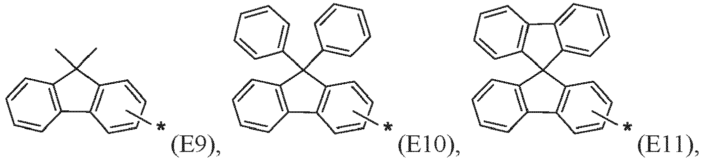 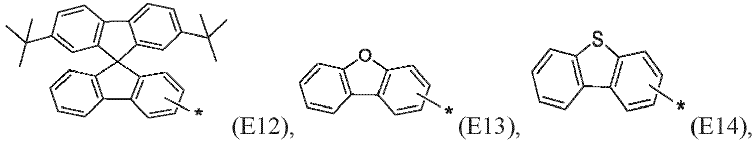 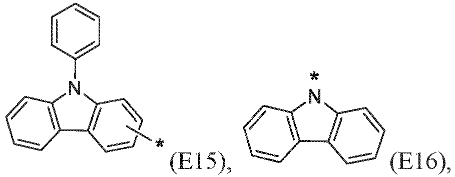 wherein the asterix "*" denotes the binding position.

According to an embodiment, wherein Ar'¹, Ar'², Ar'³, Ar'⁴ and Ar'⁵ may be independently selected from E1 to E15; alternatively selected from E1 to E10 and E13 to E15.

According to an embodiment, wherein Ar'¹, Ar'², Ar'³, Ar'⁴ and Ar'⁵ may be independently selected from the group consisting of E1, E2, E5, E7, E9, E10, E13 to E16.

The rate onset temperature may be in a range particularly suited to mass production, when Ar'¹, Ar'², Ar'³, Ar'⁴ and Ar'⁵ are selected in this range.

The "matrix compound of formula (XV) or formula (XVI)" may be also referred to as "hole transport compound" or "first hole transport matrix compound and second hole transport matrix compound".

According to one embodiment, the hole transport compound comprises at least one naphthyl group, carbazole group, dibenzofuran group, dibenzothiophene group and/or substituted fluorenyl group, wherein the substituents are independently selected from methyl, phenyl or fluorenyl.

According to one embodiment, the first hole transport matrix compound and the second hole transport matrix compound are independently of each other selected same or different from the group comprising of compounds F1 to F20:

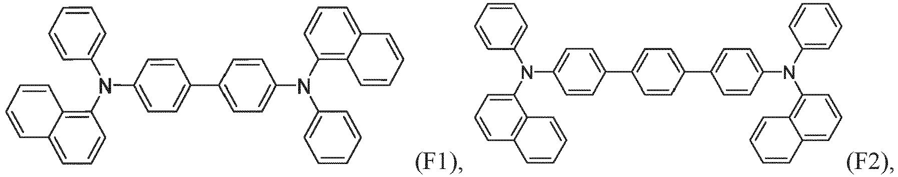

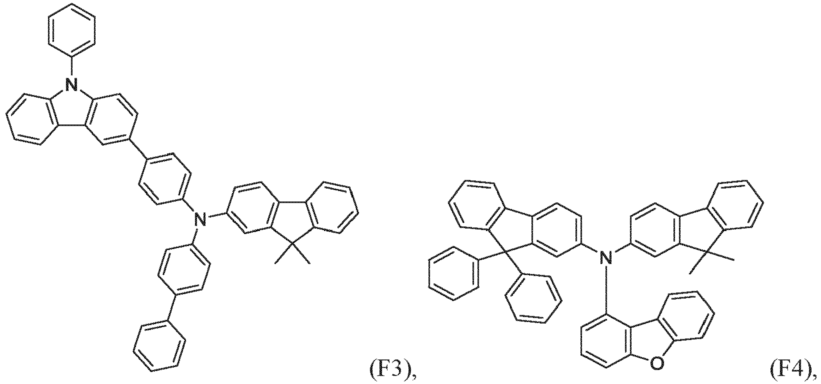

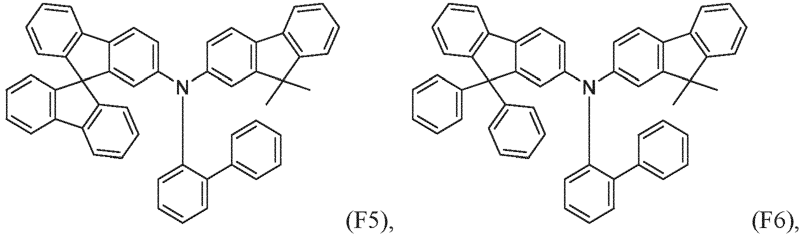

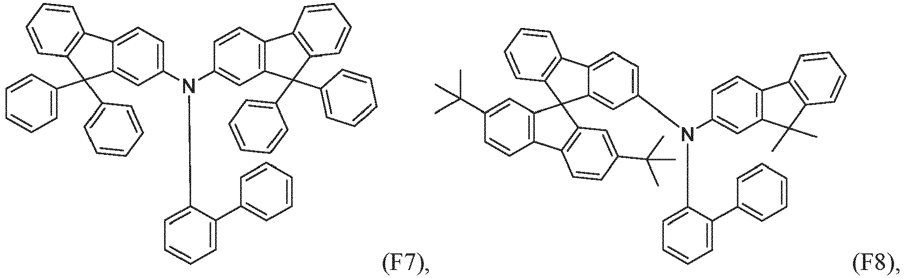

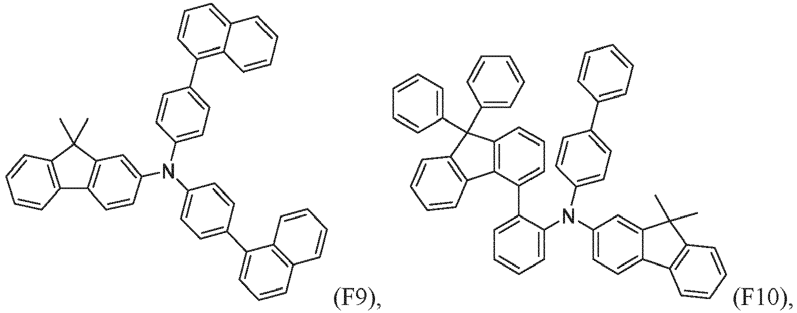

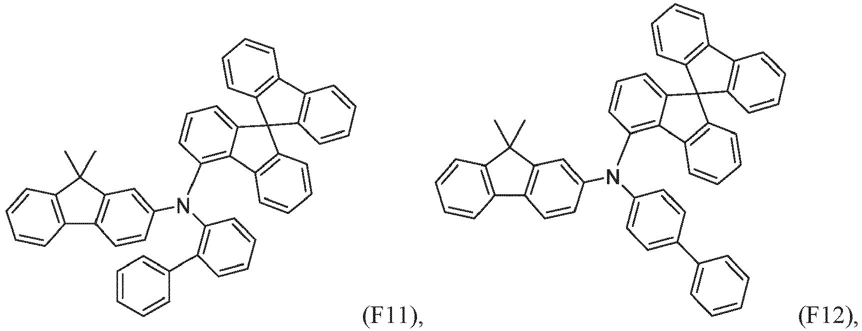

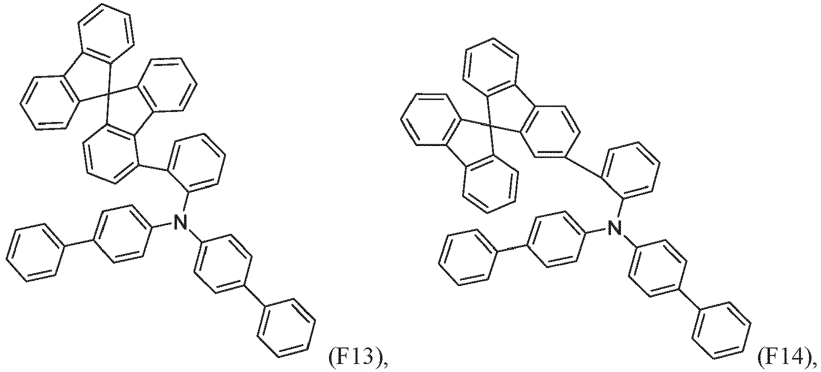

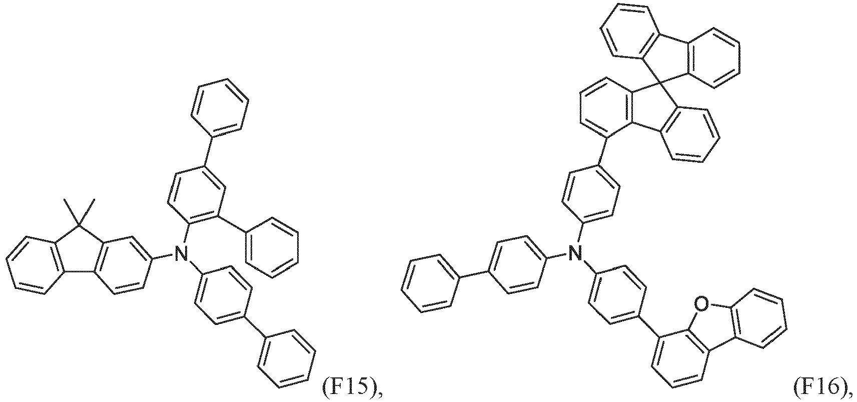

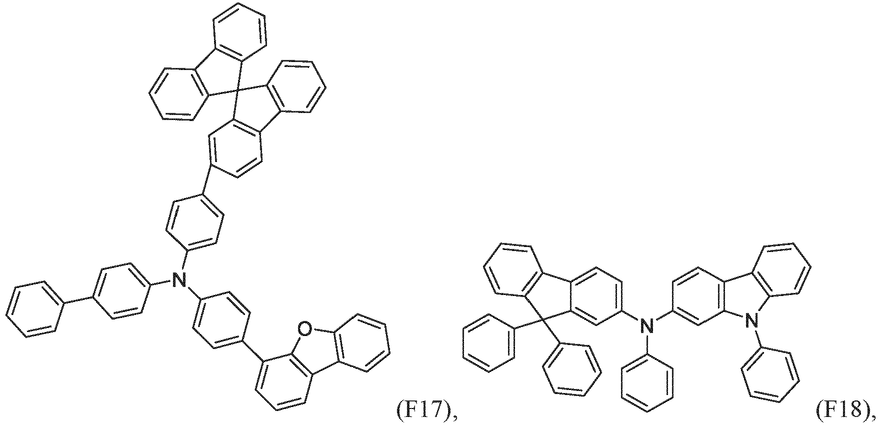

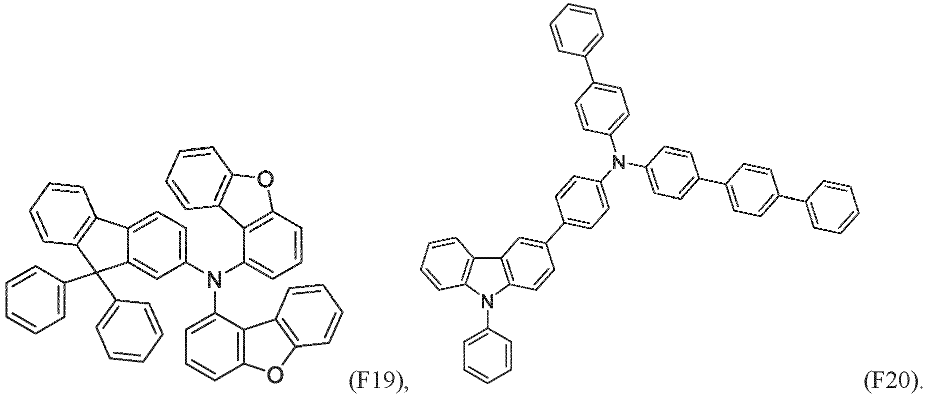

According to one embodiment, the hole transport matrix compound may have a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and ≤ 900 g/mol, also preferred a molecular weight Mw of ≥ 600 and ≤ 800 g/mol.

According to one embodiment, the hole transport matrix compound of the first p-type charge generation layer may have a calculated HOMO energy level, expressed in the absolute scale referring to vacuum energy level being zero, in the range of ≤ -4.27 eV to ≥ -5.1 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, preferably ≤ -4.3 eV to ≥ -5.0 eV, more preferably ≤ -4.4 eV and ≥ -5.0 eV, more preferably ≤ -4.5 eV and ≥ -5.0 eV, more preferably ≤ -4.5 eV and ≥ -4.9 eV and most preferably ≤ -4.6 eV and ≥ -4.9 eV.

### Layer

According to one embodiment, the organic electroluminescent device further comprises a third emission layer.

According to one embodiment, between the first emission layer and the second emission layer no more then one charge generation layer is arranged, in particular no more then one charge generation layer comprising a p-type charge generation layer and an n-type charge generation layer.

According to one embodiment, the second emission layer and the third emission layer, no more then one charge generation layer is arranged, in particular no more then one charge generation layer comprising a p-type charge generation layer and an n-type charge generation layer.

According to one embodiment, a third emission layer and a second charge generation layer, wherein the second charge generation layer is arranged between the second emission layer and the third emission layer, wherein the second charge generation layer comprises a second p-type charge generation layer and a second n-type charge generation layer, wherein the second n-type charge generation layer is closer to the anode layer then the second p-type charge generation layer,
wherein the second n-type charge generation layer comprises a metal dopant and a matrix compound,
wherein the second p-type charge generation layer comprises a hole transport matrix compound.

According to one embodiment, the organic electroluminescent device further comprises a third emission layer and a fourth emission layer.

According to one embodiment, the organic electroluminescent device comprises a third emission layer, a fourth emission layer, a second charge generation layer, and third charge generation layer, wherein the second charge generation layer is arranged between the second emission layer and the third emission layer, wherein the third charge generation layer is arranged between the third and the fourth emission layer,wherein the second charge generation layer comprises a second p-type charge generation layer and a second n-type charge generation layer,
wherein the third charge generation layer comprises a third p-type charge generation layer and a third n-type charge generation layer,
wherein the second n-type charge generation layer is closer to the anode layer then the second p-type charge generation layer,
wherein the third n-type charge generation layer is closer to the anode layer then the third p-type charge generation layer,
wherein the second n-type charge generation layer comprises a metal dopant and an organic electron transport,
wherein the third n-type charge generation layer comprises a metal dopant and an organic electron transport,
wherein the second p-type charge generation layer comprises a hole transport matrix compound,
wherein the third p-type charge generation layer comprises a hole transport matrix compound.

According to an embodiment, the organic electroluminescent device further comprises a layer selected from hole injection layer, hole transport layer, electron blocking layer, a hole blocking layer, an electron transport layer, and an electron injection layer.

According to an embodiment, the organic electroluminescent device further comprises a hole injection layer, a first hole transport layer, a second hole transport layer, first electron blocking layer, second electron blocking layer, optionally a first hole blocking layer, optionally a second hole blocking layer, a first electron transport layer, a second electron transport layer, and an electron injection layer.

According to one embodiment, the first n-type charge generation layer is in direct contact to the first p-type charge generation layer.

According to one embodiment, the second n-type charge generation layer is in direct contact to the second p-type charge generation layer.

According to one embodiment, the third n-type charge generation layer is in direct contact to the third p-type charge generation layer.

According to one embodiment, each of the at least two light-emitting units comprises an electron transport layer.

According to one embodiment, the organic electroluminescent device further comprises an electron transport layer, wherein the electron transport layer is arranged between the first emission layer and the second emission layer, wherein the electron transport layer is arranged in direct contact to the first n-type charge generation layer, and wherein the electron transport layer is arranged between the first emission layer and the first n-type charge generation layer..

According to one embodiment, the organic electroluminescent device further comprises an electron transport layer, wherein the electron transport layer is arranged between the first emission layer and the second emission layer, wherein the electron transport layer is arranged in direct contact to the first n-type charge generation layer, and wherein the electron transport layer is arranged between the first emission layer and the first n-type charge generation layer, and wherein the first n-type charge generation layer is in direct contact to the to the first p-type charge generation layer.

According to one embodiment, the organic electroluminescent device comprises at least one electron injection layer (EIL).

According to one embodiment, the electron injection layer is in direct contact to the cathode layer.

### n-type charge generation layer

According to an embodiment, wherein the n-type charge generation layer comprises an organic electron transport matrix compound and a metal dopant.

According to one embodiment, the organic electron transport matrix compound of the first n-type charge generation layer is an electron transport material.

According to one embodiment, the organic electron transport matrix compound of the first n-type charge generation layer comprises at least one C₂ to C₂₄ N-heteroaryl or P=X group, with X being O, P, Se, with P=O especially preferred.

According to an embodiment, the at least one C₂ to C₂₄ N-heteroaryl may be selected from a compound comprising at least one azine group, preferably at least two azine groups, also preferred three azine groups.

According to an embodiment, the organic electron transport matrix compound of the first n-type charge generation layer comprises at least one group selected from the list consisting of pyridine, pyrimidine, triazine, imidazole, benzimidazole, benzooxazole, quinone, benzoquinone, imidazo[1,5-*α*]pyridine, quinoxaline, benzoquinoxaline, acridine, phenanthroline, benzoacridine, dibenzoacridine phosphine oxide, terpyridine.

According to an embodiment, the organic electron transport matrix compound of the first n-type charge generation layer comprises at least one phenanthroline group, preferably two phenanthroline groups, one or more pyridine groups, one or more pyrimidine groups, one or more triazine groups, one or more imidazo[1,5-cz]pyridine groups, or one or more phosphine oxide groups.

According to an embodiment, the organic electron transport matrix compound of the first n-type charge generation layer comprises at least one phenanthroline group, preferably two phenanthroline groups, one or more pyridine groups, one or more pyrimidine groups, or one or more phosphine oxide groups.

According to an embodiment, the organic electron transport matrix compound of the first n-type charge generation layer comprises at least one phenanthroline group, preferably two phenanthroline groups, a pyridine group, a pyrimidine groups, or a phosphine oxide group.

According to an embodiment, the organic electron transport matrix compound of the first n-type charge generation layer comprises at least one phenanthroline group, preferably two phenanthroline groups, one or more pyridine groups, one or more pyrimidine groups, one or more triazine groups.

According to an embodiment, the organic electron transport matrix compound of the first n-type charge generation layer is selected from the group comprising 2,2'-(1,3-Phenylene)bis[9-phenyl-1,10-phenanthroline], (3-(10-(3-(2,6-diphenylpyrimidin-4-yl)phenyl)anthracen-9-yl)phenyl)dimethylphosphine oxide, 3-(3-(9,10-diphenylanthracen-2-yl)phenyl)-1-(pyridin-2-yl)imidazo[1,5-a]pyridine, 7-(3-(1,10-phenanthrolin-2-yl)phenyl)dibenzo[c,h]acridine, 7-(3-([2,2':6',2"-terpyridin]-4'-yl)phenyl)dibenzo[c,h]acridine, 4'-(4'-(4,6-diphenyl-1,3,5-triazin-2-yl)-[1,1'-biphenyl]-4-yl)-2,2':6',2"-terpyridine, 4'-(4-(fluoranthen-3-yl)phenyl)-2,2':6',2"-terpyridine, or 3-(9,10-di-2-naphthalenyl-2-anthracenyl)phenyl]dimethylphosphine oxide.

According to an embodiment, the organic electron transport matrix compound of the first n-type charge generation layer comprises at least one phenanthroline group, preferably two phenanthroline groups.

According to one embodiment, the metal dopant is selected from a metal with an electronegativity of ≤ 1.4 eV by Pauling scale or a metal alloy comprising a metal with an electronegativity of ≤ 1.4 eV by Pauling scale.

According to an embodiment, wherein the metal dopant is selected from a metal with an electronegativity of ≤ 1.4 eV by Pauling scale, more preferably ≤ 1.35 eV.

According to one embodiment, the metal dopant is selected from a metal with an electronegativity of ≤ 1.35 eV by Pauling scale or a metal alloy comprising a metal with an electronegativity of ≤ 1.35 eV by Pauling scale.

According to one embodiment, the metal dopant is a metal selected from the group consisting of Li, Na, K, Rb, Cs, Mg, Ca, Sr, Ba, Sm, Eu and Yb or a metal alloy comprising a metal selected from the group consisting of Li, Na, K, Rb, Cs, Mg, Ca, Sr, Ba, Sm, Eu and Yb.

According to one embodiment, the metal dopant is a metal selected from the group consisting of Li, Na, K, Cs, Mg, Ca, Ba, Sm, Eu and Yb or a metal alloy comprising a metal selected from the group consisting of Li, Na, K, Cs, Mg, Ca, Ba, Sm, Eu and Yb.

According to one embodiment, the metal dopant is a metal selected from the group consisting of Li, Mg and Yb or a metal alloy comprising a metal selected from the group consisting of Li, Mg and Yb.

According to one embodiment, wherein the metal dopant of the first n-type charge generation layer is a metal selected from the group consisting of Li, Mg and Yb or a metal alloy comprising a metal selected from the group consisting of Li, Mg and Yb.

According to one embodiment, the metal dopant is a metal selected from the group consisting of Li and Yb or a metal alloy comprising a metal selected from the group consisting of Li, and Yb.

According to one embodiment, the metal dopant is Yb or a metal alloy comprising a metal selected from the group consisting of Li and Yb.

According to one embodiment, the metal dopant is Yb.

According to one embodiment, the metal dopant is in the oxidations state ±0.

According to one embodiment, the metal dopant is present in the first n-type charge generation layer in an amount of ≤ 99.9 vol% based on the total volume of the layer, preferably ≤ 99 vol%, more preferably ≤ 95 vol%, more preferably ≤ 90 vol%, more preferably ≤80 vol%, more preferably ≤ 70 vol%, more preferably ≤ 60 vol% , more preferably ≤ 50 vol%, more preferably ≤ 40 vol%, more preferably ≤ 30 vol%, more preferably ≤ 20 vol%, more preferably ≤ 10 vol%, more preferably ≤ 5 vol% , more preferably ≤ 3.0 vol%, more preferably ≤ 2 vol%, more preferably ≤ 1.5 vol%, more preferably ≤ 1.25 vol%, and most preferably ≤ 1.0 vol%.

According to one embodiment, the organic electron transport matrix compound is present in the first n-type charge generation layer in an amount of ≥ 0.1 vol% based on the total volume of the layer, preferably ≥ 1 vol%, more preferably ≥ 5 vol%, more preferably ≥ 10 vol%, more preferably ≥ 20 vol%, more preferably ≥3 0 vol%, more preferably ≥ 40 vol%, more preferably ≥ 50 vol%, more preferably ≥ 60 vol%, more preferably ≥ 70 vol%, more preferably ≥ 80 vol%, more preferably ≥ 90 vol%, more preferably ≥ 95 vol%, more preferably ≥ 97.0 vol%, more preferably ≥ 98 vol%, more preferably ≥ 98.25 vol%, more preferably ≥ 98.5 vol%, more preferably ≥ 98.75 vol% and most preferably ≥ 99.0 vol%.

### p-type charge generation layer

The p-type charge generation layer may be formed on the anode layer or cathode layer by vacuum deposition, spin coating, printing, casting, slot-die coating, Langmuir-Blodgett (LB) deposition, or the like. When the p-type charge generation layer is formed using vacuum deposition, the deposition conditions may vary according to the compound(s) that are used to form the layer, and the desired structure and thermal properties of the layer. In general, however, conditions for vacuum deposition may include a deposition temperature of 100° C to 350° C, a pressure of 10⁻⁸ to 10⁻³ Torr (1 Torr equals 133.322 Pa), and a deposition rate of 0.1 to 10 nm/sec.

When the a p-type charge generation layer is formed using spin coating or printing, coating conditions may vary according to the compound(s) that are used to form the layer, and the desired structure and thermal properties of the organic semiconductor layer. For example, the coating conditions may include a coating speed of about 2000 rpm to about 5000 rpm, and a thermal treatment temperature of about 80° C to about 200° C. Thermal treatment removes a solvent after the coating is performed.

The thickness of the p-type charge generation layer may be in the range from about 1 nm to about 20 nm, and for example, from about 2 nm to about 15 nm, alternatively about 2 nm to about 12 nm.

### Charge generation layer

The organic electronic device according to the present invention comprise a charge generation layer, wherein the charge generation layer comprises a p-type charge generation layer, wherein the p-type charge generation layer is an organic semiconductor layer according to the invention. The charge generation layer may be arranged between two photoactive layer.

The organic electronic device according to the present invention may further comprise a charge generation layer, wherein the charge generation layer comprises a p-type charge generation layer, wherein the p-type charge generation layer is an organic semiconductor layer according to the invention, wherein the p-type charge generation layer is arranged closer to the cathode layer.

The organic electronic device according to the present invention may further comprise a charge generation layer, wherein the charge generation layer comprises a p-type charge generation layer, wherein the p-type charge generation layer is an organic semiconductor layer according to the invention, wherein the charge generation layer is arranged between two photoactive layer.

The charge generation layer may further comprise an n-type charge generation layer, wherein the n-type charge generation layer is arranged between the p-type charge generation layer and the anode layer, and wherein the p-type charge generation layer is arranged closer to the cathode layer than the n-type charge generation layer.

Preferably, the n-type charge generation layer and the p-type charge generation layer are arranged in direct contact.

The thickness of the n-type charge generation layer may be in the range from about 0.5 nm to about 15 nm, for example, in the range from about 1 nm to about 10 nm. When the thickness of the n-type charge generation layer is within this range, the EIL may have satisfactory electron-injecting properties, without a substantial penalty in driving voltage.

The n-type charge generation layer may comprise a metal dopant, wherein the metal dopant is selected from an alkali metal, alkaline earth metal or rare earth metal.

The n-type charge generation layer may comprise an azine compound. According to a preferred embodiment, the nCGL may comprise an azine compound and a metal dopant, wherein the metal dopant is selected from an alkali metal, alkaline earth metal or rare earth metal.

According to one embodiment of the present invention, the p-type and/or n-type charge generation layer and/or the Ce(IV) metal complex are non-emissive.

In the context of the present specification the term "essentially non-emissive" or "non-emissive" means that the contribution of organic electron transport compound, the organic hole transport compound, the organic hole transport compound, the Ce(IV) metal complex and/or layer, the p-type charge generation layer, as well as the n-type charge generation layer, to the visible emission spectrum from an organic electronic device, such as OLED or display device, is less than 10 %, preferably less than 5 % relative to the visible emission spectrum. The visible emission spectrum is an emission spectrum with a wavelength of about ≥ 380 nm to about ≤ 780 nm.

### Charge generation connecting layer

According to one embodiment, the charge generation layer (CGL) may further comprise a charge generation connecting layer (c-CGL), wherein the charge generation connecting layer is arranged between the n-type charge generation layer and the p-type charge generation layer. Preferably, the charge generation connecting layer is in direct contact with the n-type charge generation layer and the p-type charge generation layer.

The charge generation connecting layer may comprise or consist of a conductive compound.

According to an embodiment, the conductive compound is selected from HAT-CN or a metal complex, preferably metal phthalocyanine, zinc phthalocyanine (ZnPc) or copper phthalocyanine (CuPc).

The thickness of the charge generation connecting layer may be selected between about 0.5 and 5 nm, preferably 1 and 2.5 nm.

### Hole injection layer

A hole injection layer (HIL) may be formed on the anode layer by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of 10⁻⁸ to 10⁻³ Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

According to an embodiment, a hole transport matrix compound may be present in the hole injection layer in an amount of ≥ 0.1 wt.% based on the total weight of the hole injection layer, preferably ≥ 1.0 wt.%, more preferably ≥ 5.0 wt.%, more preferably ≥ 10.0 wt.%, more preferably ≥ 20.0 wt.%, more preferably ≥ 30.0 wt.%, more preferably ≥ 40.0 wt.%, more preferably ≥ 50 wt.%, more preferably ≥ 60 wt.%, more preferably ≥ 70 wt.%, more preferably ≥ 80 wt.%, more preferably ≥ 90 wt.%, more preferably ≥ 95 wt.%, more preferably ≥ 96 wt.%, and most preferably ≥ 97.0 wt.%.

According to one embodiment, the hole transport matrix compound of the hole injection layer may have a calculated HOMO energy level, expressed in the absolute scale referring to vacuum energy level being zero, in the range of ≤ -4.27 eV to ≥ -5.1 eV, when calculated with the program package TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, preferably ≤ -4.3 eV to ≥ -5.0 eV, more preferably ≤ -4.4 eV and ≥ -5.0 eV, more preferably ≤ -4.5 eV and ≥ -5.0 eV, more preferably ≤ -4.5 eV and ≥ -4.9 eV and most preferably ≤ -4.6 eV and ≥ -4.9 eV.

### Further layers

In accordance with the invention, the organic electronic device may comprise, besides the layers already mentioned above, further layers. Exemplary embodiments of respective layers are described in the following:

### Substrate

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate, a silicon substrate or a backplane.

### Anode layer

The anode layer may be formed by depositing or sputtering a material that is used to form the anode layer. The material used to form the anode layer may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode electrode. The anode layer may also be formed using metals, typically silver (Ag), gold (Au), or metal alloys.

According to one embodiment of the present invention, the anode layer comprises a first anode sub-layer and a second anode sub-layer, wherein
- the first anode sub-layer comprises a first metal having a work function in the range of ≥ 4 and ≤ 6 eV, and
- the second anode sub-layer comprises a transparent conductive oxide; and
- the second anode sub-layer is arranged closer to the hole injection layer.

According to one embodiment of the present invention, the first metal of the first anode sub-layer may be selected from the group comprising Ag, Mg, Al, Cr, Pt, Au, Pd, Ni, Nd, Ir, preferably Ag, Au or Al, and more preferred Ag.

According to one embodiment of the present invention, the first anode sub-layer has have a thickness in the range of 5 to 200 nm, alternatively 8 to 180 nm, alternatively 8 to 150 nm, alternatively 100 to 150 nm.

According to one embodiment of the present invention, the first anode sub-layer is formed by depositing the first metal via vacuum thermal evaporation.

It is to be understood that the first anode layer is not part of the substrate.

According to one embodiment of the present invention, the transparent conductive oxide of the second anode sub layer is selected from the group selected from the group comprising indium tin oxide or indium zinc oxide, more preferred indium tin oxide.

According to one embodiment of the present invention, the second anode sub-layer may has a thickness in the range of 3 to 200 nm, alternatively 3 to 180 nm, alternatively 3 to 150 nm, alternatively 3 to 20 nm.

According to one embodiment of the present invention, the second anode sub-layer may be formed by sputtering of the transparent conductive oxide.

According to one embodiment of the present invention, anode layer of the organic electronic device comprises in addition a third anode sub-layer comprising a transparent conductive oxide, wherein the third anode sub-layer is arranged between the substrate and the first anode sub-layer.

According to one embodiment of the present invention, the third anode sub-layer comprises a transparent oxide, preferably from the group selected from the group comprising indium tin oxide or indium zinc oxide, more preferred indium tin oxide.

According to one embodiment of the present invention, the third anode sub-layer may has a thickness in the range of 3 to 200 nm, alternatively 3 to 180 nm, alternatively 3 to 150 nm, alternatively 3 to 20 nm.

According to one embodiment of the present invention, the third anode sub-layer may be formed by sputtering of the transparent conductive oxide.

It is to be understood that the third anode layer is not part of the substrate.

According to one embodiment of the present invention, the anode layer comprises a first anode sub-layer comprising of Ag, a second anode sub-layer comprising of transparent conductive oxide, preferably ITO, and a third anode sub-layer comprising of transparent conductive oxide, preferably ITO; wherein the first anode sub-layer is arranged between the second and the third anode sub-layer.

### Hole transport layer

According to one embodiment of the present invention, the organic electronic device comprises a hole transport layer, wherein the hole transport layer is arranged between the hole injection layer and the at least one first emission layer.

The hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 110 nm to about 140 nm.

When the thickness of the HTL is within this range, the HTL may have excellent hole transporting characteristics, without a substantial penalty in driving voltage.

### Electron blocking layer

The function of an electron blocking layer (EBL) is to prevent electrons from being transferred from an emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

### Photoactive layer (PAL)

The photoactive layer converts an electrical current into photons or photons into an electrical current. The PAL may be formed on the HTL by vacuum deposition, spin coating, slot-die coating, printing, casting, LB deposition, or the like. When the PAL is formed using vacuum deposition or spin coating, the conditions for deposition and coating may be similar to those for the formation of the HIL. However, the conditions for deposition and coating may vary, according to the compound that is used to form the PAL. It may be provided that the photoactive layer does not comprise the a metal complex according to formula (I). The photoactive layer may be a light-emitting layer or a light-absorbing layer.

### Emission layer (EML)

The EML may be formed on the HTL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

According to one embodiment of the present invention, the emission layer does not comprise the compound of formula (I).

The emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), di styryl arylene (DSA) and bis(2-(2-hydroxyphenyl)benzothiazolate)zinc (Zn(BTZ)2).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2lr(acac), but are not limited thereto. These compounds are phosphorescent emitters, however, fluorescent red emitter dopants could also be used.

Examples of phosphorescent green emitter dopants are Ir(ppy)3 (ppy = phenylpyridine), Ir(ppy)2(acac), Ir(mpyp)3.

Examples of phosphorescent blue emitter dopants are F2Irpic, (F2ppy)2Ir(tmd) and Ir(dfppz)3 and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

### Hole blocking layer (HBL)

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, phenanthroline derivatives and azine derivatives, preferably triazine or pyrimidine derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

### Electron transport layer (ETL)

The organic electronic device according to the present invention may further comprise an electron transport layer (ETL).

According to another embodiment of the present invention, the electron transport layer may further comprise an azine compound, preferably a triazine compound.

In one embodiment, the electron transport layer may further comprise a dopant selected from an alkali organic complex, preferably LiQ.

The thickness of the ETL may be in the range from about 15 nm to about 50 nm, for example, in the range from about 20 nm to about 40 nm. When the thickness of the EII, is within this range, the ETL may have satisfactory electron-injecting properties, without a substantial penalty in driving voltage.

According to another embodiment of the present invention, the organic electronic device may further comprise a hole blocking layer and an electron transport layer, wherein the hole blocking layer and the electron transport layer comprise an azine compound. Preferably, the azine compound is a triazine compound.

### Electron injection layer (EIL)

An optional EIL, which may facilitate injection of electrons from the cathode, may be formed on the ETL, preferably directly on the electron transport layer. Examples of materials for forming the EIL include lithium 8-hydroxyquinolinolate (LiQ), LiF, NaCl, CsF, Li2O, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

### Cathode layer

The cathode layer is formed on the ETL or optional EIL. The cathode layer may be formed of a metal, an alloy, an electrically conductive compound, or a mixture thereof. The cathode electrode may have a low work function. For example, the cathode layer may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode electrode may be formed of a transparent conductive oxide, such as ITO or IZO.

The thickness of the cathode layer may be in the range from about 5 nm to about 1000 nm, for example, in the range from about 10 nm to about 100 nm. When the thickness of the cathode layer is in the range from about 5 nm to about 50 nm, the cathode layer may be transparent or semitransparent even if formed from a metal or metal alloy.

According to a preferred embodiment of the invention, the display device comprising an organic electroluminescent device according to the present invention, wherein the cathode layer is transparent.

It is to be understood that the cathode layer is not part of an electron injection layer or the electron transport layer.

### Organic light-emitting diode (OLED)

The organic electronic device according to the invention may be an organic light-emitting device.

According to an embodiment, wherein the organic light-emitting device comprises a substrate, an anode layer, formed on the substrate, a hole injection layer, a hole transport layer, an emission layer, an electron transport layer, and a cathode layer.

According to an embodiment, wherein the organic light-emitting device comprises a substrate, an anode layer, formed on the substrate, a hole injection layer, a hole transport layer, an electron blocking layer, an emission layer, a hole blocking layer, an electron transport layer, and a cathode layer.

According to an embodiment, wherein the organic light-emitting device comprises a substrate, an anode layer, formed on the substrate, a hole injection layer, a hole transport layer, an electron blocking layer, an emission layer, a hole blocking layer, an electron transport layer, an electron injection layer and a cathode layer.

According to an embodiment, the organic light-emitting device may comprise a substrate an anode layer, a hole injection layer, a first hole transport layer, a first electron blocking layer, the first electron blocking layer, a first emission layer, a first electron transport layer, a n-type charge generation layer, a p-type charge generation layer, a second hole transport layer, the a second electron blocking layer, second emission layer, a cathode layer, wherein between the second emission layer and the cathode layer an optional hole blocking layer, optional electron transport layer and/or an optional electron injection layer are arranged.

The organic semiconductor layer according to the invention may be the first hole injection layer and/or the p-type charge generation layer.

According to an embodiment, the organic light-emitting device may comprise a layer structure of a substrate that is adjacent arranged to an anode layer, the anode layer is adjacent arranged to a hole injection layer, the hole injection layer is adjacent arranged to a first hole transport layer, the first hole transport layer is adjacent arranged to a first electron blocking layer, the first electron blocking layer is adjacent arranged to a first emission layer, the first emission layer is adjacent arranged to a first electron transport layer, the first electron transport layer is adjacent arranged to an n-type charge generation layer, the n-type charge generation layer is adjacent arranged to a p-type charge generation layer, the p-type charge generation layer is adjacent arranged to a second hole transport layer, the second hole transport layer is adjacent arranged to a second electron blocking layer, the second electron blocking layer is adjacent arranged to a second emission layer, a cathode layer, wherein between the second emission layer and the cathode layer an optional hole blocking layer, optional electron transport layer and/or an optional electron injection layer are arranged.

The organic semiconductor layer according to the invention may be the first hole injection layer and/or the p-type charge generation layer.

### Method of manufacturing an organic light-emitting device

According to one aspect of the present invention, there is provided an organic light-emitting diode (OLED) comprising: a substrate; an anode layer formed on the substrate; a hole injection layer, a hole transport layer, an emission layer, an electron transport layer and a cathode layer.

According to another aspect of the present invention, there is provided an OLED comprising: a substrate; an anode layer formed on the substrate; a hole injection layer, a hole transport layer, an electron blocking layer, an emission layer, a hole blocking layer, an electron transport layer and a cathode layer.

According to another aspect of the present invention, there is provided an OLED comprising: a substrate; an anode layer formed on the substrate; a hole injection layer, a hole transport layer, an electron blocking layer, an emission layer, a hole blocking layer, an electron transport layer, an electron injection layer, and a cathode layer.

### Method of manufacturing an organic electronic device

The organic electronic device according to the invention may be a light emitting device, or a photovoltaic cell, and preferably a light emitting device.

According to another aspect of the present invention, there is provided a method of manufacturing an organic electronic device, the method using:
- at least one deposition source, preferably two deposition sources and more preferred at least three deposition sources.

The methods for deposition that can be suitable comprise:
- deposition via vacuum thermal evaporation;
- deposition via solution processing, preferably the processing is selected from spin-coating, printing, casting; and/or
- slot-die coating.

According to various embodiments of the present invention, there is provided a method using:
- a first deposition source to release the compound of formula (I) according to the invention, and
- a second deposition source to release the substantially covalent matrix compound;
   the method comprising the steps of forming the hole injection layer; whereby for an organic light-emitting diode (OLED):
- the hole injection layer is formed by releasing the compound of formula (I) according to the invention from the first deposition source and the substantially covalent matrix compound from the second deposition source.

According to various embodiments of the present invention, the method may further include forming on the anode layer, at least one layer selected from the group consisting of forming a hole transport layer or forming a hole blocking layer, and an emission layer between the anode layer and the first electron transport layer.

According to various embodiments of the present invention, the method may further include the steps for forming an organic light-emitting diode (OLED), wherein
- on a substrate an anode layer is formed,
- on the anode layer a hole injection layer is formed,
- on the hole injection layer a hole transport layer is formed,
- on the hole transport layer an emission layer is formed,
- on the emission layer an electron transport layer is formed, optionally a hole blocking layer is formed on the emission layer,
- and finally, a cathode layer is formed,
- optional a hole blocking layer is formed in that order between the first anode layer and the emission layer,
- optional an electron injection layer is formed between the electron transport layer and the cathode layer.

According to various embodiments, the OLED may have the following layer structure, wherein the layers having the following order:
anode layer, hole injection layer, first hole transport layer, second hole transport layer, emission layer, optional hole blocking layer, electron transport layer, optional electron injection layer, and cathode layer.

### Electronic device

According to another aspect of the invention, it is provided an electronic device comprising an organic electroluminescent device according to the invention, comprising at least one organic light emitting device according to any embodiment described throughout this application, preferably, the electronic device comprises the organic light emitting diode in one of embodiments described throughout this application. More preferably, the electronic device is a display device.

### Exemplary aspects

Hereinafter, the embodiments are illustrated in more detail with reference to examples. However, the present disclosure is not limited to the following examples. Reference will now be made in detail to the exemplary aspects.

### Description of the Drawings

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object of the invention are disclosed in the dependent claims and the following description of the respective figures which in an exemplary fashion show preferred embodiments according to the invention. Any embodiment does not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation of the present invention as claimed.
FIG. 1 is a schematic sectional view of an organic electroluminescent device according to an exemplary embodiment of the present invention.
FIG. 2 is a schematic sectional view of an organic electroluminescent device according to an exemplary embodiment of the present invention.
FIG. 3 is a schematic sectional view of an organic electroluminescent device according to an exemplary embodiment of the present invention.
FIG. 4 is a schematic sectional view of an organic electroluminescent device according to an exemplary embodiment of the present invention.

Hereinafter, the figures are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

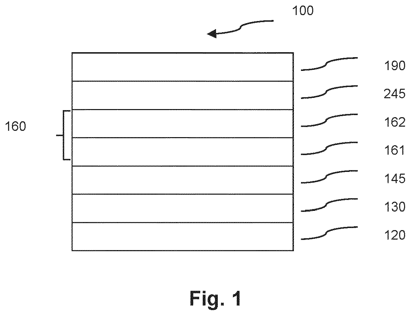

The anode layer 120 is arranged on a substrate 110, which is not shown in Figs. 1 to 4.

Referring to Fig. 1 the organic electroluminescent device 100 includes a substrate (110), an anode layer (ANO) 120, a hole injection layer (HIL) 130, a first emission layer (EML1) 145, wherein the hole injection layer (HIL) 130 comprises a hole transport matrix compound and a first metal compound selected from a metal salt or metal complex comprising a metal cation and at least one monoanion consisting of at least 5 covalently bound atoms and/or at least one monoanionic ligand consisting of at least 5 covalently bound atoms, wherein the first metal compound has a LUMO energy level of ≤ -4.65 eV and preferably < -4.65 eV.

The organic electroluminescent device further comprises a first charge generation layer (CGL1) 160, wherein the first charge generation layer (CGL1) 160 comprises a first n-type charge generation layer (n-CGL1) 161, and a first p-type charge generation layer (p-CGL1) 162, wherein the first n-type charge generation layer (n-CGL1) 161 comprises a matrix compound and a metal dopant, wherein preferably the metal dopant is selected from Ytterbium, Lithium or Magnesium, wherein the first p-type charge generation layer (p-CGL1) 162 comprises a compound of formula (II) which is a metal compound and a second hole transport matrix compound.

The organic electroluminescent device 100 further comprises a second emission layer (EML2) 245, and a cathode layer (CAT) 190.

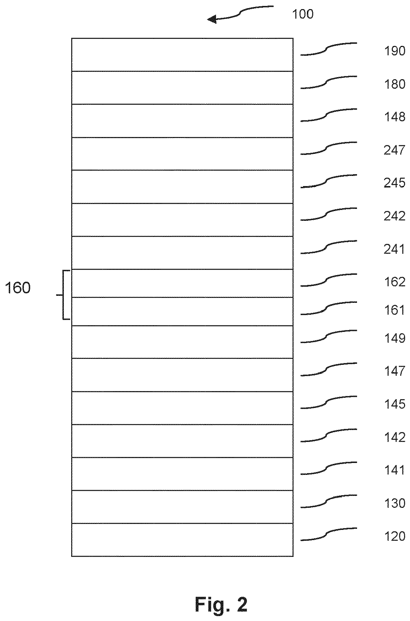

Fig. 2 is a schematic sectional view of an organic electroluminescent device 100, according to one exemplary embodiment of the present invention.

Referring to Fig. 2 the organic electroluminescent device 100 includes an anode layer (ANO) 120, a hole injection layer (HIL) 130, a first hole transport layer (HTL1) 141, a first electron blocking layer (EBL1) 142, a first emission layer (EML1) 145, a first optional hole blocking layer (HBL1) 147, and a first electron transport layer (ETL1) 149, wherein the hole injection layer (HIL) 130 comprises a first hole transport matrix compound and a first metal compound selected from a metal salt or metal complex comprising a metal cation and at least one monoanion consisting of at least 5 covalently bound atoms and/or at least one monoanionic ligand consisting of at least 5 covalently bound atoms, wherein the first metal compound has a LUMO energy level of ≤ -4.65 eV, preferably < -4.65 eV.

The organic electroluminescent device further comprises a first charge generation layer (CGL1) 160 disposed over the first electron transport layer (ETL1) 149, wherein the first charge generation layer (CGL1) 160 comprises a first n-type charge generation layer (n-CGL1) 161, and a first p-type charge generation layer (p-CGL1) 162, wherein the first p-type charge generation layer (p-CGL1) 162 comprise a second hole transport matrix compound, and a second metal compound, wherein the second metal compound is selected from the group comprising a metal salt, or a metal complex, wherein the metal complex comprises a metal cation and at least one monoanion comprising at least 5 covalently bound atoms and/or at least one monoanionic ligand L comprising at least 5 covalently bound atoms, the second metal compound has a LUMO energy level of ≤ - 4.65 eV;
wherein the first n-type charge generation layer (n-CGL1) 161 comprises a matrix compound and a metal dopant, wherein preferably the metal dopant is selected from Ytterbium, Lithium or Magnesium.

The organic electroluminescent device 100 further comprises a second hole transport layer (HTL2) 241, a second electron blocking layer (EBL2) 242.

The organic electroluminescent device 100 further comprises a second emission layer (EML2) 245.

The organic electroluminescent device 100 further comprises a second optional hole blocking layer (HBL2) 247, an electron transport layer (ETL) 148, an electron injection layer (EIL) 180, and a cathode layer (CAT) 190.

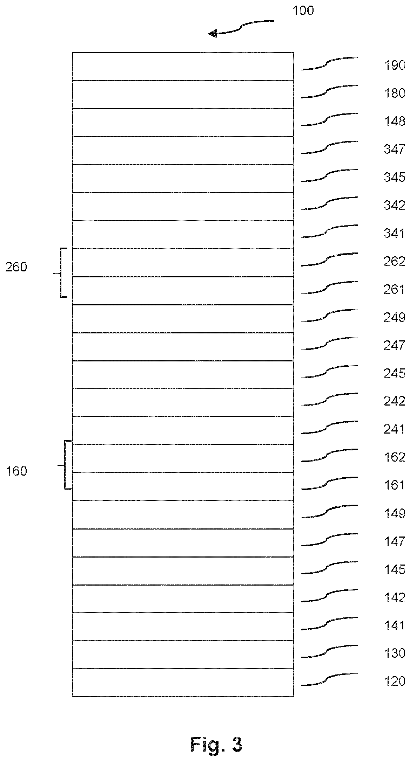

Fig. 3 is a schematic sectional view of an organic electroluminescent device 100, according to one exemplary embodiment of the present invention.

Referring to Fig. 3 the organic electroluminescent device 100 includes an anode layer (ANO) 120, a hole injection layer (HIL) 130, a hole transport layer (HTL1) 141, a first electron blocking layer (EBL1) 142, and a first emission layer (EML1) 145; wherein the hole injection layer (HIL) 130 comprises a first hole transport matrix compound and a first metal compound selected from a metal salt or metal complex comprising a metal cation and at least one monoanion consisting of at least 5 covalently bound atoms and/or at least one monoanionic ligand consisting of at least 5 covalently bound atoms wherein the first metal compound has a LUMO energy level of ≤ -4.65 eV, preferably < -4.65 eV.

The organic electroluminescent device 100 further comprises a first optional hole blocking layer (HBL1) 147.

The organic electroluminescent device 100 further comprises a first electron transport layer (ETL1) 149.

The organic electroluminescent device further comprises a first charge generation layer (CGL1) 160 disposed over the first electron transport layer (ETL1) 149, wherein the first charge generation layer (CGL1) 160 comprises a first n-type charge generation layer (n-CGL1) 161, and a first p-type charge generation layer (p-CGL1) 162, wherein the first p-type charge generation layer (p-CGL1) 162 comprise a second hole transport matrix compound, and a second metal compound, wherein the second metal compound is selected from the group comprising a metal salt, or a metal complex, wherein the metal complex comprises a metal cation and at least one monoanion comprising at least 5 covalently bound atoms and/or at least one monoanionic ligand L comprising at least 5 covalently bound atoms, the second metal compound has a LUMO energy level of ≤ - 4.65 eV;
wherein the first n-type charge generation layer (n-CGL1) 161 comprises a matrix compound and a metal dopant, wherein preferably the metal dopant is selected from Ytterbium, Lithium or Magnesium.

The organic electroluminescent device 100 further comprises a second hole transport layer (HTL2) 241, and a second electron blocking layer (EBL2) 242.

The organic electroluminescent device 100 further comprises a second emission layer (EML2) 245.

The organic electroluminescent device 100 further comprises a second optional hole blocking layer (HBL2) 247.

The organic electroluminescent device 100 further comprises a second electron transport layer (ETL2) 249.

The organic electroluminescent device further comprises a second charge generation layer (CGL2) 260 disposed over the second electron transport layer (ETL2) 249, wherein the second charge generation layer (CGL2) 260 comprises a second n-type charge generation layer (n-CGL2) 261, and a second p-type charge generation layer (p-CGL2) 262, wherein the second p-type charge generation layer (p-CGL2) 262 comprise a second hole transport matrix compound, and a second metal compound, wherein the second metal compound is selected from the group comprising a metal salt, or a metal complex, wherein the metal complex comprises a metal cation and at least one monoanion comprising at least 5 covalently bound atoms and/or at least one monoanionic ligand L comprising at least 5 covalently bound atoms, the second metal compound has a LUMO energy level of ≤ -4.65 eV; wherein second metal compound in the first p-type charge generation layer (p-CGL1) 162 and the second metal compound in the second p-type charge generation layer (p-CGL2) 262 can be the same or different,
wherein the second n-type charge generation layer (n-CGL2) 261 comprises a matrix compound and a metal dopant, wherein preferably the metal dopant is selected from Ytterbium, Lithium, Magnesium.

The organic electroluminescent device 100 further comprises a third hole transport layer (HTL3) 341, and a third electron blocking layer (EBL3) 342.

The organic electroluminescent device 100 further comprises a third emission layer (EML3) 345.

The organic electroluminescent device 100 further comprises a third optional hole blocking layer (HBL3) 347, an electron transport layer (ETL)148, an electron injection layer (EIL) 180, and a cathode layer (CAT) 190.

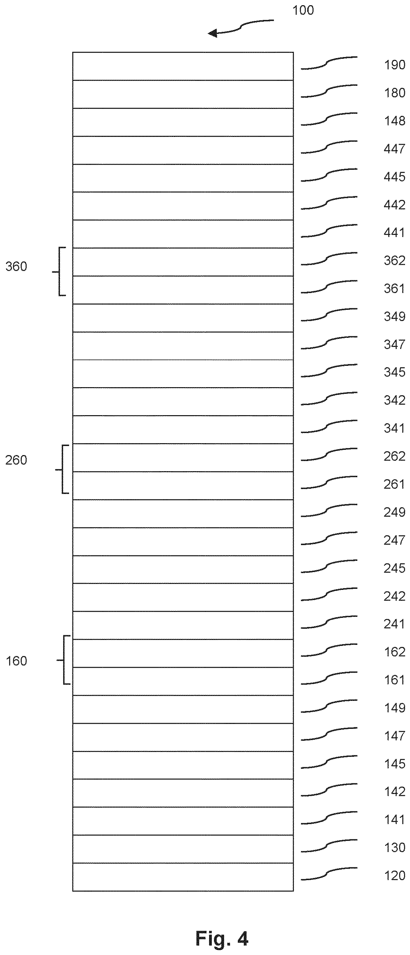

Fig. 4 is a schematic sectional view of an organic electroluminescent device 100, according to one exemplary embodiment of the present invention.

Referring to Fig. 4 the organic electroluminescent device 100 includes an anode layer (ANO) 120, a hole injection layer (HIL) 130, a hole transport layer (HTL1) 141, a first electron blocking layer (EBL1) 142, a first emission layer (EML1) 145; wherein the hole injection layer (HIL) 130 comprises a first hole transport matrix compound and a first metal compound selected from a metal salt or metal complex comprising a metal cation and at least one monoanion consisting of at least 5 covalently bound atoms and/or at least one monoanionic ligand consisting of at least 5 covalently bound atoms..

The organic electroluminescent device 100 further comprises a first optional hole blocking layer (HBL1) 147.

The organic electroluminescent device 100 further comprises a first electron transport layer (ETL1) 149.

The organic electroluminescent device further comprises a first charge generation layer (CGL1) 160 disposed over the first electron transport layer (ETL1) 149, wherein the first charge generation layer (CGL1) 160 comprises a first n-type charge generation layer (n-CGL1) 161, and a first p-type charge generation layer (p-CGL1) 162, wherein the first p-type charge generation layer (p-CGL1) 162 comprise a second hole transport matrix compound, and a second metal compound, wherein the second metal compound is selected from the group comprising a metal salt, or a metal complex, wherein the metal complex comprises a metal cation and at least one monoanion comprising at least 5 covalently bound atoms and/or at least one monoanionic ligand L comprising at least 5 covalently bound atoms, the second metal compound has a LUMO energy level of ≤ - 4.65 eV;
wherein the first n-type charge generation layer (n-CGL1) 161 comprises a matrix compound and a metal dopant, wherein preferably the metal dopant is selected from Ytterbium, Lithium or Magnesium.

The organic electroluminescent device 100 further comprises a second hole transport layer (HTL2) 241, and a second electron blocking layer (EBL2) 242.

The organic electroluminescent device 100 further comprises a second emission layer (EML2) 245.

The organic electroluminescent device 100 further comprises a second optional hole blocking layer (HBL2) 247.

The organic electroluminescent device 100 further comprises a second electron transport layer (ETL2) 249.

The organic electroluminescent device further comprises a second charge generation layer (CGL2) 260 disposed over the second electron transport layer (ETL2) 249, wherein the second charge generation layer (CGL2) 260 comprises a second n-type charge generation layer (n-CGL2) 261, and a second p-type charge generation layer (p-CGL2) 262, wherein the second p-type charge generation layer (p-CGL2) 262 comprise a second hole transport matrix compound, and a second metal compound, wherein the second metal compound is selected from the group comprising a metal salt, or a metal complex, wherein the metal complex comprises a metal cation and at least one monoanion comprising at least 5 covalently bound atoms and/or at least one monoanionic ligand L comprising at least 5 covalently bound atoms, the second metal compound has a LUMO energy level of ≤ -4.65 eV,
wherein the second n-type charge generation layer (n-CGL2) 261 comprises a matrix compound and a metal dopant, wherein preferably the metal dopant is selected from Ytterbium, Lithium, Magnesium.

The organic electroluminescent device 100 further comprises a third hole transport layer (HTL3) 341, and a third electron blocking layer (EBL3) 342.

The organic electroluminescent device 100 further comprises a third emission layer (EML3) 345.

The organic electroluminescent device 100 further comprises a third optional hole blocking layer (HBL3) 347.

The organic electroluminescent device 100 further comprises a third electron transport layer (ETL3) 349.

The organic electroluminescent device further comprises a charge generation layer (CGL3) 360 disposed over the third electron transport layer (ETL3) 349, wherein the third charge generation layer (CGL3) 360 comprising a third n-type charge generation layer (n-CGL3) 361, and a third p-type charge generation layer (p-CGL3) 362,
wherein the third p-type charge generation layer (p-CGL3) 362 comprise a second hole transport matrix compound, and a compound of formula (II) a second metal compound, wherein the second metal compound is selected from the group comprising a metal salt, or a metal complex, wherein the metal complex comprises a metal cation and at least one monoanion comprising at least 5 covalently bound atoms and/or at least one monoanionic ligand L comprising at least 5 covalently bound atoms, the second metal compound has a LUMO energy level of ≤ - 4.65 eV wherein the second metal compound in the first p-type charge generation layer (p-CGL1) 162, the second metal compound in the second p-type charge generation layer (p-CGL2) 262, and the second metal compound in the third p-type charge generation layer (p-CGL3) 362 can be the same or different;
wherein the third n-type charge generation layer (n-CGL3) 361 comprises a matrix compound and a metal dopant, wherein preferably the metal dopant is selected from Ytterbium, Lithium or Magnesium, .

The organic electroluminescent device 100 further comprises a fourth hole transport layer (HTL4) 441, and a fourth electron blocking layer (EBL4) 442.

The organic electroluminescent device 100 further comprises a fourth emission layer (EML4) 345.

The organic electroluminescent device 100 further comprises a fourth optional hole blocking layer (HBL4) 447, an electron transport layer (ETL) 148, an electron injection layer (EIL) 180, and a cathode layer (CAT) 190.

Hereinafter, one or more exemplary embodiments of the present invention will be described in detail with, reference to the following examples. However, these examples are not intended to limit the purpose and scope of the one or more exemplary embodiments of the present invention.

### Calculated HOMO and LUMO

The HOMO and LUMO energy levels of the metal compound are calculated by applying the hybrid functional B3LYP with a ZORA-Def2-TZVP basis set and the SARC-ZORA-TZVP segmented all electron relativistically contracted basis sets for elements beyond Krypton from the optimized geometries obtained by applying the functional BP86 with a ZORA-Def2-SVP basis set and the SARC-ZORA-TZVP segmented all electron relativistically basis sets for elements beyond Krypton as implemented in the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany). All the calculations were performed in the gas phase. All relativistic calculations were performed applying the zero order regular approximation (ZORA). If more than one conformation is viable, the conformation with the lowest total energy is selected.

### Experimental data

Table I shows metal compounds of formula (II) and KTFSI and Zn(TFSI)₂.

**Table I**

| **Metal compounds** | **Structure** |
|---|---|
| KTFSI | 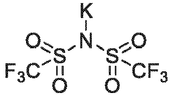 |
| Zn(TFSI)2 | 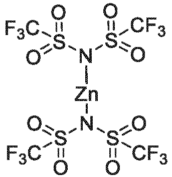 |
| M1 | 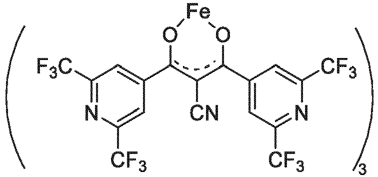 |
| M2 | 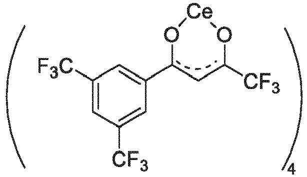 |
| M3 | 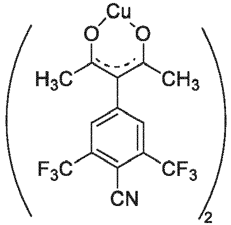 |
| M4 | 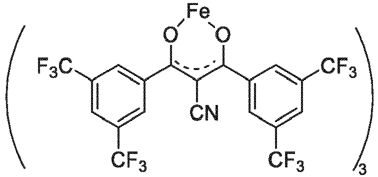 |
| M5 | 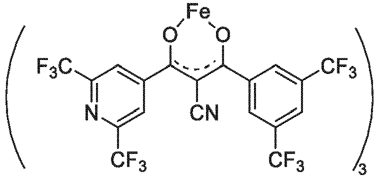 |
| M6 | 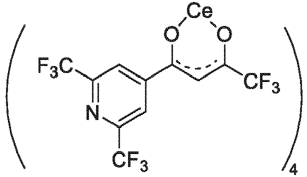 |
| M7 | 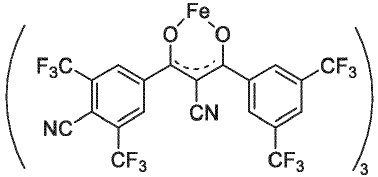 |
| M8 | 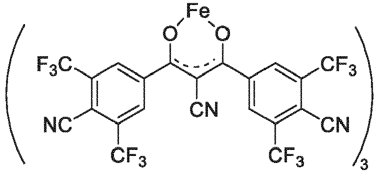 |
| M9 | 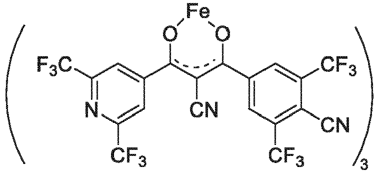 |

Table II shows the LUMO [eV] for compounds of formula **(II)** and KTFSI and Zn(TFSI)₂.

**Table II**

| | **Metal compound** | **Structure** | **LUMO [eV]** |
|---|---|---|---|
| Comparative | KTFSI | 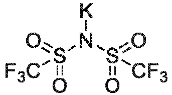 | -1.42 |
| Comparative | Zn(TFSI)2 | 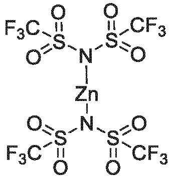 | -2.10 |

| Comparative | COMP-1 | 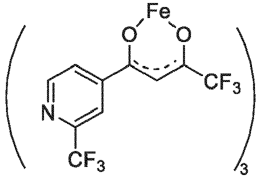 | -4.61 |
|---|---|---|---|
| | M1 | 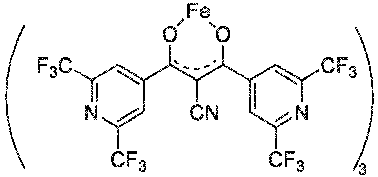 | -5.69 |
| | M2 | 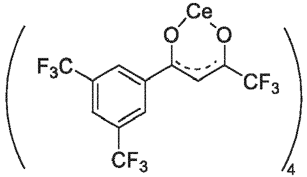 | -4.67 |
| | M3 | 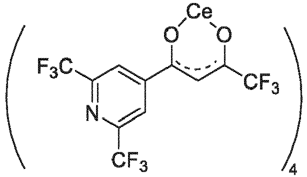 | -5.12 |
| | M4 | 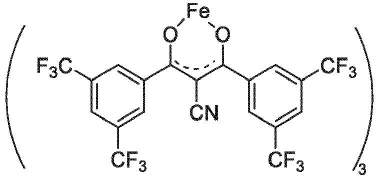 | -4.94 |
| | M5 | 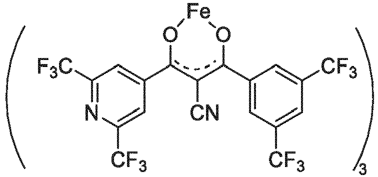 | -5.29 |
| | M7 | 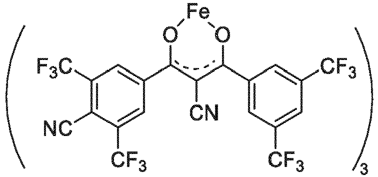 | -5.34 |
| | M8 | 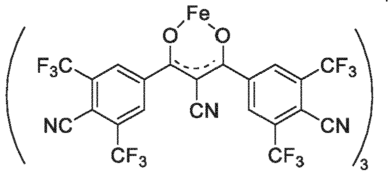 | -5.69 |
| | M9 | 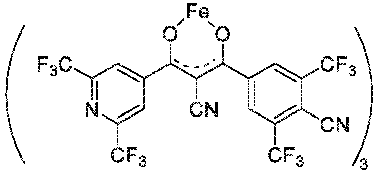 | -5.70 |

Table III shows the compound used for fabrication of OLEDs

**Table III**

| | | |
|---|---|---|
| NH-1 | N-([1,1'-biphenyl]-4-yl)-9, 9-dimethyLN-(4-(9-phenyL9H-carbazoL3-yl)phenyl)-9H-fluoren-2-amine | 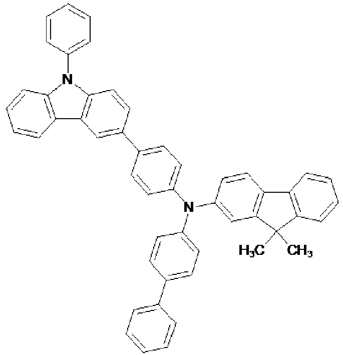 |
| NH-2 | N-([1,1'-biphenyl]-4-yl)-9,9-diphenyLN-(4-(triphenylsilyl)phenyl)-9H-fluoren-2-amine | 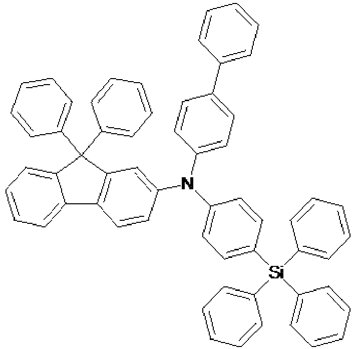 |
| NH-3 | 2-(3'-(9,9-dimethyL9H-fluoren-2-yl)-[1,1'-biphenyl]-3-yl)-4,6-diphenyL 1,3, 5-triazine. | 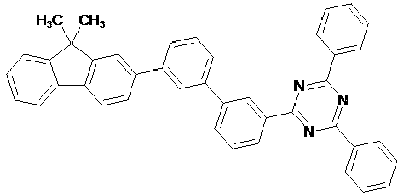 |
| NH-4 | 4'-(4-(4-(4,6-diphenyL1,3,5-triazin-2-yl)phenyl)naphthalen-1-yl)-[1,1'-biphenyl]-4-carbonitrile | 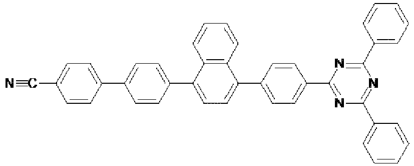 |

### General procedure for fabrication of OLEDs

For the examples according to the invention and comparative examples in Table IV, a glass substrate with an anode layer comprising a first anode sub-layer of 10 nm ITO, a second anode sub-layer of 120 nm Ag and a third anode sub-layer of 8 nm ITO was cut to a size of 100 mm x 100 mm x 0.7 mm, ultrasonically washed with water for 60 minutes and then with isopropanol for 20 minutes. The liquid film was removed in a nitrogen stream, followed by plasma treatment, to prepare the anode layer. The plasma treatment was performed in an atmosphere comprising 97.6 vol.-% nitrogen and 2.4 vol.-% oxygen.

Then N-([1,1'-biphenyl]-4-yl)-9,9-dimethyLN-(4-(9-phenyL9H-carbazoL3 -yl)phenyl)-9H-fluoren-2-amine (NH-1) was vacuum deposited with 5 wt% of the metal compound according to table IV to form a hole injection layer having a thickness 10 nm.

Then N-([1,1'-biphenyl]-4-yl)-9,9-dimethyLN-(4-(9-phenyL9H-carbazoL3 -yl)phenyl)-9H-fluoren-2-amine (NH-1) was vacuum deposited, to form a first hole transport layer having a thickness of 27 nm

Then N-([1,1'-biphenyl]-4-yl)-9,9-diphenyLN-(4-(triphenylsilyl)phenyl)-9H-fluoren-2-amine (NH-2) was vacuum deposited on the HTL, to form an electron blocking layer (EBL) having a thickness of 5 nm.

Then 97 wt.-% H09 (Sun Fine Chemicals, Korea) as EML host and 3 wt.-% BD200 (Sun Fine Chemicals, Korea) as fluorescent blue dopant were deposited on the EBL, to form a first blue-emitting emission layer (EML) with a thickness of 20 nm.

Then, a first hole blocking layer (HBL1) having a thickness of 5 nm is formed on the first emission layer by depositing 2-(3'-(9,9-dimethyL9H-fluoren-2-yl)-[1,1'-biphenyl]-3-yl)-4,6-diphenyL1,3,5-triazine (NH-3).

Then, 50 wt.-% 4'-(4-(4-(4,6-diphenyL1,3,5-triazin-2-yl)phenyl)naphthalen-1-yl)-[1,1'-biphenyl]-4-carbonitrile (NH-4) and 50 wt.-% LiQ were vacuum deposited on the first hole blocking layer to form a first electron transport layer having a thickness of 20 nm.

Then an n-type CGL (n-type charge generation layer) having a thickness of 10 nm is formed on the first electron transport layer by co-depositing 99 vol% of 2,2'-(1,3-Phenylene)bis[9-phenyL1,10-phenanthroline] and 1 vol% Yb.

Then a p-type CGL having a thickness of 10 nm is formed on the n-type CGL by co-depositing N-([1,1'-biphenyl]-4-yl)-9,9-dimethyLN-(4-(9-phenyL9H-carbazoL3-yl)phenyl)-9H-fluoren-2-amine (NH-1) with 20 wt% of the metal compound according to Table IV.

Then a second hole transport layer having a thickness of 24 nm is formed on the first p-type CGL by depositing N-([1,1'-biphenyl]-4-yl)-9,9-dimethyLN-(4-(9-phenyL9H-carbazoL3-yl)phenyl)-9H-fluoren-2-amine (NH-1).

Then a second electron blocking layer having a thickness of 5 nm is formed on the second hole transport layer by depositing N-([1,1'-biphenyl]-4-yl)-9,9-diphenyLN-(4-(triphenylsilyl)phenyl)-9H-fluoren-2-amine (NH-2).

Then 97 wt.-% H09 (Sun Fine Chemicals, Korea) as EML host and 3 wt.-% BD200 (Sun Fine Chemicals, Korea) as fluorescent blue dopant were deposited on the second EBL, to form a second blue-emitting EML with a thickness of 20 nm.

Then 2-(3'-(9,9-dimethyL9H-fluoren-2-yl)-[1,1'-biphenyl]-3-yl)-4,6-diphenyL1,3,5-triazine (NH-3) was vacuum deposited to form a second hole blocking layer having a thickness of 5 nm is formed on the second blue-emitting EML.

Then, 50 wt.-% 4'-(4-(4-(4,6-diphenyL1,3,5-triazin-2-yl)phenyl)naphthalen-1-yl)-[1,1'-biphenyl]-4-carbonitrile (NH-4) and 50 wt.-% LiQ were vacuum deposited on the second hole blocking layer to form a second electron transport layer having a thickness of 30 nm.

Then Yb was evaporated at a rate of 0.01 to 1 Å/s at 10⁻⁷ mbar to form an electron injection layer with a thickness of 2 nm on the electron transporting layer.

Ag/Mg (10wt% of Mg) is evaporated at a rate of 0.01 to 1 A/s at 10⁻⁷ mbar to form a cathode with a thickness of 13 nm.

Then, N-({[1,1-'biphenyl]-4-yl)-9,9,dimethyLN-(4-(9-phenyL9H-carbazoL3-yl)phenyl)-9H-fluoren-2-amine} was vacuum deposited on the cathode layer to form a capping layer with a thickness of 75 nm.

To assess the performance of the inventive examples compared to the prior art, the current efficiency is measured at 20°C. The current-voltage characteristic is determined using a Keithley 2635 source measure unit, by sourcing a voltage in V and measuring the current in mA flowing through the device under test. The voltage applied to the device is varied in steps of 0.1V in the range between 0V and 10V. Likewise, the luminance-voltage characteristics and CIE coordinates are determined by measuring the luminance in cd/m² using an Instrument Systems CAS-140CT array spectrometer (calibrated by Deutsche Akkreditierungsstelle (DAkkS)) for each of the voltage values. The cd/A efficiency at 15 mA/cm2 is determined by interpolating the luminance-voltage and current-voltage characteristics, respectively.

In bottom emission devices, the emission is predominately Lambertian and quantified in percent external quantum efficiency (EQE). To determine the efficiency EQE in % the light output of the device is measured using a calibrated photodiode at 15 mA/cm2.

In top emission devices, the emission is forward directed, non-Lambertian and also highly dependent on the mirco-cavity. Therefore, the efficiency EQE will be higher compared to bottom emission devices. To determine the efficiency EQE in % the light output of the device is measured using a calibrated photodiode at 15 mA/cm².

Lifetime LT of the device is measured at room temperature (20°C) and 30 mA/cm², using a Keithley 2400 sourcemeter, and recorded in hours.

The brightness of the device is measured using a calibrated photo diode. The lifetime LT is defined as the time till the brightness of the device is reduced to 97 % of its initial value.

The increase in operating voltage ΔU is used as a measure of the operational voltage stability of the device. This increase is determined during the LT measurement and by subtracting the operating voltage after 1 hour after the start of operation of the device from the operating voltage after 100 hours. $Δ U = \left[U\left(100 h\right)-U\left(1h\right)\right] .$

The smaller the value of ΔU the better is the operating voltage stability.

### Technical Effect of the invention

The comparative devices Comp. 1 to Comp.7 all contains a metal dopant in p-CGL which have a LUMO energy level above -4.65 eV.

All inventive examples Inv.1 to Inv.6 contains a metal dopant in the p-CGL which have a LUMO energy level lower than -4.65 eV.

All the inventive devices Inv.1 to Inv.6 exhibits a lower operational voltage, higher efficiency, longer lifetime and low voltage rise over time than the comparative devices Comp. 1 to Comp. 7.

A lower operating voltage may be important for the battery life of organic electronic devices, in particular mobile devices. A long lifetime may result in improved long-term stability of electronic devices. A low voltage rise over time may result in improved long-term stability of electronic devices. A high efficiency may be beneficial for reduced power consumption and improved battery life, in particular in mobile devices. A good current efficiency and a good external quantum efficiency may be beneficial for reduced power consumption and improved battery life, in particular in mobile devices.

**Table IV**

| p-HIL | p-HIL | LUMO [eV] | p-CGL | LUMO [eV | CIEy | Voltage at 15mA/cm² [V] | Ceff at 15mA/cm² [cd/A] | EQE at 15mA/cm² [%] | CEff/CIEy at 15mA/cm² [cd/A] | LT97 at 30mA/cm² [h] | Vrise (1-100h) at 30mA/cm² [V] |
|---|---|---|---|---|---|---|---|---|---|---|---|
| *Comp. 1* | *KTFSI* | *-1.42* | *KTFSI* | -1.42 | *Device gives no light*/ *did not work*/ *no measurable data* | | | | | | |
| *Comp. 2* | *KTFSI* | *-1.42* | *COMP-1* | *-4.61* | *Device gives no light*/ *did not work*/ *no measurable data* | | | | | | |
| *Comp. 3* | *Zn(TFSI)2* | *-2.10* | *Zn(TFSI)2* | *-2.10* | *Device gives no light*/ *did not work*/ *no measurable data* | | | | | | |
| *Comp. 4* | *KTFSI* | *-1.42* | *Zn(TFSI)2* | *-2.10* | *Device gives no light*/ *did not work*/ *no measurable data* | | | | | | |
| *Comp. 5* | *Zn(TFSI)2* | *-2.10* | *KTFSI* | -1.42 | *Device gives no light*/ *did not work*/ *no measurable data* | | | | | | |
| *Comp. 6* | *COMP-1* | *-4.61* | *COMP-1* | *-4.61* | *Device gives no light*/ *did not work*/ *no measurable data* | | | | | | |
| *Comp. 7* | *M4* | *-4.94* | *COMP-1* | *-4.61* | *Device gives no light*/ *did not work*/ *no measurable data* | | | | | | |
| Inv.1 | M5 | -5.29 | M4 | -4.94 | 0.048 | 7.99 | 12.0 | 23.6 | 248 | 100 | 0.141 |
| Inv.2 | M5 | -5.29 | M2 | -4.67 | 0.048 | 7.96 | 11.7 | 23.3 | 246 | 98 | 0.131 |
| Inv.3 | M4 | -4.94 | M5 | -5.29 | 0.047 | 7.83 | 11.7 | 23.6 | 250 | 100 | 0.124 |
| Inv.4 | M2 | -4.67 | M5 | -5.29 | 0.048 | 7.82 | 11.9 | 23.6 | 248 | 100 | 0.130 |
| Inv.5 | M4 | -4.94 | M2 | -4.67 | 0.048 | 7.94 | 11.9 | 23.6 | 249 | 107 | 0.139 |
| Inv.6 | M2 | -4.67 | M4 | -4.94 | 0.047 | 8.01 | 11.8 | 23.8 | 252 | 106 | 0.168 |

The combinations of elements and features in the above detailed embodiments are exemplary only; the interchanging and substitution of these teachings with other teachings in this and the patents/applications incorporated by reference are also expressly contemplated. As those skilled in the art will recognize, variations, modifications, and other implementations of what is described herein can occur to those of ordinary skill in the art without departing from the spirit and the scope of the invention as claimed. Accordingly, the foregoing description is by way of example only and is not intended as limiting. In the claims, the word "comprising" does not exclude other elements or steps, and the indefinite article "a" or "an" does not exclude a plurality. The mere fact that certain measures are recited in mutually different dependent claims does not indicate that a combination of these measured is not selected used to advantage. The invention's scope is defined in the following claims and the equivalents thereto. Furthermore, reference signs used in the description and claims do not limit the scope of the invention as claimed.

## Claims

1. An organic electroluminescent device comprising an anode layer, a cathode layer, a first emission layer, a second emission layer, a hole injection layer, and at least one first charge generation layer,
wherein the hole injection layer is in direct contact to the anode layer,
wherein the first charge generation layer is arranged between the first emission layer and the second emission layer;
wherein the first charge generation layer comprises a first n-type charge generation layer and a first p-type charge generation layer;
wherein the first n-type charge generation layer comprises an organic electron transport matrix compound and a metal-dopant, and the first n-type charge generation layer is arranged closer to the anode layer than the first p-type charge generation layer;
wherein the hole injection layer comprises a first metal compound,
wherein the first metal compound is selected from the group comprising a metal salt, or a metal complex, wherein the metal complex comprises a metal cation and at least one monoanion comprising at least 5 covalently bound atoms and/or at least one monoanionic ligand L comprising at least 5 covalently bound atoms, wherein the first metal compound has a LUMO energy level of ≤ -4.65 eV;
wherein the first p-type charge generation layer comprises a second metal compound, wherein the second metal compound is selected from the group comprising a metal salt, or a metal complex, wherein the metal complex comprises a metal cation and at least one monoanion comprising at least 5 covalently bound atoms and/or at least one monoanionic ligand L comprising at least 5 covalently bound atoms, the second metal compound has a LUMO energy level of ≤ -4.65 eV;
wherein the first metal compound of the hole injection layer is selected different from the second metal compound of the first p-type charge generation layer.

2. The organic electroluminescent device according to claim 1, wherein
- the first metal compound of the hole injection layer has a LUMO energy level of ≤ -4.65 eV, and preferably < -4.65 eV;
- the second metal compound of the first p-type charge generation layer has a LUMO energy level of ≤ -4.65 eV;
wherein the LUMO energy level is calculated by applying the hybrid functional B3LYP with a ZORA-Def2-TZVP basis set and the SARC-ZORA-TZVP segmented all-electron relativistically contracted basis sets for elements beyond Krypton from the optimized geometries obtained by applying the functional BP86 with a ZORA-Def2-SVP basis set and the SARC-ZORA-TZVP segmented all-electron relativistically contracted basis sets for elements beyond Krypton in the gas phase as implemented in the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany).

3. The organic electroluminescent device according to claim 1 or 2, wherein the first metal compound of the hole injection layer has a LUMO energy level of ≤ -4.90 eV, preferably ≤ - 5.00, more preferably ≤ -5.20 eV, and most preferably ≤ -5.40 eV.

4. The organic electroluminescent device according to any of claim 1 to 3, wherein the second metal compound in the p-type charge generation layer has a LUMO energy level of ≤ -4.90 eV,-preferably ≤ -5.00, more preferably ≤ -5.20 eV, and most preferably ≤ -5.40 eV.

5. The organic electroluminescent device according to claims 1 to 4, wherein the monoanion of the first metal compound and/or second metal compound comprises at least 10 covalently bound atoms and the at least one monoanionic ligand L of the first metal compound and/or second metal compound comprises 10 covalently bound atoms, preferably the monoanion comprises at least 15 covalently bound atoms and the at least one monoanionic ligand L comprises 15 covalently bound atoms, and more preferably the monoanion comprises at least 20 covalently bound atoms and the at least one monoanionic ligand L comprises 20 covalently bound atoms.

6. The organic electroluminescent device according to any of claims 1 to 5, wherein the monoanion and/or monoanionic ligand L is represented by formula (Ia), (Ib) or (Ic): 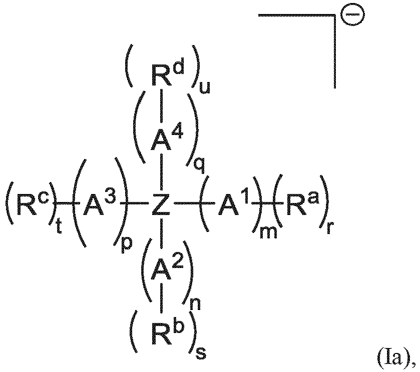 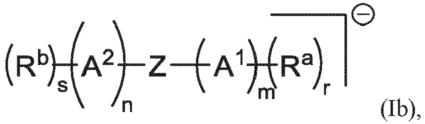 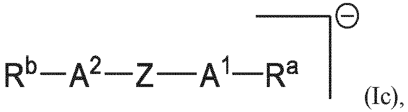 wherein
m, n, p, and q are independently selected from 0 or 1;
r, s, t, and u are independently selected from 0 or 1;
at least one of r, s, t, and u is 1;
Z is selected from CR¹, C, O, N, B, preferably Z is selected from N, O or CR¹, or further preferred Z is selected from C and A¹, A², A³ and A⁴ is selected from C-O or C-NR³,
if Z is selected O then n, p, q and are selected from 0 and s, t and u are selected from 0;
if Z is selected from N or CR¹ then p and q are selected from 0, and t and u are selected from 0;
if Z is selected from C then q is selected from 0, and u is selected from 0;
if Z is selected from B then n, m, p, and q are selected from 1, and r, s, t, and u are selected from 1;
A¹, A², A³ and A⁴ are independently selected from C=O, C-O, C=NR², C-NR³, SO, SO₂, or P(=O)R⁴, and preferably A¹, A², A³ and A⁴ are independently selected from C=O, C-O, or SO₂;
if A¹, A², A³ and A⁴ is selected from C-O or C-NR³ then Z forms a double bond to A¹, A², A³ and A⁴;
R¹ is selected from H, D, electron-withdrawing group, halogen, Cl, F, CN, NO₂, SF₅, isonitrile, ester group, carboxylic group, carbonyl group, acyl group, thio group sulfinyl group, sulfonyl group, phosphine group, substituted or unsubstituted C₁ to C₁₂ alkyl, partially perfluorinated C₁ to C₁₂ alkyl, perfluorinated C₁ to C₁₂ alkyl, CF₃, substituted or unsubstituted C₁ to C₁₂ alkoxy, partially perfluorinated C₁ to C₆ alkoxy, perfluorinated C₁ to C₆ alkoxy, CF₃, substituted or unsubstituted C₆ to C₄₀ aryl, substituted or unsubstituted C₂ to C₄₀ heteroaryl, substituted or unsubstituted C₃ to C₃₀, carbocyclyl, substituted or unsubstituted C₃ to C₃₀ heterocyclyl;
wherein the one or more substituents on R¹ are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, =N, =N-;
R², R³ and R⁴ are independently selected from H, D, electron-withdrawing group, halogen, Cl, F, CN, ester group, carboxylic group, carbonyl group, acyl group, thio group sulfinyl group, sulfonyl group, phosphine group, substituted or unsubstituted alkyl, partially perfluorinated C₁ to C₁₂ alkyl, perfluorinated C₁ to C₁₂ alkyl, CF₃, substituted or unsubstituted C₁ to C₆ alkoxy, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₃₀ heteroaryl, substituted or unsubstituted C₃ to C₃₀ carbocyclyl, substituted or unsubstituted C₂ to C₃₀ heterocyclyl,
wherein the substituents on R², R³ and R⁴ are independently selected from D, electron-withdrawing group, halogen, Cl, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃;
R^{a}, R^{b}, R^{c} and R^{d} are independently selected from H, D, electron-withdrawing group, halogen, F, Cl, CN, substituted or unsubstituted C₁ to C₁₂ alkyl, partially perfluorinated C₁ to C₁₂ alkyl, perfluorinated C₁ to C₁₂ alkyl, CF₃, substituted or unsubstituted C₆ to C₄₀ aryl, substituted or unsubstituted C₂ to C₃₀ heteroaryl, substituted or unsubstituted carbocyclyl, substituted or unsubstituted C₂ to C₃₀ heterocyclyl, O, S, N, NR⁵, substituted or unsubstituted amine group having ≥ 0 to ≤ 20 carbon atoms;
wherein the one more substituents on R^{a}, R^{b}, R^{c} and R^{d} are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, partially perfluorinated C₁ to C₆ alkoxy, perfluorinated C₁ to C₆ alkoxy, OCF₃;
wherein
R⁵ is selected from substituted or unsubstituted C₆ to C₄₀ aryl, substituted or unsubstituted C₂ to C₄₀ heteroaryl, substituted or unsubstituted C₁ to C₁₂ alkyl, partially perfluorinated C₁ to C₁₂ alkyl, perfluorinated C₁ to C₁₂ alkyl,
wherein the one or more substituents on R⁵ is selected from electron-withdrawing group, halogen, F, CN, NO₂, SF₅, isonitrile, ester group, carboxylic group, carbonyl group, acyl group, thio group sulfinyl group, sulfonyl group, phosphine group, partially fluorinated C₁ to C₁₂ alkyl, perfluorinated C₁ to C₁₂ alkyl, CF₃, CF₂CF₃, partially fluorinated C₁ to C₆ alkoxy, perfluorinated C₁ to C₆ alkoxy, OCF₃, OCF₂CCF₃.

7. The organic electroluminescent device according to claim 6, wherein
- two of A¹, A², A³ and A⁴ together form a substituted or unsubstituted heterocycle or substituted or unsubstituted carbocycle with Z; or
- one of A¹, A², A³ and A⁴ form a substituted or unsubstituted heterocycle or substituted or unsubstituted carbocycle with Z;
wherein the one or more substituent on the heterocycle or carbocycle is independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, substituted or unsubstituted alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₄₀ heteroaryl, substituted or unsubstituted C₃ to C₃₀ carbocyclyl, or substituted or unsubstituted C₂ to C₃₀ heterocyclyl.

8. The organic electroluminescent device according to claim 6, wherein at least one of R^{a}, R^{b}, R^{c} and R^{d} are independently selected from each other from substituted or unsubstituted heterocycle or substituted or unsubstituted carbocycle with R¹,
wherein the one or more substituent on the heterocycle or carbocycle is independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, substituted or unsubstituted alkyl, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, substituted or unsubstituted C₆ to C₄₀ aryl, substituted or unsubstituted C₂ to C₄₀ heteroaryl, substituted or unsubstituted C₃ to C₃₀ carbocyclyl, or substituted or unsubstituted C₂ to C₃₀ heterocyclyl;
wherein the one or more substituent on the substituent on the heterocycle or carbocyle is independently selected form D, electron-withdrawing group, halogen, F, substituted or unsubstituted C₁ to C₁₂ alkyl, partially perfluorinated C₁ to C₁₂ alkyl, perfluorinated C₁ to C₁₂ alkyl, CF₃, partially perfluorinated C₁ to C₆ alkoxy, or perfluorinated C₁ to C₆ alkoxy, OCF₃.

9. The organic electroluminescent device according to any of claims 6 to 8, wherein:
- for formula (Ib) Z is selected from O, N, or CR¹, and if Z is selected from O then n is selected from 0, and s is selected from 0; and
- for formula (Ic) Z is selected from N or CR¹.

10. The organic electroluminescent device according to any of claims 1 to 9, wherein the first metal compound and/or the second metal compound is represented by formula (II): 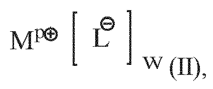 wherein
L is represented by formula (I);
M is a metal ion;
p is the valency of M;
w is p, and preferably w is independently selected from 1 to 4, more preferably 1 to 3; and wherein L is selected the same or different.

11. The organic electroluminescent device according to claims 1 to 10, wherein the first metal compound of the hole injection layer and/or the second metal compound of the p-type charge generation layer is selected from the group comprising Cr, Mn, Fe, Cu, Ce, Ru, Pt or Ag, and preferably the first metal compound of the hole injection layer and/or the second metal compound of the p-type charge generation layer is selected from the group comprising Cr(VI), Mn(III), Fe(III), Cu(II), Ce(IV), Ru(III), Pt(IV), or Ag(I).

12. The organic electroluminescent device according to claims 1 to 11, wherein the monoanion or the monoanionic ligand L is represented by one of the following formulas (III), (IV), (V), (VI), (VII), (VIII) or (IX): 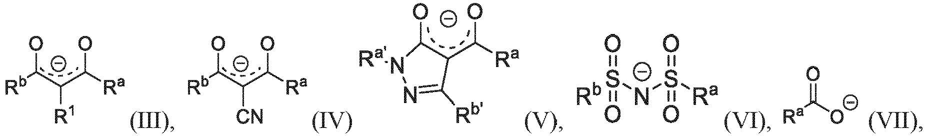 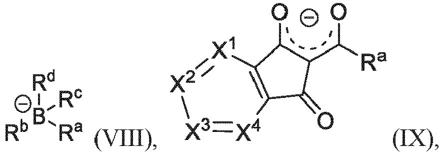 wherein
R^{a}, R^{b}, R^{c} and R^{d} are independently selected from perfluorinated C₁ to C₆ alkyl, CF₃, 3,5-CF₃-phenyl, N, NR⁵, 2,6-CF₃-pyridinyl, substituted or unsubstituted amine group having 0 to 20 carbon atoms;
wherein the one or more substituents on R^{a} and R^{b} are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, partially perfluorinated C₁ to C₆ alkoxy, perfluorinated C₁ to C₆ alkoxy, OCF₃;
R¹ is selected from H, D, CN, substituted or unsubstituted C₁ to C₈ alkyl;
wherein the one or more substituents on R¹ are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, =N, =N-;
R^{a'} is independently selected from substituted or unsubstituted C₁ to C₁₂ alkyl, substituted or unsubstituted C₆ to C₁₉ aryl, substituted or unsubstituted C₂ to C₂₀ heteroaryl, or substituted or unsubstituted 6-membered heteroaryl;
wherein at least one of the substituents of the substituted C₁ to C₁₂ alkyl, substituted C₆ to C₁₉ aryl, substituted C₂ to C₂₀ heteroaryl, or substituted 6-membered heteroaryl are independently selected from halogen, Cl, F, CN, partially or perfluorinated C₁ to C₈ alkyl, partially or perfluorinated C₁ to C₈ alkoxy;
R^{b'} is selected from substituted or unsubstituted C₁ to C₁₂ alkyl, substituted or unsubstituted C₆ to C₁₉ aryl, substituted or unsubstituted C₂ to C₂₀ heteroaryl, substituted or unsubstituted 6-membered heteroaryl, or CN;
wherein at least one of the substituents of the substituted C₁ to C₁₂ alkyl, substituted C₆ to C₁₉ aryl, substituted C₂ to C₂₀ heteroaryl, or substituted 6-membered heteroaryl are independently selected from halogen, Cl, F, CN, partially or perfluorinated C₁ to C₈ alkyl, partially or perfluorinated C₁ to C₈ alkoxy;
X¹ is selected from C-R^{1'} or N;
X² is selected from C-R^{2'} or N;
X³ is selected from C-R^{3'} or N;
X⁴ is selected from C-R^{4'} or N;
wherein
0, 1 or 2 of the group consisting of X¹, X², X³, and X⁴ are selected from N;
R^{1'} to R^{4'} are independently selected from H, D, substituted or unsubstituted C₁ to C₁₂ alkyl, substituted or unsubstituted C₆ to C₁₉ aryl, substituted or unsubstituted C₂ to C₂₀ heteroaryl, substituted or unsubstituted 6-membered heteroaryl, halogen, F, C₁ or CN; and whereby optional any R^{k'} to R(^{k-1)'} with k is from 1 to 3 form a ring, preferably a 5- or 6- membered ring.

13. The organic electroluminescent device according to claims 1 to 12, wherein monoanion and/or monoanionic ligand L is represented by formula (III) or (IV): 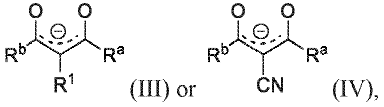 wherein
R^{a} and R^{b} are independently selected from perfluorinated C₁ to C₆ alkyl, CF₃, 3,5-CF₃-phenyl, N, NR⁵, 2,6-CF₃-pyridinyl, substituted or unsubstituted amine group having 0 to 20 carbon atoms;
wherein the one or more substituents on R^{a} and R^{b} are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, partially perfluorinated C₁ to C₆ alkoxy, perfluorinated C₁ to C₆ alkoxy, OCF₃;
R¹ is selected from H, D, CN, substituted or unsubstituted C₁ to C₈ alkyl;
wherein the one or more substituents on R¹ are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, =N, =N-;
wherein optional two adjacent substituents selected from the group of R^{a}, R^{b}, and R¹ are connected to form a heterocycle or carbocycle.

14. The organic electroluminescent device according to claims 12 or 13, wherein in formula (V) at least one of R^{a'}, R^{b'} and R^{a} comprises at least three atoms selected from the group consisting of halogen, Cl, F or N.

15. The organic electroluminescent device according to claim 12, wherein in formula (IX) at least one of R^{1'} to R^{4'} and/or R^{a} comprises at least one CF₃ moiety and/or one of R¹, R², R³, R⁴ and R⁵ is CF₃.

16. The organic electroluminescent device according to claim 12 or 13, wherein the monoanion and/or monoanionic ligand L is selected from formula (III) 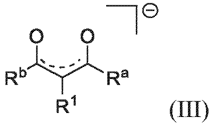
R^{a} and R^{b} are independently selected from perfluorinated C₁ to C₆ alkyl, CF₃, 3,5-CF₃-phenyl, N, NR⁵, 2,6-CF₃-pyridinyl, substituted or unsubstituted amine group having 0 to 20 carbon atoms;
wherein the one or more substituents on R^{a}, R^{b}, R^{c} and R^{d} are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, partially perfluorinated C₁ to C₆ alkoxy, perfluorinated C₁ to C₆ alkoxy, OCF₃;
R¹ is selected from H, D, CN, substituted or unsubstituted C₁ to C₈ alkyl;
wherein the one or more substituents on R¹ are independently selected from D, electron-withdrawing group, halogen, F, CN, NO₂, SF₅, isonitrile, ester group, carboxylic group, carbonyl group, acyl group, thio group sulfinyl group, sulfonyl group, phosphine group, partially perfluorinated C₁ to C₁₂ alkyl, perfluorinated C₁ to C₁₂ alkyl, CF₃, partially perfluorinated C₁ to C₆ alkoxy, perfluorinated C₁ to C₆ alkoxy, OCF₃, =N, =N-;
wherein two adjacent substituents R^{a}, R^{b}, and R¹ optionally be connected to form a heterocycle or carbocycle.

17. The organic electroluminescent device according to claims 12 to 16, wherein at least one of R^{a}, R^{b}, R^{c} or R^{d} is independently selected from the group of D1 to D108: 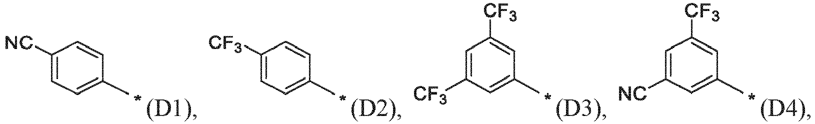 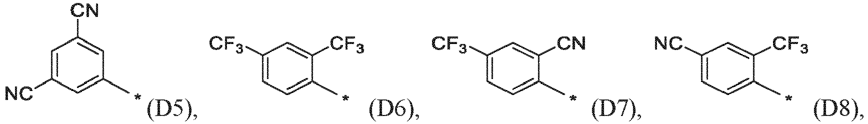 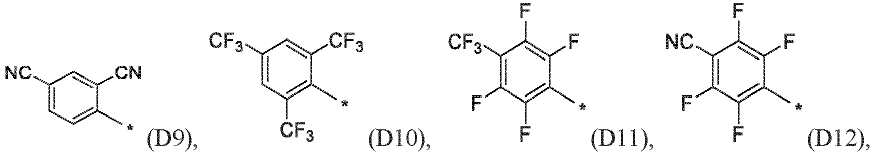 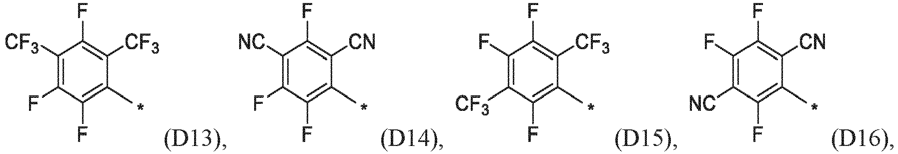 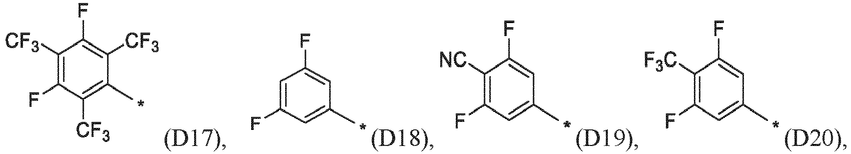 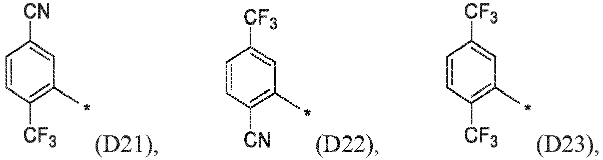 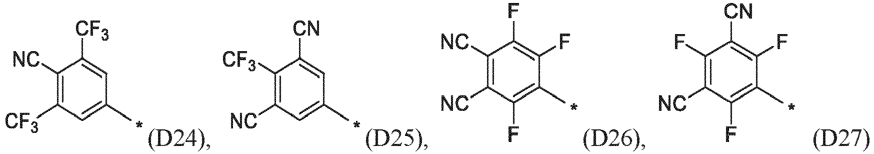 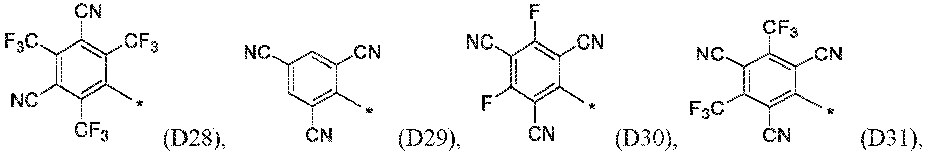 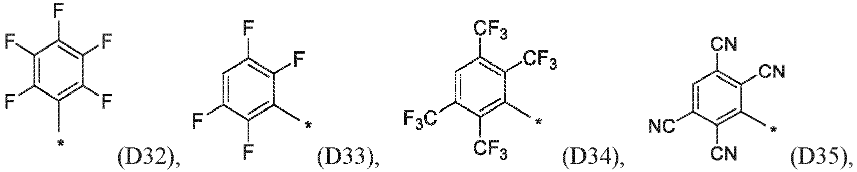 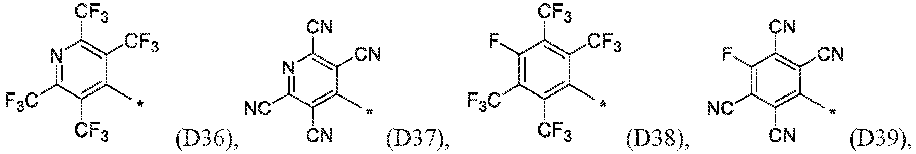 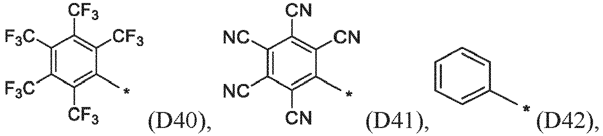 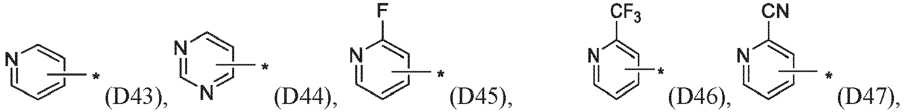 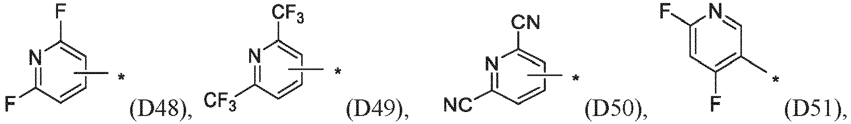 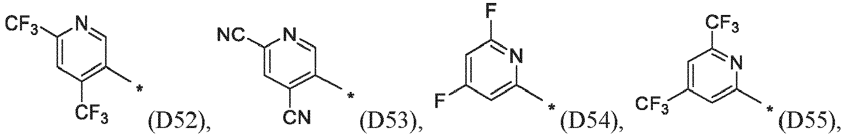 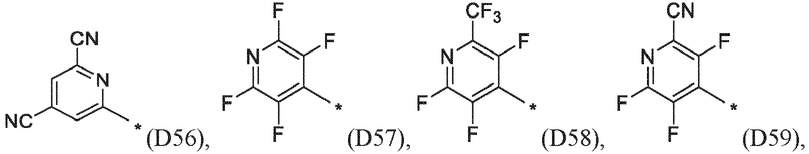 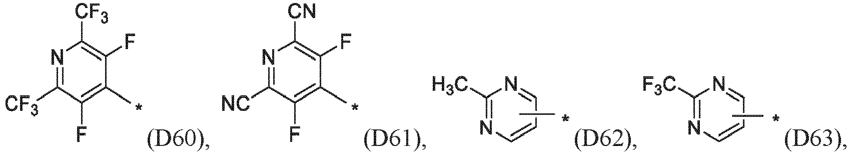 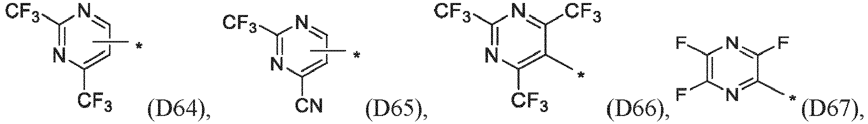 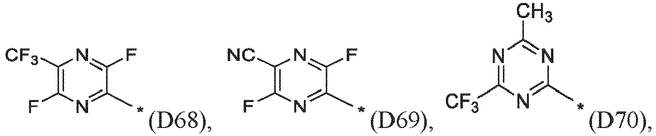 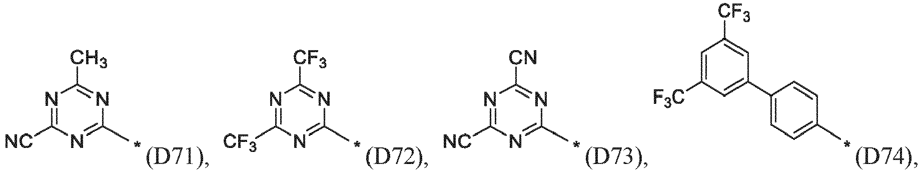 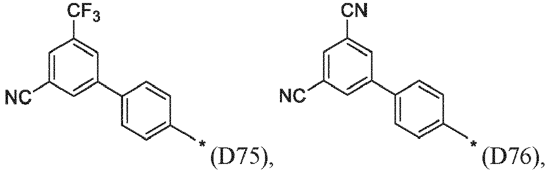
-CF₃ (D77), -C₂F₅ (D78), -C₃F₇ (D79), -CF₂CF₂CF₃ (D80), 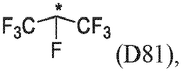
-C₄F₉ (D82), -CF₂CF₂CF₂CF₃ (D83), 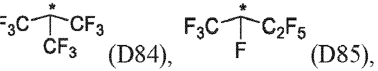
-C₅F₁₁ (D86), -C₆F₁₃ (D87), -CH₃ (D88), -C₂H₅ (D89) -CH(CH₃)₂ (D90),
-C(CH₃)₃ (91), 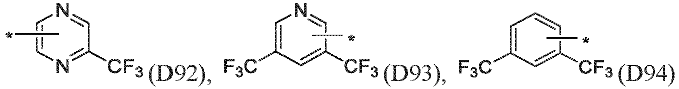 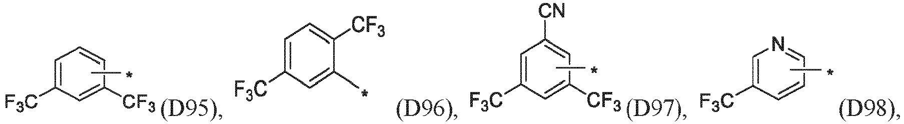 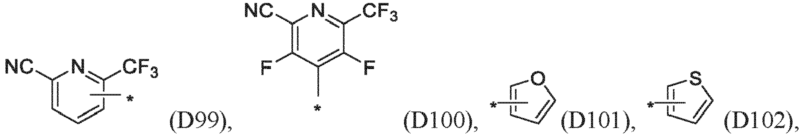 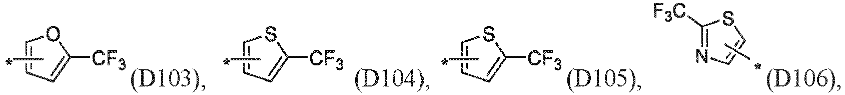 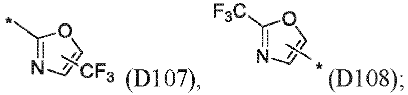 wherein the "*" or "-" denotes the binding position.

18. The organic electroluminescent device according to any one of claims 1 to 17, wherein the monoanion and/or monoanionic ligand L is selected from a group L1 to L518:

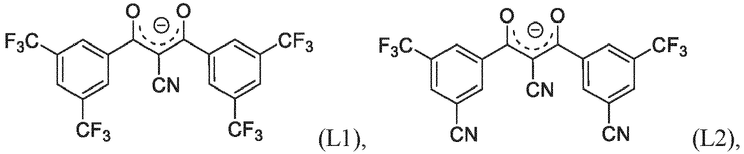

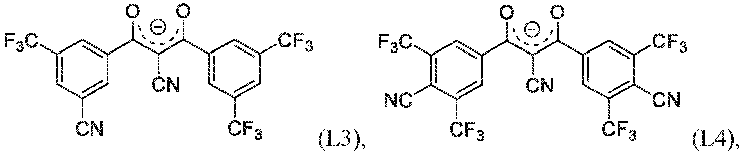

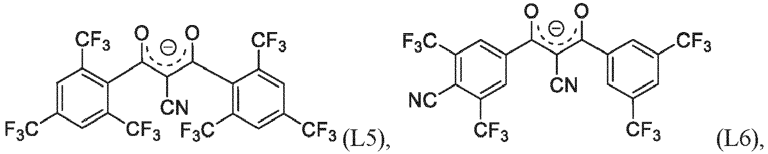

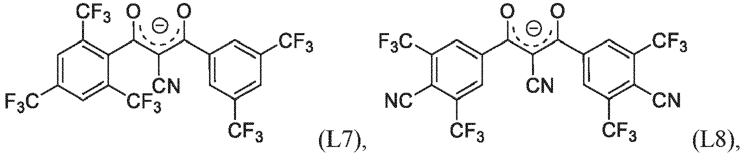

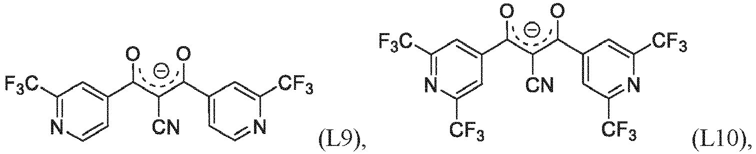

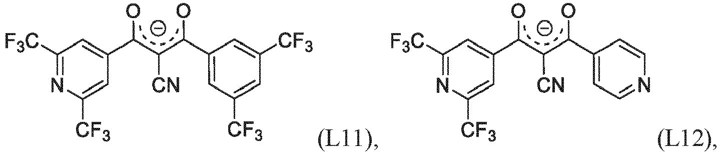

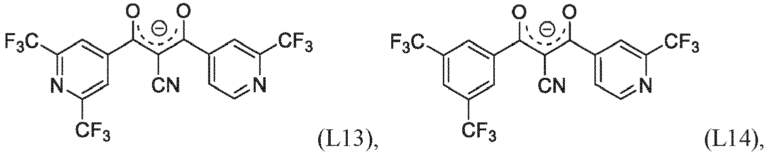

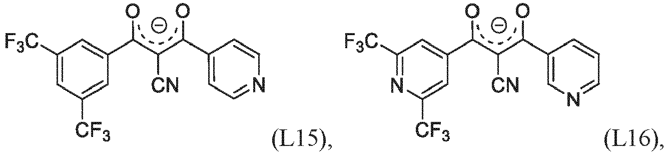

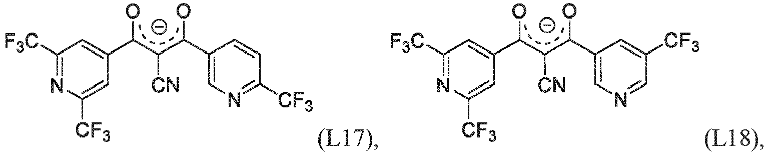

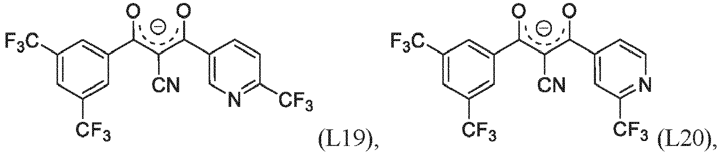

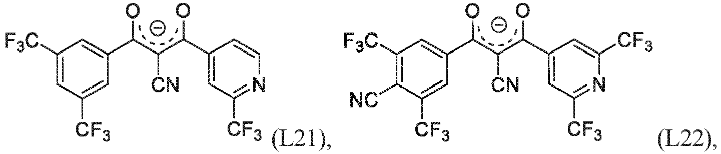

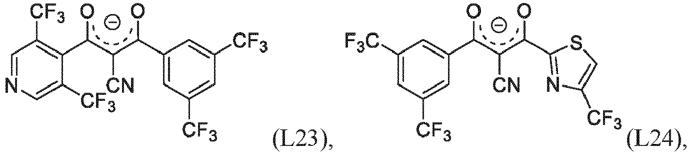

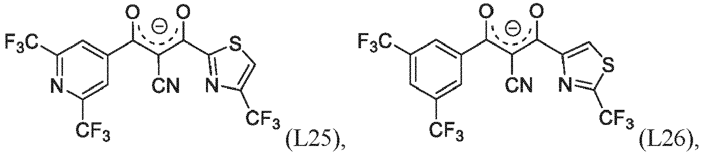

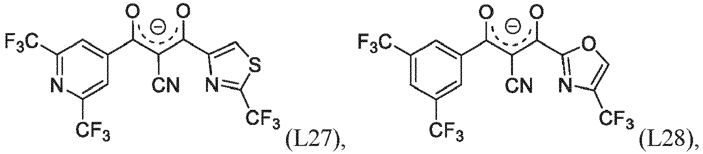

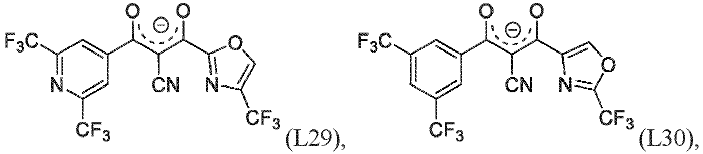

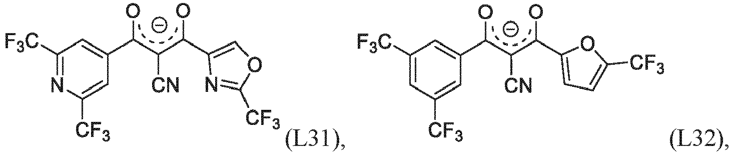

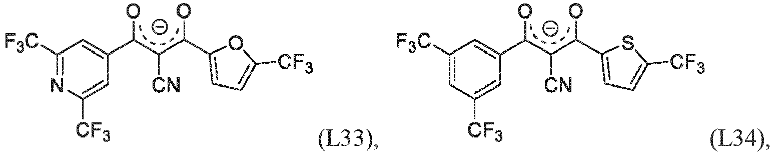

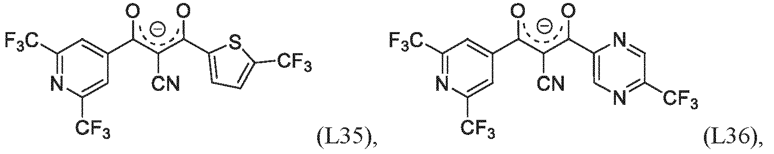

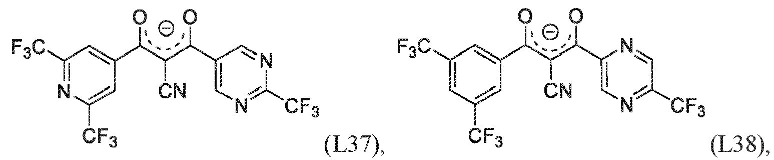

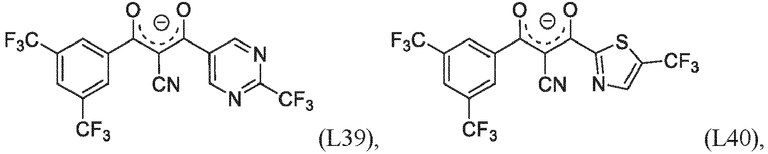

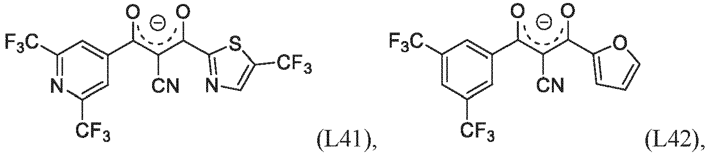

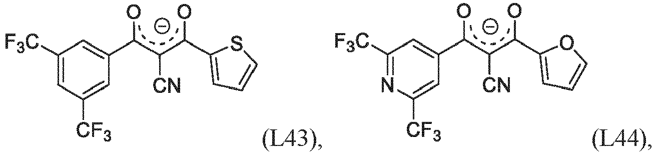

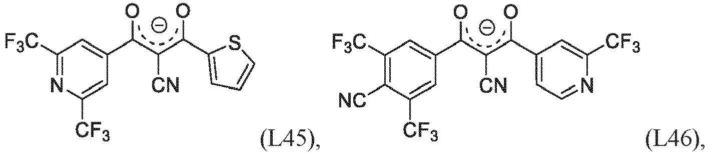

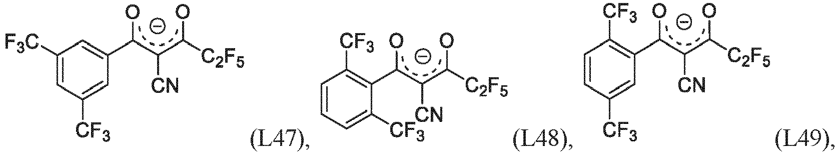

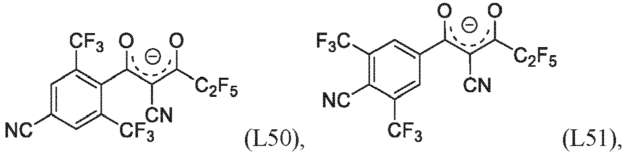

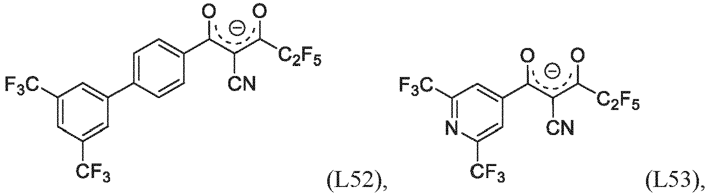

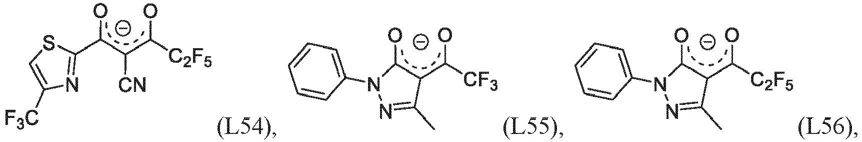

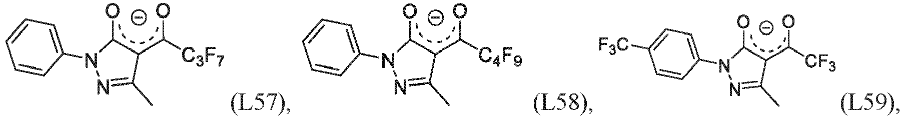

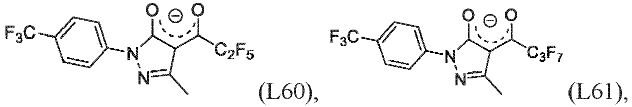

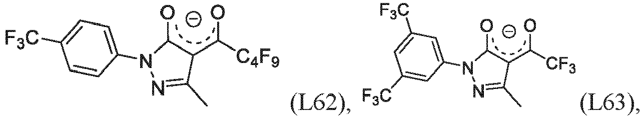

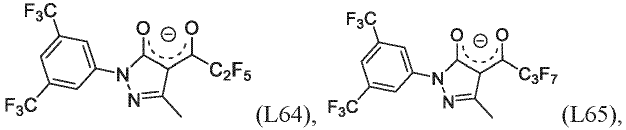

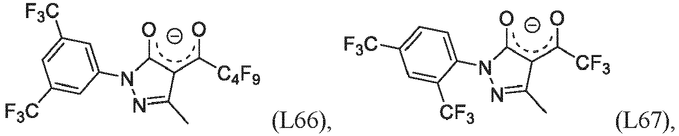

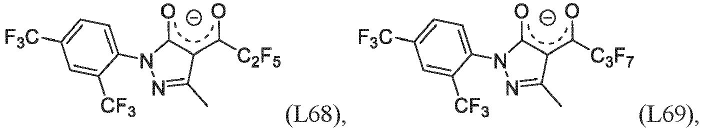

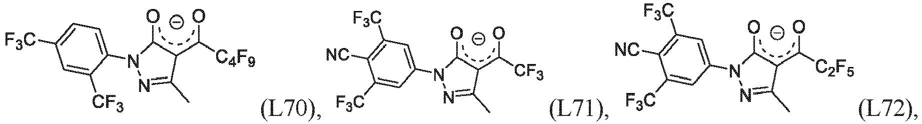

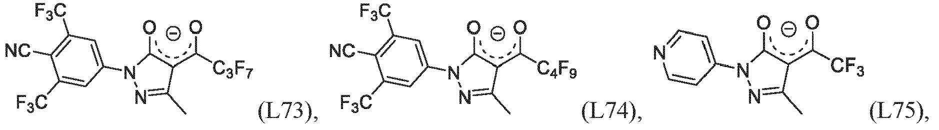

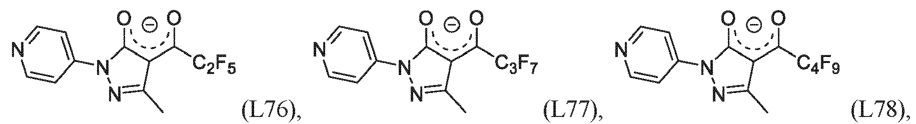

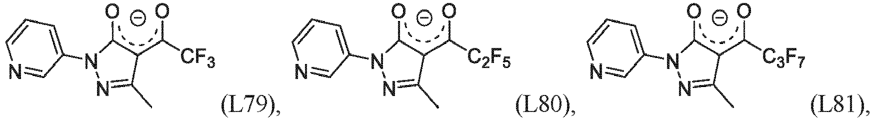

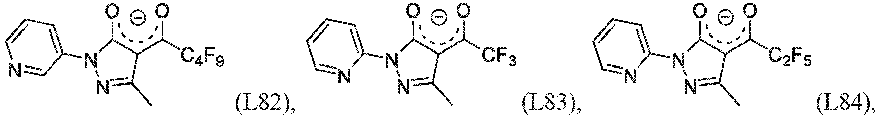

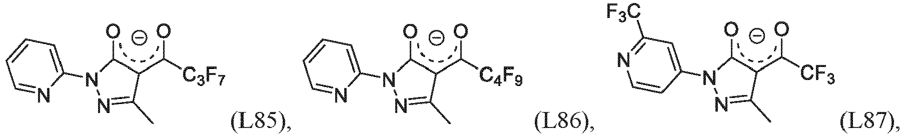

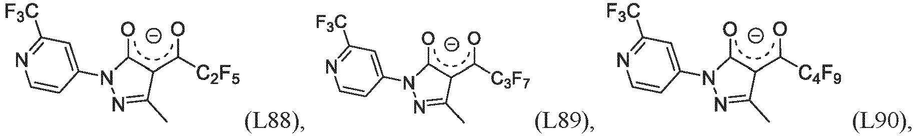

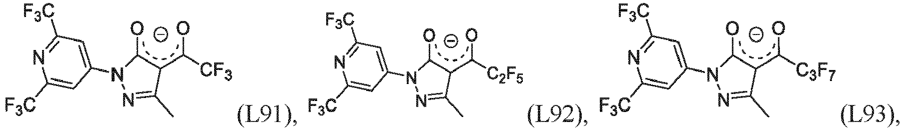

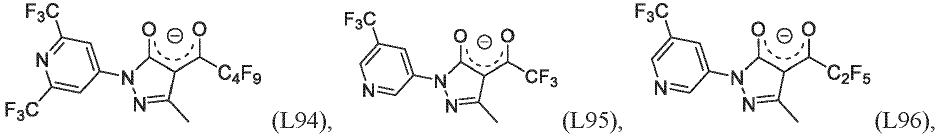

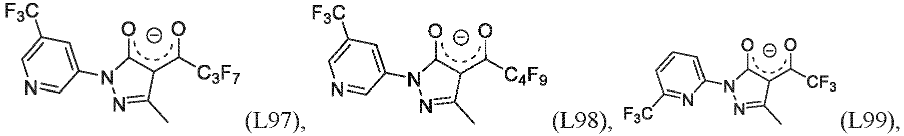

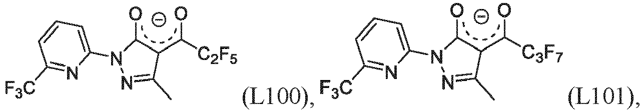

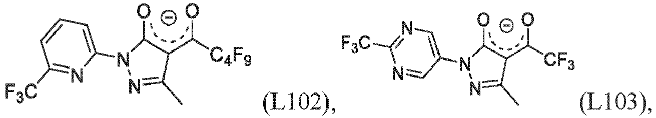

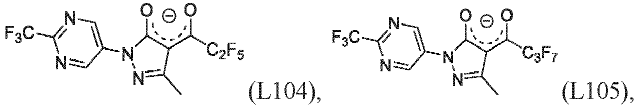

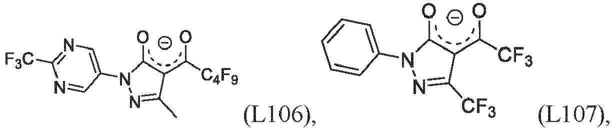

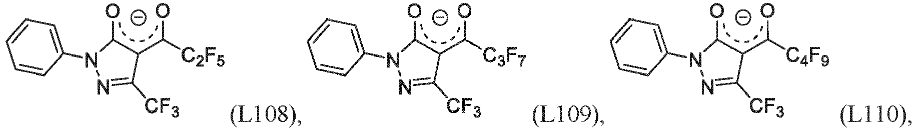

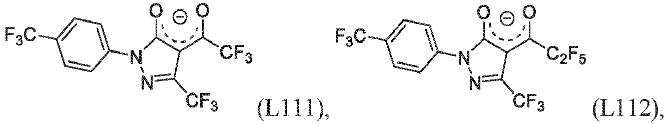

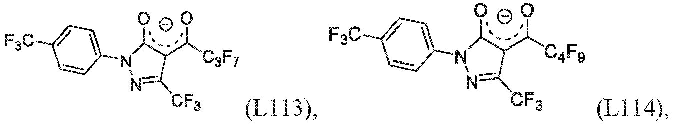

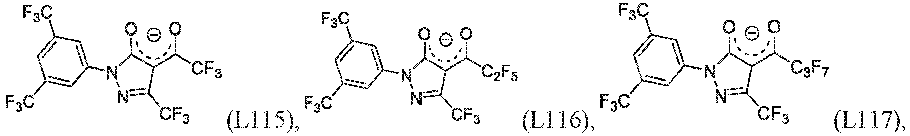

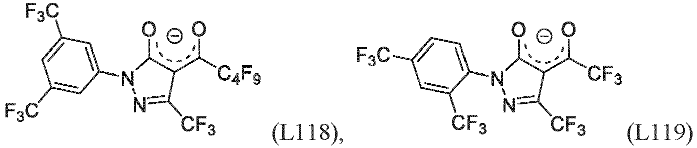

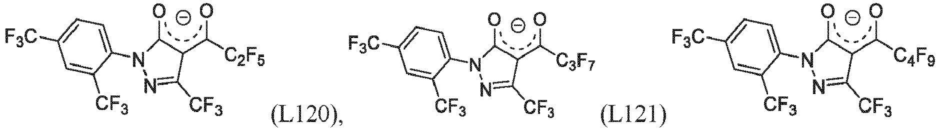

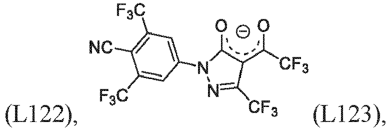

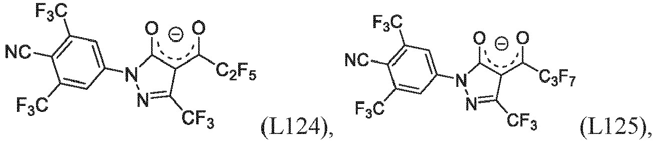

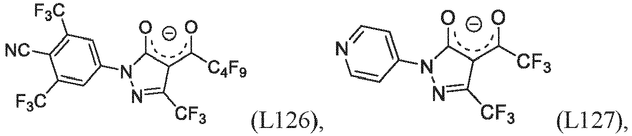

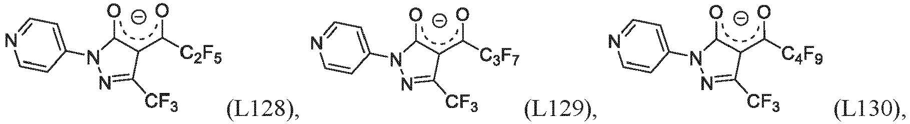

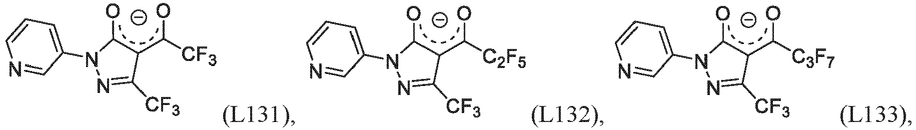

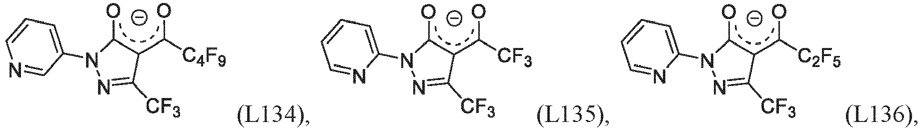

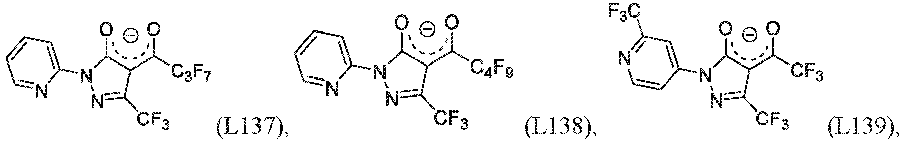

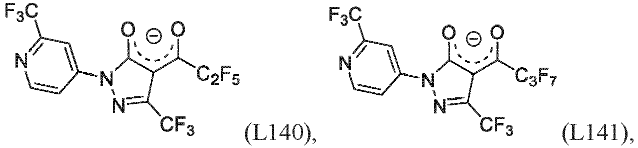

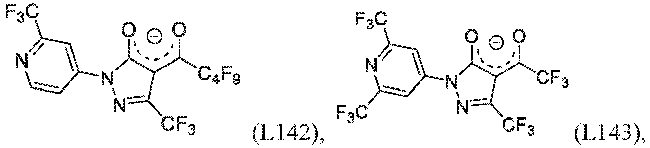

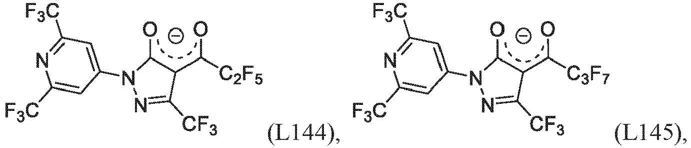

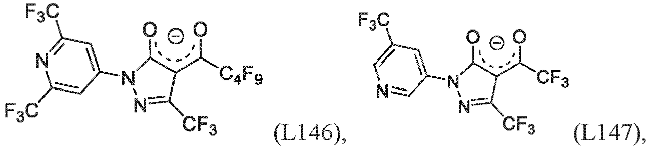

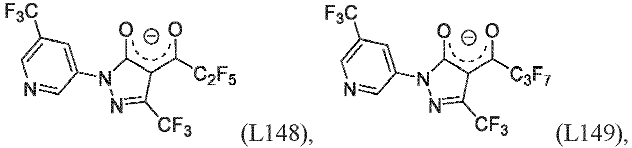

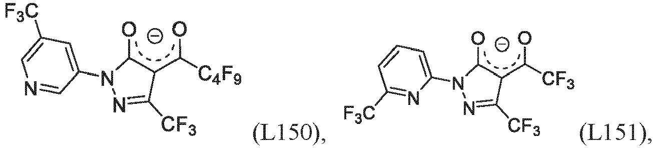

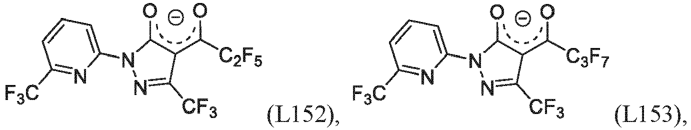

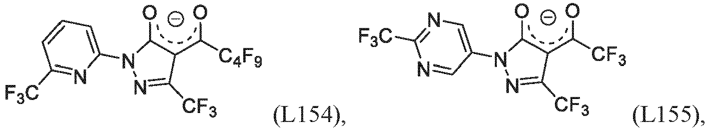

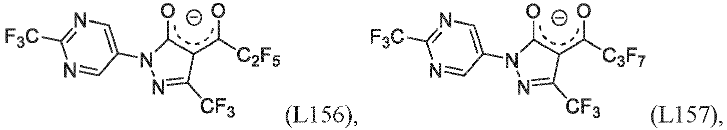

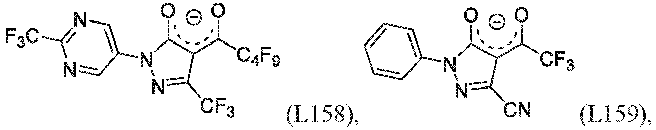

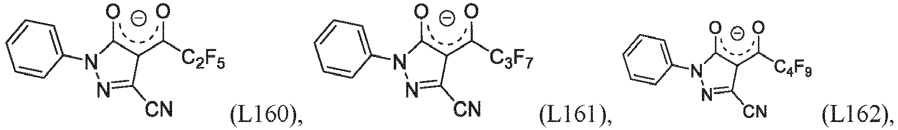

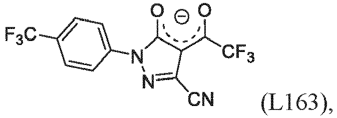

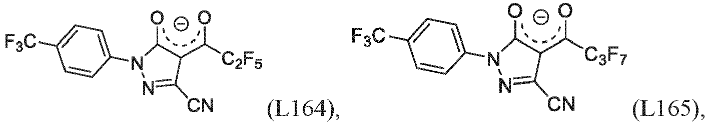

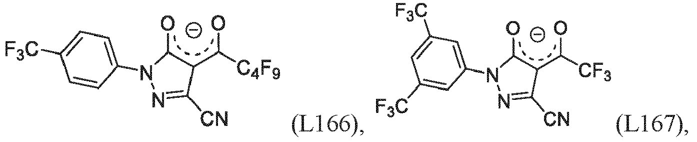

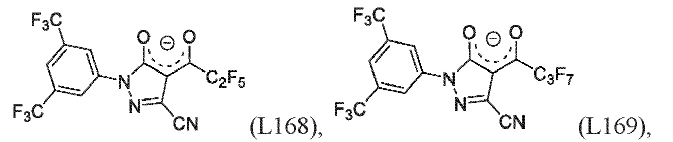

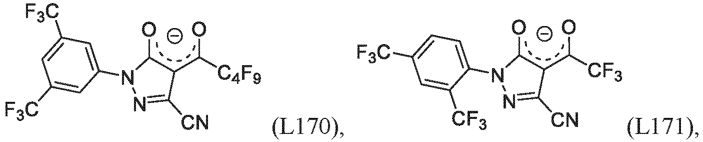

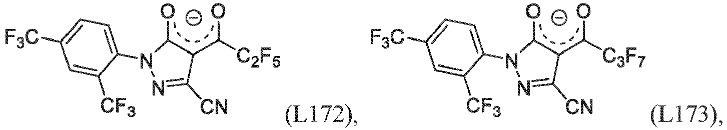

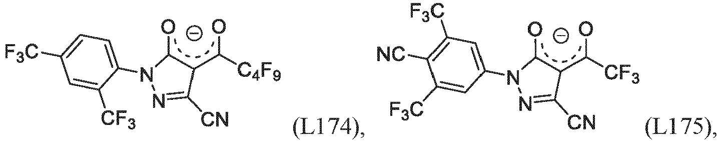

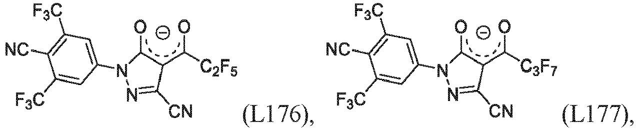

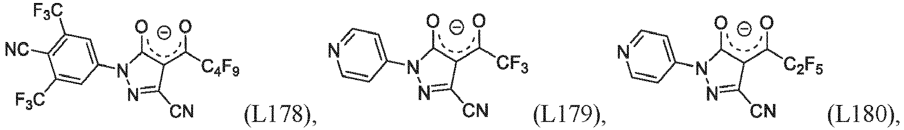

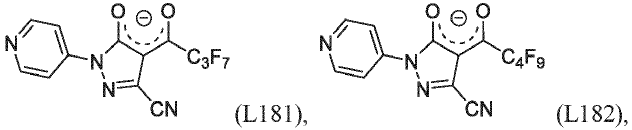

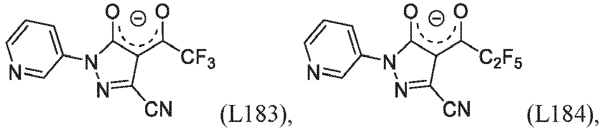

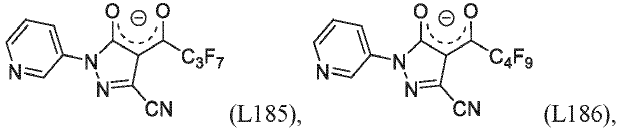

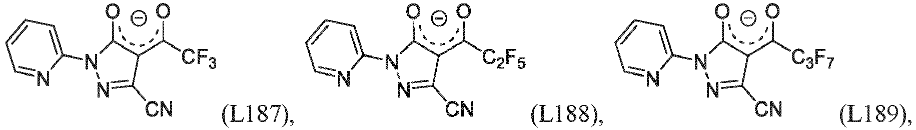

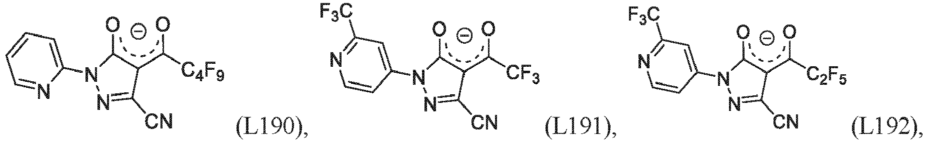

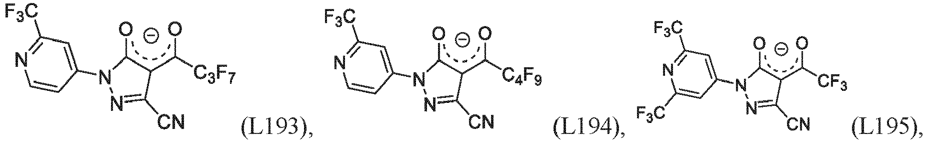

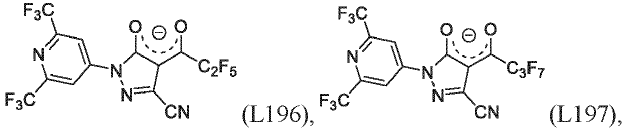

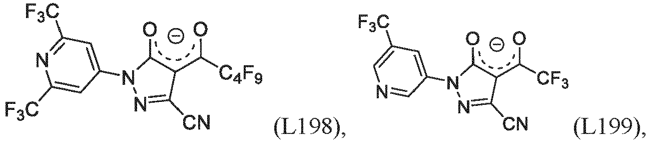

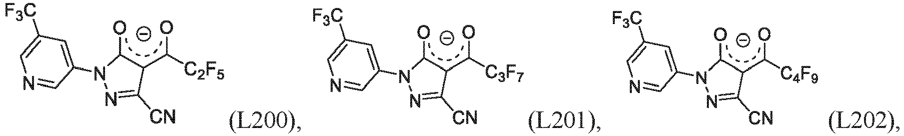

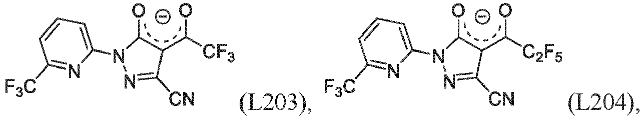

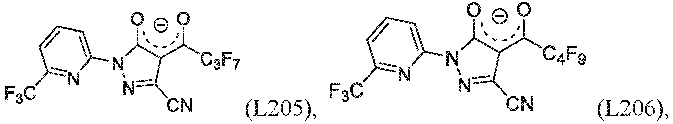

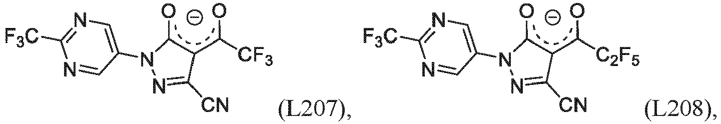

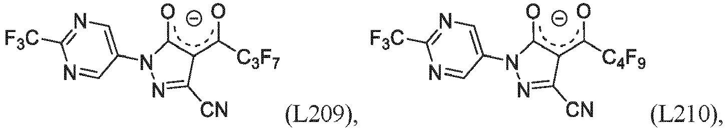

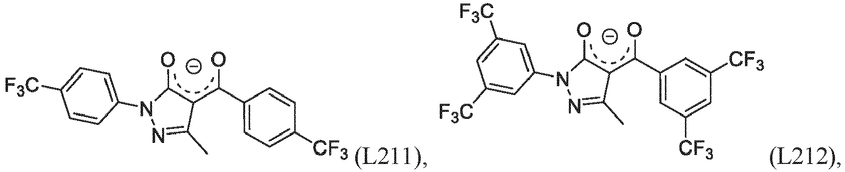

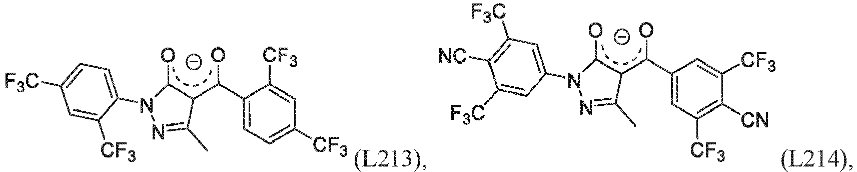

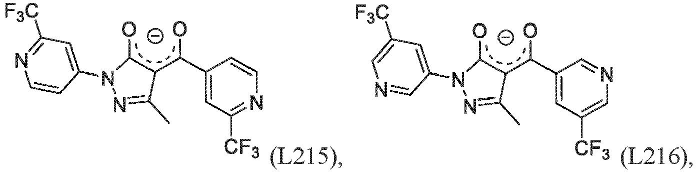

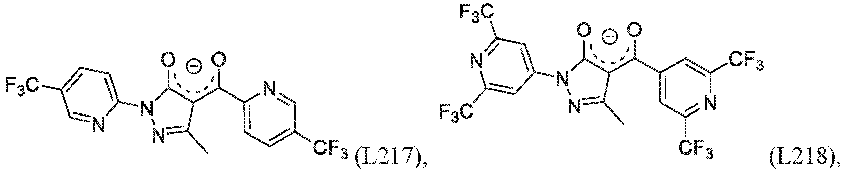

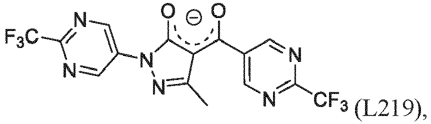

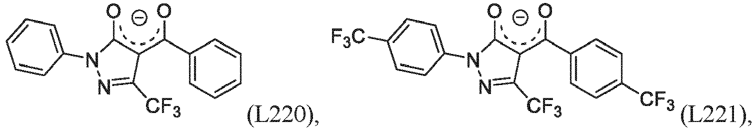

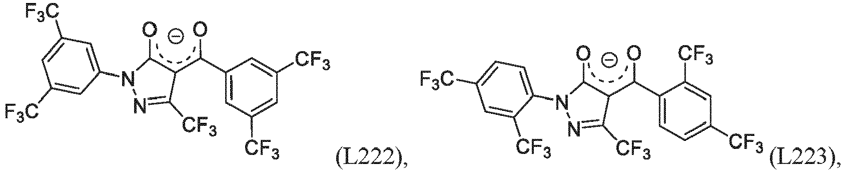

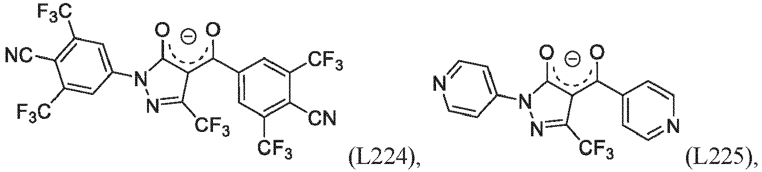

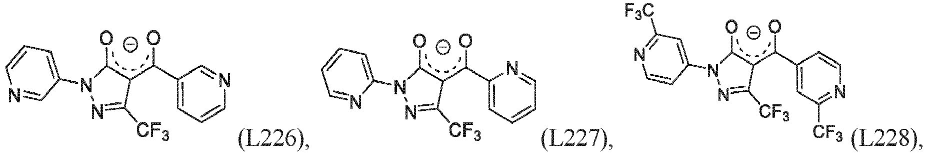

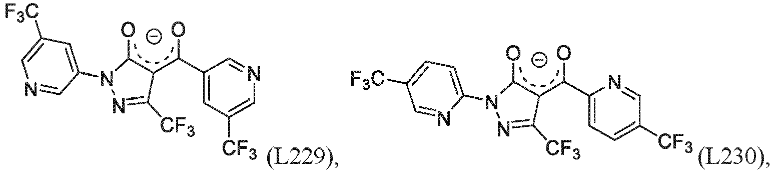

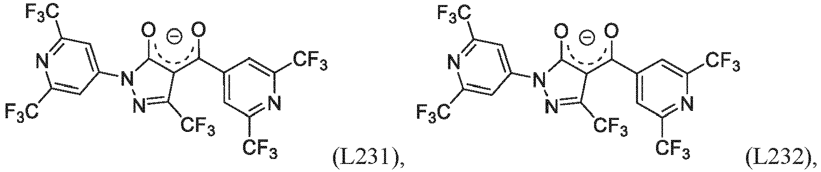

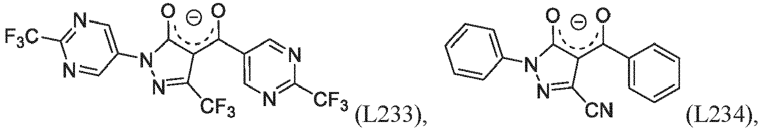

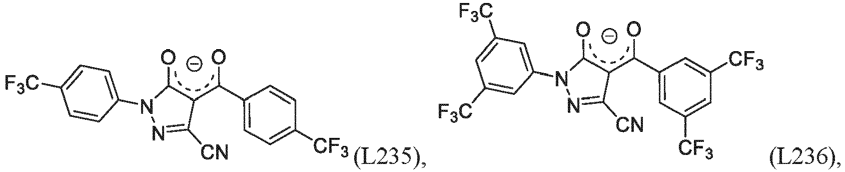

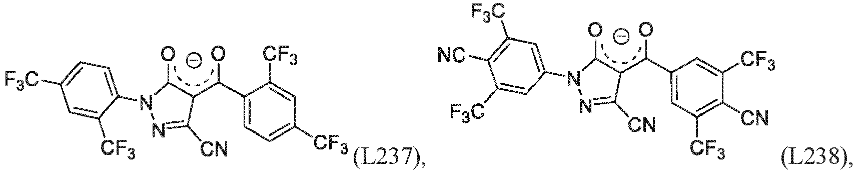

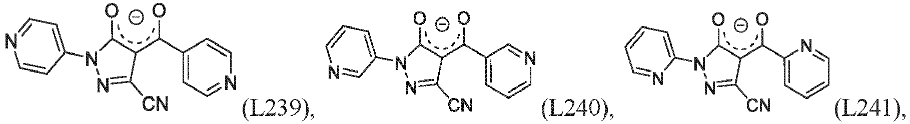

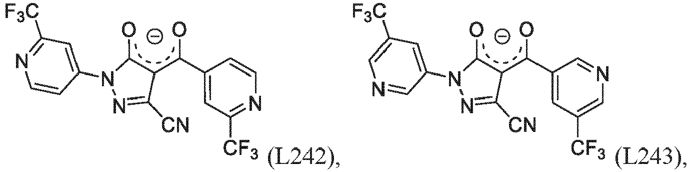

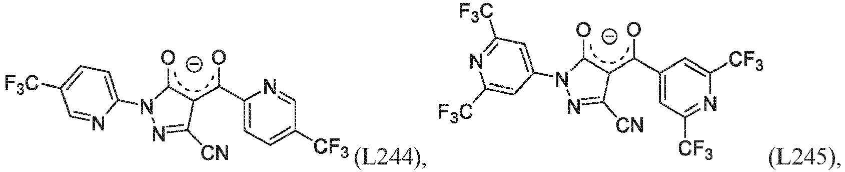

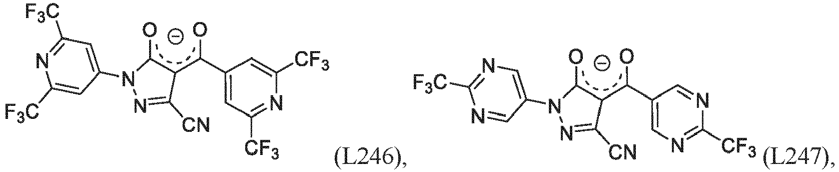

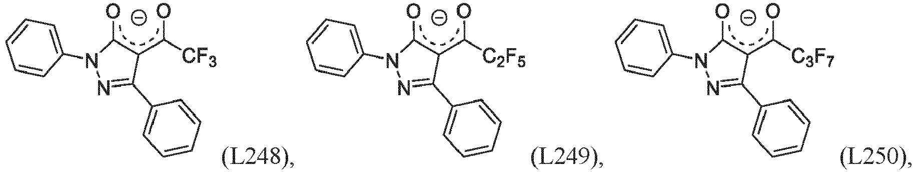

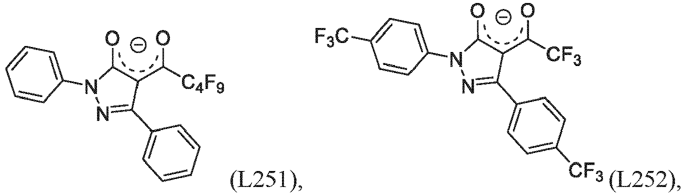

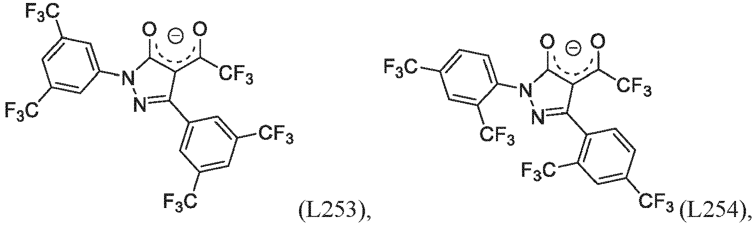

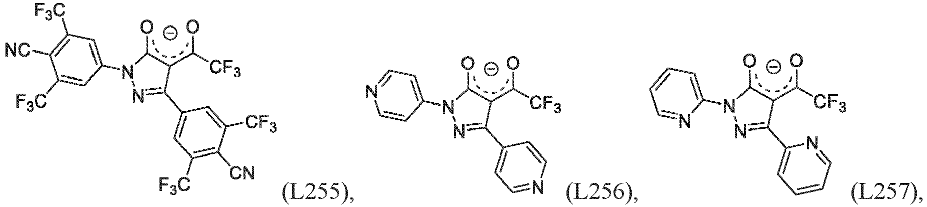

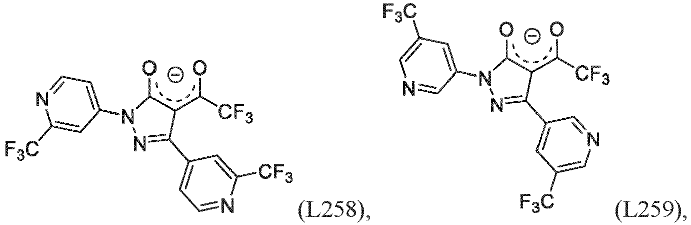

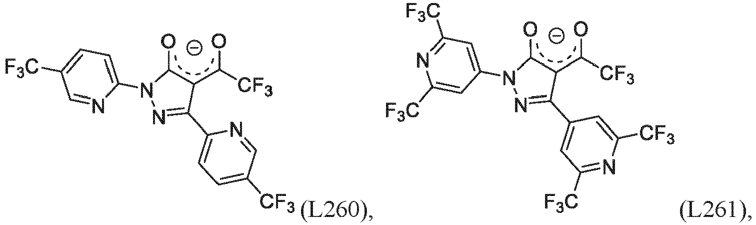

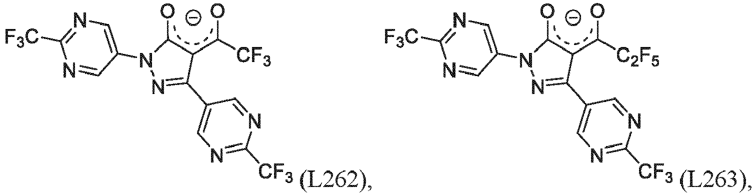

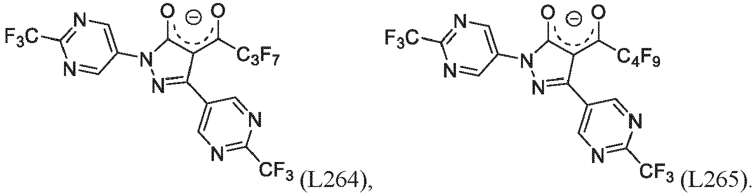

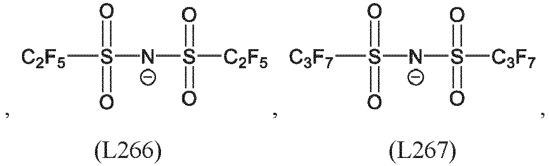

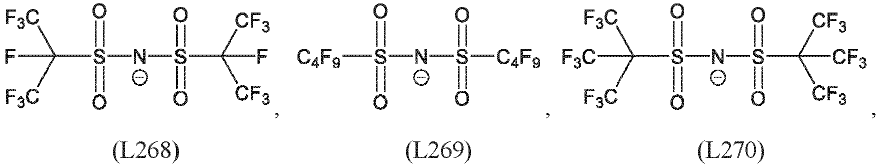

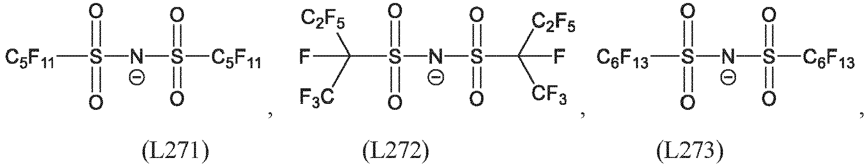

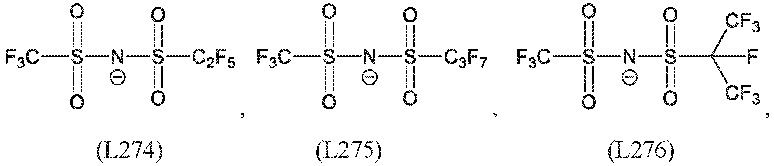

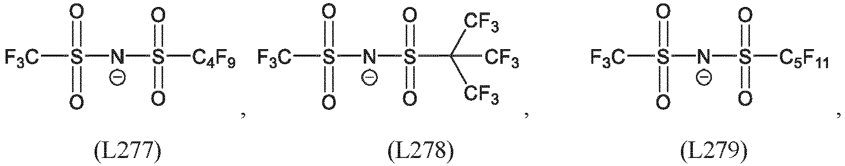

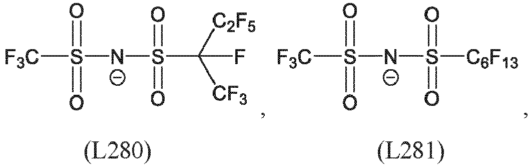

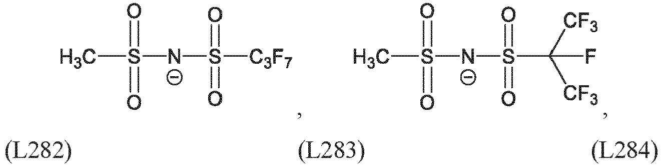

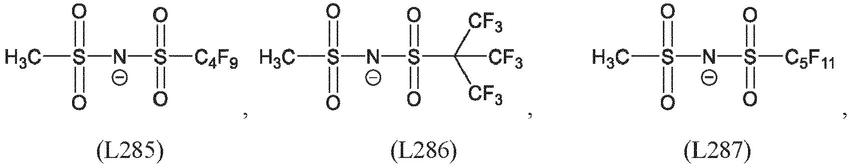

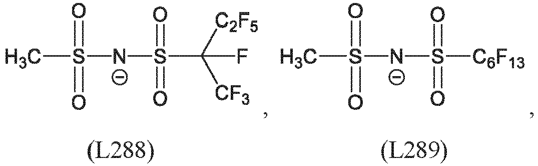

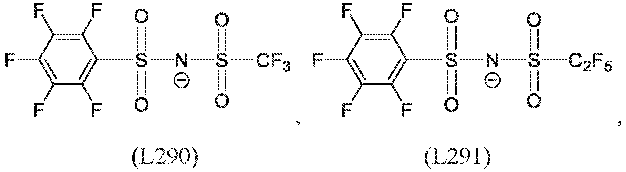

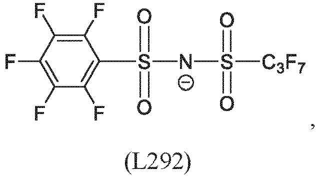

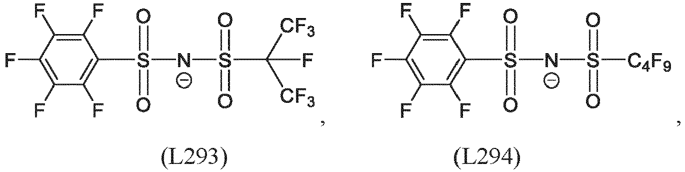

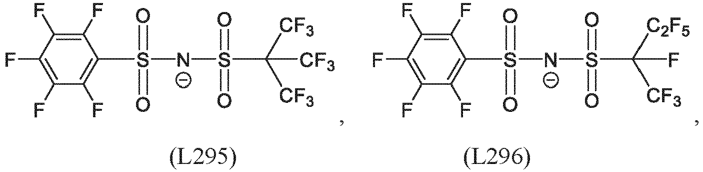

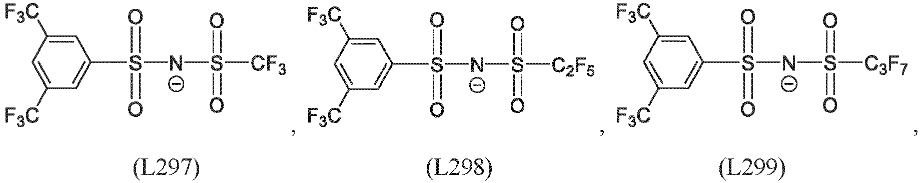

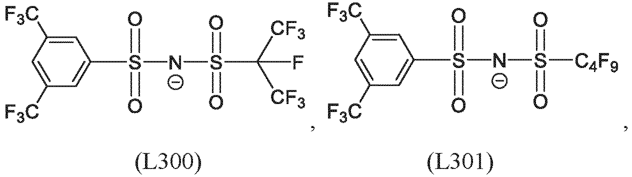

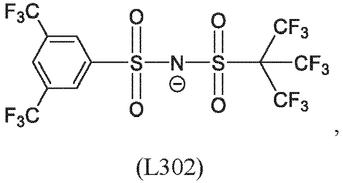

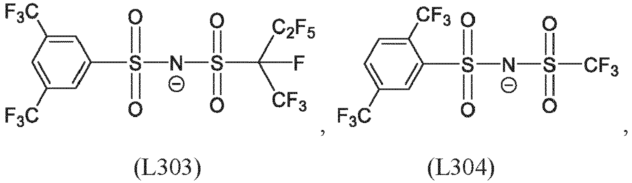

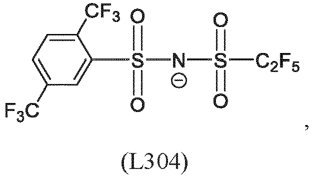

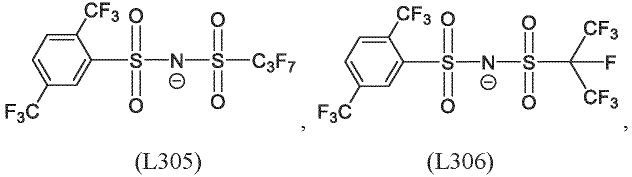

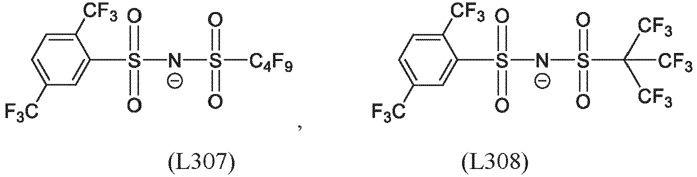

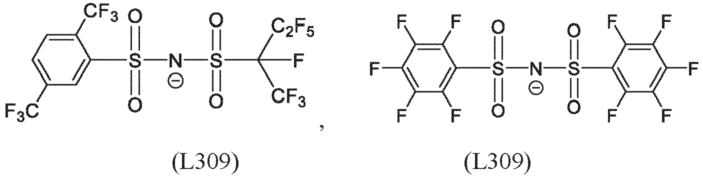

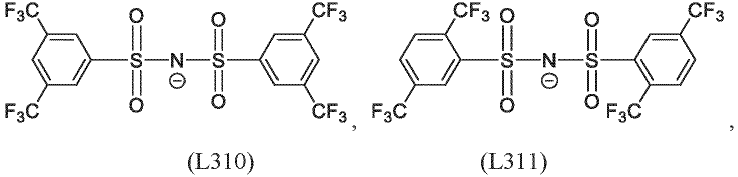

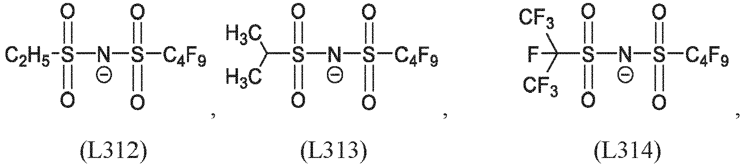

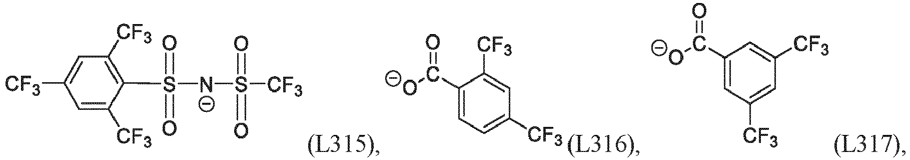

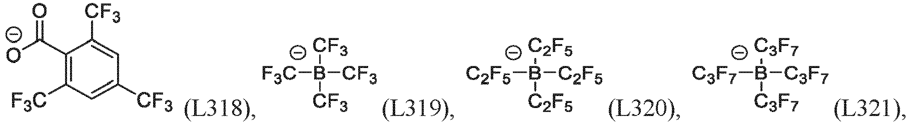

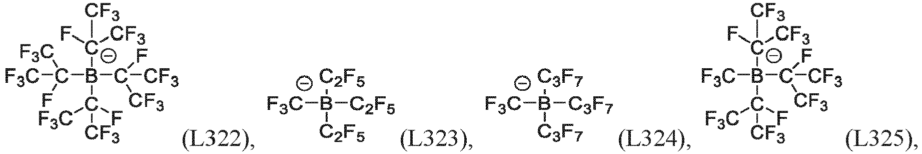

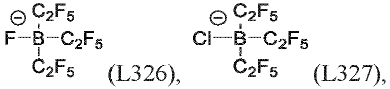

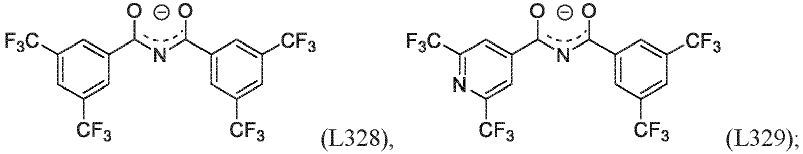

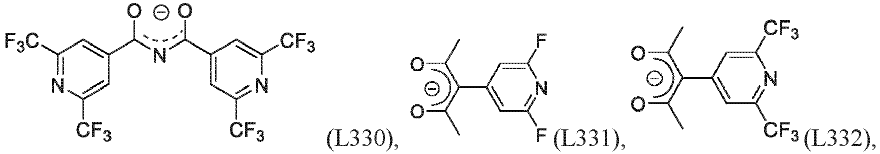

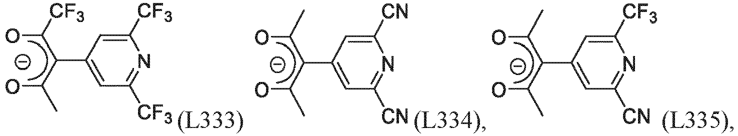

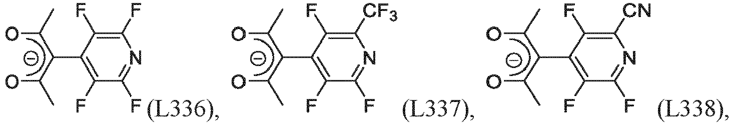

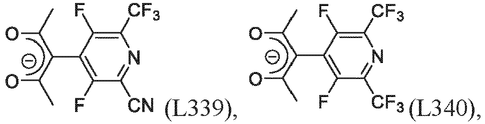

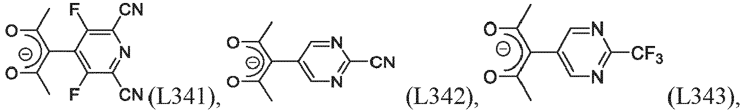

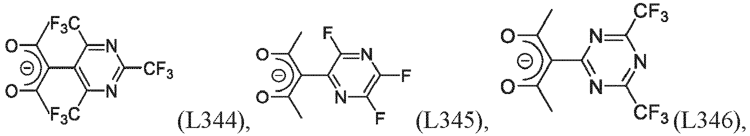

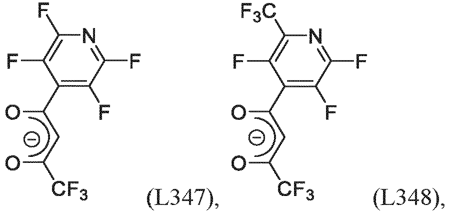

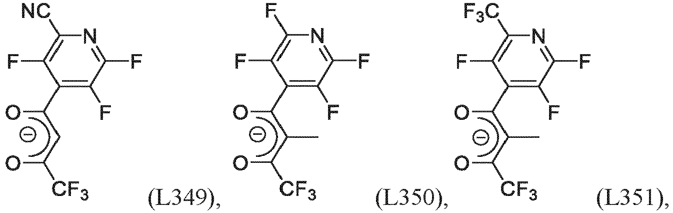

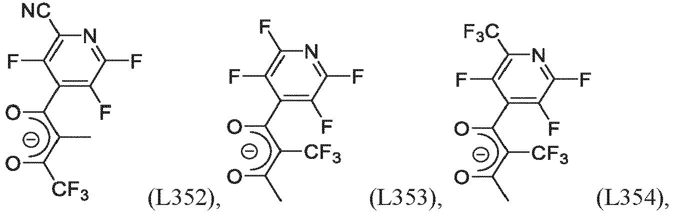

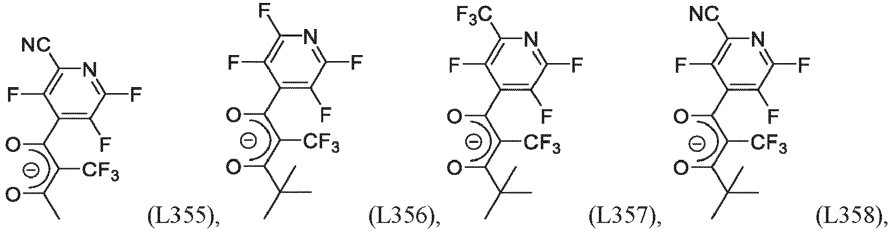

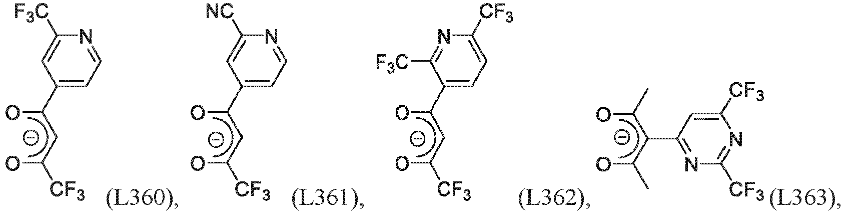

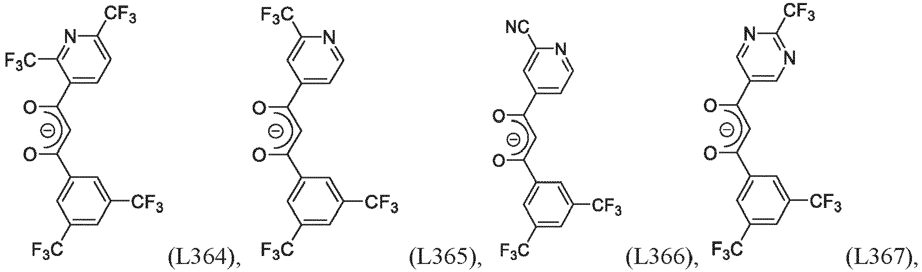

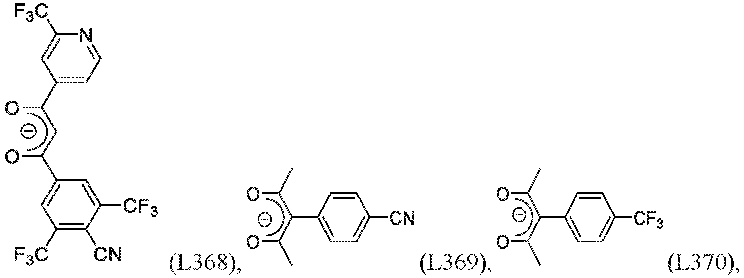

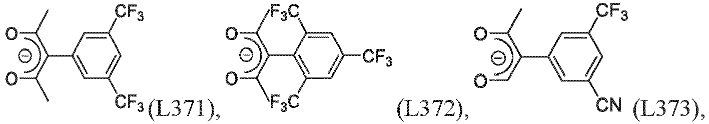

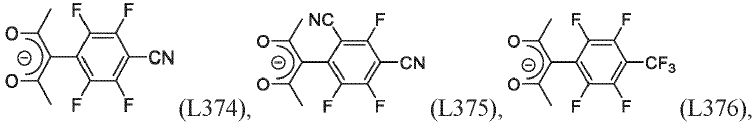

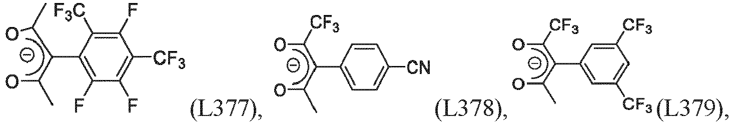

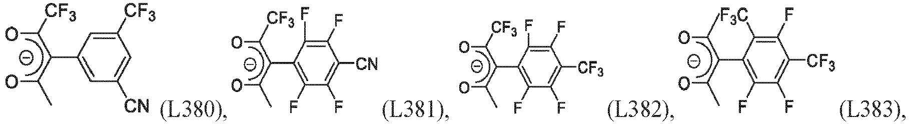

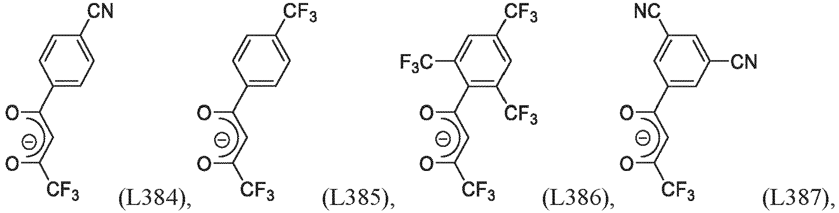

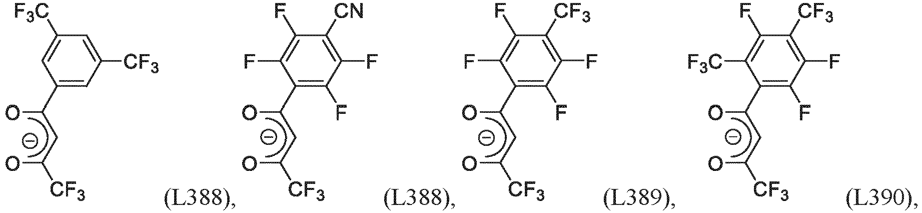

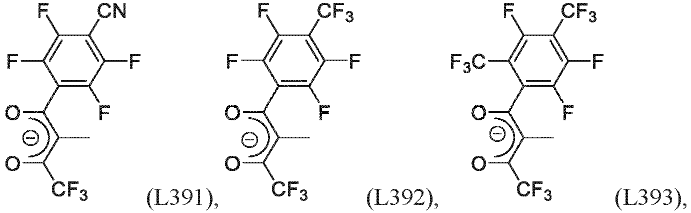

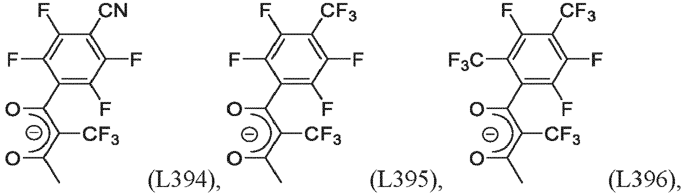

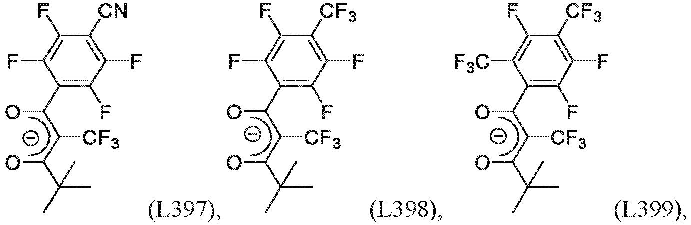

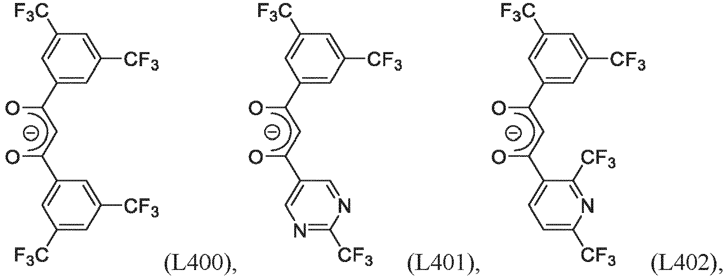

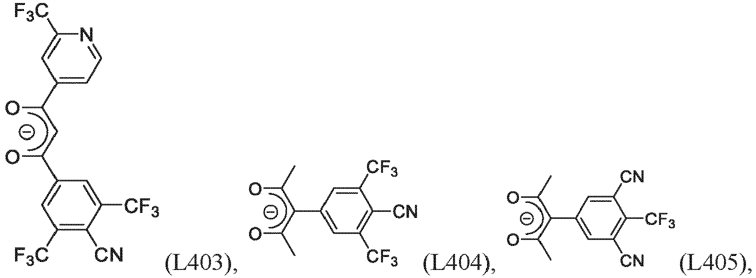

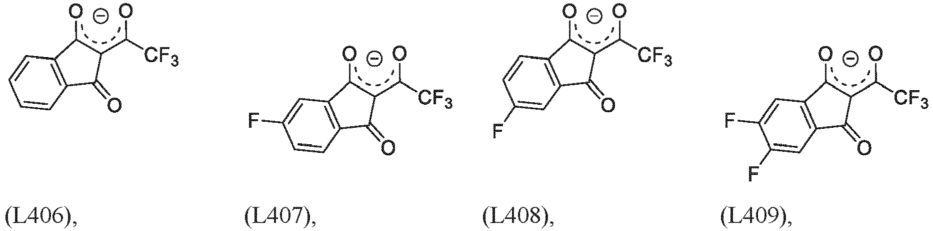

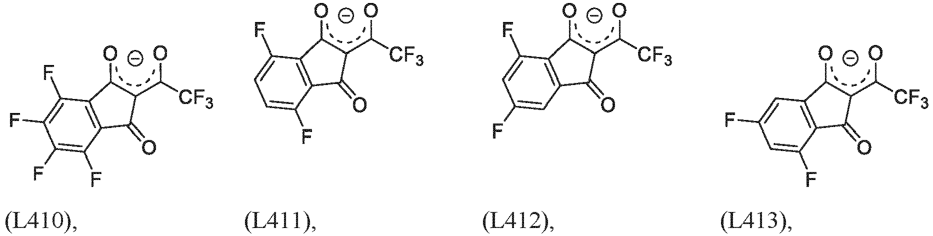

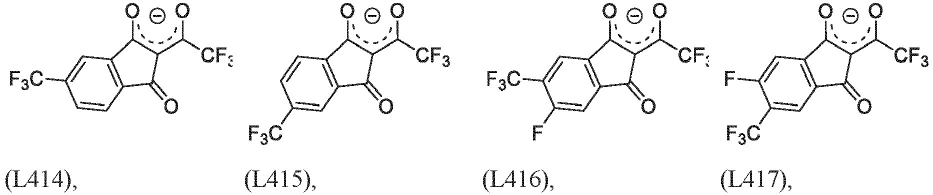

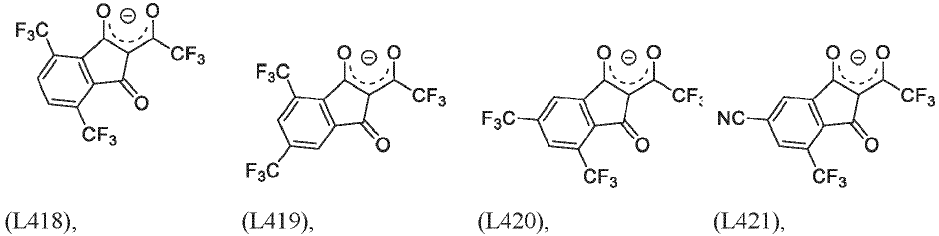

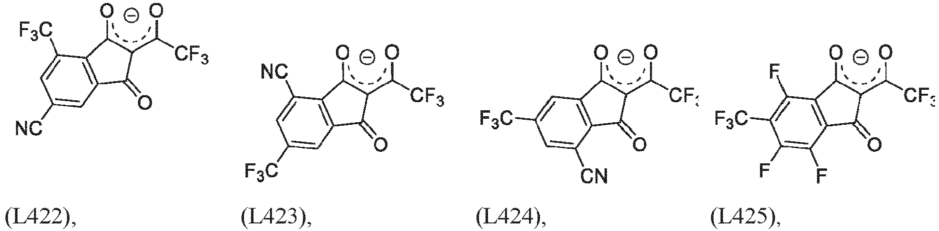

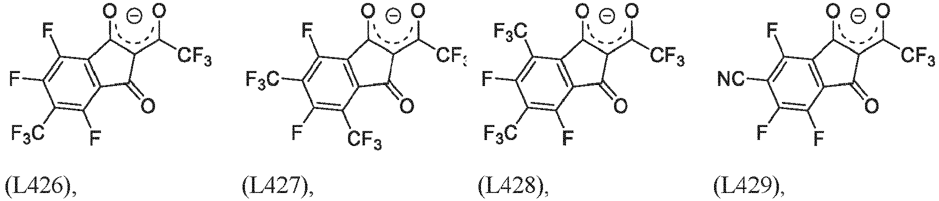

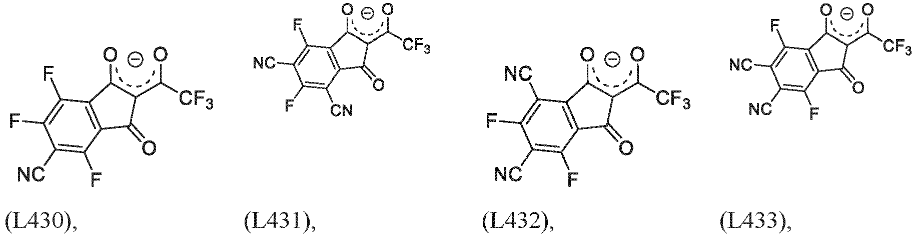

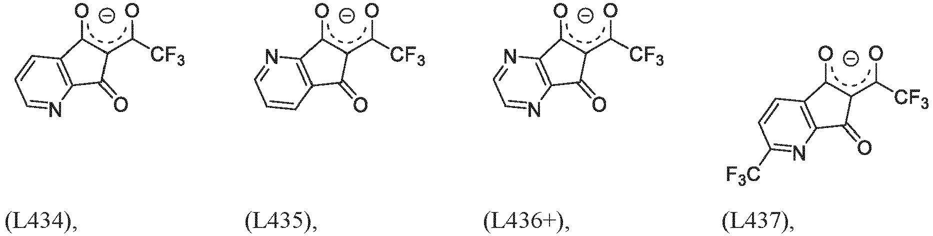

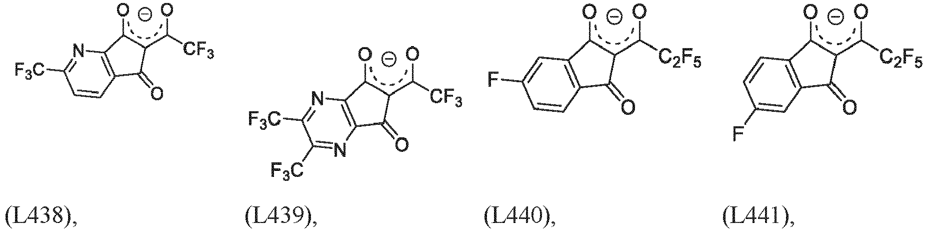

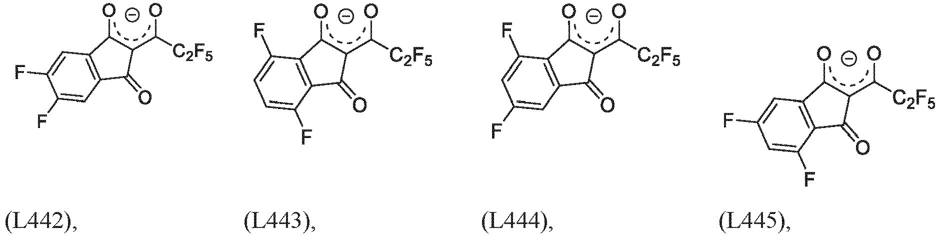

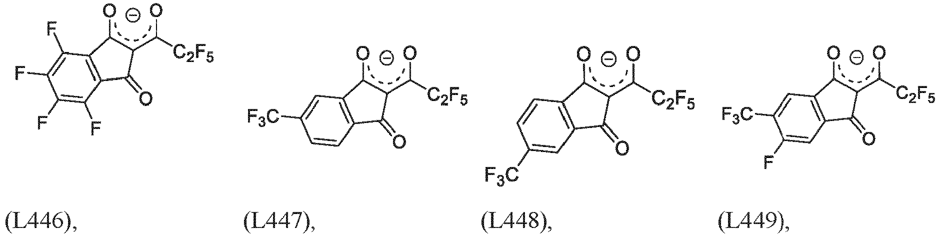

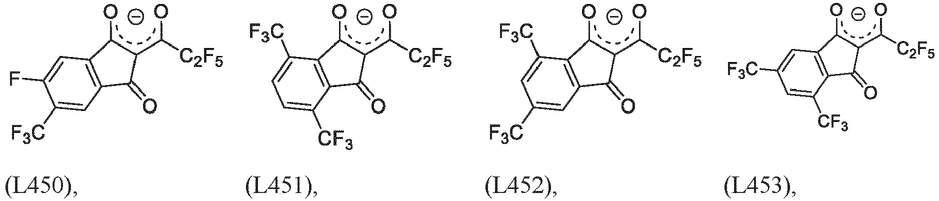

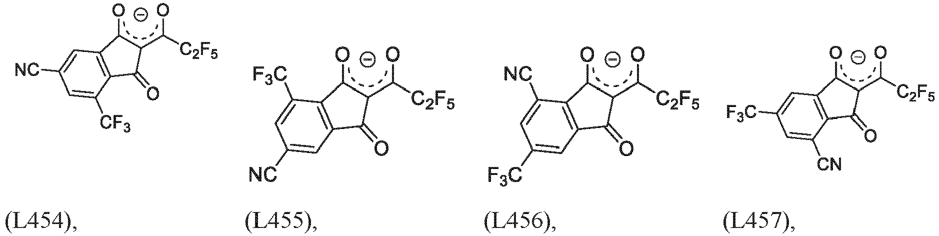

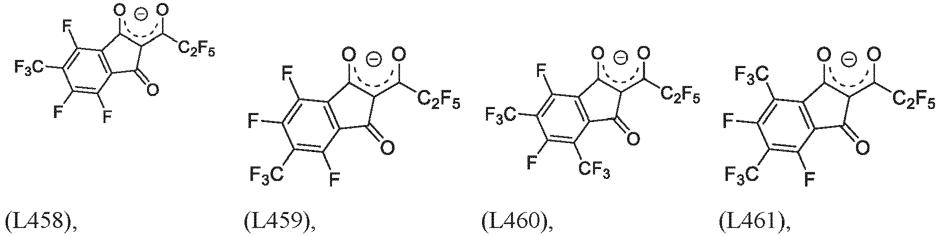

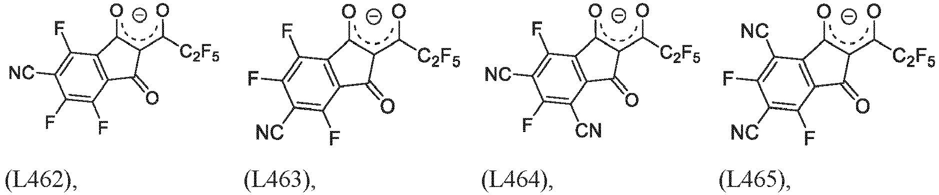

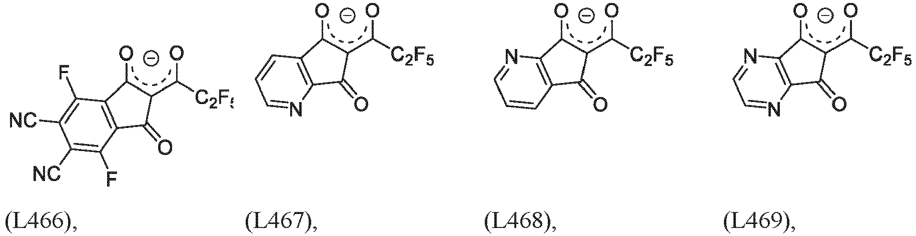

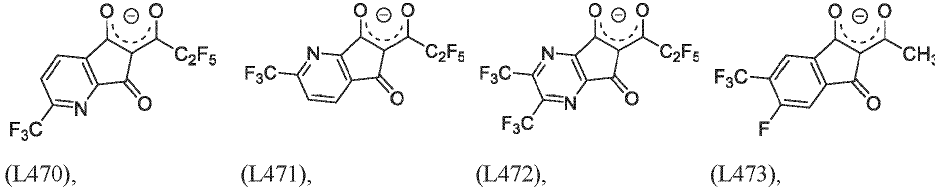

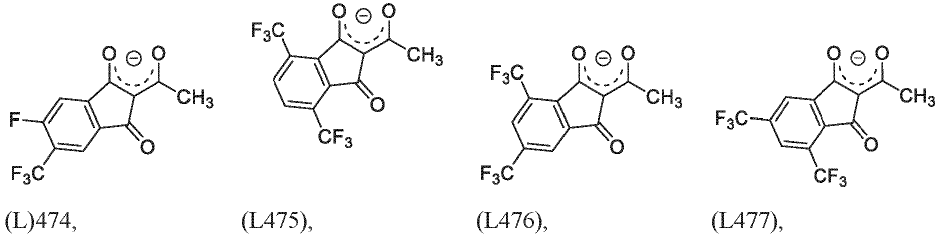

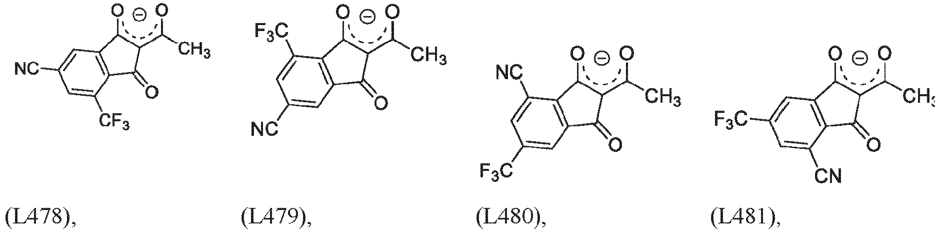

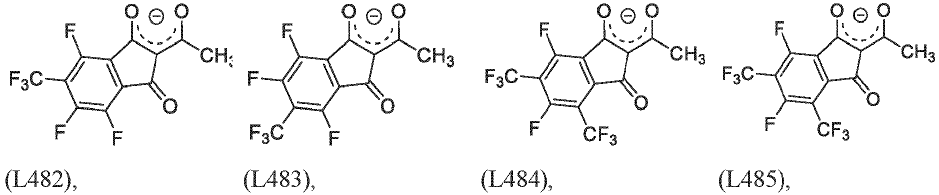

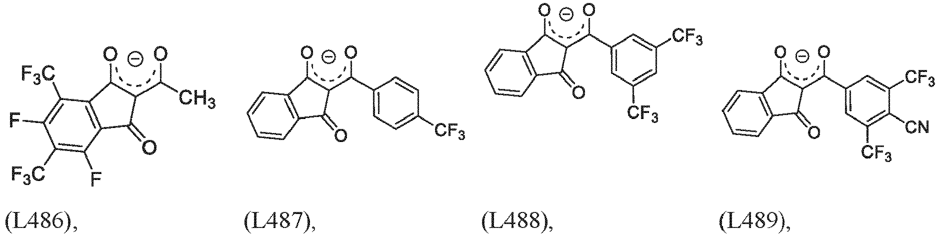

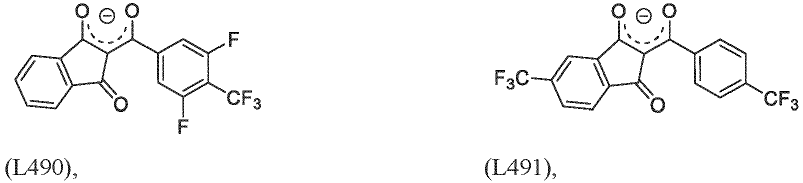

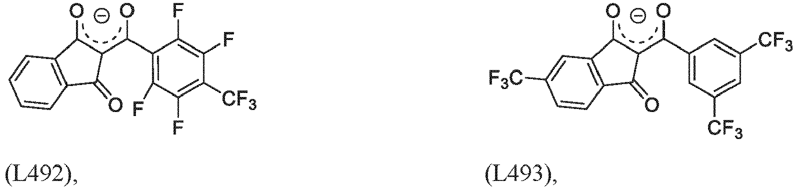

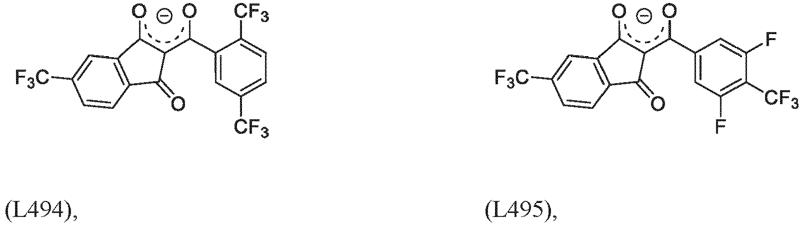

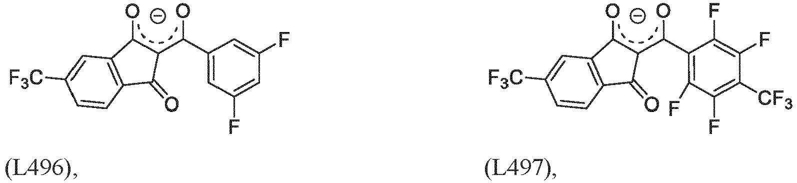

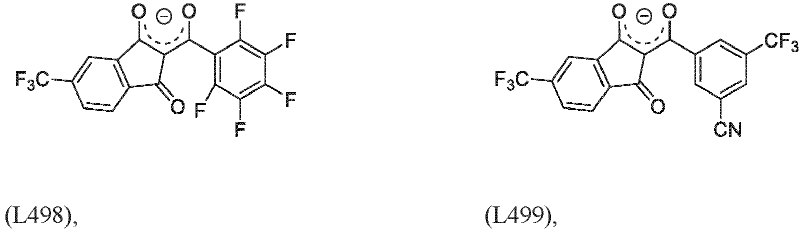

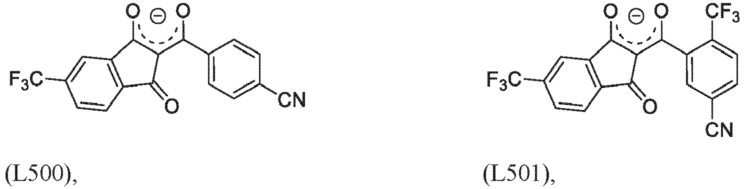

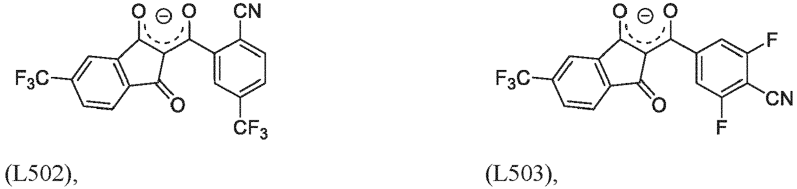

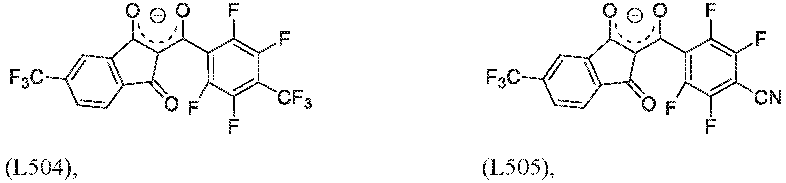

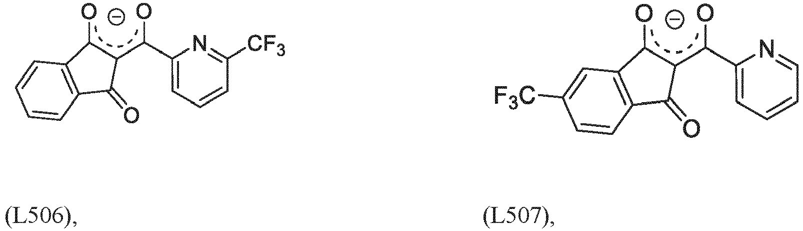

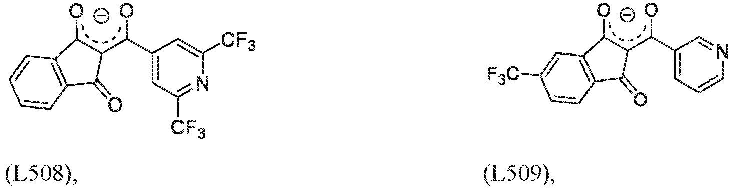

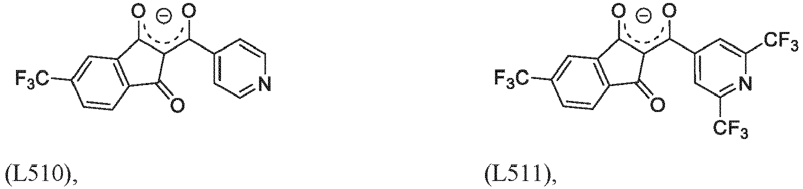

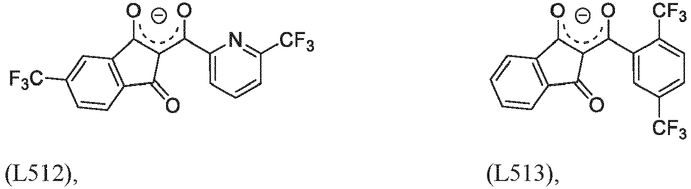

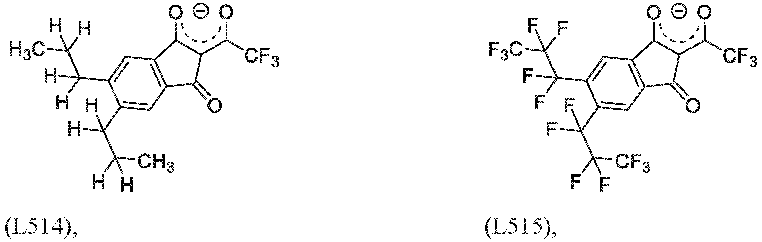

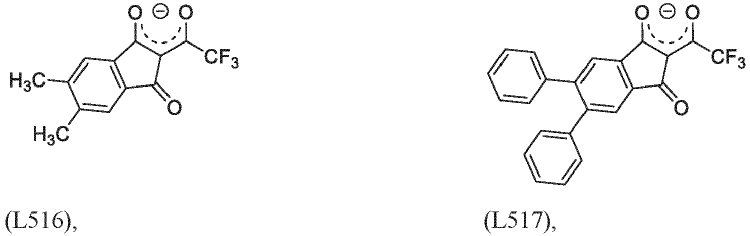

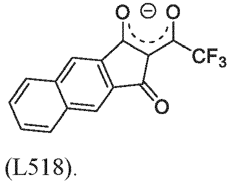

19. The organic electroluminescent device according to any of claims 1 to 18, wherein the first metal compound and/or the second metal compound, preferably the first metal compound and/or the second metal compound represented by formula (II), comprises an ancillary ligand (AL), which coordinates to a metal cation or a metal cation M^{p+}.

20. The organic electroluminescent device according to claim 19, wherein the ancillary ligand (AL) is selected from the group comprising H₂O, C₂ to C₄₀ mono- or multi-dentate ethers and C₂ to C₄₀ thioethers, C₂ to C₄₀ amines, C₂ to C₄₀ phosphine, C₂ to C₂₀ alkyl nitrile, C₂ to C₄₀ aryl nitrile, or a compound according to Formula (X): 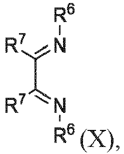 wherein
R⁶ and R⁷ are independently selected from C₁ to C₂₀ alkyl, C₁ to C₂₀ heteroalkyl, C₆ to C₂₀ aryl, heteroaryl with 5 to 20 ring-forming atoms, halogenated or perhalogenated C₁ to C₂₀ alkyl, halogenated or perhalogenated C₁ to C₂₀ heteroalkyl, halogenated or perhalogenated C₆ to C₂₀ aryl, halogenated or perhalogenated heteroaryl with 5 to 20 ring-forming atoms, or at least one R⁶ and R⁷ are bridged and form a 5 to 20 member ring, or the two R⁶ and/or the two R⁷ are bridged and form a 5 to 40 member ring or form a 5 to 40 member ring comprising an unsubstituted or C₁ to C₁₂ substituted phenanthroline.

21. The organic electroluminescent device according to any one of claims 1 to 20, wherein the metal compound or the compound of formula (II) is selected from the following compounds M1 to M9:

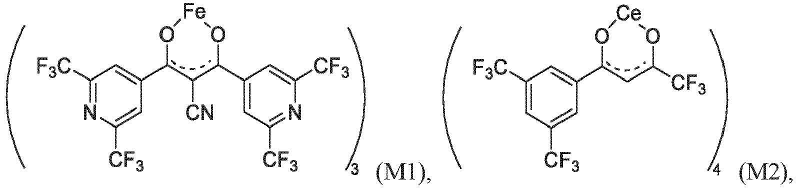

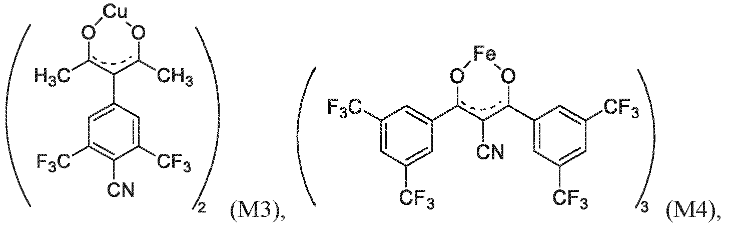

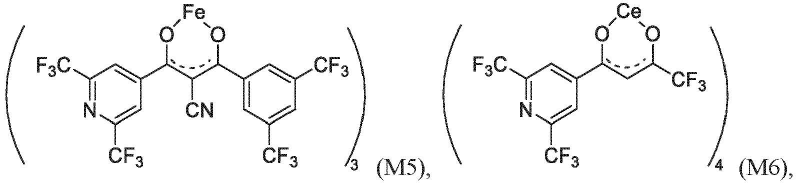

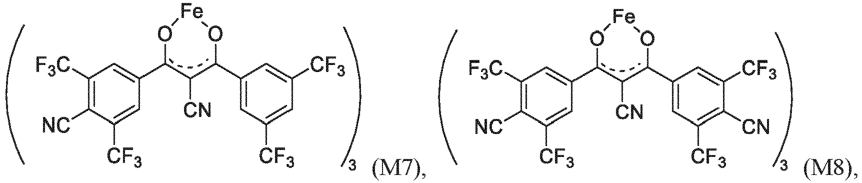

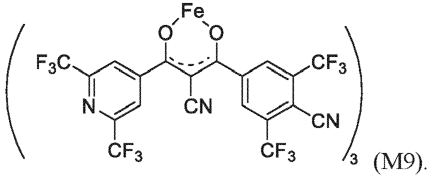

22. The organic electroluminescent device according to claims 1 to 21, wherein the hole injection layer and the first p-type charge generation layer each further comprises a hole transport matrix compound, wherein the hole transport matrix compound is selected same or different.

23. The organic electroluminescent device according to claim 22, wherein the hole transport matrix compound is selected from the group comprising arylamine, diarylamine, triarylamine, formula(XV) and formula (XVI): 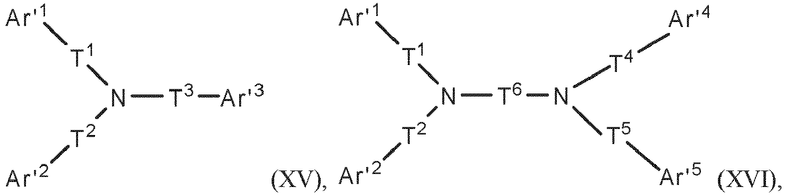 wherein:
T¹, T², T³, T⁴ and T⁵ are independently selected from a single bond, phenylene, biphenylene, terphenylene or naphthenylene, preferably a single bond or phenylene;
T⁶ is phenylene, biphenylene, terphenylene or naphthenylene;
Ar'¹, Ar'², Ar'³, Ar'⁴and Ar'⁵ are independently selected from substituted or unsubstituted C₆ to C₂₀ aryl, or substituted or unsubstituted C₃ to C₂₀ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein the substituents of Ar'¹, Ar'², Ar'³, Ar'⁴ and Ar'⁵ are selected the same or different from the group comprising H, D, F, C(=O)R'², CN, Si(R'²)₃, P(=O)(R'²)₂, OR'², S(=O)R'², S(=O)₂R'², substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted alkoxy groups having 1 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted C₆ to C₁₈ aryl, unsubstituted C₃ to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein R'² may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl or C₃ to C₁₈ heteroaryl.

24. The organic electroluminescent device according to claim 22 or 23, wherein the hole transport matrix compound is selected from the group comprising of compounds F1 to F20:

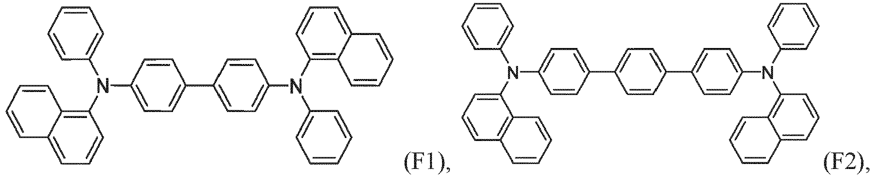

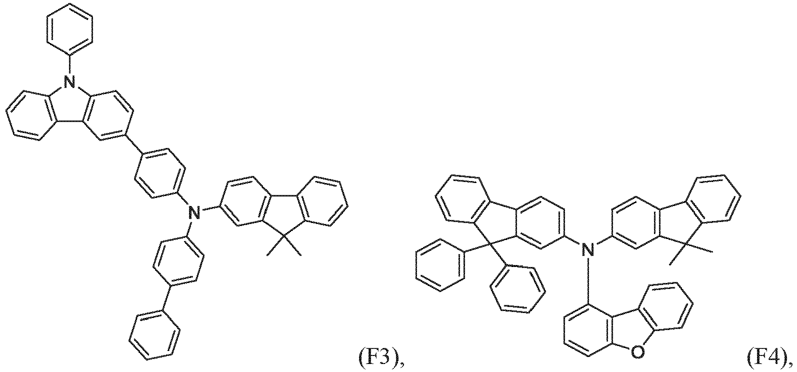

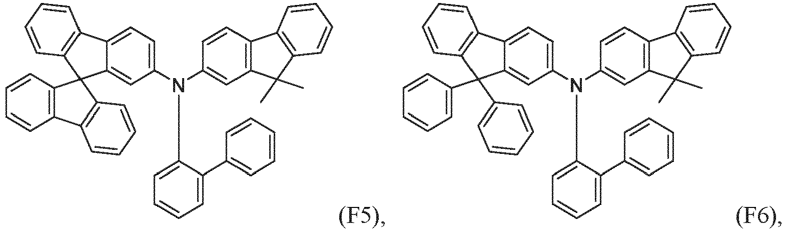

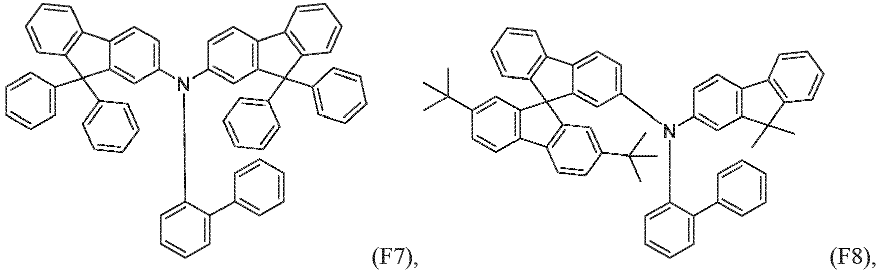

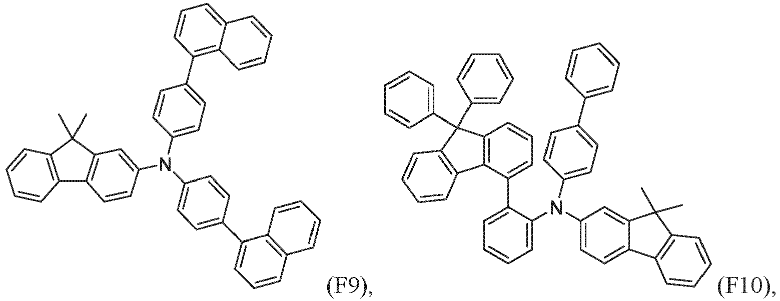

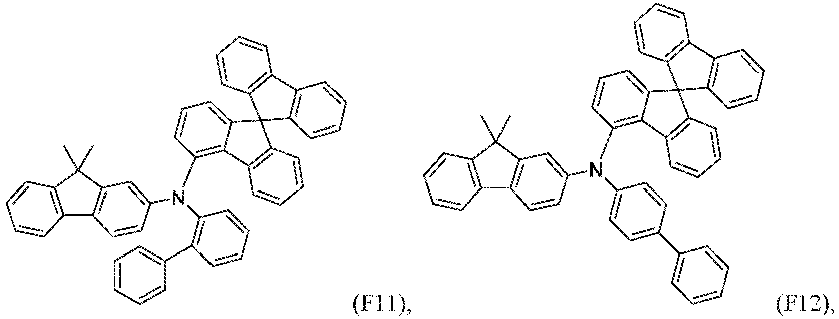

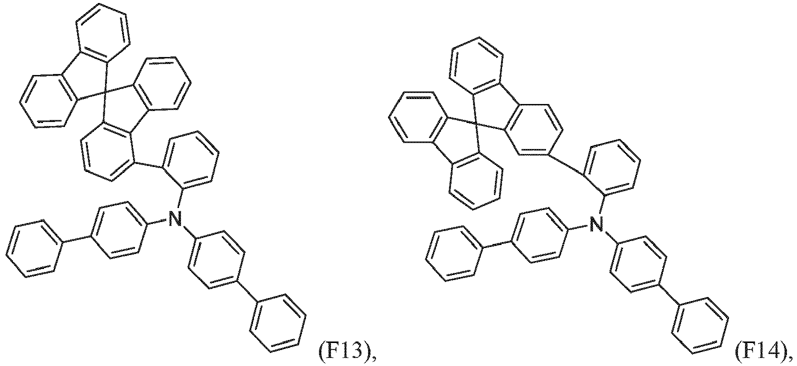

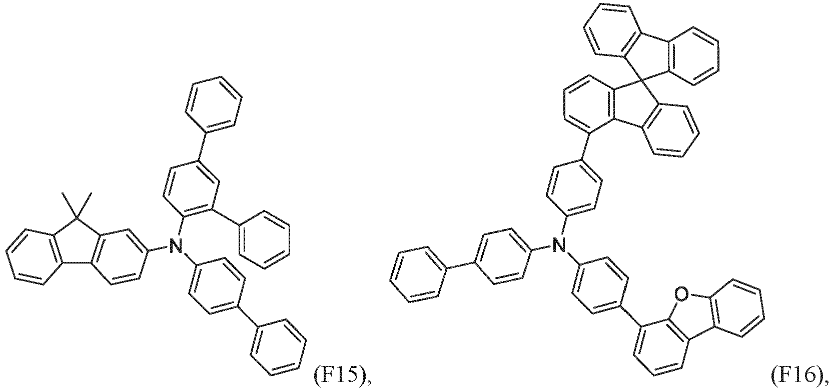

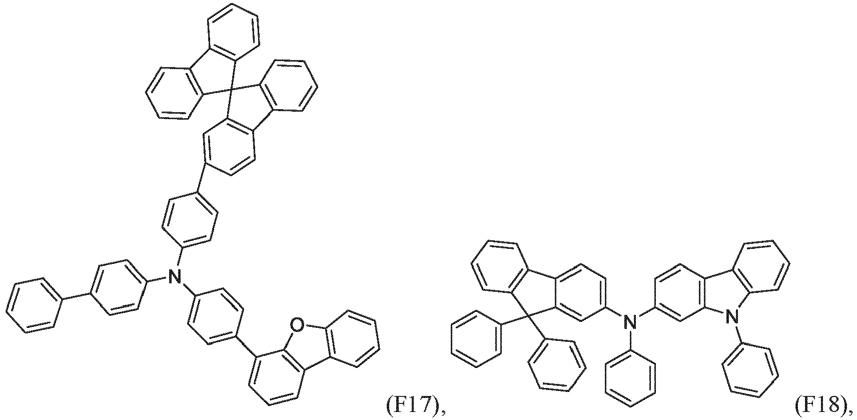

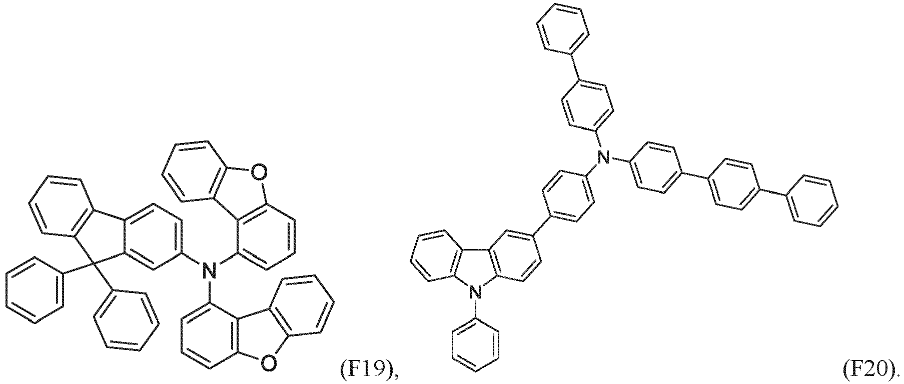

25. The organic electroluminescent device according to any one of claim 1 to 24, wherein the metal dopant is selected from a metal with an electronegativity of ≤ 1.4 eV by Pauling scale, more preferably ≤ 1.35 eV.

26. The organic electroluminescent device according to any one of claims 1 to 25, wherein the metal dopant of the first n-type charge generation layer is a metal selected from the group comprising Li, Na, K, Rb, Cs, Mg, Ca, Sr, Ba, Sm, Eu or Yb or a metal alloy comprising a metal selected from the group comprising Li, Na, K, Rb, Cs, Mg, Ca, Sr, Ba, Sm, Eu or Yb, preferably the metal dopant of the first n-type charge generation layer is selected from the group comprising Li, Mg and Yb.

27. The organic electroluminescent device according to any one of claims 1 to 26, wherein the organic luminescent device is an organic light emitting diode.

28. A display device comprising an organic electroluminescent device according to any of the claims 1 to 27.
